# EUROPÄISCHE PATENTSCHRIFT

(11) **EP 2 607 008 B1**
(45) Veröffentlichungstag und Bekanntmachung des Hinweises auf die Patenterteilung: **09.11.2016**
(21) Anmeldenummer: 11405372.1
(22) Anmeldetag: 19.12.2011
(51) Int. Cl.: B23K 3/047, B23K 1/002, B23K 1/00, B23K 3/08, H01L 31/18, H05K 3/34

(54) **Lötvorrichtung zum Befestigen eines elektrisch leitfähigen Bandes an einer Stromsammelschiene einer Solarzelle mittels induktivem Löten**
Soldering device for fixing an electrically conductive strip to a bus bar of a solar cell by means of inductive soldering
Dispositif de soudure destiné à la fixation d'une bande conductrice d'électricité sur une barre omnibus de courant d'une cellule solaire à l'aide du soudage inductif

(43) Veröffentlichungstag der Anmeldung: 26.06.2013
(73) Patentinhaber: Komax Holding AG, 6036 Dierikon (CH)
(72) Erfinder: Meisser, Claudio, 6330 Cham (CH); Dingle, Brad M., Red Lion, PA 17356 (US); Suter, Pascal, 6331 Hünenberg (CH); Morf, Peter, 8052 Zürich (CH)
(74) Vertreter: EGLI-EUROPEAN PATENT ATTORNEYS

(56) Entgegenhaltungen:
- EP-A1- 2 103 373
- WO-A1-2011/012175

## Beschreibung

Die Erfindung bezieht sich auf eine Lötvorrichtung zum Befestigen eines elektrisch leitfähigen Bandes an einer geraden Stromsammelschiene einer Solarzelle. Insbesondere handelt es sich bei der erfindungsgemässen Lötvorrichtung um eine Lötvorrichtung, welche Lötverbindungen durch induktives Löten, d.h. durch induktives Erhitzen der miteinander zu verbindenden Teile, herstellt.

Eine derartige Lötvorrichtung dient zur Herstellung von elektrischen Verbindungen in einem Solarmodul ("Photovoltaikmodul"). Ein Solarmodul umfasst in der Regel mehrere Solarzellen, welche die Aufgabe haben, auf die jeweilige Solarzelle auftreffendes Licht aufgrund des photovoltaischen Effekts in elektrische Energie umzuwandeln. Zu diesem Zweck umfasst jede einzelne Solarzelle in der Regel eine photoelektrische Schichtstruktur, welche zumindest einen Teil des auf die Solarzelle auftreffenden Lichts absorbiert. Durch die Absorption des Lichts entstehen in der Schichtstruktur einerseits Ladungsträger, welche in der Schichtstruktur einen elektrischen Strom erzeugen können. Weiterhin wird eine elektrische Spannung zwischen einer Vorderseite (bzw. Oberseite) der Solarzelle und einer Rückseite (bzw. Unterseite) der Solarzelle erzeugt. Die einzelnen Solarzellen, welche das Solarmodul bilden, sind üblicherweise nebeneinander auf einer ebenen Fläche angeordnet und elektrisch derart verbunden, dass alle Solarzellen elektrisch in Reihe geschaltet sind, sodass das Solarmodul eine Ausgangsspannung bereitstellen kann, welche der Summe der von den einzelnen Solarzellen erzeugten elektrischen Spannungen entspricht.

Um zwei Solarzellen elektrisch in Reihe zu schalten, muss in der Regel eine elektrische Verbindung zwischen der Vorderseite der einen Solarzelle mit der Rückseite der anderen Solarzelle hergestellt werden. Eine derartige elektrische Verbindung wird üblicherweise realisiert mittels eines flexiblen, elektrisch leitfähigen Bandes, wobei jeweils ein Abschnitt des Bandes an der Vorderseite der einen Solarzelle und ein anderer Abschnitt des Bandes an der Rückseite der anderen Solarzelle zu befestigen ist.

Im Hinblick auf eine Optimierung der Herstellung derartiger elektrischer Verbindungen spielen unter anderem konstruktive Unterschiede zwischen verschiedenen Typen von Solarzellen eine Rolle.

Es sind beispielsweise "Standard"-Solarzellen bekannt, welche so ausgelegt sind, dass sie lediglich Licht photoelektrisch umwandeln können, welches auf eine Seite (die Vorderseite) der Solarzelle trifft. Bei derartigen "Standard"-Solarzellen ist die Rückseite in der Regel flächendeckend mit einer (für Licht nicht transparenten) Schicht aus einem Metall (im Folgenden "Metallschicht") bedeckt. Die Vorderseite, welche für das in elektrische Energie umzuwandelnde Licht transparent sein muss, ist hingegen in der Regel mit einer Vielzahl parallel zueinander angeordneter Leiterbahnen versehen. Die Metallschicht auf der Rückseite und die Leiterbahnen auf der Vorderseite dienen dabei als elektrische Kontakte, welche die in der Solarzelle photoelektrisch erzeugten Ladungsträger aufnehmen können. Weiterhin ist die Vorderseite der Solarzelle mit mehreren (in der Regel 2 bis 4) Stromsammelschienen versehen, welche sich parallel zueinander und geradlinig jeweils senkrecht zu den Leiterbahnen erstrecken. Jede dieser Stromsammelschienen bildet eine elektrische Verbindung zwischen den jeweiligen Leiterbahnen an der Vorderseite der jeweiligen Solarzelle und hat die Aufgabe, die von den einzelnen Leiterbahnen an der Vorderseite der Solarzelle aufgenommenen Ladungsträger zu sammeln und einen Transport dieser Ladungsträger entlang der jeweiligen Stromsammelschiene zu ermöglichen. Um zwei derartige "Standard"-Solarzellen elektrisch in Reihe zu schalten, ist es in der Regel üblich, jede der Stromsammelschienen an der Vorderseite der einen Solarzelle mit der Metallschicht an der Rückseite der anderen Solarzelle mittels eines flexiblen, elektrisch leitfähigen Bandes zu verbinden.

Weiterhin sind sogenannte bifaciale Solarzellen bzw. "doppelseitige" Solarzellen bekannt. Bifaciale Solarzellen sind - im Gegensatz zu "Standard"-Solarzellen - dazu ausgelegt, sowohl Licht, welches auf die Vorderseite der Solarzelle auftrifft, als auch Licht, welches auf die Rückseite der Solarzelle auftrifft, in elektrische Energie umzuwandeln. Bei derartigen bifacialen Solarzellen muss daher in der Regel sowohl die Vorderseite als auch die Rückseite für Licht transparent sein. Aus diesem Grund ist die Rückseite einer bificialen Solarzelle im Gegensatz zur Rückseite einer "Standard"-Solarzelle nicht flächendeckend mit einer Metallschicht beschichtet. Vielmehr ist bei einer bificialen Solarzelle sowohl die Vorderseite als auch die Rückseite mit einer Vielzahl nebeneinander angeordneter Leiterbahnen versehen, welche als elektrische Kontakte zur Aufnahme der in der Solarzelle photoelektrisch erzeugten Ladungsträger dienen. Weiterhin ist sowohl die Vorderseite als auch die Rückseite der Solarzelle jeweils mit mehreren (in der Regel 2 bis 4) Stromsammelschienen versehen, welche sich zueinander parallel und geradlinig jeweils senkrecht zu den jeweiligen Leiterbahnen auf der Vorderseite bzw. auf der Rückseite der Solarzelle erstrecken und die jeweiligen Leiterbahnen miteinander verbinden. Um zwei derartige bifaciale Solarzellen elektrisch in Reihe zu schalten, ist es in der Regel üblich, jede der Stromsammelschienen an der Vorderseite der einen Solarzelle mit einer der Stromsammelschienen an der Rückseite der anderen Solarzelle mittels eines flexiblen, elektrisch leitfähigen Bandes zu verbinden.

Aus EP 2 103 373 A1 ist eine Lötvorrichtung bekannt, welche es ermöglicht, ein elektrisch leitfähiges Band an einer Stromsammelschiene einer Solarzelle zu befestigen, indem mittels induktivem Löten zwischen der Stromsammelschiene und dem leitfähigen Band eine Lötverbindung hergestellt wird, welche sich entlang einer geraden Linie, im Folgenden "Lötlinie" genannt, in der Längsrichtung der Stromsammelschiene erstreckt. Die Lötvorrichtung umfasst eine Mehrzahl Niederhalterelemente zum Niederhalten des Bandes auf einer Oberfläche der Stromsammelschiene, an welcher das Band befestigt werden soll. Zur Herstellung einer Lötverbindung kann deshalb beispielsweise ein Längsabschnitt des Bandes entlang der Lötlinie auf die Oberfläche der Stromsammelschiene gelegt und während der Herstellung der Lötverbindung mittels der Niederhalterelemente gehalten werden. Um die Herstellung der Lötverbindung zu ermöglichen, ist die Oberfläche der Stromsammelschiene mit einem Lötmittel, beispielsweise einem Weichlot, versehen. Die Niederhalterelemente sind im vorliegenden Beispiel als Stifte ausgebildet, welche entlang der Lötlinie in einer Reihe hintereinander angeordnet sind, sich jeweils senkrecht zur Oberfläche der Stromsammelschiene erstrecken und relativ zu der Lötlinie bewegbar sind, um die Niederhalterelemente mit dem Band in Kontakt bringen zu können. Die Lötvorrichtung umfasst weiterhin eine Induktionsantenne mit einem sich entlang der Lötlinie erstreckenden Strompfad für einen elektrischen Wechselstrom. Der Strompfad ist in einer aus einem gebogenen Rohr geformten Induktionsschleife ausgebildet, welche U-förmig ist und dementsprechend zwei parallel und in einem Abstand zueinander angeordnete und sich im Wesentlichen parallel zur Lötlinie erstreckende Schenkel aufweist. Diese beiden Schenkel der Induktionsschleife sind an einen Generator für (hochfrequenten) Wechselstrom angeschlossen, wobei ein von dem Generator erzeugter Wechselstrom derart durch die beiden Schenkel der Induktionsschleife fliesst, dass der Wechselstrom in einem der beiden Schenkel jeweils in Gegenphase zum Wechselstrom in dem anderen der beiden Schenkel ist. Der Wechselstrom ist dabei in beiden Schenkeln der Induktionsschleife derart geführt, dass er in der Lötlinie und/oder in einer Umgebung der Lötlinie ein magnetisches Wechselfeld erzeugt, welches an der Lötlinie in dem gesamten Bereich der Lötlinie, in dem es präsent ist, jeweils dieselbe Phase aufweist. Das magnetische Wechselfeld hat dabei die Aufgabe, in der Stromsammelschiene und/oder in dem Band durch elektromagnetische Induktion elektrische Wirbelströme zu erzeugen, welche eine Erwärmung der Stromsammelschiene und des Bandes ermöglichen, sodass das Lötmittel zunächst zum Schmelzen gebracht werden kann und schliesslich eine sich entlang der Lötlinie erstreckende Lötverbindung zwischen dem Band und der Stromsammelschiene erzeugt werden kann. Die Induktionsschleife weist entlang der Lötlinie mehrere hintereinander angeordnete Aufweitungen und Verengungen auf, wobei in jeder der Aufweitungen (d.h. zwischen den beiden Schenkeln der Induktionsschleife) eines der Niederhalterelemente platziert ist. Im vorliegenden Fall erzeugt die Induktionsschleife - entsprechend der Anordnung der beiden Schenkel der Induktionsschleife - jeweils ein magnetisches Wechselfeld, welches an den jeweiligen Aufweitungen eine grössere Feldstärke aufweist als an den Verengungen. Diese Anordnung der Induktionsschleife relativ zu den Niederhalterelementen soll eine möglichst intensive Erhitzung der Stromsammelschiene bzw. des Bandes bei möglichst effizientem Einsatz der zum Erhitzen benötigten Energie, d.h. bei möglichst hoher Energieeffizienz, ermöglichen.

Die Induktionsantenne der vorstehend genannten Lötvorrichtung zeigt allerdings beim induktiven Erhitzen verschiedene Effekte, welche als problematisch angesehen werden. Das von der Induktionsantenne erzeugte magnetische Wechselfeld ist in Regel in einem Raumbereich präsent, welcher nicht ausschliesslich auf die jeweiligen Stromsammelschiene bzw. auf das an der Stromsammelschiene zu befestigenden Band beschränkt ist, sondern sich auch auf Bereiche der Solarzelle ausserhalb der Stromsammelschiene erstreckt. Das magnetische Wechselfeld induziert deshalb zwar einerseits in der jeweiligen Stromsammelschiene bzw. in dem an der Stromsammelschiene zu befestigenden Band lokale elektrische Wirbelströme und erzeugt auf diese Weise eine elektrische Heizleistung in der Stromsammelschiene bzw. in dem zu befestigenden Band. Das magnetische Wechselfeld induziert allerdings auch elektrische Ströme, welche durch Bereiche der Solarzelle ausserhalb der jeweiligen Stromsammelschiene fliessen. Letzteres hat zur Folge, dass auch in Bereichen der Solarzelle ausserhalb der jeweiligen Stromsammelschiene eine elektrische Heizleistung erzeugt und somit eine lokale Erhitzung dieser Bereiche erzielt wird.

Letzteres ist einerseits grundsätzlich ungünstig hinsichtlich der Energieeffizienz der Heizung der jeweiligen Stromsammelschiene bzw. des an der Stromsammelschiene zu befestigenden Bandes. Nachteilig ist weiterhin, dass die elektrischen Ströme, welche - induziert durch das magnetische Wechselfeld der Induktionsantenne - durch Bereiche der Solarzelle ausserhalb der jeweiligen Stromsammelschiene fliessen können, die Solarzelle bzw. das Band räumlich inhomogen aufheizen. Diese inhomogene Aufheizung führt zu einer grossen Variation der Temperatur der Solarzelle bzw. der Temperatur des Bandes als Funktion des Ortes. Infolge der inhomogenen Aufheizung kann insbesondere die Temperatur der Stromsammelschiene bzw. die Temperatur des Bandes entlang der Lötlinie stark variieren. Dies ist insbesondere problematisch im Hinblick auf die Herstellung von Lötverbindungen, welche über eine grosse Distanz (beispielsweise über die gesamte Länge der Stromsammelschiene) möglichst homogen ausgebildet sein sollen. Wegen der inhomogenen Aufheizung der Solarzelle besteht beispielsweise die Gefahr, dass die Temperatur der Stromsammelschiene und die Temperatur des Bandes beim induktiven Aufheizen entlang der Lötlinie derart variieren, dass das erwähnte Lötmittel an der Oberfläche der Stromsammelschiene an bestimmten Abschnitten der Lötlinie nicht oder nur teilweise schmilzt, sodass entlang dieser Abschnitte der Lötlinie keine Lötverbindung oder nur eine unzureichend belastbare Lötverbindung entstehen kann. Andererseits besteht die Gefahr, dass die Temperatur der Stromsammelschiene und die Temperatur des Bandes beim induktiven Aufheizen entlang der Lötlinie derart variieren, dass das zu befestigende Band lokal überhitzt und zerstört wird.

Wird beispielsweise ein sich über die gesamte Länge einer Stromsammelschiene erstreckendes Band mit einer konventionellen Induktionsantenne induktiv über die gesamte Länge der Stromsammelschiene erhitzt, so ist beispielsweise festzustellen, dass sich die Temperatur des Bandes bzw. der Stromsammelschiene insbesondere an den beiden Enden der jeweiligen Stromsammelschiene besonders drastisch erhöhen kann. Weiterhin ist eine starke Erhitzung der Solarzelle in der Nähe eines Randes der Solarzelle zwischen zwei benachbarten Stromsammelschienen festzustellen. In diesem Fall besteht die Gefahr, dass das Band an den Enden der Stromsammelschiene beim induktiven Löten überhitzt und gegebenenfalls zerstört wird. Die vorstehend genannten Effekte sind besonders gravierend, wenn ein Band an eine der Stromsammelschienen einer bifacialen Solarzelle mittels der vorstehend genannten Induktionsantenne induktiv gelötet wird.

Der vorliegenden Erfindung liegt die Aufgabe zugrunde, die genannten Nachteile zu vermeiden und eine Lötvorrichtung zum Befestigen eines elektrisch leitfähigen Bandes an einer Stromsammelschiene einer Solarzelle entlang einer geraden Lötlinie mittels induktivem Löten mit einer Induktionsantenne zu schaffen, wobei die Induktionsantenne dazu ausgebildet sein soll, die Stromssammelschiene und/oder das Band möglichst gleichmässig induktiv zu erhitzen, sodass räumliche Variationen der Temperatur der Stromsammelschiene bzw. der Temperatur der Stromsammelschiene des Bandes entlang der Lötlinie während des Lötens reduziert sind und lokale überhitzungen des Bandes bzw. der Solarzelle vermieden werden.

Diese Aufgabe wird gelöst durch eine Lötvorrichtung mit den Merkmalen des Patentanspruchs 1.

Diese Lötvorrichtung umfasst eine Mehrzahl Niederhalterelemente zum Niederhalten des Bandes auf einer Oberfläche der Stromsammelschiene, wobei die Niederhalterelemente entlang der Lötlinie in einer Reihe hintereinander angeordnet sind. Die Lötvorrichtung umfasst ausserdem eine Induktionsantenne mit einem sich entlang der Lötlinie erstreckenden Strompfad für einen elektrischen Wechselstrom, wobei der elektrische Wechselstrom entlang des Strompfads derart geführt ist, dass er in der Lötlinie und/oder in einer Umgebung der Lötlinie ein magnetisches Wechselfeld erzeugt.

Gemäss der Erfindung erstreckt sich der Strompfad entlang mehrerer in einer Reihe hintereinander angeordneter Abschnitte der Lötlinie derart, dass das magnetische Wechselfeld in mindestens einem der Abschnitte der Lötlinie in Gegenphase zu dem magnetischen Wechselfeld in mindestens einem anderen der Abschnitte der Lötlinie ist.

In diesem Zusammenhang sei zur Verdeutlichung des Unterschieds zum Stand der Technik nochmals darauf hingewiesen, dass im Falle der aus EP 2 103 373 A1 bekannten Induktionsantenne der elektrische Wechselstrom derart entlang der Lötlinie geführt ist, dass der elektrischen Wechselstrom ein magnetisches Wechselfeld erzeugt, welches entlang der Lötlinie - in dem gesamten Bereich der Lötlinie, in dem des magnetische Wechselfeld präsent ist - jeweils dieselbe Phase aufweist.

Im Falle der erfindungsgemässen Lötvorrichtung ist hingegen (durch eine entsprechende Ausbildung des Strompfads für den elektrischen Wechselstrom) der elektrische Wechselstrom entlang der Lötlinie derart geführt, dass der elektrische Wechselstrom in verschiedenen Abschnitten der Lötlinie magnetische Wechselfelder erzeugt, welche sich hinsichtlich ihrer Phase unterscheiden. In einer Ausführungsvariante können beispielsweise zwei in einer Reihe hintereinander angeordneter Abschnitte der Lötlinie vorgesehen sein und sich der Strompfad für den Wechselstrom derart entlang der Lötlinie erstrecken, dass der Wechselstrom in jedem dieser Abschnitte ein magnetisches Wechselfeld erzeugt, wobei das magnetisches Wechselfeld in dem einen dieser Abschnitte in Gegenphase zu dem magnetischen Wechselfeld in dem anderen dieser Abschnitte ist. Dementsprechend kann das magnetische Wechselfeld in dem einem dieser Abschnitte der Lötlinie jeweils entgegengesetzt zum magnetischen Wechselfeld in dem anderen dieser Abschnitte der Lötlinie gerichtet sein. Dabei können die jeweiligen Feldstärken der magnetischen Wechselfelder in den jeweiligen Abschnitten der Lötlinie hinsichtlich des Betrags der Feldstärke identisch sein. Gemäss einer anderen Ausführungsvariante können aber auch mehr als zwei in einer Reihe hintereinander angeordneter Abschnitte der Lötlinie vorgesehen sein und sich der Strompfad für den Wechselstrom derart entlang der Lötlinie erstrecken, dass der Wechselstrom in jedem dieser Abschnitte ein magnetisches Wechselfeld erzeugt, wobei die magnetischen Wechselfelder in jeweils zwei unmittelbar hintereinander angeordneten (benachbarten) Abschnitten zueinander in Gegenphase sind. Gemäss dieser letztgenannten Ausführungsvariante sind demnach magnetische Wechselfelder in drei oder mehr in einer Reihe hintereinander angeordneten Abschnitten der Lötlinie derart erzeugbar, dass die magnetischen Wechselfelder in mindestens zwei dieser Abschnitte miteinander in Gleichphase sind und zwischen diesen zwei Abschnitten mindestens ein weiterer Abschnitt der Lötlinie angeordnet ist, in welchem das magnetische Wechselfeld in Gegenphase ist bezüglich der magnetischen Wechselfelder in den genannten zwei Abschnitten der Lötlinie, in welchen die jeweiligen magnetischen Wechselfelder zueinander in Gleichphase sind.

Dadurch, dass im Falle der erfindungsgemässen Lötvorrichtung die magnetischen Wechselfelder in verschiedenen Abschnitten der Lötlinie jeweils in Gegenphase zueinander sind, ist die Möglichkeit geschaffen, die elektrischen Ströme, welche mittels der magnetischen Wechselfelder in der Solarzelle durch elektromagnetische Induktion induzierbar sind, hinsichtlich ihrer räumlichen Verteilung und/oder ihrer Stromstärke derart zu beeinflussen, dass die induzierten elektrischen Ströme in Bereichen der Solarzelle ausserhalb der Stromsammelschiene, an welche das Band gelötet werden sollen, möglichst wenig Wärme erzeugen. Weiterhin kann eine räumliche Verteilung der induzierten elektrischen Ströme derart optimiert werden, dass die Wärme, welche die induzierten Ströme in Bereichen der Solarzelle ausserhalb der Stromsammelschiene gegebenenfalls erzeugen, räumlich möglichst gleichmässig verteilt ist. Auf dieser Grundlage wird erreicht, dass lokale Überhitzungen der Solarzelle bzw. des zu befestigenden Bandes vermieden werden können.

Die vorstehend genannten Vorteile der erfindungsgemässen Lötvorrichtung werden beispielsweise deutlich beim induktiven Löten eines elektrisch leitfähigen Bandes an eine Solarzelle, welche - wie die erwähnten "Standard"-Solarzellen oder bifacialen Solarzellen - mehrere nebeneinander angeordnete und durch eine Vielzahl von Leiterbahnen miteinander verbundene Stromsammelsammelschienen aufweist. Aus diesem Grunde sollen Vorteile der erfindungsgemässen Lötvorrichtung im Folgenden für den Fall diskutiert werden, dass das jeweilige Band an eine der Stromsammelsammelschienen einer derartigen (mehrere Stromsammelschienen aufweisenden) Solarzelle gelötet werden soll, wobei eine Lötverbindung zwischen dieser einen Stromsammelschiene und dem Band jeweils entlang einer sich in der Längsrichtung dieser einen Stromsammelschiene erstreckenden Lötlinie herzustellen ist.

Die eine Stromsammelschiene, an welche das Band gelötet werden soll, wird in der folgenden Diskussion der Einfachheit halber als die "erste" Stromsammelschiene bezeichnet.

Zur Vereinfachung der Diskussion soll dabei (als ein Beispiel) angenommen werden, dass sich die herzustellende Lötverbindung im Wesentlichen über die gesamte Länge der ersten Stromsammelschiene erstrecken soll. Dementsprechend sei in der folgenden Diskussion angenommen, dass das zu befestigende Band beim Löten mit der ersten Stromsammelschiene entlang der Lötlinie im Wesentlichen über die gesamte Länge der ersten Stromsammelschiene in Kontakt gebracht ist. Weiterhin sei angenommen, dass die mittels der Induktionsantenne erzeugten magnetischen Wechselfelder in einem Raumbereich präsent sind, welcher sich entlang der Lötlinie im Wesentlichen über die gesamte Länge der ersten Stromsammelschiene erstreckt.

Die Erfindung geht von der Überlegung aus, dass zum Erhitzen des Bandes und der ersten Stromsammelschiene beim induktiven Löten in der Regel nicht nur Wirbelströme beitragen, welche mittels der von der von der Induktionsantenne erzeugten magnetischen Wechselfelder in dem Band und/oder der ersten Stromsammelschiene induzierbar sind. Diese Wirbelströme werden von den magnetischen Wechselfeldern in dem Band und/oder in der ersten Stromsammelschiene mittels elektromagnetischer Induktion "lokal" induziert und fliessen dementsprechend entlang Bahnen, welche räumlich im Wesentlichen auf das Band und/oder die erste Stromsammelschiene beschränkt sind.

Dadurch, dass die erste Stromsammelschiene über eine Vielzahl von Leiterbahnen mit (mindestens) einer weiteren Stromsammelschiene (im Folgenden "zweite" Stromsammelschiene genannt) verbunden ist, sind in der Solarzelle beim induktiven Löten in der Regel ein oder mehrere ringförmig geschlossene Strompfade ausgebildet, welche elektrischen Strom jeweils entlang einer ringförmig geschlossenen Bahn sowohl durch das Band und/oder die erste Stromsammelschiene als auch durch Bereiche der Solarzelle ausserhalb der ersten Stromsammelschiene führen (z.B. durch einen Längsabschnitt der zweiten Stromsammelschiene und durch Leiterbahnen, welche das Band über die erste Stromsammelschiene mit jeweils einem der Enden des Längsabschnitts der zweiten Stromsammelschiene verbinden).

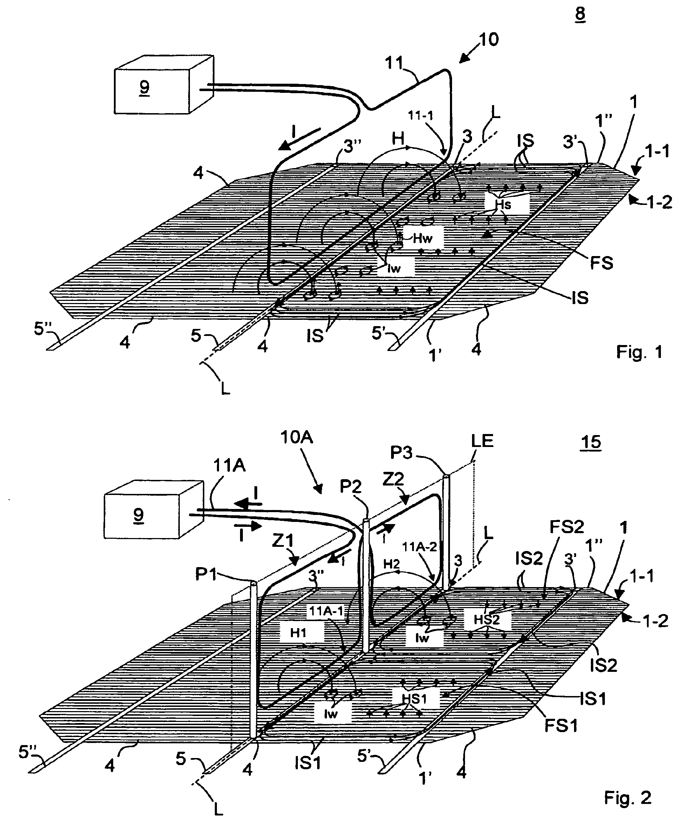

Wie insbesondere im Zusammenhang mit Fig. 1 und 2 noch erläutert wird - können die von der Induktionsantenne erzeugten magnetischen Wechselfelder mittels elektromagnetischer Induktion elektrische Ströme induzieren, welche entlang eines der vorstehend genannten ringförmigen Strompfade geführt sind. Ein elektrischer Strom, welcher elektromagnetisch in einem derartigen ringförmigen Strompfad induziert wird, soll im Folgenden als (elektromagnetisch induzierter) "sekundärer" elektrischer Wechselstrom bezeichnet werden (die Bezeichnung "sekundärer" elektrischer Wechselstrom wird - wie im Zusammenhang mit Fig. 1 und 2 näher erläutert wird - auf einen Vergleich mit einem "Transformator" gestützt, wobei anzunehmen ist, dass der Strompfad der Induktionsantenne und die jeweiligen in der Solarzelle ausgebildeten ringförmigen Strompfade sich hinsichtlich ihrer elektromagnetischen Wechselwirkung miteinander entsprechend einem klassischen, eine "primärseitige Wicklung" und eine "sekundärseitige Wicklung" umfassenden "Transformator" verhalten, wobei der Strompfad der Induktionsantenne die Funktion der primärseitigen Wicklung des Transformators und der jeweilige in der Solarzelle ausgebildete ringförmige Strompfad die Funktion der sekundärseitigen Wicklung des Transformators hat).

Ein Strompfad für einen elektromagnetisch induzierbaren sekundären elektrischen Wechselstrom kann beispielsweise wie folgt aus mehreren jeweils (ringförmig) hintereinander angeordneten Abschnitten zusammengesetzt sein: Einer der Abschnitte kann aus einem Längsabschnitt des Bandes und/oder einem Längsabschnitt der ersten Stromsammelschiene bestehen und den sekundären Wechselstrom somit in diesem Abschnitt des Strompfads entlang des Bandes und/oder der ersten Stromsammelschiene führen; ein weiterer Abschnitt des Strompfads kann von einer ersten Leiterbahn oder einer ersten Gruppe von mehreren Leiterbahnen gebildet sein, welche eines der Enden des vorstehend genannten Längsabschnitts des Bandes (über die erste Stromsammelschiene) mit der zweiten Stromsammelschiene verbinden, und somit den sekundären elektrischen Wechselstrom in diesem Abschnitt des Strompfads zwischen dem einen Ende des Längsabschnitts des Bandes und der zweiten Stromsammelschiene durch die jeweiligen Leiterbahnen führen; ein weiterer Abschnitt des Strompfads kann von einem Abschnitt der zweiten Stromsammelschiene gebildet sein und den sekundären elektrischen Wechselstrom somit in diesem Abschnitt des Strompfads entlang der zweiten Stromsammelschiene führen; ein weiterer Abschnitt des Strompfads kann von einer zweiten Leiterbahn oder einer zweiten Gruppe von mehreren Leiterbahnen gebildet sein, welche das andere Ende des vorstehend genannten Längsabschnitts des Bandes (über die erste Stromsammelschiene) mit der zweiten Stromsammelschiene verbinden, und somit den sekundären elektrischen Wechselstrom in diesem Abschnitt des Strompfads zwischen dem anderen Ende des Längsabschnitts des Bandes und der zweiten Stromsammelschiene durch die jeweiligen Leiterbahnen führen.

Entsprechend der räumlichen Struktur der vorstehend genannten Strompfade für sekundäre elektrische Ströme führen die induzierten sekundären elektrischen Ströme in Regel jeweils zu einer Erzeugung von Wärme sowohl in einem Abschnitt des Bandes und/oder in einem Abschnitt der ersten Stromsammelschiene als auch in einem Abschnitt der zweiten Stromsammelschiene und in den jeweiligen Leiterbahnen, welche den sekundären elektrischen Wechselstrom zwischen jeweils einem der Enden des Abschnitts des Bandes und einem der Enden des Abschnitts der zweiten Stromsammelschiene führen.

Die induzierten sekundären elektrischen Ströme können als wesentliche Ursache der Probleme betrachtet werden, welche durch die Erfindung gelöst werden. Problematisch an diesen sekundären elektrischen Strömen ist u.a., dass ein wesentlicher Teil der Heizleistung ausserhalb der ersten Stromsammelschiene bzw. ausserhalb des Bandes, welches an die erste Stromsammelschiene gelötet werden soll, erzeugt wird. Die induzierten sekundären Ströme führen deshalb zu einer Erhitzung der zweiten Stromsammelschiene und insbesondere zu einer besonders starken Erhitzung der Leiterbahnen zwischen der ersten Stromsammelschiene und der zweiten Stromsammelschiene (dies ist in der Regel dadurch bedingt, dass diese Leiterbahnen in der Regel einen relativ grossen elektrischen Widerstand haben, sodass der jeweilige sekundäre elektrische Wechselstrom in den Leiterbahnen eine grössere Heizleistung erzeugt als in dem Band bzw. in der ersten Stromsammelschiene oder der zweiten Stromsammelschiene).

Weiterhin ist problematisch, dass die induzierten sekundären elektrischen Ströme jeweils in einem ringförmig geschlossenen Strompfad geführt sind. Da die induzierten sekundären Ströme folglich Wärme entlang des jeweiligen (ringförmigen) Strompfads erzeugen, führen diese sekundären elektrischen Ströme somit zu einer räumlich inhomogenen Erhitzung der Solarzelle. Ein sekundärer elektrischer Wechselstrom kann deshalb Ursache einer lokalen Überhitzung des Bandes bzw. der Solarzelle sein (abhängig von der Stromstärke des jeweils induzierten sekundären elektrischen Wechselstroms).

Wie im Zusammenhang mit Fig. 1 und 2 noch näher erläutert wird, können die induzierten sekundären Ströme hinsichtlich ihrer räumlichen Verteilung und/oder ihrer Stromstärke durch eine Reihe von Parameter beeinflusst werden. Die räumliche Erstreckung der Strompfade der jeweiligen sekundären elektrischen Ströme wird wesentlich bestimmt durch die räumliche Verteilung der mittels der Induktionsantenne erzeugten magnetischen Wechselfelder.

Erzeugt die Induktionsantenne beispielsweise ein magnetisches Wechselfeld in einem vorgegeben Abschnitt der Lötlinie derart, dass die Phase dieses Wechselfelds entlang dieses vorgegebenen Abschnitts der Lötlinie konstant ist, so induziert dieses Wechselfeld einen sekundären elektrischen Wechselstrom, dessen räumliche Erstreckung wesentlich bestimmt ist durch die Länge des vorgegebenen Abschnitts der Lötlinie, in welchem die Phase dieses Wechselfelds konstant ist: Der Strompfad des induzierte sekundäre elektrische Wechselstrom erstreckt sich in dem Band bzw. in der ersten Stromsammelschiene jeweils entlang des vorgegeben Abschnitts der Lötlinie, in welchem die Phase dieses Wechselfelds konstant ist, und erstreckt sich ausserhalb des Bandes bzw. der ersten Stromsammelschiene an der Peripherie eines Bereichs der Solarzelle, welcher sich zwischen der ersten Stromsammelschiene und der zweiten Stromsammelschiene erstreckt und - in Richtung der ersten Stromsammelschiene - eine Länge aufweist, welche im Wesentlichen mit der Länge des vorgegebenen Abschnitts der Lötlinie übereinstimmt (Fig. 1 und 2). Daraus resultiert eine besonders starke lokale Erhöhung der Temperatur des Bandes, der Temperatur der ersten Stromsammelschiene und der Temperatur der Leiterbahnen jeweils im Bereich der beiden Enden des vorgegebenen Abschnitts der Lötlinie. Dabei ist die Stromstärke des induzierten sekundären elektrischen Wechselstroms (bei vorgegebener Feldstärke des magnetischen Wechselfeldes) umso grösser, je grösser die Länge des vorgegeben Abschnitts der Lötlinie ist, in welchem die Phase des Wechselfelds konstant ist (wie im Zusammenhang mit Fig. 2 noch erläutert wird).

Letzteres deutet an, dass induzierte sekundäre elektrische Ströme beim induktiven Löten zu einer besonders stark ausgeprägten Inhomogenität der Erhitzung der Solarzelle und zu besonders starken lokalen Überhitzungen führen, wenn das von der Induktionsantenne erzeugte magnetische Wechselfeld entlang der Lötlinie über die gesamte Länge der ersten Stromsammelschiene eine konstante Phase aufweist (diese Situation ist - wie erwähnt - beim induktiven Löten mittels einer Induktionsantenne gemäss dem Stand der Technik, wie z.B. aus EP 2 103 373 A1 bekannt, realisiert). In diesem Fall induziert das magnetische Wechselfeld im vorliegenden Beispiel im Wesentlichen einen sekundären elektrischen Wechselstrom in einem ringförmigen Strompfad, welcher den sekundären elektrischen Wechselstrom um einen besonders grossen Bereich der Solarzelle herumführt: Dieser eine sekundäre elektrische Wechselstrom fliesst im Wesentlichen entlang des Bandes bzw. der ersten Stromsammelschiene (über die gesamte Länge der ersten Stromsammelschiene), weiterhin entlang der zweiten Stromsammelschiene (über die gesamte Länge der zweiten Stromsammelschiene), zusätzlich durch eine erste Gruppe von Leiterbahnen, welche in der Nähe eines Randes der Solarzelle eines der Enden der ersten Stromsammelschiene mit einem der Enden der zweiten Stromsammelschiene verbinden, und ausserdem durch eine zweite Gruppe von Leiterbahnen, welche in der Nähe eines anderen Randes der Solarzelle das andere der Enden der ersten Stromsammelschiene mit dem anderen der Enden der zweiten Stromsammelschiene verbinden. Weiterhin ist die Stromstärke dieses sekundären elektrischen Wechselstroms im vorliegenden Fall (bezogen auf eine vorgegebenen Feldstärke des magnetischen Wechselfeldes) besonders gross (Fig. 1). Dieser sekundäre elektrische Wechselstrom führt folglich zu einer besonders starken lokalen Überhitzung in einzelnen Abschnitten Bandes bzw. der ersten Stromsammelschiene an den Enden der ersten Stromsammelschiene und einer starken Erhitzung der vorstehend genannten ersten und zweiten Gruppe von Leiterbahnen in zwei verschiedenen Randbereichen der Solarzelle.

Es sei daraufhin hingewiesen, dass diese Form der inhomogenen Erhitzung der jeweiligen Solarzelle im Falle von bifacialen Solarzellen besonders extrem ausgeprägt ist. Bei bifacialen Solarzellen können die sekundären elektrischen Ströme, wie experimentelle Untersuchungen zeigen, nämlich in der Solarzelle eine Heizleistung erzeugen, welche wesentlich (in der Regel um 100% oder mehr) grösser ist als die Heizleistung, welche die induktiv erzeugten Wirbelströme im Band bzw. in der Solarzelle erzeugen. Beim induktiven Löten an bifacialen Solarzelle spielt die induktive Erwärmung mittels induzierter sekundärer Ströme folglich eine dominante Rolle im Vergleich zum Beitrag der Erwärmung mittels induzierter Wirbelströme. Im Falle von Standard-Solarzellen liefern die induzierten sekundären elektrischen Ströme einen signifikanten Beitrag zur Erwärmung der jeweiligen Solarzelle; dieser Beitrag ist typischerweise von der gleichen Grössenordnung wie die Heizleistung, welche die induzierten Wirbelströme in dem Band bzw. in der ersten Stromsammelschiene erzeugen. Im Falle von "Standard"-Solarzellen führen die induzierten sekundären Ströme allerdings zu einer Inhomogenität der Erhitzung des Bandes bzw. der ersten Stromsammelschiene, welche weniger stark ausgeprägt ist als im Falle von bifacialen Solarzellen. Letzteres ist darauf zurückzuführen, dass die Rückseite der "Standard-Solarzellen mit einer (elektrisch leitfähigen) Metallschicht bedeckt ist. Demzufolge können die von der Induktionsantenne erzeugten magnetischen Wechselfelder auch in dieser Metallschicht Wirbelströme induzieren. Diese Wirbelströme führen insbesondere zu einer relativen starken Erhitzung der Metallschicht insbesondere in der Nähe der ersten Stromsammelschiene und tragen somit indirekt (über Wärmeleitung) zur Erhitzung der ersten Stromsammelschiene bzw. des Bandes bei. Weiterhin erzeugen die in der Metallschicht an der Rückseite der Solarzelle induzierten Wirbelströme magnetische Wechselfelder, welche die von der Induktionsantenne erzeugten magnetischen Wechselfelder teilweise kompensieren. Auf diese Weise ist der Beitrag der induzierten sekundären elektrischen Ströme zur Erhitzung der Solarzelle im Vergleich zum entsprechenden Beitrag der induzierten Wirbelströme im Falle von Standard-Solarzellen reduziert (verglichen mit bifacialen Solarzellen). Im Falle von bifacialen Solarzellen ist hingegen eine flächendeckende Metallschicht auf der Rückseite der Solarzelle (und dementsprechend der bei Standard-Solarzellen vorhandene Einfluss der in einer solchen Metallschicht induzierten elektrischen Wirbelströme) nicht vorhanden.

Im Falle der erfindungsgemässen Lötvorrichtung sind die vorstehend genannten induzierten sekundären elektrischen Ströme (je nach Ausbildung des Strompfads der Induktionsantenne mehr oder weniger) räumlich jeweils gleichmässiger über die Solarzelle verteilt, sodass die erwähnten nachteiligen Effekte dieser sekundären elektrischen Ströme (mehr oder weniger) reduziert oder vermieden werden können.

Im Falle der erfindungsgemässen Lötvorrichtung erstreckt sich der Strompfad der Induktionsantenne entlang mehrerer in einer Reihe hintereinander angeordneter Abschnitte der Lötlinie derart, dass das magnetische Wechselfeld in mindestens einem der Abschnitte der Lötlinie in Gegenphase zu dem magnetischen Wechselfeld in mindestens einem anderen der Abschnitte der Lötlinie ist. Dadurch wird insbesondere erreicht, dass die Wechselfelder, welche in verschiedenen Abschnitten der Lötlinie präsent und jeweils in Gegenphase zueinander sind, jeweils mehrere verschiedene sekundäre elektrische Ströme induzieren, welche in Gegenphase zueinander in verschiedenen Strompfaden fliessen, wobei die jeweiligen Strompfade jeweils in verschiedenen, entlang der Lötlinie hintereinander angeordneten Bereichen der Solarzelle räumlich getrennt voneinander ausgebildet sind. Jeder dieser Strompfade erstreckt sich dementsprechend zwischen der ersten Stromsammelschiene und der zweiten Stromsammelschiene jeweils in einem Abschnitt der Solarzelle, dessen Erstreckung entlang der ersten Stromsammelschiene nur einen Bruchteil der gesamten Länge der Stromsammelschiene beträgt. Daraus resultieren mehrere Vorteile.

Als ein erster Vorteil wird beispielsweise erreicht, dass die Heizleistung, welche die verschiedenen induzierten sekundären Ströme entlang der jeweiligen Strompfade erzeugen, räumlich gleichmässiger über die Solarzelle verteilt wird (verglichen mit dem erwähnten Stand der Technik, bei welchem das magnetische Wechselfeld entlang der Lötlinie im gesamten Bereich der Lötlinie, in welchem das Wechselfeld präsent ist, jeweils dieselbe Phase hat). Zusätzlich wird erreicht, dass die Stromstärke jedes einzelnen der verschiedenen induzierten sekundären elektrischen Ströme (bei vorgegebener Feldstärke des magnetischen Wechselfelds) reduziert ist (verglichen mit der Stromstärke eines induzierten sekundären Stroms, welcher gemäss dem Stand der Technik durch ein magnetisches Wechselfeld induzierbar ist, das entlang der Lötlinie im gesamten Bereich der Lötlinie, in welchem das Wechselfeld präsent ist, jeweils dieselbe Phase hat). Letzteres hat - als ein weiterer Vorteil - den Effekt, dass die Heizleistung jedes einzelnen induzierten sekundären elektrischen Wechselstroms (bei vorgegebener Feldstärke des magnetischen Wechselfelds) reduziert ist. Folglich ist auch die Gefahr einer lokalen Überhitzung der Solarzelle bzw. des an der ersten Stromsammelschiene zu befestigenden Bandes durch induzierte sekundäre Ströme reduziert (zumal gemäss der vorstehend genannten Vorteile die verschiedenen induzierten sekundären elektrischen Ströme aufgrund ihrer räumlichen Verteilung einerseits zu einer räumlich gleichmässigeren Erhitzung der Solarzelle führen und jeder einzelne sekundäre elektrische Wechselstrom eine reduzierte Heizleistung erzeugt).

Ein entlang des Strompfads der Induktionsantenne geführter elektrischer Wechselstrom erzeugt an einem bestimmten Punkt des Raumes ein magnetisches Wechselfeld, dessen Feldstärke bekanntlich u.a. von der Anordnung des Punktes relativ zum Strompfad der Induktionsantenne abhängig ist. Die Feldstärke an dem jeweiligen Punkt des Raumes ist dabei bestimmbar als Superposition verschiedener Beiträge zu dieser Feldstärke, wobei diese Beiträge jeweils einzelnen Abschnitten des Strompfads der Induktionsantenne zuzuordnen sind und jeweils von dem elektrischen Wechselstrom erzeugt werden, welcher durch den jeweiligen Abschnitt des Strompfads fliesst. Dabei hängt der dem jeweiligen Abschnitt des Strompfads zuzuordnende Beitrag zur magnetischen Feldstärke des an einem bestimmten Punkt des Raumes wirkenden magnetischen Wechselfeldes (entsprechend dem Biot-Savart-Gesetz) von mehreren Parametern ab: hinsichtlich des Betrags der magnetischen Feldstärke von der Stromstärke des elektrischen Wechselstroms und vom Abstand des Punktes von dem jeweiligen Abschnitt des Strompfads, wobei der Betrag des Beitrags zur Feldstärke als Funktion der Stromstärke mit wachsender Stromstärke grösser wird und umso kleiner ist, je weiter der Punkt von dem Abschnitt des Strompfads entfernt ist; hinsichtlich der Phase des Beitrags von der Stromflussrichtung des elektrischen Wechselstroms in dem jeweiligen Abschnitt des Strompfads, wobei eine Umkehrung der Stromflussrichtung zu einer Änderung der Phase (Phasenverschiebung) des Beitrags zur Feldstärke um 180° führt.

Um zu erreichen, dass das magnetische Wechselfeld erfindungsgemäss in mindestens einem der Abschnitte der Lötlinie in Gegenphase zu dem magnetischen Wechselfeld in mindestens einem anderen der Abschnitte der Lötlinie ist, kann ein Fachmann den Strompfad der Induktionsantenne folglich derart auslegen, dass jeweils einer oder mehrere Abschnitte des Strompfads in einem geeigneten Abstand von dem mindestens einen Abschnitt der Lötlinie bzw. von dem mindestens einen anderen Abschnitt der Lötlinie angeordnet sind und die momentane Stromflussrichtung des elektrischen Wechselstroms in den jeweiligen Abschnitten des Strompfads jeweils geeignet relativ zu dem mindestens einen Abschnitts der Lötlinie bzw. relativ zu dem mindestens einen anderen Abschnitt der Lötlinie gerichtet ist. Für einen Fachmann ist offensichtlich, dass die Anzahl der Möglichkeiten, eine Mehrzahl von Abschnitten eines Strompfads im Sinne der Erfindung "geeignet" relativ zu den jeweiligen Abschnitten der Lötlinie anzuordnen, unbegrenzt (beliebig gross) ist. Deshalb sollen im Folgenden lediglich einige Beispiele für mögliche Realisierungen einer erfindungsgemässen Lötvorrichtung erläutert werden. Diese Realisierungen unterscheiden sich in der Regel durch unterschiedliche geometrischen Anordnungen von Abschnitten des jeweiligen Strompfads der Induktionsantenne relativ zur Lötlinie.

Eine Ausführungsform der erfindungsgemässen Lötvorrichtung ist derart ausgebildet, dass der Strompfad der Induktionsantenne zumindest einen ersten Abschnitt und einen zweiten Abschnitt aufweist, wobei sich der erste Abschnitt des Strompfads in einer Lötebene, in welcher die Lötlinie liegt, entlang des mindestens einen der Abschnitte der Lötlinie - von diesem mindestens einen der Abschnitte der Lötlinie durch einen Luftspalt getrennt - erstreckt und sich der zweite Abschnitt des Strompfads in der Lötebene entlang des mindestens einen anderen der Abschnitte der Lötlinie - von diesem mindestens einen anderen der Abschnitte der Lötlinie durch einen Luftspalt getrennt - erstreckt. Weiterhin ist ein Ende des ersten Abschnitts des Strompfads mit einem Ende des zweiten Abschnitts des Strompfads derart verbunden, dass der erste und der zweite Abschnitt des Strompfads elektrisch in Reihe geschaltet sind und der elektrische Wechselstrom im ersten Abschnitt des Strompfads in Gegenphase zum elektrischen Wechselstrom im zweiten Abschnitt des Strompfads ist.

Als "Lötebene" soll in diesem Zusammenhang eine Ebene bezeichnet werden, welche im Wesentlichen senkrecht zu einer Ebene, in welcher die Solarzelle liegt, ausgerichtet ist und ausserdem entlang der Lötlinie verläuft. Dementsprechend ist die Lötebene parallel zur Lötlinie ausgerichtet und die Lötlinie liegt in der Lötebene.

Dadurch, dass sich der erste Abschnitt des Strompfads in der Lötebene entlang des mindestens einen der Abschnitte der Lötlinie - von diesem mindestens einen der Abschnitte der Lötlinie durch einen Luftspalt getrennt - erstreckt, ist eine Voraussetzung dafür geschaffen, dass das magnetische Wechselfeld, welches in dem mindestens einen der Abschnitte der Lötlinie präsent ist, im Wesentlichen dem magnetischen Wechselfeld entspricht, welches der durch den ersten Abschnitt des Strompfads fliessende Wechselstrom in dem mindestens einen Abschnitt der Lötlinie erzeugt. Entsprechend ist dadurch, dass sich der zweite Abschnitt des Strompfads in der Lötebene entlang des mindestens einen anderen der Abschnitte der Lötlinie - von diesem mindestens einen anderen der Abschnitte der Lötlinie durch einen Luftspalt getrennt - erstreckt, eine Voraussetzung dafür geschaffen, dass das magnetische Wechselfeld, welches in dem mindestens einen anderen der Abschnitte der Lötlinie präsent ist, im Wesentlichen dem magnetischen Wechselfeld entspricht, welches der durch den zweiten Abschnitt des Strompfads fliessende Wechselstrom in dem mindestens einen anderen der Abschnitte der Lötlinie erzeugt.

Die Breite des Luftspalts zwischen dem ersten Abschnitt des Strompfads und dem mindestens einen der Abschnitte der Lötlinie kann dabei derart klein sein, dass der durch den zweiten Abschnitt des Strompfads fliessende Wechselstrom in dem mindestens einen der Abschnitte der Lötlinie eine magnetische Feldstärke erzeugt, welche kleiner oder vernachlässigbar ist im Vergleich zu der magnetischen Feldstärke, welche der durch den ersten Abschnitt des Strompfads fliessende Wechselstrom in dem mindestens einen der Abschnitte der Lötlinie erzeugt. Entsprechend kann die Breite des Luftspalts zwischen dem zweiten Abschnitt des Strompfads und dem mindestens einen anderen der Abschnitte der Lötlinie derart klein sein, dass der durch den ersten Abschnitt des Strompfads fliessende Wechselstrom in dem mindestens einen anderen der Abschnitte der Lötlinie eine magnetische Feldstärke erzeugt, welche kleiner oder vernachlässigbar ist im Vergleich zu der magnetischen Feldstärke, welche der durch den zweiten Abschnitt des Strompfads fliessende Wechselstrom in dem mindestens einen anderen der Abschnitte der Lötlinie erzeugt.

Weiterhin ist dadurch, dass der erste und der zweite Abschnitt des Strompfads elektrisch in Reihe geschaltet sind und der elektrische Wechselstrom im ersten Abschnitt des Strompfads in Gegenphase zum elektrischen Wechselstrom im zweiten Abschnitt des Strompfads ist, jeweils gewährleistet, dass das magnetische Wechselfeld in dem mindestens einen der Abschnitte der Lötlinie jeweils in Gegenphase zum magnetischen Wechselfeld in dem mindestens einen anderen der Abschnitte der Lötlinie ist.

Die Induktionsantenne dieser Ausführungsform ist insbesondere geeignet zur Erzeugung magnetischer Wechselfelder, welche in den jeweiligen Abschnitten der Lötlinie jeweils im Wesentlichen vertikal zur Lötebene bzw. parallel zur Oberfläche der Solarzelle ausgerichtet sind. Diese Ausführungsform ist mit relativ einfachen Mitteln realisierbar, zumal zur Erzeugung des in einem der Abschnitte der Lötlinie präsenten magnetischen Wechselfeldes lediglich ein einziger Abschnitt des Strompfads vorgesehen ist. Im Rahmen dieses Konzepts ist es auch auf einfache Weise möglich, in drei oder mehr als drei hintereinander angeordneten Abschnitten der Lötlinie jeweils ein magnetisches Wechselfeld derart zu erzeugen, dass die magnetischen Wechselfelder in jeweils zwei unmittelbar hintereinander angeordneten Abschnitten der Lötlinie in Gegenphase zueinander sind. Zu diesem Zweck kann jeweils entlang des jeweiligen Abschnitts der Lötlinie ein Abschnitt des Strompfads angeordnet sein, wobei die Abschnitte des Strompfads entlang der Lötlinie hintereinander angeordnet sind und elektrisch derart in Reihe geschaltet sind, dass der Wechselstrom in zwei unmittelbar hintereinander angeordneten Abschnitten des Strompfads jeweils in Gegenphase ist.

Der Strompfad dieser Ausführungsform der erfindungsgemässen Lötvorrichtung kann mittels verschiedener Technologien realisiert werden. Prinzipiell ist es möglich, den Strompfad - wie einen Strompfad gemäss dem beispielsweise aus EP 2 103 373 A1 bekannten Stand der Technik - aus einem konventionellen Rohr auszubilden, wobei dieses Rohr mit konventionellen Biegetechniken in eine Form gebracht werden kann, welche für eine Ausführung der Erfindung geeignet ist. Alternativ kann der Strompfad auch aus einem oder mehreren elektrisch leitfähigen Festkörpern gebildet sein, wobei verschiedene Abschnitte des Strompfads durch eine Bearbeitung des jeweiligen Festkörpers, z.B. eine spanabhebende Bearbeitung, realisierbar sind.

In einer Weiterentwicklung der vorstehend genannten Ausführungsform erstrecken sich der erste Abschnitt des Strompfads und der zweite Abschnitt des Strompfads jeweils geradlinig und im Wesentlichen parallel zur Lötlinie. In diesem Fall ist das magnetische Wechselfeld, welches der Wechselstrom in der Umgebung des ersten Abschnitts des Strompfads erzeugt, entlang des mindestens einen der Abschnitte der Lötlinie im Wesentlichen homogen. Damit ist gewährleistet, dass das Band bzw. die erste Stromsammelschiene entlang dieses mindestens einen der Abschnitte der Lötlinie im Wesentlichen gleichmässig durch die elektromagnetisch induzierten Ströme erwärmt werden kann. Weiterhin ist das magnetische Wechselfeld, welches der Wechselstrom in der Umgebung des zweiten Abschnitts des Strompfads erzeugt, entlang des mindestens einen anderen der Abschnitte der Lötlinie ebenfalls im Wesentlichen homogen. Somit ist gewährleistet, dass das Band bzw. die erste Stromsammelschiene entlang dieses mindestens einen anderen der Abschnitte der Lötlinie ebenfalls im Wesentlichen gleichmässig durch die elektromagnetisch induzierten Ströme erwärmt werden kann.

Zusätzlich können der erste Abschnitt des Strompfads und der zweite Abschnitt des Strompfads hintereinander auf einer sich in der Lötebene erstreckenden Geraden liegen. In diesem Fall ist das in dem mindestens einen der Abschnitte der Lötlinie erzeugte Wechselfeld in Gegenphase zu dem in dem mindestens einen anderen der Abschnitte der Lötlinie erzeugte magnetische Wechselfeld. Zusätzlich wird erreicht, dass diese Wechselfelder in dem mindestens einen der Abschnitte der Lötlinie und in dem mindestens einen anderen der Abschnitte der Lötlinie im Wesentlichen dieselbe Feldstärke aufweisen. Somit ist zusätzlich gewährleistet, dass die Wechselfelder in dem Band bzw. in der ersten Stromsammelschiene im Bereich des mindestens einen der Abschnitte der Lötlinie in etwa dieselbe Heizleistung erzeugen wie im Bereich des mindestens einen anderen der Abschnitte der Lötlinie.

Weiterentwicklungen der genannten Ausführungsformen der erfindungsgemässen Lötvorrichtung können jeweils derart ausgebildet sein, dass sich die Niederhalterelemente jeweils in der Lötebene im Wesentlichen senkrecht zur Lötlinie erstrecken und mindestens drei dieser Niederhalterelemente entlang der Lötlinie in einer Reihe hintereinander derart angeordnet sind, dass zwischen jeweils zwei der Niederhalterelemente, welche in der Reihe unmittelbar hintereinander angeordnet sind, jeweils ein Zwischenraum ausgebildet ist. In diesem Fall können der erste Abschnitt des Strompfads in einem der Zwischenräume zwischen jeweils zwei der Niederhalterelemente und der zweite Abschnitt des Strompfads in einem anderen der Zwischenräume zwischen jeweils zwei der Niederhalterelemente angeordnet ist. Diese Weiterbildungen gewährleisten vorteilhafterweise eine kompakte Anordnung der Niederhalterelemente in Kombination mit den jeweiligen Abschnitten des Strompfads der Induktionsantenne.

Die jeweiligen Niederhalterelemente können beispielsweise als Stifte, deren Längsachsen jeweils in der Lötebene und vertikal zur Lötlinie ausgerichtet sind, ausgebildet sein und jeweils derart angeordnet sein, dass sie in Richtung ihrer Längsachsen bewegbar sind (wie aus dem Stand der Technik, beispielsweise aus EP 2 103 373 A1, bekannt). Diese Niederhalterelemente sind vorzugsweise aus einem Keramikwerkstoff gebildete zylindrische Stifte, welche nicht elektrisch leitfähig und insbesondere auch nicht magnetisierbar sind. Die Niederhalterelemente können typischerweise in einem Abstand von 8 bis 25 mm angeordnet sein und einen Durchmesser von ca. 3 mm aufweisen. Unter dieser Bedingung sind diese Niederhalterelemente gut geeignet, übliche Bänder (welche typischerweise eine Breite von 1 bis 3 mm aufweisen) auf üblichen Stromsammelschienen (welche typischerweise eine Breite von ebenfalls 1 bis 3 mm aufweisen) von Solarzellen zu halten.

Der erste Abschnitt des Strompfads und der zweite Abschnitt des Strompfads können beispielsweise geradlinig ausgebildet sein und sich in dem jeweiligen Zwischenraum zwischen jeweils zwei der Niederhalterelemente im Wesentlichen parallel zur Lötlinie erstrecken. Der erste Abschnitt des Strompfads und der zweite Strompfad können dabei vorzugsweise derart ausgebildet sein, dass sie sich im dem jeweiligen Zwischenraum jeweils geradlinig über die gesamte freie Distanz zwischen jeweils zwei Niederhalterelementen erstrecken. Auf dieser Grundlage können in den Zwischenräumen zwischen den jeweiligen Niederhalterelementen jeweils magnetische Wechselfelder erzeugt werden, welche in den jeweiligen Zwischenräumen jeweils im Wesentlichen über die gesamte freie Distanz zwischen jeweils zwei Niederhalterelementen homogen ausgebildet sind. In diesem Fall kann der Strompfad vorzugsweise in einem elektrisch leitfähigen Festkörper ausgebildet sein, wobei verschiedene Abschnitte des Strompfads durch eine Bearbeitung des Festkörpers, z.B. eine spanabhebende Bearbeitung, realisiert sind. Mittels einer derartigen Bearbeitung eines elektrisch leitfähigen Festkörpers ist es möglich, einen Abschnitt eines Strompfads zu realisieren, welcher sich geradlinig über die gesamte freie Distanz zwischen jeweils zwei Niederhalterelementen erstreckt, selbst wenn diese freie Distanz lediglich 8 bis 25 mm beträgt.

Eine andere Ausführungsform der erfindungsgemässen Lötvorrichtung ist derart ausgebildet, dass der Strompfad der Induktionsantenne mindestens vier verschiedene Abschnitte zur Führung des elektrischen Wechselstroms entlang der Lötlinie aufweist: einen ersten Abschnitt, welcher sich auf einer ersten Seite einer Lötebene, in welcher die Lötlinie liegt, in einem Abstand zur Lötebene entlang des mindestens einen der Abschnitte der Lötlinie - von diesem mindestens einen der Abschnitte der Lötlinie durch einen Luftspalt getrennt - erstreckt; einen zweiten Abschnitt, welcher sich auf einer zweiten, der ersten Seite der Lötebene gegenüberliegenden Seite der Lötebene in einem Abstand zur Lötebene entlang des mindestens einen anderen der Abschnitte der Lötlinie - von diesem mindestens einen anderen der Abschnitte der Lötlinie durch einen Luftspalt getrennt - erstreckt; einen dritten Abschnitt, welcher sich auf der ersten Seite der Lötebene in einem Abstand zur Lötebene entlang des mindestens einen anderen der Abschnitte der Lötlinie - von diesem mindestens einen anderen der Abschnitte der Lötlinie durch einen Luftspalt getrennt - erstreckt; einen vierten Abschnitt, welcher sich auf der zweiten Seite der Lötebene in einem Abstand zur Lötebene entlang des mindestens einen der Abschnitte der Lötlinie - von diesem mindestens einen der Abschnitte der Lötlinie durch einen Luftspalt getrennt - erstreckt. Dabei sind der erste Abschnitt des Strompfads, der zweite Abschnitt des Strompfads, der dritte Abschnitt des Strompfads und der vierte Abschnitt des Strompfads elektrisch in einer Reihe hintereinandergeschaltet, sodass der elektrische Wechselstrom im ersten Abschnitt des Strompfads mit dem elektrischen Wechselstrom im zweiten Abschnitt des Strompfads in Gleichphase und mit dem elektrischen Wechselstrom im dritten Abschnitt des Strompfads und mit dem elektrischen Wechselstrom im vierten Abschnitt des Strompfads in Gegenphase ist.

Als "Lötebene" soll in diesem Zusammenhang eine Ebene bezeichnet werden, welche im Wesentlichen senkrecht zu einer Ebene, in welcher die Solarzelle liegt, ausgerichtet ist und ausserdem entlang der Lötlinie verläuft. Dementsprechend ist die Lötebene parallel zur Lötlinie ausgerichtet und die Lötlinie liegt in der Lötebene.

Im Falle dieser Ausführungsform der erfindungsgemässen Lötvorrichtung sind der erste Abschnitt des Strompfad und der vierte Abschnitt des Strompfads relativ zur Lötlinie derart angeordnet, dass die Feldstärke des magnetischen Wechselfelds, welches von dem elektrischen Wechselstrom in dem mindestens einen Abschnitt der Lötlinie erzeugt wird, im Wesentlichen eine Superposition zweier Beiträge ist, d.h. die Superposition der Feldstärke, welche der durch den ersten Abschnitt des Strompfads fliessende Wechselstrom in dem mindestens einen Abschnitt der Lötlinie erzeugt, und der Feldstärke, welche der durch den vierten Abschnitt des Strompfads fliessende Wechselstrom in dem mindestens einen Abschnitt der Lötlinie erzeugt.

Entsprechend sind der zweite Abschnitt des Strompfad und der dritte Abschnitt des Strompfads relativ zur Lötlinie derart angeordnet, dass die Feldstärke des magnetischen Wechselfelds, welches von dem elektrischen Wechselstrom in dem mindestens einen anderen Abschnitt der Lötlinie erzeugt wird, im Wesentlichen eine Superposition zweier Beiträge ist, d.h. die Superposition der Feldstärke, welche der durch den zweiten Abschnitt des Strompfads fliessende Wechselstrom in dem mindestens einen anderen Abschnitt der Lötlinie erzeugt, und der Feldstärke, welche der durch den dritten Abschnitt des Strompfads fliessende Wechselstrom in dem mindestens einen anderen Abschnitt der Lötlinie erzeugt.

Die Breite des Luftspalts zwischen dem ersten Abschnitt des Strompfads und dem mindestens einen der Abschnitte der Lötlinie bzw. die Breite des Luftspalts zwischen dem vierten Abschnitt des Strompfads und dem mindestens einen der Abschnitte der Lötlinie kann dabei derart klein sein, dass der durch den zweiten Abschnitt des Strompfads fliessende Wechselstrom und der durch den dritten Abschnitt des Strompfads fliessende Wechselstrom in dem mindestens einen der Abschnitte der Lötlinie jeweils eine magnetische Feldstärke erzeugt, welche kleiner oder vernachlässigbar ist im Vergleich zu der magnetischen Feldstärke, welche der durch den ersten Abschnitt des Strompfads fliessende Wechselstrom und der durch den vierten Abschnitt des Strompfads fliessende Wechselstrom im mindestens einen der Abschnitte der Lötlinie erzeugt.

Entsprechend kann die Breite des Luftspalts zwischen dem zweiten Abschnitt des Strompfads und dem mindestens einen anderen der Abschnitte der Lötlinie bzw. die Breite des Luftspalts zwischen dem dritten Abschnitt des Strompfads und dem mindestens einen anderen der Abschnitte der Lötlinie derart klein sein, dass der durch den ersten Abschnitt des Strompfads fliessende Wechselstrom und der durch den vierten Abschnitt des Strompfads fliessende Wechselstrom in dem mindestens einen anderen der Abschnitte der Lötlinie jeweils eine magnetische Feldstärke erzeugt, welche kleiner oder vernachlässigbar ist im Vergleich zu der magnetischen Feldstärke, welche der durch den zweiten Abschnitt des Strompfads fliessende Wechselstrom und der durch den dritten Abschnitt des Strompfads fliessende Wechselstrom in dem mindestens einen anderen der Abschnitte der Lötlinie erzeugt.

Dadurch, dass der erste Abschnitt des Strompfads und der vierte Abschnitt des Strompfads auf verschiedenen Seiten der Lötebene angeordnet sind und der elektrische Wechselstrom im ersten Abschnitt des Strompfads in Gegenphase zum elektrischen Wechselstrom im vierten Abschnitt des Strompfads ist, wird erreicht, dass das magnetische Wechselfeld in dem mindestens einen Abschnitt der Lötlinie jeweils in der Lötlinie im Wesentlichen parallel zur Lötebene und senkrecht zur Lötlinie gerichtet ist. Weiterhin wird erreicht, dass die Feldstärke dieses magnetischen Wechselfelds in einer Richtung senkrecht zur Lötebene mit wachsendem Abstand von der Lötebene relativ stark abnimmt. Dementsprechend ist das erzeugte Wechselfeld im Bereich des mindestens einen Abschnitts der Lötlinie lokal stark auf das Band bzw. die erste Stromsammelschiene konzentriert und ermöglicht eine intensive induktive Aufheizung des Bandes bzw. der erstem Stromsammelschiene im Bereich des mindestens einen Abschnitts der Lötlinie (mittels Wirbelströmen, welche lokal im Band bzw. in der ersten Stromsammelschiene erzeugt werden).

Dadurch, dass der zweite Abschnitt des Strompfads und der dritte Abschnitt des Strompfads auf verschiedenen Seiten der Lötebene angeordnet sind und der elektrische Wechselstrom im zweiten Abschnitt des Strompfads in Gegenphase zum elektrischen Wechselstrom im dritten Abschnitt des Strompfads ist, wird erreicht, dass das magnetische Wechselfeld in dem mindestens einen anderen Abschnitt der Lötlinie jeweils in der Lötlinie im Wesentlichen parallel zur Lötebene und senkrecht zur Lötlinie gerichtet ist. Weiterhin wird erreicht, dass die Feldstärke dieses magnetischen Wechselfelds in einer Richtung senkrecht zur Lötebene mit wachsendem Abstand von der Lötebene relativ stark abnimmt. Dementsprechend ist das erzeugte Wechselfeld im Bereich des mindestens einen anderen Abschnitts der Lötlinie lokal stark auf das Band bzw. die erste Stromsammelschiene konzentriert und ermöglicht eine intensive induktive Aufheizung des Bandes bzw. der erstem Stromsammelschiene im Bereich des mindestens einen anderen Abschnitts der Lötlinie (mittels Wirbelströmen, welche lokal im Band bzw. in der ersten Stromsammelschiene erzeugt werden).

Dadurch, dass der elektrische Wechselstrom im ersten Abschnitt des Strompfads mit dem elektrischen Wechselstrom im zweiten Abschnitt des Strompfads in Gleichphase und mit dem elektrischen Wechselstrom im dritten Abschnitt des Strompfads und mit dem elektrischen Wechselstrom im vierten Abschnitt des Strompfads in Gegenphase ist, wird zusätzlich erreicht, dass das magnetische Wechselfeld in dem mindestens einen Abschnitt der Lötlinie in Gegenphase zum magnetischen Wechselfeld in dem mindestens einen anderen Abschnitt der Lötlinie ist.

Im Rahmen dieses Konzepts ist es auch möglich, in drei oder mehr als drei hintereinander angeordneten Abschnitten der Lötlinie jeweils ein magnetisches Wechselfeld derart zu erzeugen, dass die Wechselfelder in jeweils zwei unmittelbar hintereinander angeordneten Abschnitten der Lötlinie in Gegenphase zueinander sind. Zu diesem Zweck können jeweils entlang des jeweiligen Abschnitts der Lötlinie zwei verschiedene Abschnitte des Strompfads auf verschiedenen Seiten der Lötebene angeordnet sein, wobei die Abschnitte des Strompfads entlang der Lötlinie jeweils paarweise hintereinander angeordnet sind und elektrisch derart in Reihe geschaltet sind, dass der Wechselstrom in einem von jeweils zwei Abschnitten, welche in zwei unmittelbar hintereinander angeordneten Abschnitten des Strompfads auf derselben Seite der Lötebene angeordnet sind, jeweils in Gegenphase zum Wechselstrom in dem anderen dieser zwei Abschnitte des Strompfads ist.

Der Strompfad dieser Ausführungsform der erfindungsgemässen Lötvorrichtung kann mittels verschiedener Technologien realisiert werden. Prinzipiell ist es möglich, den Strompfad - wie einen Strompfad gemäss dem beispielsweise aus EP 2 103 373 A1 bekannten Stand der Technik - aus einem konventionellen Rohr auszubilden, wobei dieses Rohr mit konventionellen Biegetechniken in eine geeignete Form gebracht werden kann. Alternativ kann der Strompfad auch aus einem oder mehreren elektrisch leitfähigen Festkörper gebildet sein, wobei verschiedene Abschnitte des Strompfads durch eine Bearbeitung des jeweiligen Festkörpers, z.B. eine spanabhebende Bearbeitung, realisierbar sind.

Eine Weiterentwicklung der vorstehend genannten Ausführungsform ist dadurch charakterisiert, dass sich der erste Abschnitt des Strompfads und/oder der zweite Abschnitt des Strompfads und/oder der dritte Abschnitt des Strompfads und/oder der vierte Abschnitt des Strompfads und/oder jeweils geradlinig im Wesentlichen parallel zur Lötlinie erstrecken. Diese Weiterentwicklung führt zu einer verbesserten Homogenität des magnetischen Wechselfelds in dem mindestens einen Abschnitt der Lötlinie und zu einer verbesserten Homogenität des magnetischen Wechselfelds in dem mindestens einen anderen Abschnitt der Lötlinie.

Weiterhin können im Falle der vorstehend genannten Ausführungsform der erste Abschnitt des Strompfads und der vierte Abschnitt des Strompfads relativ zueinander spiegelsymmetrisch bezüglich der Lötebene ausgebildet sein. Alternativ oder zusätzlich können der zweite Abschnitt des Strompfads und der dritte Abschnitt des Strompfads relativ zueinander spiegelsymmetrisch bezüglich der Lötebene ausgebildet sein.

Dies führt zu einer verbesserten Homogenität des magnetischen Wechselfelds in dem mindestens einen Abschnitt der Lötlinie und/oder zu einer verbesserten Homogenität des magnetischen Wechselfelds in dem mindestens einen anderen Abschnitt der Lötlinie. Weiterhin ermöglicht die spiegelsymmetrische Anordnung der jeweiligen Abschnitt des Strompfads eine Ausrichtung des magnetischen Wechselfelds parallel zur Lötebene (in den jeweiligen Abschnitten der Lötlinie) und eine verbesserte Konzentration des Wechselfelds auf das Band bzw. die erste Stromsammelschiene.

Die vorstehend genannte Ausführungsform kann ausserdem derart ausgebildet sein, dass sich der erste Abschnitt und der dritte Abschnitt des Strompfads entlang einer ersten Geraden und sich der zweite Abschnitt und der vierte Abschnitt des Strompfads entlang einer zweiten Geraden erstrecken. Dies führt zu einer verbesserten Homogenität des magnetischen Wechselfelds entlang der Lötlinie über mehrere Abschnitte der Lötlinie.

Im Fall der vorstehend genannte Ausführungsform kann der Strompfad beispielsweise derart konstruiert sein, dass der erste Abschnitt und der zweite Abschnitt des Strompfads als hintereinander angeordnete Längsabschnitte eines ersten Leiterabschnitts ausgebildet sind und der dritte Abschnitt und vierte Abschnitt des Strompfads als hintereinander angeordnete Längsabschnitte eines zweiten Leiterabschnitts ausgebildet sind, wobei der erste und der zweite Leiterabschnitt miteinander verdrillt sind. Ein derart konstruierter Strompfad hat den Vorteil, dass er - wie einen Strompfad gemäss dem beispielsweise aus EP 2 103 373 A1 bekannten Stand der Technik - aus einem konventionellen Rohr gebildet werden kann. Das Rohr kann durch Biegen und/oder Verdrillen von Abschnitten des Rohrs geeignet geformt werden, sodass der Strompfad dieser Ausführungsform mit einfachen Mitteln realisierbar ist.

Im Falle der vorstehend genannten Ausführungsform können die Niederhalterelemente derart realisiert sein, dass sich die Niederhalterelemente jeweils in der Lötebene im Wesentlichen senkrecht zur Lötlinie erstrecken und mindestens drei dieser Niederhalterelemente entlang der Lötlinie in einer Reihe hintereinander derart angeordnet sind, dass zwischen jeweils zwei der Niederhalterelemente, welche in der Reihe unmittelbar hintereinander angeordnet sind, jeweils ein Zwischenraum ausgebildet ist. In diesem Fall kann der Strompfad beispielsweise derart ausgebildet sein, dass der erste Abschnitt und der vierte Abschnitt des Strompfads in einem der Zwischenräume zwischen jeweils zwei der Niederhalterelemente und der zweite Abschnitt und der dritte Abschnitt des Strompfads in einem anderen der Zwischenräume zwischen jeweils zwei der Niederhalterelemente angeordnet sind. Diese Ausführungsform gewährleistet vorteilhafterweise eine kompakte Anordnung der Niederhalterelemente in Kombination mit den jeweiligen Abschnitten des Strompfads der Induktionsantenne. Die jeweiligen Niederhalterelemente können auch in diesem Fall beispielsweise als Stifte, deren Längsachsen jeweils in der Lötebene und vertikal zur Lötlinie ausgerichtet sind, ausgebildet sein und jeweils derart angeordnet sein, dass sie in Richtung ihrer Längsachsen bewegbar sind. Dadurch, dass die jeweiligen Abschnitte des Strompfads jeweils in einem der Zwischenräume zwischen jeweils zwei der Niederhalterelemente angeordnet ist, wird eine besonders starke Konzentration des magnetischen Wechselfelds auf das Band bzw. die erste Stromsammelschiene ermöglicht. Dies ermöglicht eine besonders intensive induktive Erhitzung des Bandes bzw. der Stromsammelschiene (mittels Wirbelströmen, welche lokal im Band bzw. in der ersten Stromsammelschiene erzeugt werden).

In einer alternativen Variante der vorstehend genannte Ausführungsform ist der Strompfad der Induktionsantenne derart konstruiert, dass zwischen dem ersten Abschnitt des Strompfads und dem vierten Abschnitt des Strompfads ein freier Raumbereich ausgebildet ist und sich mindestens eines der Niederhalterelemente durch diesen freien Raumbereich erstreckt und/oder zwischen dem zweiten Abschnitt des Strompfads und dem dritten Abschnitt des Strompfads ein freier Raumbereich ausgebildet ist und sich mindestens eines der Niederhalterelemente durch diesen freien Raumbereich erstreckt. Ein derart konstruierter Strompfad hat den Vorteil, dass er - wie einen Strompfad gemäss dem beispielsweise aus EP 2 103 373 A1 bekannten Stand der Technik - aus einem konventionellen Rohr gebildet werden kann (durch Biegen und/oder Verdrillen von Abschnitten des Rohrs) und dementsprechend mit einfachen Mitteln realisierbar ist.

In einer weiteren Ausführungsform der erfindungsgemässen Lötvorrichtung ist die Induktionsantenne derart konzipiert, dass der Strompfad der Induktionsantenne ein schleifenförmiger Leiter ist, welcher zwei Schenkel aufweist, wobei ein Ende des einen Schenkels mit einem Ende des anderen Schenkels verbunden ist. Mindestens einer der zwei Schenkel erstreckt sich in einer Mäanderform entlang der Lötlinie und kreuzt eine Lötebene, in welcher die Lötlinie liegt, an mehreren separaten Orten, sodass dieser eine Schenkel mehrere in seiner Längsrichtung aufeinander folgende Längsabschnitte aufweist, welche sich - jeweils entlang einer Kurve, welche gekrümmt und/oder abschnittsweise gekrümmt und/oder abschnittsweise geradlinig ist - abwechselnd auf einer Seite der Lötebene und auf der anderen Seite der Lötebene erstrecken. Dieser Strompfad kann ebenfalls aus einem konventionellen Rohr gebildet werden (durch Biegen von Abschnitten des Rohrs) und ist dementsprechend mit einfachen Mitteln realisierbar.

In einer Weiterentwicklung der vorstehend genannten Ausführungsform sind die zwei Schenkel des schleifenförmigen Leiters derart ausgebildet, dass sich die zwei Schenkel in einer Ebene erstrecken, welche senkrecht zur Lötebene und/oder parallel zu einer Oberfläche der Solarzelle angeordnet ist, und sich der andere der zwei Schenkel parallel zu dem einen der zwei Schenkel erstreckt. In diesem Fall ist der elektrische Wechselstrom derart in den schleifenförmigen Leiter einkoppelbar, dass der elektrische Wechselstrom in dem einen der zwei Schenkel in Gegenphase zu dem elektrischen Wechselstrom in dem anderen der zwei Schenkel ist. Die Anordnung der zwei Schenkel bewirkt, dass das magnetische Wechselfeld insbesondere zwischen den beiden Schenkeln konzentriert ist und ermöglicht eine intensivere induktive Erhitzung des Bandes bzw. der ersten Stromsammelschiene (mittels Wirbelströmen, welche lokal im Band bzw. in der ersten Stromsammelschiene erzeugt werden).

Weitere Einzelheiten der Erfindung und insbesondere beispielhafte Ausführungsformen der erfindungsgemässen Lötvorrichtung werden im Folgenden anhand der beigefügten Zeichnungen erläutert. Es zeigen:
- Fig. 1: eine perspektivische Ansicht einer Lötvorrichtung in einer schematischen Darstellung beim Herstellen einer Lötverbindung zwischen einem elektrisch leitfähigen Band und einer geraden Stromsammelschiene an einer Seite einer Solarzelle, mit einer Induktionsantenne, welche in der Stromsammelschiene und einer Umgebung der Stromsammelschiene ein magnetisches Wechselfeld erzeugt, welches über die gesamte Länge der Stromsammelschiene in Gleichphase ist (entsprechend dem Stand der Technik);
- Fig. 2: eine perspektivische Ansicht einer Lötvorrichtung in einer schematischen Darstellung beim Herstellen einer Lötverbindung zwischen einem elektrisch leitfähigen Band und einer geraden Stromsammelschiene an einer Seite einer Solarzelle, mit einer Induktionsantenne, welche in der Stromsammelschiene und einer Umgebung der Stromsammelschiene ein magnetisches Wechselfeld erzeugt, wobei das magnetische Wechselfeld gemäss der Erfindung in einem ersten Abschnitt der Lötlinie in Gegenphase zum magnetischen Wechselfeld in einem zweiten Abschnitt der Lötlinie ist;
- Fig. 3: eine perspektivische Ansicht einer ersten Ausführungsform der erfindungsgemässen Lötvorrichtung, umfassend eine Induktionsantenne und eine Mehrzahl von Niederhalterelementen in Form von Stiften zum Niederhalten eines Bandes an einer Solarzelle;
- Fig. 4: eine perspektivische Ansicht der Lötvorrichtung gemäss Fig. 3 mit einer Darstellung der mittels der Induktionsantenne erzeugbaren magnetischen Wechselfelder für verschiedene Abschnitte einer Lötlinie, wobei die Induktionsantenne vergrössert und aus einer anderen Perspektive als in Fig. 3 dargestellt ist;
- Fig. 5: eine Explosionsdarstellung der Induktionsantenne gemäss Fig. 4, umfassend zwei elektrisch leitfähige Festkörper, in welchen jeweils Abschnitte des Strompfads der Induktionsantenne ausgebildet sind;
- Fig. 6: die elektrisch leitfähigen Festkörper gemäss Fig. 5 in einer vergrösserten perspektivischen Darstellung;
- Fig. 7-10: Seitenansichten der elektrisch leitfähigen Festkörper gemäss Fig. 5 bzw. 6;
- Fig. 11: die Induktionsantenne gemäss Fig. 4, aus einer anderen Perspektive;
- Fig. 12: eine Seitenansicht der Induktionsantenne gemäss Fig. 4;
- Fig. 13: vier Querschnitte der Induktionsantenne gemäss Fig. 4 für Schnittebenen A-A, B-B, C-C und D-D gemäss Fig. 12;
- Fig. 14: eine schematische Darstellung einer ersten Variante des Strompfads der Induktionsantenne gemäss Fig. 4;
- Fig. 15: eine schematische Darstellung einer zweiten Variante des Strompfads der Induktionsantenne gemäss Fig. 4;
- Fig. 16: die Induktionsantenne gemäss Fig. 3 in derselben perspektivischen Ansicht wie in Fig. 11, wobei zusätzlich die jeweilige (momentanen) Flussrichtungen eines elektrischen Wechselstroms in verschiedenen Abschnitten des Strompfads der Induktionsantenne und die (momentanen) Richtungen der durch den Wechselstrom in der Umgebung der jeweiligen Abschnitte des Strompfads erzeugten magnetischen Wechselfelder dargestellt sind;
- Fig. 17: einen Querschnitt der Induktionsantenne gemäss Fig. 4 für die Schnittebene B-B gemäss Fig. 12 mit einer Darstellung der Feldlinien eines magnetischen Wechselfeldes, welches von einem elektrischen Wechselstrom in einer Umgebung des Strompfads der Induktionsantenne erzeugbar ist;
- Fig. 18: eine perspektivische Ansicht einer zweiten Ausführungsform der erfindungsgemässen Lötvorrichtung, umfassend eine Induktionsantenne und eine Mehrzahl von Niederhalterelementen in Form von Stiften zum Niederhalten eines Bandes an einer Solarzelle, mit einer Darstellung der mittels der Induktionsantenne erzeugbaren magnetischen Wechselfelder für verschiedene Abschnitte einer Lötlinie;
- Fig. 19: eine perspektivische Ansicht der Induktionsantenne gemäss Fig. 18, wobei die Induktionsantenne aus einer anderen Perspektive als in Fig. 18 dargestellt ist;
- Fig. 20: die Induktionsantenne gemäss Fig. 18 in derselben perspektivischen Ansicht wie in Fig. 19, wobei zusätzlich die jeweilige (momentanen) Flussrichtungen eines elektrischen Wechselstroms in verschiedenen Abschnitten des Strompfads der Induktionsantenne und die (momentanen) Richtungen der durch den Wechselstrom in der Umgebung der jeweiligen Abschnitte des Strompfads erzeugten Wechselfelder dargestellt sind;
- Fig. 21: eine Explosionsdarstellung der Induktionsantenne gemäss Fig. 18, umfassend zwei elektrisch leitfähige Festkörper, in welchen jeweils verschiedene Abschnitte des Strompfads der Induktionsantenne ausgebildet sind;
- Fig. 22-25: die elektrisch leitfähigen Festkörper gemäss Fig. 21, jeweils in einer Seitenansicht;
- Fig. 26: eine schematische Darstellung des Strompfads der Induktionsantenne gemäss Fig. 18;
- Fig. 27: eine perspektivische Ansicht einer dritten Ausführungsform der erfindungsgemässen Lötvorrichtung, umfassend eine Induktionsantenne und eine Mehrzahl von Niederhalterelementen in Form von Stiften zum Niederhalten eines Bandes an einer Solarzelle, mit einer Darstellung der mittels der Induktionsantenne erzeugbaren magnetischen Wechselfelder für verschiedene Abschnitte einer Lötlinie;
- Fig. 28: eine perspektivische Ansicht der Induktionsantenne gemäss Fig. 27, wobei die Induktionsantenne aus einer anderen Perspektive als in Fig. 27 dargestellt ist;
- Fig. 29: eine Explosionsdarstellung der Induktionsantenne gemäss Fig. 27, umfassend drei nebeneinander angeordnete Gruppen von jeweils einem oder mehreren elektrisch leitfähigen Festkörpern, in welchen jeweils verschiedene Abschnitte des Strompfads der Induktionsantenne ausgebildet sind;
- Fig. 30: die elektrisch leitfähigen Festkörper gemäss Fig. 29 in vier verschiedenen Darstellungen (a)-(d), wobei die Darstellung (a) die drei Gruppen von elektrisch leitfähigen Festkörpern gemäss Fig. 29 aus einer anderen Perspektive als in Fig. 29 zeigt und die Darstellungen (b), (c) und (d) jede dieser drei Gruppen von elektrisch leitfähigen Festkörpern jeweils separat in einer perspektivischen Darstellung zeigen;
- Fig. 31-33: die drei Gruppen von elektrisch leitfähigen Festkörpern gemäss Fig. 29 jeweils separat in einer Seitenansicht;
- Fig. 34: eine schematische Darstellung des Strompfads der Induktionsantenne gemäss Fig. 27;
- Fig. 35: eine Draufsicht auf ein untere (der jeweiligen Lötlinie zugewandte) Seite der Induktionsantenne gemäss Fig. 27;
- Fig. 36: die Induktionsantenne gemäss Fig. 27 in einer Seitenansicht;
- Fig. 37: vier Querschnitte der Induktionsantenne gemäss Fig. 27 für Schnittebenen A-A, B-B, C-C und D-D gemäss Fig. 36;
- Fig. 38: ein unterer Teil der Induktionsantenne gemäss Fig. 27 in einer perspektivischen Ansicht, wobei dieser untere Teil an einer oberen Seite entlang einer Schnittebene XXXVIII-XXXVIII gemäss Fig. 36 geschnitten ist;
- Fig. 39: zwei Darstellungen (a) und (b) eines unteren Teils der Induktionsantenne gemäss Fig. 27 in einer perspektivischen Ansicht, wobei dieser untere Teil an einer oberen Seite entlang einer Schnittebene XXXIX-XXXIX gemäss Fig. 36 geschnitten ist, in der Darstellung (b) mit einer Angabe der (momentanen) Stromflussrichtungen eines elektrischen Wechselstroms in verschiedenen Abschnitten des Strompfads der Induktionsantenne und in der Darstellung (a) ohne Angabe dieser Stromflussrichtungen;
- Fig. 40: einen Querschnitt der Induktionsantenne gemäss Fig. 27 für die Schnittebene B-B gemäss Fig. 36 mit einer Darstellung der Feldlinien eines magnetischen Wechselfeldes, welches von einem elektrischen Wechselstrom in einer Umgebung des Strompfads der Induktionsantenne erzeugbar ist;
- Fig. 41: eine perspektivische Ansicht einer vierten Ausführungsform der erfindungsgemässen Lötvorrichtung, umfassend eine Induktionsantenne und eine Mehrzahl von Niederhalterelementen in Form von Federelementen zum Niederhalten eines Bandes an einer Solarzelle;
- Fig. 42: einen Endabschnitt der Lötvorrichtung gemäss Fig. 41;
- Fig. 43: die Lötvorrichtung gemäss Fig. 41 in einer Draufsicht auf eine untere (einer Lötlinie zugewandten Seite) der Lötvorrichtung;
- Fig. 44: die Lötvorrichtung gemäss Fig. 41 in einer Seitenansicht;
- Fig. 45A: die Lötvorrichtung gemäss Fig. 41 in einem Querschnitt entlang der Schnittebene A-A in Fig. 44 mit einer Darstellung eines mittels der Induktionsantenne erzeugbaren magnetischen Wechselfelds für einen ersten Abschnitt der Lötlinie;
- Fig. 45B: die Lötvorrichtung gemäss Fig. 41 in einem Querschnitt entlang der Linie B-B in Fig. 44 mit einer Darstellung eines mittels der Induktionsantenne erzeugbaren magnetischen Wechselfelds für einen zweiten Abschnitt der Lötlinie;
- Fig. 46: eine perspektivische Ansicht einer fünften Ausführungsform der erfindungsgemässen Lötvorrichtung, umfassend eine Induktionsantenne und eine Mehrzahl von Niederhalterelementen in Form von Stiften, mit einer Darstellung der mittels der Induktionsantenne erzeugbaren magnetischen Wechselfelder für verschiedene Abschnitte einer Lötlinie;
- Fig. 47: eine perspektivische Ansicht einer sechsten Ausführungsform der erfindungsgemässen Lötvorrichtung, umfassend eine Induktionsantenne und eine Mehrzahl von Niederhalterelementen in Form von Stiften, mit einer Darstellung der mittels der Induktionsantenne erzeugbaren magnetischen Wechselfelder für verschiedene Abschnitte einer Lötlinie.

In der folgenden detaillierten Figurenbeschreibung sind gleiche oder gleich wirkende Bauteile aus Gründen der Übersichtlichkeit mit gleichen Bezugszeichen versehen.

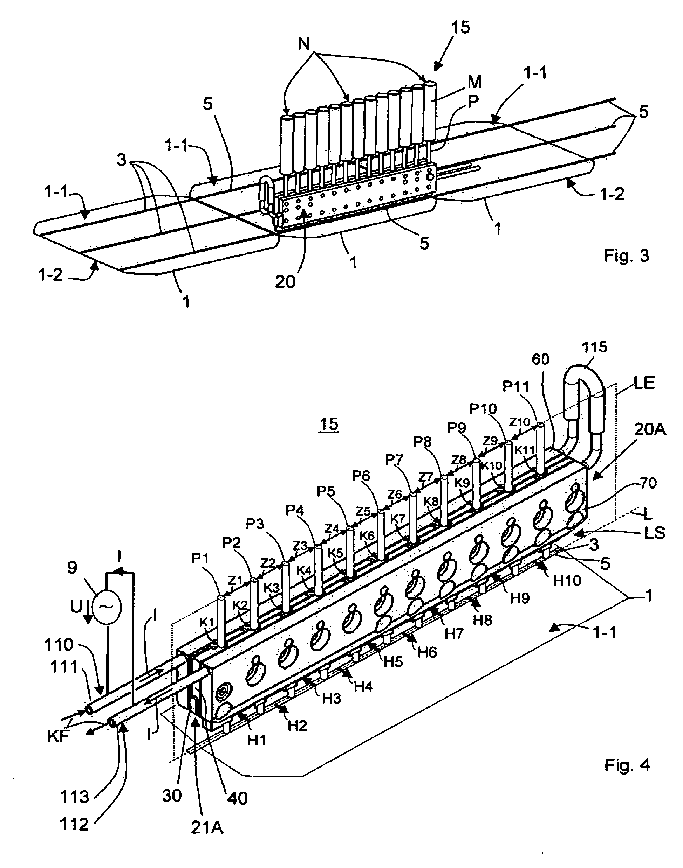

In Fig. 1-47 werden verschiedene Lötvorrichtungen dargestellt, welche jeweils geeignet sind, mittels induktivem Löten zwischen einem elektrisch leitfähigen Band und einer Solarzelle eine Lötverbindung herzustellen, welche sich entlang einer geradlinigen Lötlinie erstrecken. Aus diesem Grunde repräsentiert in Fig. 4-47 eine mit dem Bezugszeichen "L" versehene (mathematische) Gerade jeweils eine derartige Lötlinie.

Ein "magnetisches Wechselfeld" wird bekanntlich durch zwei verschiedene physikalische Grössen charakterisiert, durch eine "magnetische Feldstärke" (H-Feld) und eine "magnetische Induktion" (B-Feld). In der folgenden Darstellung wird bei einer Verwendung des Begriffs "magnetisches Wechselfeld" in der Regel nicht strikt zwischen H-Feld und B-Feld unterschieden, sodass der Begriff "magnetisches Wechselfeld" - sofern nichts anderes spezifiziert ist - abhängig vom Kontext wahlweise als H-Feld oder B-Feld interpretiert werden kann. Im Folgenden wird als Bezugszeichen zur formellen Bezeichnung eines spezifischen magnetischen Wechselfelds entweder der Buchstabe "H" oder der Buchstabe "H" in Kombination mit einer Zahl (z.B. H1, H2, usw.) verwendet, um auf verschiedene magnetische Wechselfelder Bezug nehmen zu können.

Fig. 1 zeigt schematisch eine (konventionelle) Lötvorrichtung 8 in Kombination mit einer Solarzelle 1 und drei elektrisch leitfähigen Bändern 5, 5' und 5", wobei die Lötvorrichtung 8 dazu dient, die Bänder 5, 5' und 5" mittels induktivem Löten an der Solarzelle 1 zu befestigen. Die Solarzelle 1 kann beispielsweise als "Standard"-Solarzelle oder als bifaciale Solarzelle ausgebildet sein. Die Solarzelle 1 umfasst eine Vorderseite (Oberseite) und eine Rückseite (Unterseite), wobei an der Vorderseite eine im Wesentlichen ebene Oberfläche 1-1 und an der Rückseite eine im Wesentlichen ebene Oberfläche 1-2 ausgebildet ist. Die Solarzelle 1 weist an der Oberfläche 1-1 eine Vielzahl von parallelen Leiterbahnen 4 und zusätzlich drei geradlinige Stromsammelschienen 3, 3' und 3" auf. Dabei sind die Stromsammelschienen 3, 3' und 3'' im vorliegenden Beispiel parallel und jeweils in einem Abstand zueinander derart angeordnet, dass sie sich senkrecht zu den jeweiligen Leiterbahnen 4 über die gesamte Oberfläche 1-1 der Solarzelle 1 (von einem Rand 1' der Solarzelle 1 zu einem anderen Rand 1" der Solarzelle 1) erstrecken und jeweils eine elektrische Verbindung zwischen allen Leiterbahnen 4 bilden. Die Fig. 1 zeigt die Lötvorrichtung 8 in einem Betriebszustand, in welchem jede der Stromsammelschienen 3, 3' und 3'' an der Oberfläche 1-1 mit jeweils einem Längsabschnitt eines der Bänder 5, 5' und 5" bedeckt ist. Wie ersichtlich, ist das Band 5 parallel zur Längsachse der Stromsammelschiene 3 ausgerichtet und derart auf die Stromsammelschiene 3 gelegt, dass es die an der Oberfläche 1-1 zugängliche Oberfläche der Stromsammelschiene 3 im Wesentlichen über die gesamte Länge der Stromsammelschiene 3 bedeckt und mit der Stromsammelschiene 3 im Wesentlichen über die gesamte Länge der Stromsammelschiene 3 in Kontakt steht. Die Bänder 5' bzw. 5" sind entsprechend auf die Stromsammelschienen 3' bzw. 3" gelegt. Im vorliegenden Beispiel ist angenommen, dass die Stromsammelschienen 3, 3' und 3" jeweils auf ihren den jeweiligen Bändern 5, 5' und 5" zugewandten Oberflächen mit einem Lötmittel, z.B. einem Weichlot, versehen sind, um eine Herstellung von Lötverbindungen zwischen diesen Stromsammelschienen und den jeweiligen Bändern zu ermöglichen. Alternativ wäre es natürlich auch möglich, die Bänder 5, 5' und 5'' anstelle der Stromsammelschienen 3, 3' und 3" mit einem derartigen Lötmittel zu beschichten.

Wie Fig. 1 andeutet, verläuft eine Lötlinie L in Form einer mathematischen Geraden im vorliegenden Beispiel parallel zur Längsachse der Stromsammelschiene 3 an der dem Band 5 zugewandten Oberfläche der Stromsammelschiene 3. Dementsprechend ist die Lötvorrichtung 8 in einer Situation dargestellt, in der eine (sich geradlinig erstreckende) Lötverbindung zwischen den Band 5 und der Stromsammelschiene 3 über die gesamte Länge der Stromsammelschiene 3 hergestellt werden soll. Zu diesem Zweck umfasst die Lötvorrichtung 8 eine Induktionsantenne 10 mit einem Strompfad für einen elektrischen Wechselstrom, welcher dazu dient, ein zum induktiven Erhitzen der Bänder 5, 5' und 5" bzw. der Stromsammelschienen 3, 3' und 3'' geeignetes magnetisches Wechselfeld zu erzeugen. Im vorliegenden Beispiel bildet ein länglicher Leiter 11 den Strompfad der Induktionsantenne 10, wobei sich der Leiter 11 in Form einer Induktionsschleife im Wesentlichen in einer senkrecht zur Oberfläche 1-1 angeordneten (in Fig. 1 nicht dargestellten) Ebene, in welcher auch die Lötlinie L liegt, erstreckt und ausserdem zwei Enden aufweist, welche an einen Generator 9 für einen hochfrequenten elektrischen Wechselstrom I mit einer Frequenz im Bereich von beispielsweise 800-900 kHz angeschlossen sind, sodass der vom Generator 9 jeweils erzeugte Wechselstrom I entlang des Leiters 11 fliesst. Wie in Fig. 1 angedeutet, umfasst der Leiter 11 insbesondere einen geradlinigen Abschnitt 11-1, welcher in etwa dieselbe Länge aufweist wie die Stromsammelschienen 3, 3' und 3" und sich im Wesentlichen parallel zur Lötlinie L derart erstreckt, dass er von der Lötlinie L durch einen Luftspalt getrennt ist.

Wenn der elektrische Wechselstrom I im Betrieb der Lötvorrichtung 8 durch den Leiter 11 fliesst, ist die momentane Stromflussrichtung des elektrischen Wechselstroms I im Abschnitt 11-1 entlang der Lötlinie L über die gesamte Länge des Abschnitts 11-1 jeweils gleich. Der Wechselstrom I erzeugt deshalb in der Umgebung des Abschnitts 11-1 und dementsprechend in der Lötlinie L ein magnetisches Wechselfeld H, welches in der Lötlinie L im Wesentlichen über die gesamte Länge des Abschnitts 11-1 homogen ist und insbesondere dieselbe Feldstärke und dieselbe Phase aufweist. In Fig. 1 gibt ein mit I bezeichneter, parallel zu einem Abschnitt des Leiters 11 gerichteter Pfeil die Stromflussrichtung des elektrischen Wechselstroms I für einen bestimmten Zeitpunkt an. Ausserdem sind - für denselben Zeitpunkt - mehrere Feldlinien für die jeweilige Feldstärke des magnetischen Wechselfelds H dargestellt, welches der Wechselstrom I in der Umgebung der Lötlinie L erzeugt, wobei auf den jeweiligen Feldlinien jeweils Pfeile eingezeichnet sind, welche die momentane Richtung der Feldstärke entlang der jeweiligen Feldlinie angegeben. Unter den genannten Umständen erzeugt der elektrische Wechselstrom I in der Lötlinie L im Wesentlichen über die gesamte Länge der Stromsammelschiene 3 ein magnetisches Wechselfeld H, welches in der Lötlinie L jeweils parallel zur Oberfläche 1-1 und senkrecht zur Lötlinie L gerichtet ist (entsprechende Feldlinien, welche die Richtung des Wechselfelds H in der Lötlinie charakterisieren und dementsprechen die Lötlinie L kreuzen müssten, sind in Fig. 1 nicht dargestellt). Dementsprechend können von diesem Wechselfeld H in dem Band 5 bzw. in der Stromsammelschiene 3 mittels elektromagnetischer Induktion jeweils (in Fig. 1 nicht dargestellte) Wirbelströme induziert werden, welche jeweils lokal in dem Band 5 bzw. in der Stromsammelschiene 3 fliessen und in dem Band 5 bzw. in der Stromsammelschiene 3 eine elektrische Heizleistung erzeugen. Die Grösse der durch diese Wirbelströme in dem Band 5 bzw. in der Stromsammelschiene 3 erzeugten Heizleistung hängt dabei u.a. von der jeweiligen Grösse des elektrischen Widerstands des Bandes 5 bzw. des elektrischen Widerstands der Stromsammelschiene 3 und der Feldstärke des magnetischen Wechselfelds H im Band 5 bzw. in der Stromsammelschiene 3 ab. Um eine Lötverbindung zwischen dem Band 5 und der Stromsammelschiene 3 zu erzeugen, kann im vorliegenden Fall die Stromstärke des Wechselstroms I derart bemessen sein, dass die durch Wirbelströme in dem Band 5 bzw. in der Stromsammelschiene 3 erzeugte elektrische Heizleistung hinreichend gross ist, um ein Schmelzen des Lötmittels und somit eine Herstellung einer Lötverbindung entlang der Lötlinie L zu veranlassen.

Wie der räumliche Verlauf der in Fig. 1 dargestellten Feldlinien andeutet, ist im Falle der Induktionsantenne 10 das von dem Wechselstrom I erzeugte magnetische Wechselfeld H in der Solarzelle 1 auch ausserhalb der Stromsammelschiene 3 präsent: Die Feldlinien des magnetischen Wechselfeldes H durchkreuzen die Oberfläche 1-1 der Solarzelle 1 sowohl im Bereich zwischen den Stromsammelschienen 3 und 3" als auch im Bereich zwischen den Stromsammelschienen 3 und 3' und erzeugen folglich einen magnetischen Fluss durch die Oberfläche 1-1, welcher als Funktion der Zeit entsprechend der jeweiligen Frequenz des elektrischen Wechselstroms I variiert. Dementsprechend kann im Falle der Induktionsantenne 10 das magnetische Wechselfeld H in der Solarzelle 1 sowohl im Bereich zwischen den Stromsammelschienen 3 und 3" als auch im Bereich zwischen den Stromsammelschienen 3 und 3' mittels elektromagnetischer Induktion eine elektrische Spannung induzieren und folglich elektrische Ströme generieren, welche in der Solarzelle 1 auch ausserhalb der Stromsammelschiene 3 fliessen. Letzteres ist in Fig. 1 der Einfachheit halber lediglich für denjenigen Teil der Solarzelle 1 schematisch dargestellt, welcher sich im Wesentlichen von der Stromsammelschiene 3 bis zur Stromsammelschiene 3' erstreckt und die Stromsammelschienen 3 und 3' umfasst.

Wie Fig. 1 andeutet, kann das von dem elektrischen Wechselstrom I erzeugte magnetische Wechselfeld H in der Solarzelle 1 ausserhalb der Stromsammelschiene 3 beispielsweise elektrische Wirbelströme Iw induzieren. Derartige elektrischen Wirbelströme Iw zirkulieren jeweils auf im Wesentlichen kreisförmigen Bahnen um die Richtung des magnetischen Wechselfelds H und sind dementsprechend in Fig. 1 durch Pfeile repräsentiert, welche sich jeweils entlang einer kreisförmigen Kurve erstrecken, wobei diese Pfeile die momentane Stromflussrichtung des jeweiligen elektrischen Wirbelstroms Iw charakterisieren. Wie Fig. 1 weiter andeutet, erzeugt der jeweilige Wirbelstrom Iw jeweils ein magnetisches Wechselfeld Hw, welches jeweils (entsprechend der jeweiligen Stromflussrichtung des Wirbelstroms) derart gerichtet ist, dass es das vom elektrischen Wechselstrom I erzeugte magnetische Wechselfeld H lokal ganz oder teilweise kompensiert (je nach Grösse des elektrischen Widerstands in dem Bereich der Solarzelle, in dem der jeweilige Wirbelstrom induziert wird).

Jeweils zwei verschiedene Leiterbahnen 4 sind sowohl durch einen Abschnitt der Stromsammelschiene 3 als auch durch einen Abschnitt der Stromsammelschiene 3' verbunden und bilden folglich einen ringförmig geschlossenen Strompfad, welcher sich derart an der Oberfläche 1-1 erstreckt, dass das von dem elektrischen Wechselstrom I erzeugte magnetische Wechselfeld H durch elektromagnetische Induktion eine elektrische Spannung in diesem Strompfad induzieren kann. Die Gesamtheit aller Leiterbahnen 4 und die Stromsammelschienen 3 und 3' bilden dementsprechend ein über die gesamte Oberfläche 1-1 verteiltes, elektrisch leitfähiges "Netzwerk", welches aus einer Vielzahl dieser ringförmig geschlossenen Strompfade zusammengesetzt ist, wobei die jeweiligen Strompfade elektrisch miteinander verbunden sind. Da das von dem elektrischen Wechselstrom I erzeugte magnetische Wechselfeld H im Bereich zwischen den Stromsammelschienen 3 und 3' im Wesentlichen über die gesamte Länge der Stromsammelschienen 3 bzw. 3' präsent ist, kann das magnetische Wechselfeld H in einer Vielzahl der vorstehend genannten ringförmig geschlossenen Strompfade durch elektromagnetische Induktion elektrische Spannungen induzieren und dementsprechend elektrische Wechselströme generieren, welche jeweils entlang des jeweiligen ringförmig geschlossenen Strompfads und somit jeweils zumindest abschnittsweise entlang der Stromsammelschienen 3, 3' und einzelner Leiterbahnen 4 geführt sind.

Im vorliegenden Beispiel ist die Stromsammelschienen 3 mit dem Band 5 und die Stromsammelschiene 3' mit dem Band 5' in Kontakt gebracht. In diesem Fall kann angenommen werden, dass eine elektrische Verbindung zwischen der Stromsammelschiene 3 und dem Band 5 und eine elektrische Verbindung zwischen der Stromsammelschienen 3' und dem Band 5' besteht (diese Annahme ist realistisch, zumal beim induktiven Löten in der Regel immer eine derartige elektrische Verbindung zwischen der jeweiligen Stromsammelschiene und dem an der Stromsammelschiene zu befestigenden Band zumindest über die gesamte Länge der herzustellenden Lötverbindung realisiert wird).

Falls eine elektrische Verbindung zwischen der Stromsammelschienen 3 und dem Band 5 besteht, ist zu beachten, dass auch das Band 5 zusammen mit jeweils zwei verschiedenen Leiterbahnen 4 und einem Abschnitt der Stromsammelschiene 3' jeweils einen ringförmig geschlossenen Strompfad bilden kann, zumal die jeweiligen Leiterbahnen 4 durch einen Längsabschnitt des Bandes 5 (jeweils parallel zur Stromsammelschiene 3) verbunden sein können. In diesem Strompfad kann das magnetische Wechselfeld H durch elektromagnetische Induktion dementsprechend einen elektrischen Wechselstrom generieren, welcher zumindest abschnittsweise entlang des Bandes 5, die Stromsammelschiene 3' und die jeweiligen Leiterbahnen 4 geführt ist.

Falls ausserdem eine elektrische Verbindung zwischen der Stromsammelschienen 3' und dem Band 5' besteht, ist zu beachten, dass auch das Band 5' zusammen mit jeweils zwei verschiedenen Leiterbahnen 4 und einem Abschnitt der Stromsammelschiene 3 (bzw. alternativ mit einem Abschnitt des Bandes 5) jeweils einen ringförmig geschlossenen Strompfad bilden kann, zumal die jeweiligen Leiterbahnen 4 durch einen Längsabschnitt des Bandes 5' (jeweils parallel zur Stromsammelschiene 3') verbunden sein können. In einem derartigen Strompfad kann das magnetische Wechselfeld H durch elektromagnetische Induktion dementsprechend einen elektrischen Wechselstrom generieren, welcher zumindest abschnittsweise entlang des Bandes 5', die Stromsammelschiene 3 (bzw. alternativ entlang des Bandes 5) und die jeweiligen Leiterbahnen 4 geführt ist.

Mit Bezug auf Fig. 1 wird im Folgenden die räumliche Verteilung der elektrischen Wechselströme erläutert, welche das durch den Wechselstrom I erzeugte magnetische Wechselfeld H im Falle der Induktionsantenne 10 in den erwähnten ringförmig geschlossenen, aus den Leiterbahnen 4 und den Stromsammelschienen 3, 3' und/oder den Bändern 5, 5' gebildeten Strompfaden erzeugt.

Es sei darauf hingewiesen, dass der (durch den Leiter 11 gebildete) Strompfad der Induktionsantenne 10 und die ringförmigen, aus den Leiterbahnen 4, den Stromsammelschienen 3, 3' und/oder den Bändern 5, 5' gebildeten Strompfade sich hinsichtlich ihrer elektromagnetischen Wechselwirkung miteinander entsprechend einem klassischen, eine "primärseitige Wicklung" und eine "sekundärseitige Wicklung" umfassenden "Transformator" verhalten. Dabei hat der Strompfad der Induktionsantenne die Funktion der primärseitigen Wicklung des Transformators und der jeweilige ringförmige, aus den Leiterbahnen 4, den Stromsammelschienen 3, 3' und/oder den Bändern 5, 5' gebildete Strompfad die Funktion der sekundärseitigen Wicklung des Transformators. Dementsprechend ist plausibel, dass der elektrische Wechselstrom, welcher in einem ringförmigen, aus den Leiterbahnen 4, den Stromsammelschienen 3, 3' und/oder den Bändern 5, 5' gebildeten Strompfad induziert wird, bekannten physikalischen Gesetzmässigkeiten genügt, welche für in der sekundärseitigen Wicklung eines Transformators fliessende elektrische Wechselströme anwendbar sind. Ausgehend von diesem Vergleich mit der sekundärseitigen Wicklung eines Transformators soll in diesem Zusammenhang ein elektrischer Wechselstrom, welcher mittels des von der Induktionsantenne erzeugten magnetischen Wechselfelds H durch elektromagnetische Induktion in einem in der Solarzelle ausgebildeten, ringförmigen Strompfad induziert wird (z.B. in einem ringförmigen, aus den Leiterbahnen 4, den Stromsammelschienen 3, 3' und/oder den Bändern 5, 5' gebildeten Strompfad), als (elektromagnetisch induzierter) "sekundärer" elektrischer Wechselstrom bezeichnet werden.

Sekundäre elektrische Wechselströme, welche das durch den Wechselstrom I erzeugte magnetische Wechselfeld H der Induktionsantenne 10 induziert, werden im Folgenden mit IS bezeichnet. Der Einfachheit halber sind in Fig. 1 ausschliesslich sekundäre elektrische Wechselströme IS schematisch dargestellt, welche in den Stromsammelschienen 3, 3' und/oder den Bändern 5, 5' und dem sich zwischen den Stromsammelschienen 3 und 3' erstreckenden Bereich der Solarzelle 1 fliessen. Strompfade dieser sekundären elektrischen Wechselströme IS sind in Fig. 1 durch mit Pfeilen versehenen Linien repräsentiert, wobei die jeweiligen Pfeile die momentane Stromflussrichtung des jeweiligen sekundären elektrischen Wechselstroms IS angeben. In Fig. 1 bezeichnet FS eine Fläche an der Oberfläche 1-1 der Solarzelle 1, welche durch die Stromsammelschienen 3 und 3' und die Ränder 1' und 1" der Solarzelle 1 begrenzt ist. Die räumliche Verteilung des magnetischen Wechselfelds H im Bereich der Fläche FS korrespondiert im vorliegenden Fall mit induzierten sekundären elektrischen Wechselströmen IS, welche in ringförmig geschlossenen Strompfaden ausschliesslich entlang des äusseren Randes der Fläche FS geführt sind: Wie Fig. 1 andeutet, fliessen die sekundären elektrische Wechselströme IS im Wesentlichen
- entlang der Stromsammelschiene 3 und/oder entlang des Bandes 5, wobei die Stromflussrichtung des sekundären Wechselstroms IS in der Stromsammelschiene 3 bzw. im Band 5 zwischen den Rändern 1' und 1" jeweils identisch ist,
- in der Nähe des Randes 1' der Solarzelle 1 entlang einer oder mehrerer Leiterbahnen 4, welche in der Nähe des Randes 1' angeordnet sind und das dem Rand 1' zugewandte Ende der Stromsammelschiene 3 mit dem dem Rand 1' zugewandten Ende der Stromsammelschiene 3' verbinden,
- entlang der Stromsammelschiene 3' und/oder entlang des Bandes 5', wobei die Stromflussrichtung des sekundären Wechselstroms IS in der Stromsammelschiene 3' bzw. im Band 5' zwischen den Rändern 1' und 1" jeweils identisch ist (allerdings entgegengesetzt zur Stromflussrichtung des sekundären Wechselstroms IS in der Stromsammelschiene 3 bzw. im Band 5),
- in der Nähe des Randes 1" der Solarzelle 1 entlang einer oder mehrerer Leiterbahnen 4, welche in der Nähe des Randes 1" angeordnet sind und das dem Rand 1" zugewandte Ende der Stromsammelschiene 3 mit dem dem Rand 1" zugewandten Ende der Stromsammelschiene 3' verbinden.

Wie aus Fig. 1 ersichtlich, ist dabei die momentane Stromflussrichtung der sekundären elektrischen Wechselströme IS derart, dass die elektrischen Wechselströmen IS jeweils im Bereich der Fläche FS ein magnetisches Wechselfeld Hs erzeugen, welches das durch den Wechselstrom I erzeugte magnetische Wechselfeld H zumindest teilweise kompensiert (die jeweilige Richtung des magnetischen Felds Hs ist in Fig. 1 durch einen entsprechenden Pfeil angegeben).

Die sekundären elektrische Wechselströme IS erzeugen dementsprechend eine Heizleistung ausschliesslich am äusseren Rand der Fläche FS, d.h. in den Stromsammelschienen 3 und 3' (jeweils über die gesamte Länge dieser Stromsammelschienen) und/oder in den Bändern 5 und 5' (jeweils über die gesamte Länge dieser Bänder) und ausserdem zwischen den Stromsammelschienen 3 und 3' in zwei "schmalen" Bereichen der Solarzelle 1, welche sich am Rand 1' bzw. am Rand 1" zwischen den Stromsammelschienen 3 und 3' in Richtung der Lötlinie L jeweils über eine Distanz erstrecken, welche relativ klein ist im Vergleich zur Länge der Stromsammelschienen 3 bzw. 3'.

Die Stromstärke des sekundären elektrische Wechselströme IS kann insbesondere dann relativ gross sein, wenn eine elektrische Verbindung zwischen dem Band 5 und der Stromsammelschiene 3 bzw. Band 5' und der Stromsammelschiene 3' hergestellt ist, bedingt durch die elektrische Leitfähigkeit der Bänder 5, 5 im Vergleich zu der elektrischen Leitfähigkeit der Stromsammelschienen 3 bzw. 3' und den Leiterbahnen 4. Die Bänder 5 und 5' können vorzugsweise aus einem Metall (z.B. Kupfer oder Aluminium) gefertigt sein und haben deshalb in der Regel einen elektrischen Widerstand, der wesentlich geringer ist als der elektrische Widerstand der Stromsammelschienen 3, 3' und der elektrische Widerstand der Leiterbahnen 4 (unter der Annahme, dass die Stromsammelschienen 3, 3' und Leiterbahnen 4 der Solarzelle 1 gemäss üblichen Technologien realisiert sind). Wegen des hohen elektrischen Widerstands der Leiterbahnen 4 führen die sekundären elektrische Wechselströme IS demzufolge insbesondere zu einer starken Erhitzung der Solarzelle 1 in der Nähe der Ränder 1' und 1". Dementsprechend wird durch den sekundären elektrischen Wechselstrom IS auch das zu lötende Band 5 erhitzt, wobei an die Ränder 1' bzw.1" grenzende Abschnitte des Bandes 5 besonders stark erhitzt werden. Demzufolge führt der sekundäre elektrische Wechselstrom IS zu einer ungleichmässigen Erhitzung des Bandes 5 und der Solarzelle 1.

Fig. 2 zeigt schematisch eine gemäss der Erfindung ausgebildete, zum induktiven Löten geeignete Lötvorrichtung 15 in Kombination mit einer Solarzelle 1 und drei elektrisch leitfähigen Bändern 5, 5' und 5". Um einen Vergleich mit der Lötvorrichtung 8 gemäss Fig. 1 zu ermöglichen, sind die Darstellungen der Fig. 1 und 2 hinsichtlich der Solarzelle 1 und der Bänder 5, 5' und 5" identisch. Entsprechend ist die Lötvorrichtung 15 in Fig. 2 in einer Situation dargestellt, in der sie zur Herstellung einer Lötverbindung zwischen der Stromsammelschiene 3 und dem Band 5 entlang der Lötlinie L über die gesamte Länge der Stromsammelschiene 3 bereit ist.

Im Unterschied zu Fig. 1 ist in Fig. 2 zusätzlich eine Lötebene LE eingezeichnet, welche senkrecht zur Oberfläche 1-1 der Solarzelle 1 angeordnet ist, wobei die Lötlinie L in der Lötebene LE liegt. Wie ersichtlich, umfasst die Lötvorrichtung 15 mehrere Niederhalterelemente zum Niederhalten des Bandes 5, im vorliegenden Beispiel drei Niederhalterelemente P1, P2 und P3 in Form von zylindrischen Stiften, welche sich in der Lötebene LE vertikal zur Lötlinie L erstrecken und entlang der Lötlinie L in einer Reihe hintereinander derart angeordnet sind, dass sie auf das Band 5 eine vertikal zur Oberfläche der Stromsammelschiene 3 gerichtete Kraft ausüben. Dabei sind die Niederhalterelemente P1 bzw. P3 am Rand 1' bzw. 1" der Solarzelle 1 angeordnet und halten das Band 5 dementsprechend am Rand 1' bzw. 1'' auf der Stromsammelschiene 3, während das Niederhalterelement P2 zwischen den Niederelementen P1 und P3 angeordnet ist und das Band 5 an einer Stelle auf der Stromsammelschiene 3 hält, welche in der Mitte zwischen den Rändern 1' und 1" liegt.

Wie Fig. 2 andeutet, umfasst die Lötvorrichtung 15 eine Induktionsantenne 10A mit einem Strompfad für einen elektrischen Wechselstrom, wobei der Strompfad in Form eines länglichen Leiter 11A realisiert ist. Der Leiter 11A umfasst zwei Enden, welche an einen (mit dem Generator 9 gemäss Fig. 1 hinsichtlich seiner Funktion identischen) Generator 9 für einen elektrischen Wechselstrom I angeschlossen ist, sodass der vom Generator 9 jeweils erzeugte elektrische Wechselstrom I entlang des Leiters 11A fliesst. In Fig. 2 stellen mit dem Bezugszeichen I versehene und entlang des Leiters 11A gerichtete Pfeile jeweils die momentane Stromflussrichtung des elektrischen Wechselstroms I im Leiter 11A für einen bestimmten Zeitpunkt dar.

Der Leiter 11A erstreckt sich (ähnlich wie der Leiter 11) entlang der Lötlinie L derart, dass der elektrische Wechselstrom I in der Lötlinie L und in einer Umgebung der Lötlinie L im Wesentlichen über die gesamte Länge der Stromsammelschiene 3 ein magnetisches Wechselfeld erzeugt. Um einen Vergleich mit der Lötvorrichtung 8 gemäss Fig. 1 zu ermöglichen, ist der Strompfad der Induktionsantenne 10A (Leiter 11A) derart ausgebildet, dass der Wechselstrom I in der Lötlinie L und/oder in der Umgebung der Lötlinie L eine magnetisches Wechselfeld erzeugt, welches hinsichtlich seiner räumlichen Verteilung (wie beispielsweise charakterisiert durch den Verlauf von Feldlinien in der Lötlinie L und/oder in der Umgebung der Lötlinie L) im Wesentlichen mit dem magnetischen Wechselfeld H der Induktionsantenne 10 gemäss Fig. 1 übereinstimmt, mit dem wesentlichen Unterschied, dass im Falle der Induktionsantenne 10A gemäss Fig. 2 das vom Wechselstrom I erzeugte magnetische Wechselfeld in dem sich zwischen den Niederhalterelementen P1 und P2 erstreckenden Abschnitt der Lötlinie L in Gegenphase (d.h. entgegengesetzt gerichtet) zum magnetischen Wechselfeld in dem sich zwischen den Niederhalterelementen P2 und P3 erstreckenden Abschnitt der Lötlinie L ist.

Wie aus Fig. 2 ersichtlich, umfasst der Leiter 11A mehrere Längsabschnitte, welche sich in der Lötebene LE derart erstrecken, dass der Leiter 11A zwei nebeneinander angeordnete Schleifen bildet, wobei eine dieser Schleifen in einem Zwischenraum Z1 zwischen den Niederhalterelementen P1 und P2 und die andere dieser Schleifen in einem Zwischenraum Z2 zwischen den Niederhalterelementen P2 und P3 angeordnet ist und die Stromflussrichtung des elektrischen Wechselstroms I in der einen dieser Schleife entgegengesetzt zur Stromflussrichtung des elektrischen Wechselstroms I in der anderen dieser Schleifen ist. Der Leiter 11A umfasst insbesondere einen ersten Abschnitt 11A-1, welcher sich in der Lötebene LE im Zwischenraum Z1 zwischen den Niederhalterelementen P1 und P2 - von der Lötlinie L durch einen Luftspalt getrennt - im Wesentlichen geradlinig und im Wesentlichen parallel zur Lötlinie L erstreckt. Weiterhin umfasst der Leiter 11A einen zweiten Abschnitt 11A-2, welcher sich in der Lötebene LE im Zwischenraum Z2 zwischen den Niederhalterelementen P2 und P3 - von der Lötlinie L durch einen Luftspalt getrennt - im Wesentlichen geradlinig und im Wesentlichen parallel zur Lötlinie L erstreckt. Wie aus Fig. 2 ersichtlich, sind die Abschnitte 11A-1 und 11A-2 derart in Reihe geschaltet, dass die Stromflussrichtung des elektrischen Wechselstroms I im Abschnitt 11A-1 entgegengesetzt zur Stromflussrichtung des elektrischen Wechselstroms I im Abschnitt 11A-2 ist, d.h. der elektrische Wechselstrom I ist somit im Abschnitt 11A-1 in Gegenphase zum elektrischen Wechselstrom I im Abschnitt 11A-2). Dadurch, dass die Stromflussrichtung des elektrischen Wechselstroms I im Abschnitt 11A-1 entgegengesetzt zur Stromflussrichtung des elektrischen Wechselstroms I im Abschnitt 11A-2 ist, ist das magnetische Wechselfeld H1, welches der elektrische Wechselstrom I in dem sich zwischen den Niederhalterelementen P1 und P2 erstreckenden Abschnitt der Lötlinie L erzeugt, jeweils entgegengesetzt gerichtet zu dem magnetischen Wechselfeld H2, welches der elektrische Wechselstrom I in dem sich zwischen den Niederhalterelementen P2 und P3 erstreckenden Abschnitt der Lötlinie L erzeugt. Somit ist das magnetische Wechselfeld im Falle der Induktionsantenne 10A - entsprechend der Erfindung - in mindestens einem Abschnitt der Lötlinie L in Gegenphase zu dem magnetischen Wechselfeld in mindestens einem anderen Abschnitt der Lötlinie L. Dabei ist das magnetische Wechselfeld in der Lötlinie sowohl im Bereich zwischen den Niederhalterelementen P1 und P2 als auch im Bereich im zwischen den Niederhalterelementen P2 und P3 jeweils im Wesentlichen senkrecht zur Lötlinie L und parallel zur Oberfläche 1-1 der Solarzelle 1 (bzw. senkrecht zur Lötebene LE) gerichtet (in Fig. 2 nicht dargestellt).

In Fig. 2 sind mehrere Feldlinien für die jeweilige Feldstärke des magnetischen Wechselfelds H1 dargestellt, welches der Wechselstrom I in der Umgebung des Abschnitts 11A-1 des Leiters 11 im Bereich zwischen den Niederhalterelementen P1 und P2 in einer Umgebung der Lötlinie L erzeugt, wobei auf den jeweiligen Feldlinien jeweils Pfeile eingezeichnet sind, welche momentane Richtung der Feldstärke des magnetischen Wechselfelds H1 entlang der jeweiligen Feldlinie angegeben. Entsprechend sind in Fig. 2 mehrere Feldlinien für die jeweilige Feldstärke des magnetischen Wechselfelds H2 dargestellt, welches der Wechselstrom I in der Umgebung des Abschnitts 11A-2 des Leiters 11 im Bereich zwischen den Niederhalterelementen P2 und P3 in einer Umgebung der Lötlinie L erzeugt, wobei auf den jeweiligen Feldlinien jeweils Pfeile eingezeichnet sind, welche die momentane Richtung der Feldstärke des magnetischen Wechselfelds H2 angegeben. Wie Fig. 2 andeutet, haben die Feldlinien der magnetischen Wechselfelder H1 und H2 in einer Umgebung der Lötlinie L jeweils im Wesentlichen denselben Verlauf, wobei die magnetischen Wechselfelder H1 und H2 - entsprechend den auf den Feldlinien angegebenen Pfeilen zur Kennzeichnung der momentanen Richtung der Feldstärke - einander entgegengesetzte Richtungen aufweisen und somit in Gegenphase zueinander sind.

Wie aus Fig. 2 ersichtlich, durchkreuzen die Feldlinien der magnetischen Wechselfelder H1 und H2 die Oberfläche 1-1 der Solarzelle 1 sowohl im Bereich zwischen den Stromsammelschienen 3 und 3" als auch im Bereich zwischen den Stromsammelschienen 3 und 3' und erzeugen folglich einen magnetischen Fluss durch die Oberfläche 1-1, welcher als Funktion der Zeit entsprechend der jeweiligen Frequenz des elektrischen Wechselstroms I variiert. Dementsprechend können im Falle der Induktionsantenne 10A die magnetischen Wechselfelder H1 und H2 in der Solarzelle 1 sowohl im Bereich zwischen den Stromsammelschienen 3 und 3" als auch im Bereich zwischen den Stromsammelschienen 3 und 3' mittels elektromagnetischer Induktion elektrische Spannungen induzieren und folglich elektrische Ströme generieren, welche in der Solarzelle 1 auch ausserhalb der Stromsammelschiene 3 fliessen (Wirbelströme, sekundäre elektrische Wechselströme). Letzteres ist in Fig. 2 der Einfachheit halber lediglich für denjenigen Teil der Solarzelle 1 schematisch dargestellt, welcher sich im Wesentlichen von der Stromsammelschiene 3 bis zur Stromsammelschiene 3' erstreckt und die Stromsammelschienen 3 und 3' umfasst.

In Fig. 2 bezeichnet FS1 eine im Wesentlichen rechteckige Fläche an der Oberfläche 1-1 der Solarzelle 1, welche einerseits durch die Stromsammelschienen 3 und 3' begrenzt ist und sich andererseits in Richtung der Lötlinie L - ausgehend vom Rand 1' der Solarzelle 1 - um eine Distanz erstreckt, welche gleich der halben Länge der Stromsammelschiene 3 ist. Entsprechend bezeichnet FS2 eine im Wesentlichen rechteckige Fläche an der Oberfläche 1-1 der Solarzelle 1, welche einerseits durch die Stromsammelschienen 3 und 3' begrenzt ist und sich andererseits in Richtung der Lötlinie L - ausgehend vom Rand 1" der Solarzelle 1 - um eine Distanz erstreckt, welche gleich der halben Länge der Stromsammelschiene 3 ist. Dementsprechend haben die Flächen FS1 und FS2 denselben Flächeninhalt, wobei dieser 50% des Flächeninhalts der Fläche FS gemäss Fig. 1 beträgt.

Da die magnetischen Wechselfelder H1 und H2 in Gegenphase zueinander sind, erzeugt das magnetische Wechselfeld H1 in der Solarzelle 1 im Bereich der Fläche FS1 jeweils mittels elektromagnetischer Induktion elektrische Spannungen, welche in Gegenphase zu den elektrischen Spannungen sind, welche das magnetische Wechselfeld H2 im Bereich der Fläche FS2 induziert.

Dementsprechend erzeugen die magnetischen Wechselfelder H1 und H2 im Bereich der Flächen FS1 und FS2 jeweils Wirbelströme Iw mit unterschiedlichen Stromflussrichtungen (abhängig von der Richtung des jeweiligen Wechselfelds H1 bzw. H2). Weiterhin erzeugt jedes der magnetischen Wechselfelder H1 und H2 im Bereich der Flächen FS1 und FS2 jeweils sekundäre elektrische Wechselströme, wobei die vom magnetischen Wechselfeld H1 erzeugten sekundären elektrischen Wechselströme und die vom magnetischen Wechselfeld H1 erzeugten sekundären elektrischen Wechselströme räumlich getrennt in benachbarten Bereichen der Solarzelle 1 fliessen.

Sekundäre elektrische Wechselströme, welche das magnetische Wechselfeld H1 der Induktionsantenne 10A induziert, werden im Folgenden mit IS1 bezeichnet. Entsprechend werden sekundäre elektrische Wechselströme, welche das magnetische Wechselfeld H2 der Induktionsantenne 10A induziert, im Folgenden mit IS2 bezeichnet. Der Einfachheit halber sind in Fig. 2 ausschliesslich sekundäre elektrische Wechselströme IS1 bzw. IS2 schematisch dargestellt, welche in den Stromsammelschienen 3, 3' und/oder den Bändern 5, 5' und dem sich zwischen den Stromsammelschienen 3 und 3' erstreckenden Bereich der Solarzelle 1 fliessen. Strompfade dieser sekundären elektrischen Wechselströme IS1 bzw. IS2 sind in Fig. 2 durch mit Pfeilen versehenen Linien repräsentiert, wobei die jeweiligen Pfeile die momentane Stromflussrichtung des jeweiligen sekundären elektrischen Wechselstroms IS1 bzw. IS2 angeben.

Wie aus Fig. 2 ersichtlich, ist dabei die momentane Stromflussrichtung der sekundären elektrischen Wechselströme IS1 derart, dass die elektrischen Wechselströme IS1 jeweils ein magnetisches Wechselfeld HS1 erzeugen, welches das magnetische Wechselfeld H1 im Bereich der Fläche FS1 zumindest teilweise kompensiert (die jeweilige Richtung des magnetischen Wechselfeld HS1 ist in Fig. 1 durch einen entsprechenden Pfeil angegeben). Entsprechend ist dabei die momentane Stromflussrichtung der sekundären elektrischen Wechselströme IS2 derart, dass die elektrischen Wechselströmen IS2 jeweils ein magnetisches Wechselfeld HS2 erzeugen, welches das magnetische Wechselfeld H2 im Bereich der Fläche FS2 zumindest teilweise kompensiert (die jeweilige Richtung des magnetischen Wechselfeld HS2 ist in Fig. 2 durch einen entsprechenden Pfeil angegeben).

Wie aus Fig. 2 ersichtlich, sind die sekundären elektrischen Wechselströme IS1 - der räumlichen Verteilung des magnetischen Wechselfelds H1 im Bereich der Fläche FS1 entsprechend
- in ringförmig geschlossenen Strompfaden geführt, welche sich im Wesentlichen entlang des äusseren Randes der Fläche FS1 erstrecken. Die sekundären elektrischen Wechselströme IS2 sind hingegen - der räumlichen Verteilung des magnetischen Wechselfelds H2 im Bereich der Fläche FS2 entsprechend
- in ringförmig geschlossenen Strompfaden geführt, welche sich im Wesentlichen entlang des äusseren Randes der Fläche FS2 erstrecken.

Demnach erstrecken sich die Strompfade der sekundären elektrischen Wechselströme IS1 durch: einen sich zwischen den Niederhalterelementen P1 und P2 erstreckenden Abschnitt des Bandes 5 und/oder einen sich zwischen den Niederhalterelementen P1 und P2 erstreckenden Abschnitt der Stromsammelschiene 3; eine oder mehrere am Rand 1' bzw. in der Nähe des Randes 1' angeordnete, sich zwischen den Stromsammelschienen 3 und 3' erstreckende Leiterbahnen 4; einen Abschnitt des Bandes 5' und/oder einen Abschnitt der Stromsammelschiene 3' ; eine oder mehrere Leiterbahnen 4, welche in der Nähe des Niederhalterelements P2 angeordnet sind und sich an dieser Stelle zwischen den Stromsammelschienen 3 und 3' erstrecken.

Die Strompfade der sekundären elektrischen Wechselströme IS2 erstrecken sich hingegen durch: einen sich zwischen den Niederhalterelementen P2 und P3 erstreckenden Abschnitt des Bandes 5 und/oder einen sich zwischen den Niederhalterelementen P2 und P3 erstreckenden Abschnitt der Stromsammelschiene 3; eine oder mehrere am Rand 1" bzw. in der Nähe des Randes 1" angeordnete, sich zwischen den Stromsammelschienen 3 und 3' erstreckende Leiterbahnen 4; einen Abschnitt des Bandes 5' und/oder einen Abschnitt der Stromsammelschiene 3'; eine oder mehrere Leiterbahnen 4, welche in der Nähe dese Niederhalterelements P2 angeordnet sind und sich an dieser Stelle zwischen den Stromsammelschienen 3 und 3' erstrecken.

Wie aus Fig. 2 ersichtlich, fliessen die sekundären elektrischen Wechselströme IS1 und IS2 entlang des Bandes 5 bzw. der Stromsammelschiene 3 in jeweils verschiedenen Abschnitten des Bandes 5 bzw. der Stromsammelschiene 3 derart, dass die momentane Stromrichtung des sekundären elektrischen Wechselströme IS1 entgegengesetzt zur momentanen Stromrichtung des sekundären elektrischen Wechselströme IS2 gerichtet ist. Entsprechend fliessen die sekundären elektrischen Wechselströme IS1 und IS2 entlang des Bandes 5' bzw. der Stromsammelschiene 3' in jeweils verschiedenen Abschnitten des Bandes 5' bzw. der Stromsammelschiene 3' derart, dass die momentane Stromrichtung des sekundären elektrischen Wechselströme IS1 entgegengesetzt zur momentanen Stromrichtung des sekundären elektrischen Wechselströme IS2 gerichtet ist.

Wie aus Fig. 2 weiterhin ersichtlich, fliessen die sekundären elektrischen Wechselströme IS1 und IS2 allerdings in jenen Leiterbahnen 4, welche in der Nähe dese Niederhalterelements P2 angeordnet sind und sich an dieser Stelle zwischen den Stromsammelschienen 3 und 3' erstrecken, jeweils in dieselbe Richtung und sind deshalb in diesen Leiterbahnen jeweils in Gleichphase. Daraus resultiert in jenen Leiterbahnen 4, welche in der Nähe dese Niederhalterelements P2 angeordnet sind und sich an dieser Stelle zwischen den Stromsammelschienen 3 und 3' erstrecken, ein Stromfluss zwischen den Stromsammelschienen 3 und 3' mit einer Stromstärke, welche gleich der Summe der jeweiligen Stromstärken der sekundären elektrischen Wechselströme IS1 und IS2 ist.

Im Unterschied zu den sekundären elektrischen Wechselströmen IS, welche mit der Induktionsantenne 10 der Lötvorrichtung 8 gemäss Fig. 1 erzeugbar sind, erzeugen die mit der Induktionsantenne 10A induzierten sekundären elektrischen Wechselströme IS1 und IS2 folglich eine Heizleitung nicht nur in der Stromsammelschiene 3, in der Stromsammelschiene 3' und/oder in dem Band 5 und/oder in dem Band 5' und in Leiterbahnen 4, welche sich entweder am Rand 1' oder am Rand 1" der Solarzelle 1 erstrecken. Die sekundären elektrischen Wechselströme IS1 und IS2 erzeugen zusätzlich eine Heizleistung in jenen Leiterbahnen 4, welche in der Nähe dese Niederhalterelements P2 angeordnet sind und sich an dieser Stelle zwischen den Stromsammelschienen 3 und 3' erstrecken. Daraus resultiert u.a. eine zusätzliche Erhitzung des Bandes 5 in der Nähe des Niederhalterelements P2

Da die Leiterbahnen 4 in der Regel einen relativ grossen elektrischen Widerstand aufweisen und die sekundären elektrischen Wechselströme IS (im Falle der Induktionsantenne 10) bzw. IS1 und IS2 (im Falle der Induktionsantenne 10A) insbesondere in den jeweiligen Leiterbahnen 4 eine relativ grosse Heizleistung erzeugen können, haben im Falle der Induktionsantenne 10A die sekundären elektrischen Wechselströme IS1 und IS2 folglich (vorteilhafterweise) den Effekt, dass die durch die sekundären elektrischen Wechselströme IS1 und IS2 erzeugte Heizleistung räumlich gleichmässiger über die gesamte Oberfläche 1-1 bzw. das gesamte Volumen der Solarzelle 1 verteilt ist (im Vergleich zur räumlichen Verteilung der Heizleistung, welche die sekundären elektrischen Wechselströme IS im Falle der Induktionsantenne 10 in der Solarzelle 1 erzeugen).

Hinsichtlich der Stromstärke der sekundären elektrischen Wechselströme IS1 und IS2, welche mittels der Induktionsantenne 10A induzierbar sind, ist weiterhin erwähnenswert, dass die Stromstärke der sekundären elektrischen Wechselströme IS1 und IS2 in der Regel reduziert ist im Vergleich zur Stromstärke der sekundären elektrischen Wechselströme IS1, welche mittels der Induktionsantenne 10A induzierbar sind (hierbei ist angenommen, dass die Feldstärken der Wechselfelder H, H1, und H2 in der Lötlinie L jeweils hinsichtlich ihres Betrags identisch sind).

Diese Reduktion beruht unter anderem darauf, dass das magnetische Wechselfeld H im Falle der Induktionsantenne 10 entlang der jeweiligen Strompfade der sekundären elektrischen Wechselströme IS mittels elektromagnetischer Induktion eine elektrische Spannung generieren kann, welche grösser ist als die elektrische Spannung, welche im Falle der Induktionsantenne 10A das magnetische Wechselfeld H1 entlang der jeweiligen Strompfade der sekundären elektrischen Wechselströme IS1 bzw. das magnetische Wechselfeld H2 entlang der jeweiligen Strompfade der sekundären elektrischen Wechselströme IS2 mittels elektromagnetischer Induktion generieren kann. Dies ist dadurch bedingt, dass im Falle der Induktionsantenne 10 das magnetische Wechselfeld H in der Fläche FS einen magnetischen Fluss erzeugt, welcher grösser ist als der magnetische Fluss, welches im Falle der Induktionsantenne 10A das magnetische Wechselfeld H1 in der Fläche FS1 bzw. das magnetische Wechselfeld H2 in der Fläche FS2 erzeugt. Das Ausmass der Reduktion der Stromstärken der sekundären elektrischen Wechselströme IS1 und IS2 hängt dabei von den elektrischen Widerständen einzelner Abschnitte der jeweiligen Strompfade ab (z.B. den jeweiligen elektrischen Widerständen der Stromsammelschienen 3 bzw. 3', der Bänder 5 bzw. 5' und der Leiterbahnen 4). Die Stromstärken der sekundären elektrischen Wechselströme IS1 und IS2 können beispielsweise gegenüber der Stromstärke des sekundären elektrischen Wechselströme IS etwa um einen Faktor 2 reduziert sein (beispielweise wenn der elektrische Widerstand der Leiterbahnen 4 relativ gross ist im Vergleich zu den elektrischen Widerständen der Stromsammelschienen 3 bzw. 3' und/oder der Bänder 5 bzw. 5'). Daraus resultiert ebenfalls eine Reduktion (beispielsweise um einen Faktor 2) der gesamten Heizleitung, welche die sekundären elektrischen Wechselströme IS1 und IS2 in der Solarzelle 1 erzeugen (im Vergleich zur entsprechenden Heizleistung des sekundären elektrischen Wechselströme IS im Falle der Induktionsantenne 10).

Die vorstehend genannten Angaben zu den Vorteilen der Induktionsantenne 10A beruhen auf der Annahme, dass in zwei (entlang der Lötlinie L hintereinander angeordneten) Abschnitten der Lötlinie L jeweils zwei magnetische Wechselfelder (H1 und H2 im Beispiel gemäss Fig. 2) präsent sind, welche zueinander in Gegenphase sind, wobei sich jedes dieser magnetischen Wechselfelder entlang der Lötlinie über einen Abschnitt der Lötlinie erstreckt, dessen Länge der Hälfte der Länge der Stromsammelschiene beträgt. Die genannten Vorteile (gleichmässigere Verteilung der durch die jeweils induzierten sekundären Wechselströme erzeugten Heizleistung über die Solarzelle, Reduktion der gesamten Heizleistung der jeweils induzierten sekundären Wechselströme) sind sogar in gesteigertem Masse realisierbar mittels einer Induktionsantenne, welche - anstelle der beiden Wechselfelder H1 und H2, welche mittels der Induktionsantenne 10A erzeugbar sind - jeweils drei oder mehr als drei verschiedene magnetische Wechselfelder in einer Reihe von drei oder mehr als drei hintereinander angeordneten Abschnitten der Lötlinie L derart erzeugt, dass die magnetischen Wechselfelder in jeweils zwei der Abschnitte der Lötlinie L, welche in der Reihe unmittelbar hintereinander angeordnet sind, jeweils in Gegenphase zueinander sind. Eine derartige Induktionsantenne kann beispielsweise derart ausgelegt sein, dass sie n (mit n>2) verschiedene magnetische Wechselfelder in n verschiedenen Abschnitten der Lötlinie erzeugt, wobei beispielsweise jeder dieser Abschnitte der Lötlinie eine Länge aufweisen kann, welche lediglich das 1/n-fache der Länge der Stromsammelschiene 3 beträgt. Die magnetischen Wechselfelder dieser Induktionsantenne induzieren - anstelle der beiden sekundären elektrischen Wechselströme IS1 und IS2, welche mittels der Induktionsantenne 10A in der Solarzelle induzierbar sind - insgesamt n verschiedene sekundäre elektrische Wechselströme, wobei jeder dieser sekundären elektrischen Wechselströme auf einen Bereich der Solarzelle beschränkt ist, welcher sich lediglich entlang eines der Abschnitte der Lötlinie L erstreckt, in welchem eines der magnetischen Wechselfelder präsent ist. Die von den induzierten sekundären Wechselströmen erzeugte Heizleistung ist folglich umso gleichmässiger über die Solarzelle verteilt, je grösser die Anzahl n der magnetischen Wechselfelder und je kürzer folglich die Länge der jeweiligen Abschnitte der Lötlinie sind. Entsprechend ist eine Reduktion der gesamten Heizleistung der jeweils induzierten sekundären Wechselströme realisierbar, welche umso grösser ist, je grösser die Anzahl n der magnetischen Wechselfelder bzw. je kürzer die Länge der jeweiligen Abschnitte der Lötlinie ist.

Fig. 3 zeigt eine perspektivische Ansicht einer erfindungsgemässen Lötvorrichtung 15 in Kombination mit drei Solarzellen 1, welche in einer Reihe hintereinander angeordnet sind und jeweils an einer auf der Vorderseite der Solarzelle ausgebildeten Oberfläche 1-1 drei Stromsammelschienen 3 aufweisen. Diese Lötvorrichtung 15 hat die Aufgabe, jeweils zwei der Solarzellen 1 mittels eines der dargestellten Bänder 5 zu verbinden. Zu diesem Zweck ist ein Abschnitt des jeweiligen Bandes 5 an eine Oberfläche 1-2 auf der Rückseite der einen der miteinander zu verbindenden Solarzellen 1 zu löten und ein anderer Abschnitt des Bandes 5 an eine der Stromsammelschienen 3 an der Oberfläche 1-1 der anderen der miteinander zu verbindenden Solarzellen 1 zu löten. In Fig. 1 ist jede der Stromsammelschienen 3 der mittleren und der rechten der in der Figur dargestellten Solarzellen 1 jeweils mit einem der Bänder 5 bedeckt und deshalb nicht sichtbar. Die Lötvorrichtung 15 umfasst im vorliegenden Beispiel mehrere Niederhalter N zum Niederhalten eines Bandes 5 an einer Oberfläche einer der Stromsammelschienen 3 und eine Induktionsantenne 20 zum Erzeugen von magnetischen Wechselfeldern. Die Induktionsantenne 20 ist dabei (mit einer nicht dargestellten Vorrichtung) relativ zu den Solarzellen 1 bewegbar, um eine geeignete Positionierung der Induktionsantenne 20 zu ermöglichen. Jeder der Niederhalter N umfasst im vorliegenden Beispiel ein Niederhalterelement P in Form eines sich senkrecht zur Oberfläche 1-1 der Solarzelle 1 erstreckenden Stifts und eine Masse M, wobei die Masse M dazu dient, das Niederhalterelement P zu beschweren und somit eine senkrecht zur Oberfläche 1-1 gerichtete Kraft auf das Niederhalterelement P auszuüben.

Die Induktionsantenne 20 der Lötvorrichtung 15 gemäss Fig. 3 kann erfindungsgemäss in einer Vielzahl von Varianten realisiert werden. Mit Bezug auf Fig. 4-47 sollen deshalb im Folgenden zumindest sechs verschiedene Ausführungsformen der Lötvorrichtung 15 erläutert werden, welche sich insbesondere dadurch unterscheiden, dass sie jeweils verschiedene Induktionsantennen umfassen, welche erfindungsgemäss ausgebildet sind und als mögliche Realisierungen bzw. Varianten der Induktionsantenne 20 gemäss Fig. 3 betrachtet werden können. Die verschiedenen Ausführungsformen der Lötvorrichtung 15 können dabei - abhängig von der Konstruktion der Induktionsantenne - auch verschiedene Ausführungsformen von Niederhalterelementen umfassen (anstelle der Niederhalter N bzw. der Niederhalterelemente P gemäss Fig. 3). Die in den Fig. 4-47 offenbarten Induktionsantennen werden im Folgenden mit 20A, 20B, 20C, 20D, 20E bzw. 20F bezeichnet.

Die Induktionsantennen 20A-20F sind (im Sinne von Beispielen) jeweils dazu ausgebildet, magnetische Wechselfelder in einer Reihe von mehr als zwei hintereinander angeordneten Abschnitten der Lötlinie derart zu erzeugen, dass die magnetischen Wechselfelder in jeweils zwei der in der Reihe unmittelbar hintereinander angeordneten Abschnitten der Lötlinie L jeweils in Gegenphase zueinander sind.

Fig. 4-17 stellen die Lötvorrichtung 15 (in einer ersten Variante) mit einer Induktionsantenne 20A dar.

Fig. 4 zeigt die Lötvorrichtung 15 einschliesslich der Induktionsantenne 20A und elf Niederhalterelementen P1-P11 in Kombination mit einer Solarzelle 1, wobei eine an der Oberfläche 1-1 der Solarzelle 1 angeordnete Stromsammelschiene 3 mit einem Band 5 in Kontakt gebracht ist, welches sich in der Längsrichtung der Stromsammelschiene 3 erstreckt. In Fig. 4 ist weiterhin die Lötlinie L in Form einer mathematischen Geraden angegeben. Wie ersichtlich, erstreckt sich die Lötlinie L an einer dem Band 5 zugewandten Oberfläche der Stromsammelschiene 3 in Längsrichtung der Stromsammelschiene 3. Zusätzlich ist in Fig. 4 eine Lötebene LE angegeben, d.h. eine Ebene, welche sich im Wesentlichen senkrecht zur Oberfläche 1-1 der Solarzelle 1 erstreckt und in welcher die Lötlinie L liegt. Die Niederhalterelemente P1-P11 sind entlang der Lötlinie L in einer Reihe hintereinander angeordnet und erstrecken sich im vorliegenden Bespiel in der Lötebene LE im Wesentlichen senkrecht zur Lötlinie L. Dabei sind die Niederhalterelemente P1-P11 jeweils als länglichen (beispielsweise zylindrische) Stifte ausgebildet und jeweils im Wesentlichen senkrecht zur Oberfläche 1-1 der Solarzelle 1 bewegbar, um ein Niederhalten des Bandes 5 auf einer Oberfläche der Stromsammelschiene 3 zu ermöglichen.

Die Stromsammelschiene 3 und das Band 5 kann beispielsweise eine Breite (parallel zur Oberfläche 1-1 der Solarzelle 1) von 1-3 mm haben. Die Niederhalterelemente P1-P11 können beispielsweise einen Durchmesser von 3 mm aufweisen und entlang der Lötlinie L derart in einer Reihe hintereinander angeordnet sein, dass der Abstand von zwei der Niederhalterelemente P1-P11, welche in der Reihe unmittelbar hintereinander angeordnet sind, beispielsweise 8-24 mm beträgt.

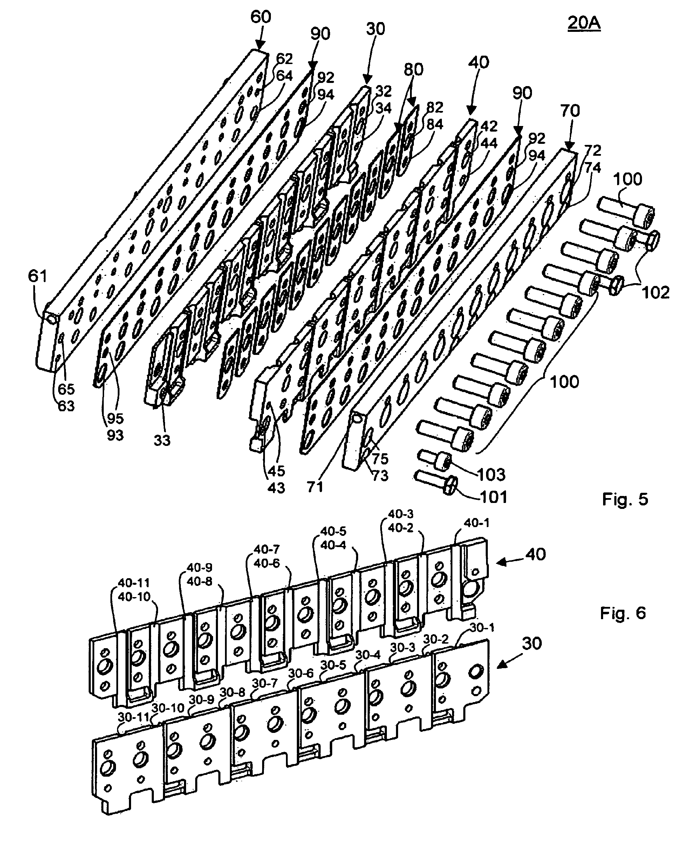

Wie Fig. 4 weiterhin andeutet, umfasst die Induktionsantenne 20A einen sich entlang der Lötlinie L erstreckenden Strompfad 21A für einen elektrischen Wechselstrom I, wobei der elektrische Wechselstrom I entlang des Strompfads 21A derart geführt ist, dass er in der Lötlinie L und/oder in einer Umgebung der Lötlinie L ein magnetisches Wechselfeld erzeugt. Im vorliegenden Beispiel ist der Strompfad 21A jeweils abschnittsweise in einem ersten elektrisch leitfähigen Festkörper 30 und in einem zweiten elektrisch leitfähigen Festkörper 40 ausgebildet (was im Folgenden im Zusammenhang mit Fig. 5-10 und 14-15 näher erläutert wird), wobei sich die Festkörper 30 und 40 - von der Lötlinie L durch einen Luftspalt LS getrennt - entlang der Lötlinie L erstrecken und einzelne Abschnitte der Festkörper 30 und 40 den elektrischen Wechselstrom I entlang der Lötlinie L führen. Demnach bilden die Festkörper 30 und 40 (und entsprechend einzelne Abschnitte der Festkörper 30 und 40) jeweils verschiedene Abschnitte des Strompfads 21A.

Zur Erzeugung des elektrischen Wechselstroms I ist gemäss Fig. 4 ein Generator 9 vorgesehen (entsprechend Generator 9 gemäss Fig. 1 und 2). Der vom Generator 9 erzeugte (hochfrequente) elektrische Wechselstrom I ist dabei über zwei (in Fig. 4 mit den Bezugszeichen 110 bzw. 112 gekennzeichnete) elektrische Anschlüsse in den Strompfad 21A (bzw. in die Festkörper 30 und 40) einkoppelbar bzw. aus dem Strompfad 21A (bzw. aus den Festkörpern 30 und 40) auskoppelbar. In Fig. 4 geben mit dem Bezugszeichen I versehene Pfeile jeweils die momentane Stromflussrichtung des elektrischen Wechselstroms I für einen bestimmten (beliebig ausgewählten) Zeitpunkt dar. In der Darstellung gemäss Fig. 4 hat der mit dem Bezugszeichen 110 bezeichnete elektrische Anschluss momentan die Funktion eines "Stromeinkopplungselements", welches den Strom in Richtung der angegebenen Stromflussrichtung in den Strompfad 21A einkoppelt. Entsprechend hat in der Darstellung gemäss Fig. 4 der mit dem Bezugszeichen 112 bezeichnete elektrische Anschluss momentan die Funktion eines "Stromauskopplungselements", welches den Strom in Richtung der angegebenen Stromflussrichtung aus dem Strompfad 21A auskoppelt. Da die Stromflussrichtung, welche der Wechselstrom I momentan in bestimmten Abschnitten des Strompfads 21A aufweist, im Hinblick auf die Richtung der vom elektrischen Wechselstrom I erzeugten magnetischen Wechselfelder relevant ist, sollen im Folgenden der Übersichtlichkeit halber die Bezeichnungen "Stromeinkopplungselement 110" bzw. "Stromauskopplungselement 112" verwendet werden, entsprechend den in Fig. 4-17 dargestellten momentanen Stromflussrichtungen des Wechselstroms I in den mit 110 bzw. 112 bezeichneten Anschlüssen (obwohl sich die momentane Stromflussrichtung des Wechselstroms I als Funktion der Zeit periodisch umkehrt, sodass zu einem anderen Zeitpunkt der mit 110 bezeichnete Anschluss die Funktion eines "Stromauskopplungselements" und der mit 112 bezeichneten Anschluss die Funktion eines "Stromeinkopplungselements" übernehmen kann).

Wie Fig. 4 weiterhin andeutet, kann die Lötvorrichtung 15 eine (optionale) Kühleinrichtung zur Kühlung der elektrisch leitfähigen Festkörper 30 und 40 umfassen: In Fig. 4 ist ein erster Kühlkörper 60 und ein zweiter Kühlkörper 70 dargestellt. Der erste Kühlkörper 60 und der zweite Kühlkörper 70 erstrecken sich - in einem Abstand zueinander - jeweils in der Längsrichtung der Lötlinie L, wobei die Festkörper 30 und 40 zwischen diesen Kühlkörpern 50 und 70 derart angeordnet ist, dass einzelne Bereiche der Festkörper 30 und 40 mit einem der Kühlkörper 60 bzw. 70 in thermischem Kontakt stehen. Weitere Einzelheiten zur (optionalen) Kühleinrichtung werden im Folgenden noch erläutert.

Gemäss Fig. 4 sind in der Induktionsantenne 20A insgesamt elf (durchgehende) Kanäle K1-K11 ausgebildet, welche sich in der Lötebenen LE jeweils im Wesentlichen vertikal zur Lötlinie L erstrecken, wobei in jedem der Kanäle K1-K11 eines der Niederhalterelemente P1-P11 angeordnet ist, sodass jedes der Niederhalterelemente P1-P11 in einem der Kanäle K1-K11 geführt ist. Wie Fig. 4 weiterhin andeutet, sind die Niederhalterelemente P1-P11 entlang der Lötlinie L in einer Reihe derart hintereinander derart angeordnet, dass zwischen je zwei der Niederhaltelemente P1-P11, welche in der Reihe unmittelbar hintereinander angeordnet sind, ein Zwischenraum ausgebildet ist: Jeder dieser Zwischenräume ist in Fig. 4 durch einen (sich zwischen je zwei der Niederhaltelemente P1-P11 erstreckenden) Doppelpfeil und ein Bezugszeichen Z1, Z2, Z3, Z4, Z5, Z6, Z7, Z8, Z9 bzw. Z10 gekennzeichnet (demnach sind im vorliegenden Fall zehn verschiedene, entlang der Lötlinie L angeordnete Zwischenräume Z1-Z10 vorhanden).

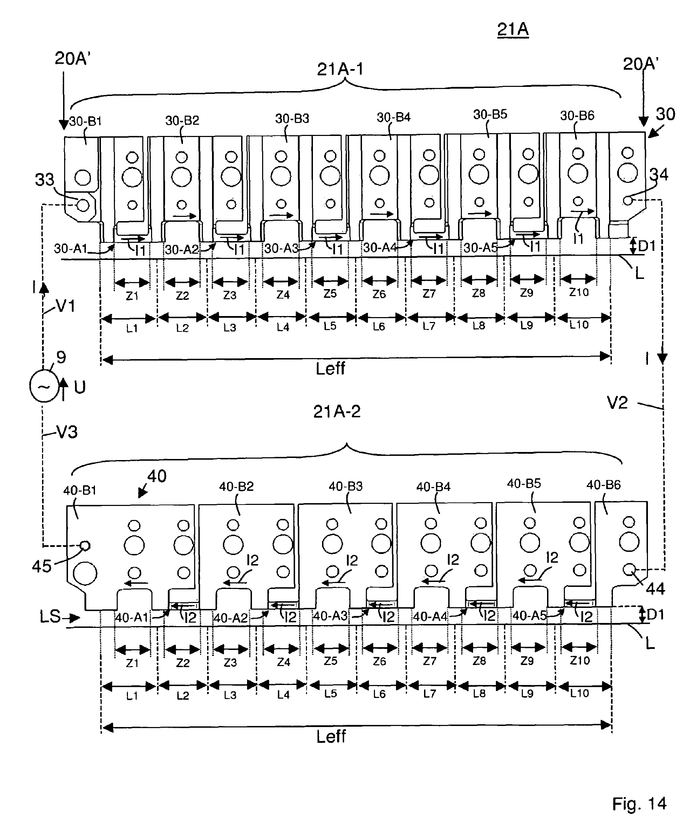

Jeder dieser Zwischenräume Z1, Z2, Z3, Z4, Z5, Z6, Z7, Z8, Z9 bzw. Z10 korrespondiert mit genau einem von insgesamt zehn Abschnitten der Lötlinie L, welche Abschnitte im Folgenden mit L1, L2, L3, L4, L5, L6, L7, L8, L9 bzw. L10 bezeichnet werden und in dieser Reihenfolge in einer Reihe aufeinander folgend angeordnet sind, wie in Fig. 14 dargestellt. Die Enden jedes der genannten Abschnitte L1-L10 der Lötlinie L sind im vorliegenden Fall durch Schnittpunkte der Längsachsen der Niederhalterelemente P1-P11 mit der Lötlinie L bestimmt: Das Niederhalterelement P1 ist beispielsweise an einem Ende des Abschnitts L1 der Lötlinie platziert und das Niederhalterelement P2 an dem anderen Ende des Abschnitts L1 platziert, sodass der Längsabschnitt L1 der Lötlinie L sich durch den Zwischenraum Z1, aber nicht durch die übrigen Zwischenräume Z2-Z10 erstreckt; entsprechend ist das Niederhalterelement P2 an einem Ende des Abschnitts L2 der Lötlinie platziert und das Niederhalterelement P3 an dem anderen Ende des Abschnitts L2 platziert, sodass der Längsabschnitt L2 der Lötlinie L sich durch den Zwischenraum Z2, aber nicht durch die übrigen Zwischenräume Z1 und Z3-Z10 erstreckt; jeder der übrigen Längsabschnitte L3-L10 erstreckt sich auf analoge Weise zwischen je zwei der Niederhalterelemente P3-P11, welche entlang der Lötlinie L unmittelbar hintereinander angeordnet sind, und erstreckt sich somit durch je einen der Zwischenräume Z3-Z10 (Fig. 4 und 14).

Der Wechselstrom I ist im Strompfad 21A der Induktionsantenne 20A derart entlang der Lötlinie L geführt, dass er in den verschiedenen Abschnitten L1-L10 der Lötlinie L bzw. in den Zwischenräumen Z1-Z10 magnetische Wechselfelder erzeugt, welche im Folgenden mit H1, H2, H3, H4, H5, H6, H7, H8, H9 bzw. H10 bezeichnet werden: Dabei bezeichnet der Ausdruck "Hi" (mit i=1-10) das magnetische Wechselfeld, welches im Abschnitt "Li" der Lötlinie L bzw. im Zwischenraum "Zi" (jeweils mit i=1-10) präsent ist.

In Fig. 4 stellen die mit H1, H2, H3, H4, H5, H6, H7, H8, H9 bzw. H10 bezeichneten Pfeile jeweils die Richtung der Feldstärke der magnetischen Wechselfelder H1, H2, H3, H4, H5, H6, H7, H8, H9 bzw. H10 in den verschiedenen Abschnitten L1-L10 der Lötlinie L dar (jeweils für einen Ort in der Lötlinie und jeweils für die angegebene momentane Stromflussrichtung des Wechselstroms I). Wie ersichtlich, ist jedes der magnetischen Wechselfelder H1-H10 in der Lötlinie L jeweils im Wesentlichen senkrecht zur Lötebene LE und senkrecht zur Lötlinie L gerichtet. Dabei weisen die magnetischen Wechselfelder H1, H3, H5, H7 und H9 in den Abschnitten L1, L3, L5, L7 und L9 jeweils dieselbe Richtung auf und sind somit miteinander in Gleichphase. Hingegen sind die magnetischen Wechselfelder H2, H4, H6, H8 und H10 in den Abschnitten L2, L4, L6, L8 und L10 entgegengesetzt zu den magnetischen Wechselfeldern H1, H3, H5, H7 und H9 gerichtet, sodass die magnetischen Wechselfelder H1, H3, H5, H7 und H9 in den Abschnitten L1, L3, L5, L7 und L9 jeweils in Gegenphase zu den magnetischen Wechselfelder H2, H4, H6, H8 und H10 in den Abschnitten L2, L4, L6, L8 und L10 sind.

Mit Bezug auf Fig. 5-15 werden im Folgenden konstruktive Einzelheiten des Strompfads 21A der Induktionsantenne 20A erläutert.

Fig. 5 zeigt einzelne Komponenten der Induktionsantenne 20A gemäss Fig. 4 in einer Explosionsdarstellung, wobei die jeweiligen Komponenten in einer zur Lötebene LE senkrechten Richtung voneinander separiert sind. Wie ersichtlich, umfasst die Induktionsantenne 20A zusätzlich zu dem ersten elektrisch leitfähigen Festkörper 30, dem zweiten elektrisch leitfähigen Festkörper 40, dem ersten Kühlkörper 60 und dem zweiten Kühlkörper 70 u.a. zwei Isolationskörper 90, welche aus einem elektrisch isolierenden Material gefertigt sind. Einer dieser Isolationskörper 90 ist zwischen dem ersten Kühlkörper 60 und dem elektrisch leitfähigen Festkörper 30 angeordnet, um eine elektrische Isolierung zwischen dem ersten Kühlkörper 60 und dem elektrisch leitfähigen Festkörper 30 zu bewirken. Der andere dieser Isolationskörper 90 ist zwischen dem zweiten Kühlkörper 70 und dem elektrisch leitfähigen Festkörper 40 angeordnet, um eine elektrische Isolierung zwischen dem zweiten Kühlkörper 70 und dem elektrisch leitfähigen Festkörper 40 zu bewirken. Wie weiterhin aus Fig. 5 ersichtlich ist, umfasst die Induktionsantenne 20A gemäss Fig. 4 ausserdem mehrere Isolationskörper 80, welche (entlang der Lötlinie L verteilt) zwischen den elektrisch leitfähigen Festkörper 30 und 40 angeordnet sind, um eine elektrische Isolierung zwischen diesen Festkörpern 30 und 40 zu erzielen.

Wie weiterhin aus Fig. 5 ersichtlich ist, umfasst die Induktionsantenne 20A gemäss Fig. 4 Befestigungsmittel 100, welche dazu dienen, die elektrisch leitfähigen Festkörper 30 und 40, den ersten Kühlkörper 60, den zweiten Kühlkörper 70 und die Isolationskörper 80 und 90 mechanisch miteinander zu verbinden und derart zusammenzuhalten, dass die Induktionsantenne 20A eine Einheit bildet, welche als Ganzes in einer vorgegebenen Position bezüglich der Lötlinie L gehalten werden kann. Weiterhin umfasst die Induktionsantenne 20A ein (erstes) Kurzschlusselement 101, welches dazu dient, eine elektrische Verbindung zwischen dem ersten Kühlkörper 60 bzw. dem Stromeinkopplungselement 110 und dem Festkörper 30 herzustellen. Weiterhin umfasst die Induktionsantenne 20A ein oder mehrere (zweite) Kurzschlusselemente 102, welche dazu dienen, eine elektrische Verbindung zwischen dem Festkörper 30 und dem Festkörper 40 herzustellen. Zusätzlich umfasst die Induktionsantenne 20A mindestens ein (drittes) Kurzschlusselement 103, welches dazu dient, eine elektrische Verbindung zwischen dem zweiten Kühlkörper 70 bzw. dem Stromauskopplungselement 112 und dem Festkörper 40 herzustellen.

Die Befestigungsmittel 100 und die Kurzschlusselemente 101, 102 und 103 sind im vorliegenden Beispiel als Schrauben ausgeführt. Selbstverständlich können die Befestigungsmittel 100 und Kurzschlusselemente 101, 102 und 103 jeweils durch andere, hinsichtlich ihrer Funktion ebenfalls geeignete Mittel (z.B. Nieten) ersetzt werden. Um die Befestigungsmittel 100 bei einer Montage der Induktionsantenne 20A geeignet platzieren zu können, weisen der erste Kühlkörper 60, der zweite Kühlkörper 70, der Festkörper 30, der Festkörper 40 und die Isolationskörper 80 und 90 entsprechend angeordnete Bohrungen auf, in welche die jeweiligen Befestigungsmittel 100 einsetzbar sind (in Fig. 5 sind derartige Bohrungen mit den Bezugszeichen 32, 42, 62, 72, 82 bzw. 92 gekennzeichnet). Entsprechend weisen der erste Kühlkörper 60, der zweite Kühlkörper 70, der Festkörper 30, der Festkörper 40 und die Isolationskörper 80 und 90 geeignet angeordnete Bohrungen auf, in welche die Kurzschlusselemente 101, 102 und 103 eingesetzt werden können, um die erwähnten elektrischen Verbindungen herstellen zu können (in Fig. 5 sind derartige Bohrungen für das Kurzschlusselement 101 mit dem Bezugszeichen 33, 43, 63, 73bzw. 93, Bohrungen für das Kurzschlusselement 102 mit dem Bezugszeichen 34, 44, 64, 74, 84 bzw. 94 und Bohrungen für das Kurzschlusselement 103 mit dem Bezugszeichen 35, 45, 65, 75, 85 bzw. 95 bezeichnet).

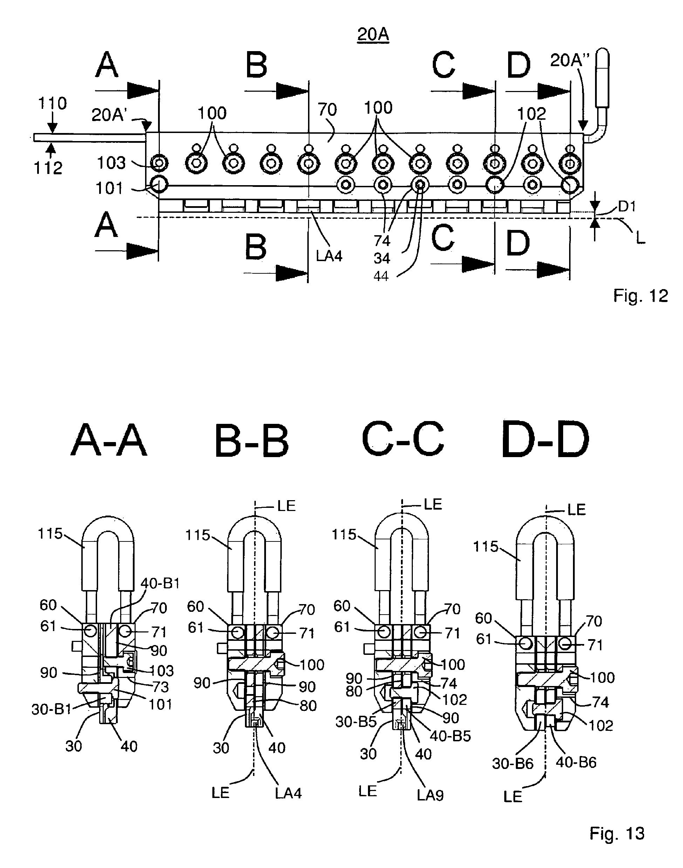

Wenn alle in Fig. 5 sichtbaren Teile der Induktionsantenne 20A derart zusammengefügt sind, dass sie eine (betriebsbereite) Induktionsantenne 20A in der in Fig. 4 dargestellten Form bilden, dann sorgen die Kurzschlusselemente 101, 102 und 103 dafür, dass eine durchgehende elektrische Verbindung für den Wechselstrom I zwischen dem Stromeinkopplungselement 110 und dem Stromauskopplungselement 112 über den (ersten elektrisch leitfähigen) Festkörper 30 und den (zweiten elektrisch leitfähigen) Festkörper 40 besteht, wobei jeweils Abschnitte der Festkörper 30 und 40 elektrisch in Reihe geschaltet sind. Die Kurzschlusselemente 101, 102 und 103 sind demnach als Bestandteile des Strompfads 21A zu betrachten. Letzteres wird im Zusammenhang mit Fig. 12-15 noch näher erläutert.

Fig. 6 zeigt den (ersten elektrisch leitfähigen) Festkörper 30 und den (zweiten elektrisch leitfähigen) Festkörper 40 der Induktionsantenne 20A jeweils separat (aus einer anderen Perspektive als in Fig. 5). Wie ersichtlich, weist der Festkörper 30 insgesamt elf längliche, in einer Reihe hintereinander angeordnete und sich parallel zueinander erstreckende Ausnehmungen 30-1, 30-2, 30-3, 30-4, 30-5, 30-6, 30-7, 30-8, 30-9, 30-10, 30-11 auf. Entsprechend weist der Festkörper 40 insgesamt elf längliche, in einer Reihe hintereinander angeordnete und sich parallel zueinander erstreckende Ausnehmungen 40-1, 40-2, 40-3, 40-4, 40-5, 40-6, 40-7, 40-8, 40-9, 40-10, 40-11 auf. Wenn die Festkörper 30 und 40 der Induktionsantenne 20A derart angeordnet sind, dass sie sich relativ zueinander und relativ zu den Niederhalterelementen P1-P11 in der in Fig. 4 dargestellten Anordnung befinden, dann bilden jeweils eine der im Festkörper 30 ausgebildeten Ausnehmungen 30-1, 30-2, 30-3, 30-4, 30-5, 30-6, 30-7, 30-8, 30-9, 30-10, 30-11 zusammen mit einer der im Festkörper 40 ausgebildeten Ausnehmungen 40-1, 40-2, 40-3, 40-4, 40-5, 40-6, 40-7, 40-8, 40-9, 40-10, 40-11 jeweils einen der Kanäle K1-K11. Wie ein Vergleich zwischen Fig. 4 und 6 offenbart, bilden beispielsweise die Ausnehmungen 30-1 und 40-1 den Kanal K1 für das Niederhalterelement P1 und die Ausnehmungen 30-i und 40-i den Kanal Ki für das Niederhalterelement Pi, wobei i=2-11.

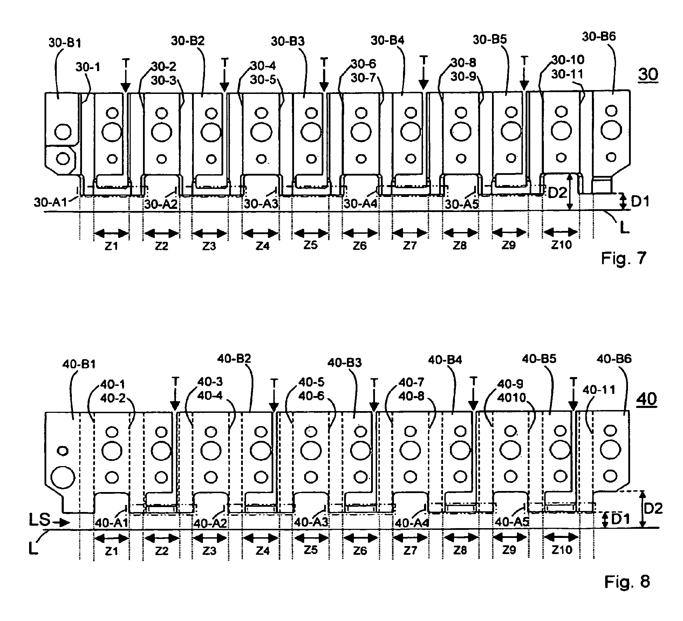

Fig. 7 und 8 stellen die Festkörper 30 und 40 separat jeweils in einer Anordnung relativ zur Lötlinie L dar, welche mit der Anordnung der Festkörper 30 und 40 gemäss Fig. 4 identisch ist. Dabei zeigt Fig. 7 den Festkörper 30 in einer Seitenansicht (mit Blickrichtung senkrecht zur Lötebene LE gemäss Fig. 4) und Fig. 8 den Festkörper 40 in einer Seitenansicht (mit Blickrichtung senkrecht zur Lötebene LE gemäss Fig. 4). Wie aus Fig. 7 und 8 ersichtlich, erstrecken sich die Festkörper 30 und 40 im Wesentlichen parallel zur Lötlinie L und sind von der Lötlinie L jeweils durch einen Luftspalt LS getrennt. Um einen Vergleich zwischen der Anordnung des Festkörpers 30 gemäss Fig. 7 und der Anordnung des Festkörpers 40 gemäss Fig. 8 zu ermöglichen, sind sowohl in Fig. 7 als auch in Fig. 8 jeweils die räumlichen Lagen der jeweiligen Zwischenräume Z1-Z11 (wie in Fig. 4 definiert) markiert, sodass aus Fig. 7 und 8 die relative Anordnung der Festkörper 30 und 40 bezüglich der Niederhalterelemente P1-P11 und der Abschnitte L1-L10 der Lötlinie (wie in Fig. 14 definiert) entnehmbar ist.

Die Festkörper 30 und 40 haben die Funktion, den Wechselstrom I entlang der Lötlinie L durch die verschiedenen Zwischenräume Z1-Z10 in einem Abstand zur Lötlinie L zu führen, welcher entlang der Lötlinie L variiert.

Wie Fig. 7 andeutet, kann der Festkörper 30 als eine lineare Anordnung von elf verschiedenen, miteinander verbundenen Abschnitten betrachtet werden, welche entlang der Lötlinie L in einer Reihe hintereinander angeordnet sind und sich durch verschiedene Zwischenräume Z1-Z10 in unterschiedlichen Abständen D1 bzw. D2 (mit D2>D1) bezüglich der Lötlinie L erstrecken.

Im Folgenden sollen zwei verschiedene Gruppen von Abschnitten des Festkörpers 30 unterschieden werden, welche sich hinsichtlich ihres Abstands zur Lötlinie L und ihrer Funktion unterscheiden: eine "erste Gruppe" von Abschnitten des Festkörpers 30 umfasst fünf Abschnitte, welche in Fig. 7 mit 30-A1, 30-A2, 30-A3, 30-A4 bzw. 30-A5 bezeichnet sind; eine "zweite Gruppe" von Abschnitten des Festkörpers 30 umfasst sechs Abschnitte, welche in Fig. 7 mit 30-B1, 30-B2, 30-B3, 30-B4, 30-B5 und 30-B6 bezeichnet sind.

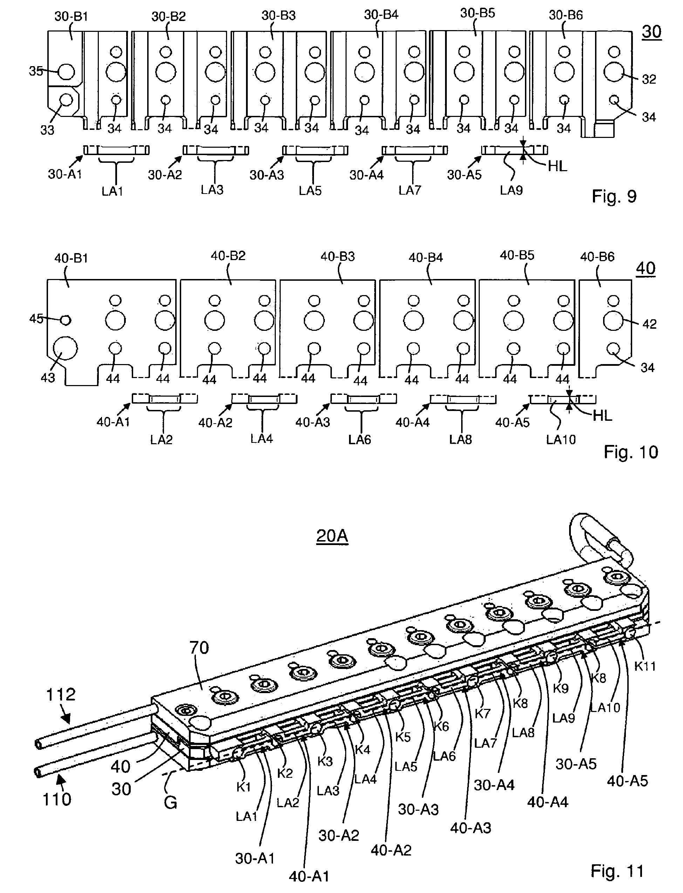

Um zu kennzeichnen, welche Bereiche des Festkörpers 30 in diesem Zusammenhang als einer der genannten Abschnitte zu verstehen sein sollen, ist in Fig. 7 jeder der Abschnitte 30-A1, 30-A2, 30-A3, 30-A4 und 30-A5 mit einem aus einer unterbrochenen Linie gebildeten Rechteck umrahmt (zur Abgrenzung der Abschnitte 30-A1, 30-A2, 30-A3, 30-A4 und 30-A5 von den übrigen Abschnitten des Festkörpers 30). Dabei sollen die Schnittlinien zwischen den in Fig. 7 dargestellten Rechtecken und dem Festkörper 30 jeweils virtuelle Grenzen zwischen den jeweiligen Abschnitten des Festkörpers 30 kennzeichnen. Zur Verdeutlichung zeigt Fig. 9 eine Darstellung des Festkörpers 30, in welcher die Abschnitte 30-A1, 30-A2, 30-A3, 30-A4 und 30-A5 von den Abschnitten 30-B1, 30-B2, 30-B3, 30-B4, 30-B5 und 30-B6 getrennt (jeweils entlang der in Fig. 9 angegebenen gestrichelten Linien) und gegenüber den Abschnitten 30-B1, 30-B2, 30-B3, 30-B4, 30-B5 und 30-B6 in Richtung der Lötlinie L verschoben sind (verglichen mit der Darstellung des Festkörpers 30 in Fig. 7).

Wie aus Fig. 7 und 9 ersichtlich, sind die verschiedenen Abschnitte des Festkörpers 30 entlang der Lötlinie L in einer Reihe derart hintereinander angeordnet, dass in einer vorgegebenen Richtung entlang der Lötlinie L jeweils abwechselnd ein Abschnitt, welcher zur ersten Gruppe der Abschnitte des Festkörpers 30 gehört, und ein Abschnitt, welcher zur zweiten Gruppe der Abschnitte des Festkörpers 30 gehört, aufeinander folgen.

Dabei unterscheiden sich die zur ersten Gruppe gehörenden Abschnitte 30-A1, 30-A2, 30-A3, 30-A4 und 30-A5 von den zur zweiten Gruppe gehörenden Abschnitte 30-B1, 30-B2, 30-B3, 30-B4, 30-B5 und 30-B6 hinsichtlich ihres Abstandes von der Lötlinie L und hinsichtlich ihrer Funktion.

Die Abschnitte 30-A1, 30-A2, 30-A3, 30-A4 und 30-A5 des Festkörpers 30 haben im vorliegenden Beispiel jeweils eine längliche Form und erstrecken sich jeweils im Wesentlichen parallel zur Lötlinie L, im vorliegenden Beispiel jeweils in einem Abstand D1 bezüglich der Lötlinie L. In der Induktionsantenne 20A gemäss Fig. 4 ist der Festkörper 30 derart angeordnet, dass die Abschnitte 30-A1, 30-A2, 30-A3, 30-A4 und 30-A5 in der Lötebene LE liegen. Wie im Folgenden noch deutlich wird, haben die Abschnitte 30-A1, 30-A2, 30-A3, 30-A4 und 30-A5 die Funktion, den Wechselstrom I entlang der Lötlinie derart zu führen, dass der Wechselstrom I in der Umgebung dieser Abschnitte bzw. in der Lötlinie L die magnetischen Wechselfelder H1, H3, H5, H7 und H9 erzeugt. Wegen dieser Funktion sollen die Abschnitte 30-A1, 30-A2, 30-A3, 30-A4 und 30-A5 im Folgenden auch als "wechselfelderzeugende" Abschnitte des Festkörpers 30 bzw. des Strompfads 21A bezeichnet werden.

Dabei ist der Abschnitt 30-A1 im Zwischenraum Z1 angeordnet, wobei sich die beiden Enden des Abschnitts 30-A1 so weit über den Zwischenraum Z1 hinaus erstrecken, dass sich die Ausnehmung 30-1 durch eines der beiden Enden und die Ausnehmung 30-2 durch das andere der beiden Enden erstreckt.

Der Abschnitt 30-A2 ist im Zwischenraum Z3 angeordnet, wobei sich die beiden Enden des Abschnitts 30-A2 so weit über den Zwischenraum Z3 hinaus erstrecken, dass sich die Ausnehmung 30-3 durch eines der beiden Enden und die Ausnehmung 30-4 durch das andere der beiden Enden erstreckt.

Der Abschnitt 30-A3 ist im Zwischenraum Z5 angeordnet, wobei sich die beiden Enden des Abschnitts 30-A3 so weit über den Zwischenraum Z5 hinaus erstrecken, dass sich die Ausnehmung 30-5 durch eines der beiden Enden und die Ausnehmung 30-6 durch das andere der beiden Enden erstreckt.

Der Abschnitt 30-A4 ist im Zwischenraum Z7 angeordnet, wobei sich die beiden Enden des Abschnitts 30-A4 so weit über den Zwischenraum Z7 hinaus erstrecken, dass sich die Ausnehmung 30-7 durch eines der beiden Enden und die Ausnehmung 30-8 durch das andere der beiden Enden erstreckt.

Der Abschnitt 30-A5 ist im Zwischenraum Z9 angeordnet, wobei sich die beiden Enden des Abschnitts 30-A5 so weit über den Zwischenraum Z9 hinaus erstrecken, dass sich die Ausnehmung 30-9 durch eines der beiden Enden und die Ausnehmung 30-10 durch das andere der beiden Enden erstreckt.

Wie Fig. 7 weiter andeutet, sind die Abschnitte 30-B1, 30-B2, 30-B3, 30-B4, 30-B5 und 30-B6 in einer Reihe derart hintereinander entlang der Lötlinie L angeordnet, dass jeweils zwei dieser Abschnitte, welche in der Reihe unmittelbar hintereinander angeordnet sind, durch einen sich vertikal zur Lötlinie L erstreckenden Spalt T separiert sind, um eine elektrische Isolation zwischen diesen Abschnitten zu erreichen.

Andererseits sind jeweils zwei der Abschnitte 30-B1, 30-B2, 30-B3, 30-B4, 30-B5 an einer der Lötlinie L zugewandten Seite über einen der Abschnitte 30-A1, 30-A2, 30-A3, 30-A4 und 30-A5 miteinander verbunden. Wie aus Fig. 7 ersichtlich, ist der Abschnitt 30-A1 an einem seiner beiden Enden mit dem Abschnitt 30-B1 und an dem anderen seiner beiden Enden mit dem Abschnitt 30-B2 verbunden. Weiterhin ist der Abschnitt 30-A2 an einem seiner beiden Enden mit dem Abschnitt 30-B2 und an dem anderen seiner beiden Enden mit dem Abschnitt 30-B3 verbunden. Weiterhin ist der Abschnitt 30-A3 an einem seiner beiden Enden mit dem Abschnitt 30-B3 und an dem anderen seiner beiden Enden mit dem Abschnitt 30-B4 verbunden. Weiterhin ist der Abschnitt 30-A4 an einem seiner beiden Enden mit dem Abschnitt 30-B4 und an dem anderen seiner beiden Enden mit dem Abschnitt 30-B5 verbunden. Weiterhin ist der Abschnitt 30-A5 an einem seiner beiden Enden mit dem Abschnitt 30-B5 und an dem anderen seiner beiden Enden mit dem Abschnitt 30-B6 verbunden. Auf diese Weise ist gewährleistet, dass die Abschnitte 30-A1, 30-A2, 30-A3, 30-A4 und 30-A5 derart verbunden sind, dass sie in dieser Reihefolge elektrisch in Reihe geschaltet sind.

Wie Fig. 8 andeutet, kann der Festkörper 40 (wie der Festkörper 30) ebenfalls als eine lineare Anordnung von elf verschiedenen, miteinander verbundenen Abschnitten betrachtet werden, welche entlang der Lötlinie L in einer Reihe hintereinander angeordnet sind und sich durch verschiedene Zwischenräume Z1-Z10 in unterschiedlichen Abständen D1 bzw. D2 (mit D2>D1) bezüglich der Lötlinie L erstrecken.

Im Folgenden sollen zwei verschiedenen Gruppen von Abschnitten des Festkörpers 40 unterschieden werden, welche sich hinsichtlich ihres Abstands zur Lötlinie L und ihrer Funktion unterscheiden: eine "erste Gruppe" von Abschnitten des Festkörpers 40 umfasst fünf Abschnitte, welche in Fig. 8 mit 40-A1, 40-A2, 40-A3, 40-A4 bzw. 40-A5 bezeichnet sind; eine "zweite Gruppe" von Abschnitten des Festkörpers 40 umfasst sechs Abschnitte, welche in Fig. 8 mit 40-B1, 40-B2, 40-B3, 40-B4, 40-B5 und 40-B6 bezeichnet sind.

Um zu kennzeichnen, welche Bereiche des Festkörpers 40 in diesem Zusammenhang als einer der genannten Abschnitte zu verstehen sein sollen, ist in Fig. 8 jeder der Abschnitte 40-A1, 40-A2, 40-A3, 40-A4 und 40-A5 mit einem aus einer unterbrochenen Linie gebildeten Rechteck umrahmt (zur Abgrenzung der Abschnitte 40-A1, 40-A2, 40-A3, 40-A4 und 40-A5 von den übrigen Abschnitten des Festkörpers 40). Dabei sollen die Schnittlinien zwischen den in Fig. 8 dargestellten Rechtecken und dem Festkörper 40 jeweils virtuelle Grenzen zwischen den jeweiligen Abschnitten des Festkörpers 40 kennzeichnen. Zur Verdeutlichung zeigt Fig. 10 eine Darstellung des Festkörpers 40, in welcher die Abschnitte 40-A1, 40-A2, 40-A3, 40-A4 und 40-A5 von den Abschnitten 40-B1, 40-B2, 40-B3, 40-B4, 40-B5 und 40-B6 getrennt (jeweils entlang der in Fig. 10 angegebenen gestrichelten Linien) und gegenüber den Abschnitten 40-B1, 40-B2, 40-B3, 40-B4, 40-B5 und 40-B6 in Richtung der Lötlinie L verschoben sind (verglichen mit der Darstellung des Festkörpers 40 in Fig. 8).

Wie aus Fig. 8 und 10 ersichtlich, sind die verschiedenen Abschnitte des Festkörpers 40 entlang der Lötlinie L in einer Reihe derart hintereinander angeordnet, dass in einer vorgegebenen Richtung entlang der Lötlinie L jeweils abwechselnd ein Abschnitt, welcher zur ersten Gruppe der Abschnitte des Festkörpers 40 gehört, und ein Abschnitt, welcher zur zweiten Gruppe der Abschnitte des Festkörpers 40 gehört, aufeinander folgen.

Dabei unterscheiden sich die zur ersten Gruppe gehörenden Abschnitte 40-A1, 40-A2, 40-A3, 40-A4 und 40-A5 von den zur zweiten Gruppe gehörenden Abschnitte 40-B1, 40-B2, 40-B3, 40-B4, 40-B5 und 40-B6 hinsichtlich ihres Abstandes von der Lötlinie L und hinsichtlich ihrer Funktion.

Die Abschnitte 40-A1, 40-A2, 40-A3, 40-A4 und 40-A5 des Festkörpers 40 haben im vorliegenden Beispiel jeweils eine längliche Form und erstrecken sich jeweils im Wesentlichen parallel zur Lötlinie L, im vorliegenden Beispiel jeweils in einem Abstand D1 bezüglich der Lötlinie. In der Induktionsantenne 20A gemäss Fig. 4 ist der Festkörper 40 derart angeordnet, dass die Abschnitte 40-A1, 40-A2, 40-A3, 40-A4 und 40-A5 in der Lötebene LE liegen. Wie im Folgenden noch deutlich wird, haben die Abschnitte 40-A1, 40-A2, 40-A3, 40-A4 und 40-A5 die Funktion, den Wechselstrom I entlang der Lötlinie derart zu führen, dass der Wechselstrom I in der Umgebung dieser Abschnitte bzw. in der Lötlinie L die magnetischen Wechselfelder H2, H4, H6, H8 und H10 erzeugt. Wegen dieser Funktion sollen die Abschnitte 40-A1, 40-A2, 40-A3, 40-A4 und 40-A5 im Folgenden auch als "wechselfelderzeugende" Abschnitte des Festkörpers 40 bzw. des Strompfads 21A bezeichnet werden.

Dabei ist der Abschnitt 40-A1 im Zwischenraum Z2 angeordnet, wobei sich die beiden Enden des Abschnitts 40-A1 so weit über den Zwischenraum Z2 hinaus erstrecken, dass sich die Ausnehmung 40-2 durch eines der beiden Enden und die Ausnehmung 40-3 durch das andere der beiden Enden erstreckt.

Der Abschnitt 40-A2 ist im Zwischenraum Z4 angeordnet, wobei sich die beiden Enden des Abschnitts 40-A2 so weit über den Zwischenraum Z4 hinaus erstrecken, dass sich die Ausnehmung 40-4 durch eines der beiden Enden und die Ausnehmung 40-5 durch das andere der beiden Enden erstreckt.

Der Abschnitt 40-A3 ist im Zwischenraum Z6 angeordnet, wobei sich die beiden Enden des Abschnitts 40-A3 so weit über den Zwischenraum Z6 hinaus erstrecken, dass sich die Ausnehmung 40-6 durch eines der beiden Enden und die Ausnehmung 40-7 durch das andere der beiden Enden erstreckt.

Der Abschnitt 40-A4 ist im Zwischenraum Z8 angeordnet, wobei sich die beiden Enden des Abschnitts 40-A4 so weit über den Zwischenraum Z8 hinaus erstrecken, dass sich die Ausnehmung 40-8 durch eines der beiden Enden und die Ausnehmung 40-9 durch das andere der beiden Enden erstreckt.

Der Abschnitt 40-A5 ist im Zwischenraum Z10 angeordnet, wobei sich die beiden Enden des Abschnitts 40-A5 so weit über den Zwischenraum Z10 hinaus erstrecken, dass sich die Ausnehmung 40-10 durch eines der beiden Enden und die Ausnehmung 40-11 durch das andere der beiden Enden erstreckt.

Wie Fig. 8 weiter andeutet, sind die Abschnitte 40-B1, 40-B2, 40-B3, 40-B4, 40-B5 und 40-B6 in einer Reihe derart hintereinander entlang der Lötlinie L angeordnet, dass jeweils zwei dieser Abschnitte, welche in der Reihe unmittelbar hintereinander angeordnet sind, durch einen sich vertikal zur Lötlinie L erstreckenden Spalt T separiert sind, um eine elektrische Isolation zwischen diesen Abschnitten zu erreichen.

Andererseits sind jeweils zwei der Abschnitte 40-B1, 40-B2, 40-B3, 40-B4, 40-B5 und 40-B6 an einer der Lötlinie L zugewandten Seite über einen der Abschnitte 40-A1, 40-A2, 40-A3, 40-A4 und 40-A5 miteinander verbunden. Wie aus Fig. 8 ersichtlich, ist der Abschnitt 40-A1 an einem seiner beiden Enden mit dem Abschnitt 40-B1 und an dem anderen seiner beiden Enden mit dem Abschnitt 40-B2 verbunden. Weiterhin ist der Abschnitt 40-A2 an einem seiner beiden Enden mit dem Abschnitt 40-B2 und an dem anderen seiner beiden Enden mit dem Abschnitt 40-B3 verbunden. Weiterhin ist der Abschnitt 40-A3 an einem seiner beiden Enden mit dem Abschnitt 40-B3 und an dem anderen seiner beiden Enden mit dem Abschnitt 40-B4 verbunden. Weiterhin ist der Abschnitt 40-A4 an einem seiner beiden Enden mit dem Abschnitt 40-B4 und an dem anderen seiner beiden Enden mit dem Abschnitt 90-B5 verbunden. Weiterhin ist der Abschnitt 40-A5 an einem seiner beiden Enden mit dem Abschnitt 40-B5 und an dem anderen seiner beiden Enden mit dem Abschnitt 40-B6 verbunden. Auf diese Weise ist gewährleistet, dass die Abschnitte 40-A1, 40-A2, 40-A3, 40-A4 und 40-A5 derart verbunden sind, dass sie in dieser Reihefolge elektrisch in Reihe geschaltet sind.

Wie Fig. 7 und 8 zeigen, sind die Festkörper 30 und 40 hinsichtlich ihrer Anordnung bezüglich der Lötlinie L und der Zwischenräume Z1-Z10 auf die folgende Weise komplementär:
Die Abschnitte 30-A1, 30-A2, 30-A3, 30-A4 und 30-A5 des Festkörpers 30 sind entlang der Lötlinie L jeweils hintereinander (in dieser Reihenfolge) in einem der Zwischenräume Z1, Z3, Z5, Z7 und Z9 jeweils in einem Abstand D1 zur Lötlinie L angeordnet und erstrecken sich nicht durch die Zwischenräume Z2, Z4, Z6, Z8 und Z10, während sich die Abschnitte 30-B2, 30-B3, 30-B4, 30-B5 und 30-B6 des Festkörpers 30 durch die Zwischenräume Z2, Z4, Z6, Z8 und Z10 jeweils in einem Abstand D2 zur Lötlinie erstrecken, wobei D2 jeweils grösser als der Abstand D1 ist; andererseits sind die Abschnitte 40-A1, 40-A2, 40-A3, 40-A4 und 40-A5 entlang der Lötlinie L jeweils hintereinander (in dieser Reihenfolge) in den Zwischenräumen Z2, Z4, Z6, Z8 und Z10 jeweils in dem Abstand D1 zur Lötlinie L angeordnet, während sich die Abschnitte 40-B1, 40-B2, 40-B3, 40-B4, 40-B5 des Festkörpers 40 durch die Zwischenräume Z1, Z3, Z5, Z7 und Z9 jeweils in einem Abstand D2 zur Lötlinie erstrecken, wobei D2 jeweils grösser als der Abstand D1 ist.

In vorliegenden Beispiel sind die Abstände D1 und D2 derart gewählt, dass die Differenz D2-D1 jeweils grösser ist die Erstreckung der Abschnitte 30-A1, 30-A2, 30-A3, 30-A4 und 30-A5 des Festkörpers 30 und der Abschnitte 40-A1, 40-A2, 40-A3, 40-A4 und 40-A5 des Festkörpers 40 in den jeweiligen Zwischenräumen Z1-Z10 jeweils senkrecht zur Lötlinie L und parallel zur Lötebene LE (in Fig. 9 und 10 ist jeweils eine derartige Erstreckung - jeweils mit "HL" - bezeichnet, im Falle des Abschnitts 30-A5 für den Zwischenraum Z9 und im Falle des Abschnitts 40-A5 für den Zwischenraum Z10 dargestellt). Dadurch können die Festkörper 30 und 40 in Kombination mit den Niederhalterelementen P1-P11 gemäss Fig. 4 in eine Anordnung gebracht werden, in welcher die Festkörper 30 und 40 nebeneinander angeordnet sind und die Abschnitte 30-A1, 30-A2, 30-A3, 30-A4 und 30-A5 des Festkörpers 30 und die Abschnitte 40-A1, 40-A2, 40-A3, 40-A4 und 40-A5 des Festkörpers 40 in einer Reihe hintereinander in jeweils einem der Zwischenräume Z1-Z10 platziert sind (wie in Fig. 7 und 8 dargestellt).

Eine derartige Anordnung der Festkörper 30 und 40 ist im Falle der Induktionsantenne 20A gemäss Fig. 4 realisiert. Dies ist u.a. Fig. 11 entnehmbar. Fig. 11 zeigt die Induktionsantenne 20A gemäss Fig. 4 aus einer Perspektive, welche einen Blick auf diejenige Seite der Induktionsantenne 20A ermöglicht, welche in der Anordnung gemäss Fig. 4 der Lötlinie L bzw. der Solarzelle 1 zugewandt ist. In Fig. 11 sind einerseits die Kanäle K1-K11 für die Niederhalterelemente P1-P11 erkennbar (die Niederhalterelemente P1-P11 sind in Fig. 11 nicht dargestellt). Weiterhin ist die Anordnung der Abschnitte 30-A1, 30-A2, 30-A3, 30-A4 und 30-A5 des Festkörpers 30 relativ zu den Abschnitten 40-A1, 40-A2, 40-A3, 40-A4 und 40-A5 des Festkörpers 40 erkennbar. Wie ersichtlich, sind die wechselfelderzeugenden Abschnitte 30-A1, 30-A2, 30-A3, 30-A4 und 30-A5 des Festkörpers 30 und die wechselfelderzeugenden Abschnitte 40-A1, 40-A2, 40-A3, 40-A4 und 40-A5 des Festkörpers 40 abwechselnd in einer Reihe hintereinander angeordnet, sodass auf einen wechselfelderzeugenden Abschnitt des Festkörpers 30 jeweils ein wechselfelderzeugender Abschnitt des Festkörpers 40 folgt (oder umgekehrt).

In Fig. 11 zeigt die Induktionsantenne 20A in einer bevorzugten Ausführungsform, in welcher die Abschnitte 30-A1, 30-A2, 30-A3, 30-A4 und 30-A5 des Festkörpers 30 und die Abschnitten 40-A1, 40-A2, 40-A3, 40-A4 und 40-A5 derart geformt und angeordnet sind, dass sie sich gemeinsam in einer Reihe hintereinander entlang einer Geraden G - wie in Fig. 11 dargestellt - erstrecken. Letzteres ist vorteilhaft im Hinblick auf die Homogenität der magnetischen Wechselfelder H1-H10 entlang der Lötlinie L.

Hinsichtlich der Homogenität der magnetischen Wechselfelder H1-H10 ist von Interesse, dass die "wechselfelderzeugenden" Abschnitte 30-A1, 30-A2, 30-A3, 30-A4, 30-A5, 40-A1, 40-A2, 40-A3, 40-A4 und 40-A5 der Festkörper 30 und 40 jeweils einen länglichen Abschnitt umfassen, welcher sich geradlinig und vorzugsweise mit konstantem Querschnitt in der Lötebene LE zwischen jeweils zwei der Kanäle K1-K11 erstreckt. Diese geradlinigen, länglichen Abschnitte werden im Folgenden mit LA1, LA2, LA3, LA4, LA5, LA6, LA7, LA8, LA9 bzw. LA10 bezeichnet und sind in Fig. 8 und 9 gekennzeichnet (mittels geschweiften Klammern, welche die Erstreckung des jeweiligen länglichen Abschnitts in Richtung der Lötlinie L markiert).

Wie in Fig. 11 dargestellt, können im Falle der Induktionsantenne 20A die länglichen Abschnitte LA1-LA10 vorteilhafterweise in einer Reihe hintereinander derart angeordnet sind, dass sie sich jeweils entlang einer Geraden G erstrecken. Die Gerade G erstreckt sich vorzugsweise in der Lötebene LE im Wesentlichen parallel zur Lötlinie L. Dies ist vorteilhaft im Hinblick auf die Homogenität der magnetischen Wechselfelder H1-H10 entlang der Lötlinie L.

Mit Bezug auf Fig. 12 und 13 werden im Folgenden die Funktionen der Befestigungsmittel 100 und der Kurzschlusselemente 101, 102 und 103 erläutert. Fig. 12 zeigt die Induktionsantenne 20A gemäss Fig. 4 in einer Seitenansicht, parallel entlang der Lötlinie L ausgerichtet, in einem Abstand D1 zur Lötlinie L (D1 bezeichnet den Abstand der Festkörper 30 und 40 von der Lötlinie L, wie in Fig. 7 und 8 angegeben). Fig. 13 zeigt vier Querschnitte der Induktionsantenne 20A längs verschiedener, in Fig. 12 angegebenen Schnittebenen A-A, B-B, C-C und D-D. Diese Schnittebenen sind jeweils senkrecht zur Lötlinie L gerichtet und bezüglich der Induktionsantenne 20A an verschiedenen Positionen entlang der Lötlinie L zwischen einem ersten Ende 20A' und einem zweiten Ende 20A" der Induktionsantenne 20A angeordnet.

Wie die Querschnitte der Induktionsantenne 20A entlang der Schnittebenen B-B, C-C und D-D gemäss Fig. 13 andeuten, stellen die Befestigungsmittel 100 (im vorliegenden Beispiel Schrauben) eine starre Verbindung zwischen den Kühlkörpern 60 und 70 her und sind dabei durch Bohrungen in den Kühlkörpern 60 und 70, den Festkörpern 30 und 40 und den Isolationskörpern 80 und 90 (d.h. Bohrungen 62 im Kühlkörper 60, Bohrungen 72 im Kühlkörper 70, Bohrungen 32 im Festkörper 30, Bohrungen 42 im Festkörper 40, Bohrungen 82 im Isolationskörper 80, Bohrungen 92 im Isolationskörper 90) durchgeführt, sodass die Festkörpern 30 und 40 und die Isolationskörper 80 und 90 auf diese Weise in einer stabilen Position bezüglich der Kühlkörper 60 und 70 gehalten sind. Wie aus Fig. 5-10 entnehmbar ist, sind die Bohrungen 32 bzw. 42 in den Abschnitten 30-B1, 30-B2, 30-B3, 30-B4, 30-B5 und 30-B6 des Festkörpers 30 bzw. in den Abschnitten 40-B1, 40-B2, 40-B3, 40-B4, 40-B5 und 40-B6 des Festkörpers 40 angeordnet. Die Abschnitte 30-B1, 30-B2, 30-B3, 30-B4, 30-B5 und 30-B6 des Festkörpers 30 bzw. die Abschnitte 40-B1, 40-B2, 40-B3, 40-B4, 40-B5 und 40-B6 des Festkörpers 40 haben demnach u.a. die Funktion, die wechselfelderzeugenden Abschnitte 30-A1, 30-A2, 30-A3, 30-A4, 30-A5, 40-A1, 40-A2, 40-A3, 40-A4 und 40-A5 der Festkörper 30 und 40 in einer vorgegebenen Position an der Induktionsantenne 20A zu halten.

Im Falle der Induktionsantenne 20A gemäss Fig. 4 ist vorausgesetzt, dass die Kühlkörper 60 und 70 aus einem elektrisch leitfähigen Material besteht. Um zu vermeiden, dass die Befestigungsmittel 100 einen elektrischen Kurzschluss zwischen einem der Festkörper 30 bzw. 40 und einem der Kühlkörper 60 bzw. 70 verursachen, bestehen die Befestigungsmittel 100 vorzugsweise aus einem elektrisch isolierenden Material.

Wie aus Fig. 13 in Kombination mit Fig. 5 und 12 ersichtlich, ist zwischen dem Festkörper 30 und dem Kühlkörper 60 einer der Isolationskörper 90 derart angeordnet, dass der Festkörper 30 gegenüber dem Kühlkörper 60 im gesamten Bereich zwischen den beiden Enden 20A' und 20A" der Induktionsantenne 20A mittels des Isolationskörpers 90 elektrisch isoliert ist. Weiterhin ist zwischen dem Festkörper 40 und dem Kühlkörper 70 einer der Isolationskörper 90 derart angeordnet, dass der Festkörper 40 gegenüber dem Kühlkörper 70 im gesamten Bereich zwischen den beiden Enden 20A' und 20A" der Induktionsantenne 20A mittels des Isolationskörpers 90 elektrisch isoliert ist. Ausserdem sind zwischen den Festkörpern 30 und 40 die Isolationskörper 80 derart angeordnet, dass der Festkörper 30 gegenüber dem Festkörper 40 im gesamten Bereich zwischen den beiden Enden 20A' und 20A" der Induktionsantenne 20A mittels der Isolationskörper 80 elektrisch isoliert ist.

Wie Fig. 13 in Kombination mit Fig. 5 und 12 andeutet, haben die Kurzschlusselemente 101 und 103 (im vorliegenden Fall beispielsweise Schrauben aus einem elektrisch leitfähigen Material) die Funktion, in der Nähe des Endes 20A' der Induktionsantenne 20A einerseits eine elektrische Verbindung zwischen dem Festkörper 30 und dem Kühlkörper 60 und andererseits eine elektrische Verbindung zwischen dem Festkörper 40 und dem Kühlkörper 70 herzustellen. Wie aus Fig. 13 ersichtlich, sind die Kurzschlusselemente 101 und 103 in der Schnittebene A-A derart platziert, dass das Kurzschlusselement 101 einen elektrischen Kurzschluss zwischen dem Kühlkörper 60 und dem Abschnitt 30-B1 des Festkörpers 30 und das Kurzschlusselement 103 einen elektrischen Kurzschluss zwischen dem Kühlkörper 70 und dem Abschnitt 40-B1 des Festkörpers 40 herstellt. Zu diesem Zweck ist das Kurzschlusselement 101 derart angeordnet, dass es sich mit Kontakt zum Kühlkörper 60 und zum Festkörper 30 sowohl durch eine Bohrung 33 im Abschnitt 30-B1 des Festkörpers 30 und durch eine Bohrung 63 im Kühlkörper 60 erstreckt (um diese Anordnung zu ermöglichen, verfügt der Kühlkörper 70 bzw. der Isolationskörper 90 bzw. der Festkörper 40 über eine Bohrung 73 bzw. 93 bzw. 43, durch welche Bohrungen das Kurzschlusselement 101 durchgeführt ist, wobei die Bohrungen 93 bzw. 43 in Fig. 5, aber nicht in Fig. 13, mit Bezugszeichen gekennzeichnet sind). Entsprechend ist das Kurzschlusselement 103 derart angeordnet, dass es sich mit Kontakt zum Kühlkörper 70 und zum Festkörper 40 sowohl durch eine Bohrung 45 im Abschnitt 40-B1 des Festkörpers 40 und durch eine Bohrung 75 im Kühlkörper 70 erstreckt (um diese Anordnung zu ermöglichen, verfügt der Isolationskörper 90 über eine Bohrung 95, durch welche das Kurzschlusselement 103 durchgeführt ist, wobei die Bohrungen 45, 75 und 95 in Fig. 5, aber nicht in Fig. 13, mit Bezugszeichen gekennzeichnet sind).

Mit Bezug auf Fig. 4 sei darauf hingewiesen, dass im Falle der Induktionsantenne 20A das Stromeinkopplungselement 110 mit dem Kühlkörper 60 und das Stromauskopplungselement 112 mit dem Kühlkörper 70 verbunden ist. Das Kurzschlusselement 101, falls platziert wie in Fig. 12 und 13 dargestellt, realisiert folglich eine elektrische Verbindung zwischen dem Stromeinkopplungselement 110 und dem Abschnitt 30-B1 des Festkörpers 30. Entsprechend realisiert das Kurzschlusselement 103, falls platziert wie in Fig. 12 und 13 dargestellt, eine elektrische Verbindung zwischen dem Stromauskopplungselement 112 und dem Abschnitt 40-B1 des Festkörpers 40.

Mit Bezug auf Fig. 13 in Kombination mit Fig. 5 und 12 sei darauf hingewiesen, dass das jeweilige Kurzschlusselement 102 gemäss Fig. 5 (im vorliegenden Fall beispielsweise eine Schraube aus einem elektrisch leitfähigen Material) die Funktion hat, in der Nähe des Endes 20A" der Induktionsantenne 20A eine elektrische Verbindung zwischen dem Festkörper 30 und dem Festkörper 40 herzustellen. Im Fall der in Fig. 4 dargestellten Ausführungsform der Induktionsantenne 20A besteht die Möglichkeit, eine derartige elektrische Verbindung zwischen dem Festkörper 30 und dem Festkörper 40 mittels eines Kurzschlusselements 102 in mehreren verschiedenen Abständen vom Ende 20A" der Induktionsantenne 20A zu realisieren. Im vorliegenden Fall ist beispielsweise die Möglichkeit vorgesehen, jeweils eines der Abschnitte 30-B2, 30-B3, 30-B4, 30-B5, 30-B6 des Festkörpers 30 mit einem der Abschnitte 40-B2, 40-B3, 40-B4, 40-B5, 40-B6 des Festkörpers 40 mithilfe eines Kurzschlusselements 102 verbinden zu können. Diese Möglichkeit ist im vorliegenden Fall dadurch realisiert, dass der Festkörper 30 in jedem der Abschnitte 30-B2, 30-B3, 30-B4, 30-B5, 30-B6 je zwei Bohrungen 34 und der Festkörper 40 in jedem der Abschnitte 40-B2, 40-B3, 40-B4, 40-B5, 40-B6 je zwei Bohrungen 44 aufweist. Die Bohrungen 34 und 44 sind dabei derart ausgebildet, dass sich jeweils ein Kurzschlusselement 102 durch je eine der Bohrungen 34 in Kontakt mit dem Festkörper 30 und zusätzlich durch je eine der Bohrungen 44 in Kontakt mit dem Festköper 40 erstrecken kann. Mit Bezug auf Fig. 5 und 13 sei darauf hingewiesen, dass die Isolationskörper 80 bzw. 90 Bohrungen 84 bzw. 94 aufweisen, durch welche sich das Kurzschlusselement 102 erstreckt, wenn es in einer der Bohrungen 34 bzw. 44 sitzt. Wie Fig. 12 zeigt, umfasst der Kühlkörper 70 mehrere Bohrungen 74, welche derart angeordnet sind, dass die jeweiligen Bohrungen 34 im Festkörper 30 und die jeweiligen Bohrungen 44 im Festkörper 40 durch je eine der Bohrungen 74 zugänglich sind. Im vorliegenden Beispiel gemäss Fig. 12 und 13 weist die Induktionsantenne 20A sowohl in der Schnittebene C-C als auch in der Schnittebene D-D jeweils ein Kurzschlusselement 102 auf. Dabei stellt das Kurzschlusselement 102, welches in der Schnittebene D-D platziert ist, einen elektrischen Kurzschluss zwischen dem Abschnitt 30-B6 des Festkörpers 30 und dem Abschnitt 40-B6 des Festkörpers 40 her. Das Kurzschlusselement 102, welches in der Schnittebene C-C platziert ist, stellt einen elektrischen Kurzschluss zwischen dem Abschnitt 30-B5 des Festkörpers 30 und dem Abschnitt 40-B5 des Festkörpers 40 her.

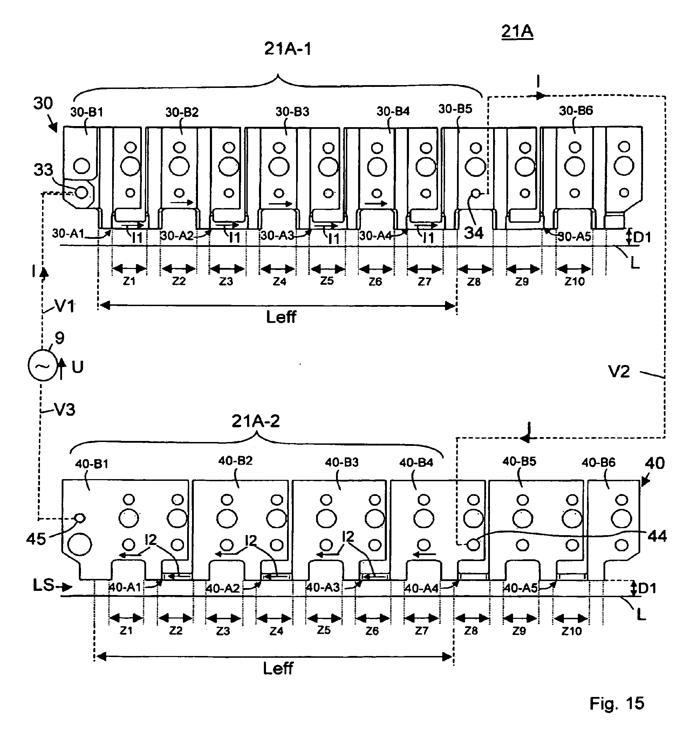

Fig. 14 und 15 zeigen schematische Darstellungen des Strompfads 21A der Induktionsantenne 20A gemäss Fig. 4 bzw. 12 für zwei verschiedene Varianten, welche sich dadurch unterscheiden, dass ein Kurzschlusselement 102 in unterschiedlichen Abständen vom Ende 20A" der Induktionsantenne 20A platziert ist. Dabei ist jeweils angenommen, dass der Generator 9 für den Wechselstrom I - wie in Fig. 4 dargestellt - an das Stromeinkopplungselement 110 bzw. Stromauskopplungselement 112 angeschlossen ist, so dass ein vom Generator 9 erzeugter Wechselstrom I im Strompfad 21A zwischen dem Stromeinkopplungselement 110 und dem Stromauskopplungselement 112 fliessen kann und dabei in der Lötlinie L ein magnetisches Wechselfeld bzw. magnetische Wechselfelder erzeugt.

Fig. 14 stellt die Anordnung des Strompfads 21A der Induktionsantenne 20A relativ zur Lötlinie L für den Fall dar, dass der Abschnitt 30-B6 des Festkörpers 30 mit dem Abschnitt 40-B6 des Festkörpers 40 elektrisch verbunden ist. In Fig. 14 stellen gestrichelte, mit V1, V2 bzw. V3 bezeichnete Linien jeweils elektrische Verbindungen dar, welche zwischen dem Generator 9 und den Festkörpern 30 bzw. 40 oder zwischen den Festkörpern 30 und 40 bestehen. Dabei repräsentiert die elektrische Verbindung V1 die bereits erwähnte Verbindung zwischen dem Generator 9 und dem Abschnitt 30-B1 des Festkörpers 30 (beispielsweise realisiert mittels eines Kurzschlusselements 101, welches in der in Fig. 14 dargestellten Bohrung 33 im Abschnitt 30-B1 des Festkörpers 30 platziert ist und für eine elektrische Verbindung zwischen dem Abschnitt 30-B1 und dem Kühlkörper 60 bzw. dem Stromeinkopplungselement 110 sorgt). Entsprechend repräsentiert die elektrische Verbindung V2 die bereits erwähnte Verbindung zwischen dem Abschnitt 30-B6 des Festkörpers 30 und dem Abschnitt 40-B6 des Festkörpers 40. Diese Verbindung V2 kann - wie im Zusammenhang mit Fig. 12 und 13 beschrieben - mittels eines Kurzschlusselements 102, welches sowohl in einer Bohrung 34 des Abschnitts 30-B6 des Festkörpers 30 als auch in einer Bohrung 44 des Abschnitt 40-B6 des Festkörpers 40 sitzt, realisiert sein. Entsprechend repräsentiert die elektrische Verbindung V3 die bereits erwähnte Verbindung zwischen dem Generator 9 und dem Abschnitt 40-B1 des Festkörpers 40 (beispielsweise realisiert mittels eines Kurzschlusselements 103, welches in der in Fig. 14 dargestellten Bohrung 45 im Abschnitt 40-B1 des Festkörpers 40 platziert ist und für eine elektrische Verbindung zwischen dem Abschnitt 40-B1 und dem Kühlkörper 70 bzw. dem Stromauskopplungselement 112 sorgt).

In Fig. 14 ist - der Übersichtlichkeit halber - die Anordnung des Festkörpers 30 und die Anordnung des Festkörpers 40 in zwei übereinander angeordneten Zeichnungen - jeweils relativ zur Lötlinie L - dargestellt. Aus diesem Grund enthält Fig. 14 in einem oberen Teil eine Darstellung des Festkörpers 30 in einer Seitenansicht (mit Blickrichtung senkrecht zur Lötebene LE gemäss Fig. 4, entsprechend der Darstellung des Festkörpers 30 in Fig. 7) und in einem unteren Teil eine Darstellung des Festkörpers 40 in einer Seitenansicht (mit Blickrichtung senkrecht zur Lötebene LE gemäss Fig. 4, entsprechend der Darstellung des Festkörpers 40 in Fig. 8). Gemäss Fig. 14 ist der Festkörper 30 bezüglich der Lötlinie L und der Zwischenräume Z1-Z10 derart angeordnet, dass sich die Abschnitte 30-A1, 30-A2, 30-A3, 30-A4 bzw. 30-A5 jeweils in einem der Zwischenräume Z1, Z3, Z5, Z7 bzw. Z9 erstrecken (jeweils im Wesentlichen parallel zur Lötlinie L, entsprechend der Darstellung des Festkörpers 30 in Fig. 7). Entsprechend ist gemäss Fig. 14 der Festkörper 40 bezüglich der Lötlinie L und der Zwischenräume Z1-Z10 derart angeordnet ist, dass sich die Abschnitte 40-A1, 40-A2, 40-A3, 40-A4 bzw. 40-A5 jeweils in einem der Zwischenräume Z2, Z4, Z6, Z8 bzw. Z10 erstrecken (jeweils im Wesentlichen parallel zur Lötlinie L, entsprechend der Darstellung des Festkörpers 40 in Fig. 8).

In Fig. 14 ist weiterhin eine Einteilung der Lötlinie L in zehn verschiedene Abschnitte L1, L2, L3, L4, L5, L6, L7, L8, L9 bzw. L10 dargestellt, welche in der vorstehend genannten Reihenfolge in einer Reihe hintereinander angeordnet sind, wobei sich jeder der Abschnitte L1-L10 über genau einen der Zwischenräume Z1, Z2, Z3, Z4, Z5, Z6, Z7, Z8, Z9 bzw. Z10 erstreckt (dementsprechend erstreckt sich der Abschnitt Li über den Zwischenraum Zi, wobei i=1-10).

Gemäss Fig. 14 kann der Strompfad 20A als eine Reihenschaltung von zwei Abschnitten dieses Strompfads aufgefasst werden, welche in Fig. 14 mit 21A-1 und 21A-2 bezeichnet sind: "Abschnitt 21A-1" repräsentiert denjenigen Abschnitt des Strompfads 21A, welcher im Festkörper 30 ausgebildet ist; entsprechend repräsentiert "Abschnitt 21A-2" denjenigen Abschnitt des Strompfads 21A, welcher im Festkörper 40 ausgebildet ist.

Dabei bilden die Abschnitte 30-B1, 30-A1, 30-B2, 30-A2, 30-B3, 30-A3, 30-B4, 30-A4, 30-B5, 30-A5 und 30-B6 des Festkörpers 30 jeweils "Abschnitte" des Abschnitts 21A-1 des Strompfads 21A, welche ihrerseits (in der vorstehend genannten Reihenfolge) elektrisch in Reihe geschaltet sind: Wie bereits erwähnt, sind Enden der Abschnitte 30-A1, 30-A2, 30-A3, 30-A4 und 30-A5 des Festkörpers 30 über jeweils einen der Abschnitte 30-B2, 30-B3, 30-B4 und 30-B5 des Festkörpers 30 derart verbunden, dass die Abschnitte 30-A1, 30-A2, 30-A3, 30-A4 und 30-A5 jeweils elektrisch in Reihe geschaltet sind (Fig. 7). Entsprechend bilden die Abschnitte 40-B1, 40-A1, 40-B2, 40-A2, 40-B3, 40-A3, 40-B4, 40-A4, 40-B5, 40-A5 und 40-B6 des Festkörpers 40 jeweils "Abschnitte" des Abschnitts 21A-1 des Strompfads 21A, welche ihrerseits (in der vorstehend genannten Reihenfolge) elektrisch in Reihe geschaltet sind: Wie bereits erwähnt, sind Enden der Abschnitte 40-A1, 40-A2, 40-A3, 40-A4 und 40-A5 des Festkörpers 40 über jeweils einen der Abschnitte 40-B2, 40-B3, 40-B4 und 40-B5 des Festkörpers 40 derart verbunden, dass die Abschnitte 40-A1, 40-A2, 40-A3, 40-A4 und 40-A5 jeweils elektrisch in Reihe geschaltet sind (Fig. 8).

Dadurch, dass der Abschnitt 30-B1 des Festkörpers 30 und der Abschnitt 40-B1 des Festkörpers 40 mit des Generator 9 verbunden sind (über die elektrischen Verbindungen V1 bzw. V3 in Fig. 14) und der Abschnitt 30-B6 des Festkörpers 30 mit dem Abschnitt 40-B6 des Festkörpers 40 elektrisch verbunden ist (gemäss Verbindung V2 in Fig. 14), sind die Abschnitte 21A-1 und 21-A2 des Strompfads 21A über die elektrische Verbindung V2 derart in Reihe hintereinander geschaltet, dass der Wechselstrom I sowohl im Abschnitt 21A-1 und als auch im Abschnitt 21-A2 entlang der Lötlinie L jeweils zwischen den Enden 20A' und 20A" der Induktionsantenne 20A geführt ist, allerdings derart, dass der Wechselstrom I im Abschnitt 21A-1 des Strompfads 21A in Gegenphase zum Wechselstrom I im Abschnitt 21A-2 des Strompfads 21A ist.

Zur Verdeutlichung dieses Sachverhalts geben in Fig. 14 jeweils mit dem Bezugszeichen I versehene Pfeile die momentane Stromflussrichtung eines vom Generator 9 erzeugten elektrischen Wechselstroms I für einen bestimmten Zeitpunkt an, wobei die momentane Stromflussrichtung des Wechselstroms I in der Darstellung gemäss Fig. 14 mit der momentanen Stromflussrichtung des Wechselstroms I in der Darstellung gemäss Fig. 4 übereinstimmt. Der Wechselstrom I fliesst, wie ersichtlich, zwischen den elektrischen Verbindungen V1 und V2 jeweils durch den Abschnitt 21A-1 des Strompfads 21A und zwischen den elektrischen Verbindungen V2 und V3 jeweils durch den Abschnitt 21A-2 des Strompfads 21A. Weiterhin geben mit dem Bezugszeichen I1 versehene Pfeile die momentane Stromflussrichtung des elektrischen Wechselstroms I im Abschnitt 21A-1 des Strompfads 21A und mit dem Bezugszeichen I2 versehene Pfeile die momentane Stromflussrichtung des elektrischen Wechselstroms I im Abschnitt 21A-2 des Strompfads 21A (für denselben bestimmten Zeitpunkt) an.

Wie aus Fig. 14 ersichtlich, erstreckt sich der Abschnitt 21A-1 des Strompfads 21A entlang der Abschnitte L1-L10 bzw. durch die Zwischenräume Z1-Z10 derart, dass der Wechselstroms I in den Abschnitten 30-A1, 30-A2, 30-A3, 30-A4 und 30-A5 des Festkörpers 30 jeweils im Wesentlichen parallel zur Lötlinie L und jeweils in dieselbe Richtung fliesst (entsprechend den in Fig. 14 angegebenen Pfeilen I1, welche entlang der Lötlinie L vom Abschnitt L1 in Richtung auf den Abschnitt L10 weisen). Weiterhin erstreckt sich der Abschnitt 21A-2 des Strompfads 21A entlang der Abschnitte L1-L10 bzw. durch die Zwischenräume Z1-Z10 derart, dass der Wechselstroms I in den Abschnitten 40-A1, 40-A2, 40-A3, 40-A4 und 40-A5 des Festkörpers 40 jeweils im Wesentlichen parallel zur Lötlinie L und jeweils in dieselbe Richtung fliesst (entsprechend den in Fig. 14 angegebenen Pfeilen I2, welche entlang der Lötlinie L vom Abschnitt L10 in Richtung auf den Abschnitt L1 weisen). Wie aus Fig. 14 ersichtlich, ist die momentane Stromflussrichtung des Wechselstroms I in den Abschnitten 30-A1, 30-A2, 30-A3, 30-A4 und 30-A5 des Festkörpers 30 (entsprechend der Stromflussrichtung I1 in Fig. 14) jeweils entgegengesetzt zur Stromflussrichtung des Wechselstroms I in den Abschnitten 40-A1, 40-A2, 40-A3, 40-A4 und 40-A5 des Festkörpers 40 (entsprechend Stromflussrichtung I2 in Fig. 14). Dementsprechend ist der elektrische Wechselstrom I in den Abschnitten 30-A1, 30-A2, 30-A3, 30-A4 und 30-A5 des Festkörpers 30 jeweils in Gleichphase und in den Abschnitten 30-A1, 30-A2, 30-A3, 30-A4 und 30-A5 des Festkörpers 30 jeweils in Gegenphase zum elektrischen Wechselstrom I in den Abschnitten 40-A1, 40-A2, 40-A3, 40-A4 und 40-A5 des Festkörpers 40.

Wie Fig. 14 andeutet, erstreckt sich durch jeden der Zwischenräume Z1-Z10 sowohl ein Teil des Abschnitts 21A-1 des Strompfads 21A als auch ein Teil des Abschnitts 21A-2 des Strompfads 21A jeweils im Wesentlichen parallel zur der Lötlinie L. Dabei erstreckt sich (wie bereits im Zusammenhang mit Fig. 7 und 8 erläutert wurde) in jedem der Zwischenräume Z1, Z3, Z5, Z7 bzw. Z9 der Abschnitt 21A-1 relativ zum Abschnitt 21A-2 derart, dass sich der jeweilige durch einen der Zwischenräume Z1, Z3, Z5, Z7 bzw. Z9 erstreckende Teil des Abschnitts 21A-1 des Strompfads 21A (d.h. einer der Abschnitte 30-A1, 30-A2, 30-A3, 30-A4 bzw. 30-A5 des Festkörpers 30) in einem geringeren Abstand zur Lötlinie L angeordnet ist als der entsprechende Teil des Abschnitts 21A-2 des Strompfads 21A (d.h. einer der Abschnitte 40-B1, 40-B2, 30-B3, 40-B4 bzw. 40-B5 des Festkörpers 40).

Andererseits erstreckt sich in jedem der Zwischenräume Z2, Z4, Z6, Z8 bzw. Z10 der Abschnitt 21A-1 relativ zum Abschnitt 21A-2 derart, dass sich der jeweilige durch einen der Zwischenräume Z2, Z4, Z6, Z8 bzw. Z10 erstreckende Teil des Abschnitts 21A-2 des Strompfads 21A (d.h. einer der Abschnitte 40-A1, 40-A2, 40-A3, 40-A4 bzw. 40-A5 des Festkörpers 40) in einem geringeren Abstand zur Lötlinie L angeordnet ist als der entsprechende Teil des Abschnitts 21A-1 des Strompfads 21A (d.h. einer der Abschnitte 30-B2, 30-B3, 30-B4, 30-B5 bzw. 30-B6 des Festkörpers 30).

Diese Anordnung der jeweiligen Abschnitte der Festkörpers 30 und 40 hat hinsichtlich der vom elektrischen Wechselstrom erzeugten magnetischen Wechselfelder H1-H10 (wie in Fig. 4 dargestellt) die folgende Relevanz. Wie in Fig. 14 ersichtlich, erstrecken sich im vorliegenden Beispiel die Abschnitte 30-A1, 40-A1, 30-A2, 40-A2, 30-A3, 40-A3, 30-A4, 40-A4, 30-A5 und 40-A5 in dieser Reihenfolge in einer Reihe hintereinander entlang der Lötlinie L jeweils in einem Abstand D1 zur Lötlinie L und sind dabei durch einen Luftspalt LS von der Lötlinie getrennt. Im Vergleich zum Abstand D1 sind die jeweiligen Abstände der Abschnitte 40-B1, 40-B2, 40-B3, 40-B4 bzw. 40-B5 des Festkörpers 40 und der Abschnitte 30-B2, 30-B3, 30-B4, 30-B5 bzw. 30-B6 des Festkörpers 30 von der Lötlinie L derart gross gewählt, dass der in den Abschnitten 40-B1, 40-B2, 30-B3, 40-B4 bzw. 40-B5 des Festkörpers 40 und den Abschnitten 30-B2, 30-B3, 30-B4, 30-B5 bzw. 30-B6 fliessende Wechselstrom I keinen bzw. einen relativ kleinen (vernachlässigbaren) Beitrag zu den magnetischen Wechselfeldern H1-H10 liefert, welche der elektrische Wechselstrom I in der Lötlinie L erzeugt. Dementsprechend erzeugt der durch die Abschnitte 30-A1, 30-A2, 30-A3, 30-A4 bzw. 30-A5 des Festkörpers 30 fliessende elektrische Wechselstrom I die magnetischen Wechselfelder H1, H3, H5, H7 und H9, welche in den Zwischenräumen Z1, Z3, Z5, Z7 und Z9 bzw. den Abschnitten L1, L3, L5, L7 und L9 präsent sind. Entsprechend erzeugt der durch die Abschnitte 40-A1, 40-A2, 40-A3, 40-A4 bzw. 40-A5 des Festkörpers 40 fliessende elektrische Wechselstrom I die magnetischen Wechselfelder H2, H4, H6, H8 und H10, welche in den Zwischenräumen Z2, Z4, Z6, Z8 und Z10 bzw. den Abschnitten L2, L4, L6, L8 und L10 präsent sind. Da der elektrische Wechselstrom I in den Abschnitten 30-A1, 30-A2, 30-A3, 30-A4 bzw. 30-A5 des Festkörpers 30 (wie erwähnt) in Gegenphase zum elektrische Wechselstrom I in den Abschnitten 40-A1, 40-A2, 40-A3, 40-A4 bzw. 40-A5 des Festkörpers 40 ist, ist jeweils gewährleistet, dass die magnetischen Wechselfelder H1, H3, H5, H7 und H9 jeweils in Gegenphase zu den magnetischen Wechselfeldern H2, H4, H6, H8 und H10 sind.

Im Folgenden bezeichnet der Begriff "effektive Länge einer Induktionsantenne" die Länge des Abschnitts der Lötlinie, in welchem die von der jeweiligen Induktionsantenne erzeugten magnetischen Wechselfelder präsent sind. In Fig. 14 stellt ein Pfeil mit der Bezeichnung "Leff" die effektive Länge der Induktionsantenne 20A für die vorliegende Ausbildung des Strompfads 21A dar. Dadurch, dass im Falle der Induktionsantenne 20A das Kurzschlusselement 102 in unterschiedlichen Abständen vom Ende 20A" der Induktionsantenne 20A platzierbar ist, ist es möglich, die effektive Länge der Induktionsantenne 20A auf einfache Weise zu ändern (in diesem Zusammenhang wird auf die nachfolgende Diskussion der Fig. 15 verwiesen). Diese "effektive Länge" kann jeweils geeignet gewählt und gegebenenfalls angepasst werden, abhängig von der Länge der Stromsammelschiene 3 und der Länge des an der Stromsammelschiene zu befestigenden Bandes 5 bzw. der Länge der jeweils herzustellenden Lötverbindung.

Fig. 15 stellt eine Anordnung des Strompfads 21A der Induktionsantenne 20A relativ zur Lötlinie L dar, wobei sich die Anordnung gemäss Fig. 15 von der in Fig. 14 dargestellten Anordnung des Strompfads 21A lediglich dadurch unterschiedet, dass im Fall der in Fig. 15 dargestellten Anordnung des Strompfads 21A der Abschnitt 30-B5 des Festkörpers 30 mit dem Abschnitt 40-B4 des Festkörpers 40 elektrisch verbunden ist. In Fig. 15 repräsentieren gestrichelte, mit V1 bzw. V3 bezeichnete Linien jeweils elektrische Verbindungen, welche zwischen dem Generator 9 und dem Abschnitt 30-B1 des Festkörpers 30 bzw. dem Abschnitt 40-B1 des Festkörpers 40 bestehen (entsprechend den Verbindungen V1 bzw. V3 in Fig. 14). Entsprechend repräsentiert die gestrichelte, mit V2 bezeichnete Linie die erwähnte elektrische Verbindung zwischen dem Abschnitt 30-B5 des Festkörpers 30 und dem Abschnitt 40-B4 des Festkörpers 40.

In Fig. 15 bezeichnet 21A-1 einen Abschnitt 21A-1 des Strompfads 21A, welcher im Festkörper 30 ausgebildet ist; entsprechend bezeichnet 21A-2 einen Abschnitt 21A-2 des Strompfads 21A, welcher im Festkörper 40 ausgebildet ist. Wie ersichtlich, umfasst der Abschnitt 21A-1 des Strompfads 21A die Abschnitte 30-B1, 30-A1, 30-B2, 30-A2, 30-B3, 30-A3, 30-B4, 30-A4 und 30-B5 des Festkörpers 30 und der Abschnitt 21A-2 des Strompfads 21A die Abschnitte 40-B1, 40-A1, 40-B2, 40-A2, 40-B3, 40-A3 und 40-B4 des Festkörpers 40. Dabei sind die Abschnitte 21A-1 und 21A-2 des Strompfads 21A mittels der Verbindungen V1, V2, V3 derart in Reihe geschaltet, dass ein von dem Generator 9 erzeugter Wechselstrom I durch die Abschnitte 30-A1, 30-A2, 30-A3 und 30-A4 des Festkörpers 30 und die Abschnitte 40-A1, 40-A2 und 40-A3 des Festkörpers 40 fliesst. In Fig. 15 geben mit dem Bezugszeichen I1 versehene Pfeile die momentane Stromflussrichtung des elektrischen Wechselstroms I im Abschnitt 21A-1 des Strompfads 21A und mit dem Bezugszeichen I2 versehene Pfeile die momentane Stromflussrichtung des elektrischen Wechselstroms I im Abschnitt 21A-2 des Strompfads 21A an (jeweils für einen bestimmten Zeitpunkt). Wie ersichtlich, ist der elektrische Wechselstrom I in den Abschnitten 30-A1, 30-A2, 30-A3 und 30-A4 des Festkörpers 30 in Gegenphase zum elektrische Wechselstrom I in den Abschnitte 40-A1, 40-A2 und 40-A3 des Festkörpers 40.

Im vorliegenden Fall kann der elektrische Wechselstrom I nicht durch den Abschnitt 30-A5 des Festkörpers 30 und die Abschnitte 40-A4 und 40-A5 des Festkörpers 40 fliessen. Dementsprechend ist der Strompfad 21A gemäss Fig. 15 dazu ausbildet, den Wechselstrom I entlang der Lötlinie L derart zu führen, dass der Wechselstrom I magnetische Wechselfelder in einem Abschnitt der Lötlinie L erzeugt, welcher sich zumindest durch die Zwischenräume Z1, Z2, Z3, Z4, Z5, Z6 und Z7 erstreckt (entsprechend den magnetischen Wechselfeldern H1-H7 gemäss Fig. 4). In Fig. 15 stellt ein Pfeil mit der Bezeichnung "Leff" die entsprechende effektive Länge der Induktionsantenne 20A für den gemäss Fig. 15 ausgebildeten Strompfad 21A dar. Wie ersichtlich, ist die effektive Länge Leff der Induktionsantenne 20A für einen gemäss Fig. 15 ausgebildeten Strompfad 21A kürzer als für einen gemäss Fig. 14 ausgebildeten Strompfad 21A.

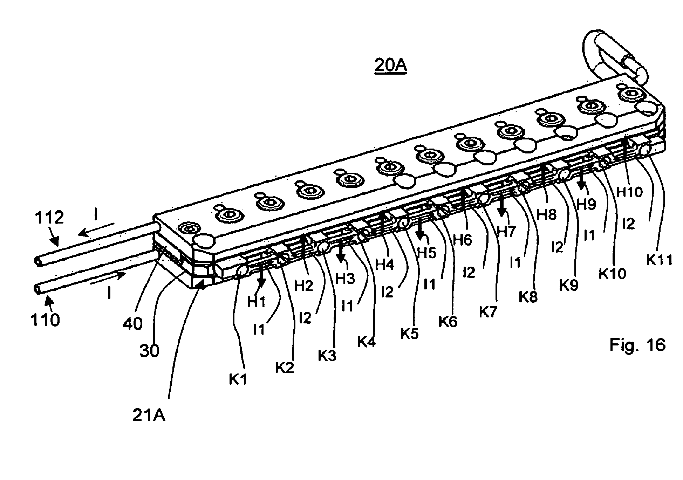

Fig. 16 zeigt die Induktionsantenne 20A gemäss Fig. 11 in einer der Fig. 11 entsprechenden Ansicht. Im Falle der Fig. 16 ist angenommen, dass der Strompfad 21A der Induktionsantenne 20A entsprechend der in Fig. 14 dargestellten Variante des Strompfads 21A ausbildet ist. In Fig. 16 sind jeweils mit den Bezugszeichen I, I1 bzw. I2 bezeichnete Pfeile eingezeichnet, welche dieselbe Bedeutung haben wie die entsprechenden, mit I, I1 bzw. I2 bezeichneten Pfeile im Falle der Fig. 14. Dementsprechend geben mit I1 bezeichneten Pfeile die momentane Stromrichtung des Wechselstroms I in den in Fig. 11 gekennzeichneten länglichen Abschnitten LA1, LA3, LA5, LA7 und LA9 des Festkörpers 30 und die mit I2 bezeichneten Pfeile die momentane Stromrichtung des Wechselstroms I in den in Fig. 11 gekennzeichneten länglichen Abschnitten LA2, LA4, LA6, LA8 und LA10 des Festkörpers 40 jeweils für einen bestimmten Zeitpunkt an. Zusätzlich sind in Fig. 16 Pfeile H1, H2, H3, H4, H5, H6, H7, H8, H9 und H10 eingezeichnet, welche die momentane Richtung der magnetischen Feldstärke der durch den Wechselstrom I erzeugten magnetischen Wechselfelder H1-H10, wie in Fig. 4 angegeben, darstellen. Dementsprechend gibt der mit Hi bezeichnete Pfeil in Fig. 16 die momentane Richtung der Feldstärke des Wechselfelds Hi an der Lötlinie L im Zwischenraum Zi gemäss Fig. 4 an, wobei i=1-10. Demnach zeigt Fig. 14 verschiedene Abschnitte des Strompfads 21A mit einander entgegengesetzten Stromflussrichtungen I1 bzw. I2 im Korrelation mit der momentanen Richtung der Wechselfelder, welche in der Umgebung der jeweiligen Abschnitte des Strompfads 21A erzeugt werden. Deutlich erkennbar sind verschiedene Abschnitte des Strompfads 21A, in deren Umgebung die jeweiligen magnetischen Wechselfelder entgegengesetzt gerichtet sind und somit in Gegenphase zueinander sind.

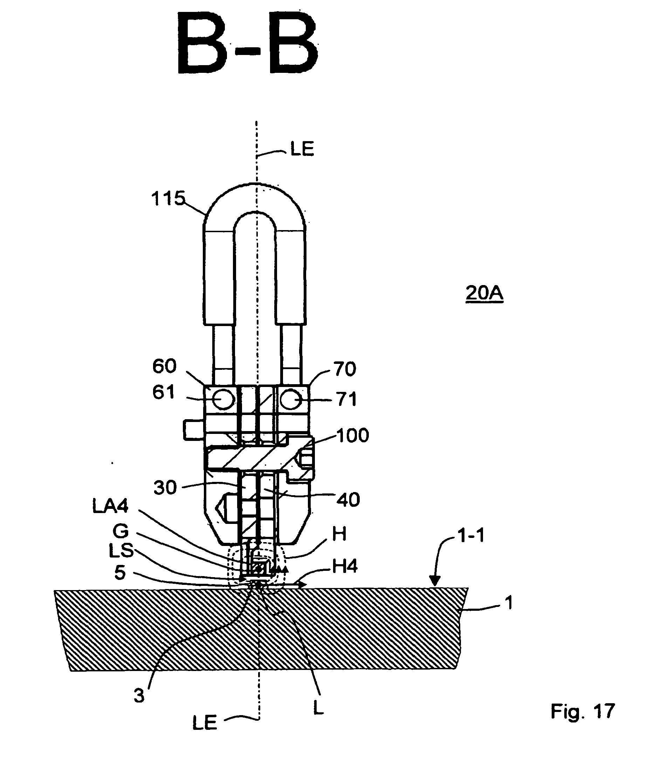

Fig. 17 zeigt die Induktionsantenne 20A in einem Querschnitt entlang der Schnittebene B-B gemäss Fig. 12 in Kombination mit einer Solarzelle 1 gemäss Fig. 4 und einem Band 5, wobei sich das Band 5 entlang der Lötlinie L in Längsrichtung der Stromsammelschiene 3 der Solarzelle 1 erstreckt. Zu erkennen ist u.a. ein Querschnitt des länglichen Abschnitts LA4, welcher ein Teil des Abschnitts 40-A2 des Festkörpers 40 ist (siehe Fig. 10) und sich in der Lötebene LE - von der Lötlinie L durch einen Luftspalt LS getrennt - im Wesentlichen parallel zur Lötlinie L durch den Zwischenraum Z4 erstreckt. Hieraus ist zu erkennen, dass der längliche Abschnitt LA4 (wie jeder der länglichen Abschnitte LA1-LA10) der Induktionsantenne 20A senkrecht zur Lötebene LE eine Dimension aufweisen kann, welche in etwa so gross ist wie eine Breite der Stromsammelschiene 3 und/oder eine Breite des elektrisch leitfähigen Bandes 5. Im vorliegenden Beispiel ist der längliche Abschnitt LA4 (wie jeder der länglichen Abschnitte LA1-LA10) symmetrisch zu Lötebene LE angeordnet und hat einen quadratischen Querschnitt, welcher beispielsweise einen Flächeninhalt von 1.5 mm x 1.5 mm aufweisen kann. Die Induktionsantenne ist damit geeignet zum Löten von Bändern 5 bzw. Stromsammelschienen 3 mit einer Breite von 1-3 mm. In Fig. 17 ist weiterhin der räumliche Verlauf mehrerer Feldlinien des magnetischen Wechselfeldes mittels gestrichelter Linien, welche den in Fig. 17 dargestellten länglichen Abschnitt LA4 jeweils in Form einer geschlossenen Kurve umgeben, schematisch skizziert. Die jeweiligen Feldlinien sind jeweils mit einer (in einem Fall mit dem Bezugszeichen H gekennzeichneten) Pfeilspitze versehen, welche die momentane Richtung des magnetischen Wechselfelds entlang der jeweiligen Feldlinie angibt, jeweils für die in Fig. 4 angegebene momentane Stromrichtung des elektrischen Wechselstroms I. Wie aus Fig. 17 ersichtlich, verlaufen die jeweiligen Feldlinien des magnetischen Wechselfeldes symmetrisch zur Lötebene LE. Dementsprechend ist das magnetische Wechselfeld H4 in der Lötlinie L gemäss Fig. 17 senkrecht zur Lötebene LE und somit im Wesentlichen parallel zur Oberfläche 1-1 der Solarzelle 1 gerichtet.

Wie im Zusammenhang mit Fig. 4 und 5 bereits erwähnt, kann die erfindungsgemässe Lötvorrichtung 15 gemäss Fig. 4 optional mit einer Kühleinrichtung zum Kühlen der Festkörper 30 und 40 ausgestattet sein. Wenn der Wechselstrom I - wie in Fig. 14 und 15 dargestellt - durch die Festkörper 30 und 40 fliesst, dann können sich die länglichen Abschnitte LA1-LA10 am stärksten erhitzen, zumal in den länglichen Abschnitten LA1-LA10 die Stromdichte des Wechselstroms I relativ gross ist. Im vorliegenden Fall besteht die Möglichkeit, die jeweils in den länglichen Abschnitten LA1-LA10 erzeugte Wärme mittels Wärmeleitung über einen oder mehrere der Abschnitte 30-B1, 30-B2, 30-B3, 30-B4, 30-B5 und 30-B6 des Festkörpers 30 und/oder über einen oder mehrere der Abschnitte 40-B1, 40-B2, 40-B3, 40-B4, 40-B5 und 40-B6 des Festkörpers 40 abzuführen. Durch Kühlen eines oder mehrerer der Abschnitte 30-B1, 30-B2, 30-B3, 30-B4, 30-B5 und 30-B6 des Festkörpers 30 und/oder durch Kühlen eines oder mehrerer der Abschnitte 40-B1, 40-B2, 40-B3, 40-B4, 40-B5 und 40-B6 des Festkörpers 40 können deshalb die länglichen Abschnitten LA1-LA10 bei Bedarf indirekt gekühlt werden. Wie Fig. 4, 5, 13 und 17 andeuten, ist die Induktionsantenne 20A gemäss Fig. 4 in Kombination mit einer Kühleinrichtung offenbart, welche beispielsweise die bereits erwähnten Kühlkörper 60 und 70 umfasst. Im Beispiel gemäss Fig. 4 und 5 ist der Kühlkörper 60 über einen Isolationskörper 90 mit den Abschnitten 30-B1, 30-B2, 30-B3, 30-B4, 30-B5 und 30-B6 des Festkörpers 30 in thermischen Kontakt. Entsprechend ist der Kühlkörper 70 über einen Isolationskörper 90 mit den Abschnitten 40-B1, 40-B2, 40-B3, 40-B4, 40-B5 und 40-B6 des Festkörpers 40 in thermischem Kontakt. Um eine effiziente Kühlung zu ermöglichen, können die Isolationskörper 90 vorzugsweise aus einem elektrisch isolierenden, wärmeleitenden Material gefertigt sein. Alternativ zu den Isolationskörper 90 ist es auch vorstellbar, dass eine Beschichtung aus einem elektrisch isolierenden, wärmeleitenden Material, welche auf die Abschnitte 30-B1, 30-B2, 30-B3, 30-B4, 30-B5 und 30-B6 des Festkörpers 30 und/oder auf die Abschnitte 40-B1, 40-B2, 40-B3, 40-B4, 40-B5 und 40-B6 des Festkörpers 40 aufgebracht ist, und/oder eine Beschichtung aus einem elektrisch isolierenden, wärmeleitenden Material, welche auf den Kühlkörpern 60 bzw. 70 aufgebracht ist, vorgesehen ist.

Wie Fig. 4 andeutet, ist das Stromeinkopplungselement 110 als eine aus einem elektrisch leitfähigen Material bestehende Kühlfluidleitung 111 ausgebildet, wobei durch die Kühlfluidleitung 111 ein Kühlfluid dem Kühlkörper 60 zuführbar und/oder von dem Kühlkörper 60 abführbar ist (wie in Fig. 4 mittels eines mit KF bezeichneten Pfeils, welcher einen Kühlfluid-Strom KF repräsentiert, angedeutet ist). Darüber hinaus kann das Stromauskopplungselement 112 als eine aus einem elektrisch leitfähigen Material bestehende Kühlfluidleitung 113 ausgebildet sein, wobei durch die Kühlfluidleitung 113 ein Kühlfluid dem Kühlkörper 70 zuführbar und/oder von dem Kühlkörper 70 abführbar ist (wie in Fig. 2 mittels eines mit KF bezeichneten Pfeils, welcher einen Kühlfluid-Strom KF repräsentiert, angedeutet ist). Dabei mündet die Kühlfluidleitung 111 in einen im Kühlkörper 60 ausgebildeten Kühlkanal 61, welcher sich entlang der Lötlinie L von einem Ende des Kühlkörpers 60 zum anderen Ende des Kühlkörpers 60 erstreckt. Entsprechend mündet die Kühlfluidleitung 113 in einen im Kühlkörper 70 ausgebildeten Kühlkanal 71, welcher sich entlang der Lötlinie L von einem Ende des Kühlkörpers 70 zum anderen Ende des Kühlkörpers 70 erstreckt. Die beiden Kühlkanäle 61 und 71 können dabei insbesondere am anderen Ende der beiden Kühlkörper 60 und 70 über eine (elektrisch isolierende) Verbindungsleitung 115 miteinander verbunden sein. Dadurch ist es möglich, die beiden Kühlkörper 60, 70 mit einem Kühlfluidkreislauf zu versorgen. Selbstverständlich ist es jedoch auch denkbar, dass jeder der beiden Kühlkörper 60, 70 einen eigenen Külfluidkreislauf aufweist.

Gemäss einer weiteren Variante der in Fig. 4 dargestellten Ausführungsform der Induktionsantenne 20A ist es auch denkbar, den vom Generator 9 erzeugten elektrischen Wechselstrom I nicht über die Kühlfluidleitungen 111 und 113 in die Festkörper 30, 40 einzukoppeln bzw. aus den Festkörpern 30, 40 auszukoppeln. Alternativ kann der elektrische Wechselstrom I auch direkt über die Kühlkörper 60 und 70 ein- bzw. ausgekoppelt werden. Beispielsweise kann der Generator 9 zur Einkopplung bzw. Auskopplung des Wechselstroms auch direkt mit den Kühlkörpern 60 und 70 elektrisch verbunden sein. Da der Festkörper 30 über das Kurzschlusselemente 101 mit dem Kühlkörper 60 verbunden ist und ausserdem der Festkörper 40 über das Kurzschlusselemente 103 mit dem Kühlkörper 70 verbunden ist, können zu diesem Zweck im Prinzip beliebige Bereiche der Kühlkörper 60 und 70 mit dem Generator 9 elektrisch verbunden werden. Beispielsweise kann der Kühlkörper 60 auch an einem von der Kühlmittelleitung 111 abgewandten Ende und der Kühlkörper 70 an einem von der Kühlmittelleitung 113 abgewandten Ende elektrisch mit dem Generator 9 verbunden werden.

Die Induktionsantenne 20A ermöglicht die Erzeugung magnetischer Wechselfelder (H1-H10) mit grosser Feldstärke derart, dass die magnetischen Wechselfelder im Wesentlichen im gesamten Bereich der Lötlinie L, in denen diese Wechselfelder (H1-H10) präsent sind, homogen sind. Zur Verbesserung der Homogenität der magnetischen Wechselfelder trägt insbesondere bei, dass die wechselfelderzeugenden Abschnitte 30-A1, 30-A2, 30-A3, 30-A4 und 30-A5 des Festkörpers 30 und die wechselfelderzeugenden Abschnitte 40-A1, 40-A2, 40-A3, 40-A4 und 40-A5 des Festkörpers 40 geradlinig ausgebildet sein können und ausserdem in einer Reihe hintereinander derart angeordnet sein können, dass sich alle wechselfelderzeugenden Abschnitte der Festkörper 30 und 40 auf einer Geraden im Wesentlichen parallel zur Lötlinie erstrecken. Zur Verbesserung der Homogenität der magnetischen Wechselfelder trägt insbesondere auch bei, dass die länglichen Abschnitte LA1-LA10 sich geradlinig und parallel zur Lötlinie L erstrecken können und über ihre gesamte Länge einen konstanten Querschnitt aufweisen können.

Die Festkörper 30 und 40 können beispielsweise durch spanabhebende Bearbeitung geformt werden. So ist gewährleistet, dass die Festkörper 30 und 40 mit hoher Präzision auf reproduzierbare Weise gefertigt werden können.

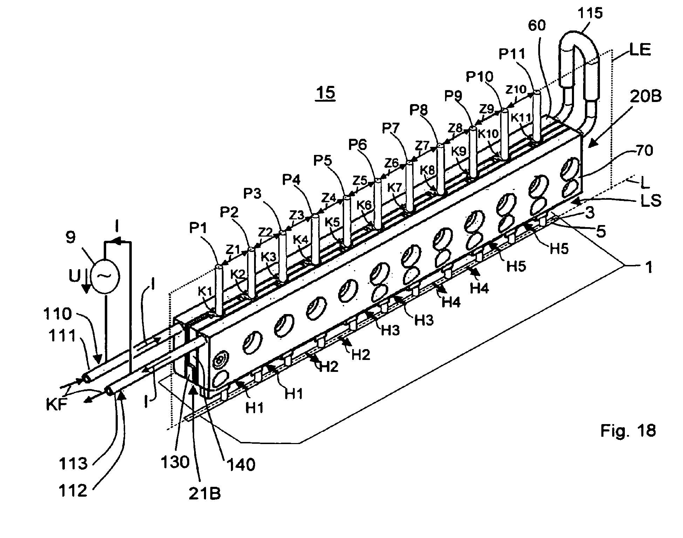

Fig. 18-26 stellen eine zweite Variante der erfindungsgemässen Lötvorrichtung 15 dar, welche eine Induktionsantenne 20B umfasst. Diese Variante der Lötvorrichtung 15 ist mit der Lötvorrichtung 15 gemäss Fig. 4-17 hinsichtlich einer Reihe von Einzelheiten identisch. In Fig. 4-17 bzw. 18-26 dargestellte Merkmale, welche strukturell oder funktionell identisch sind, sind jeweils mit identischen Bezugszeichen versehen. Im Folgenden werden im Wesentlichen Unterschiede zwischen der Lötvorrichtung 15 in der Variante gemäss Fig. 18-26 und der Lötvorrichtung 15 in der Variante gemäss Fig. 4-17 erläutert.

Fig. 18 zeigt die Lötvorrichtung 15 einschliesslich der Induktionsantenne 20B und elf Niederhalterelementen P1-P11 in Kombination mit einer Solarzelle 1, wobei eine an der Oberfläche 1-1 der Solarzelle 1 angeordnete Stromsammelschiene 3 mit einem Band 5 in Kontakt gebracht ist, welches sich in der Längsrichtung der Stromsammelschiene 3 erstreckt. In Fig. 4 ist weiterhin die Lötlinie L in Form einer mathematischen Geraden angegeben. Wie ersichtlich, erstreckt sich die Lötlinie L an einer dem Band 5 zugewandten Oberfläche der Stromsammelschiene 3 in Längsrichtung der Stromsammelschiene 3. Zusätzlich ist in Fig. 4 eine Lötebene LE angegeben, d.h. eine Ebene, welche sich im Wesentlichen senkrecht zur Oberfläche 1-1 der Solarzelle 1 erstreckt und in welcher die Lötlinie L liegt.

Die Niederhalterelemente P1-P11 gemäss Fig. 18 sind wie die Niederhalterelement P1-P11 gemäss Fig. 4 ausgebildet und angeordnet, d.h. die Niederhalterelemente P1-P11 gemäss Fig. 18 erstrecken sich in der Lötebene LE im Wesentlichen senkrecht zur Lötlinie L und sind entlang der Lötlinie L in einer Reihe hintereinander derart angeordnet, dass zwischen diesen Niederhalterelementen P1-P11 Zwischenräume Z1-Z10 ausgebildet sind, wobei jedes der Niederhalterelemente P1-P11 in einem der Kanäle K1-K11 geführt ist, welche in der Induktionsantenne 20B ausgebildet sind.

Wie Fig. 18 andeutet, umfasst die Induktionsantenne 20B einen Strompfad 21B für einen (hochfrequenten) Wechselstrom I, welcher mittels des Generators 9erzeugbar und über das Stromeinkopplungselement 110 und/oder das Stromauskopplungselement 112 in den Strompfad 21B einkoppelbar bzw. aus dem Strompfad 21B auskoppelbar ist, wobei der elektrische Wechselstrom I entlang des Strompfads 21B derart geführt ist, dass er in der Lötlinie L und/oder in einer Umgebung der Lötlinie L ein magnetisches Wechselfeld erzeugt. Im vorliegenden Beispiel ist der Strompfad 21B jeweils abschnittsweise in einem ersten elektrisch leitfähigen Festkörper 130 und in einem zweiten elektrisch leitfähigen Festkörper 140 ausgebildet, wobei sich die Festkörper 130 und 140 - von der Lötlinie L durch einen Luftspalt LS getrennt - entlang der Lötlinie L erstrecken und einzelne Abschnitte der Festkörper 130 und 140 den elektrischen Wechselstrom I entlang der Lötlinie L führen. Demnach bilden die Festkörper 130 und 140 (und entsprechend einzelne Abschnitte der Festkörper 130 und 140) jeweils verschiedene Abschnitte des Strompfads 21B.

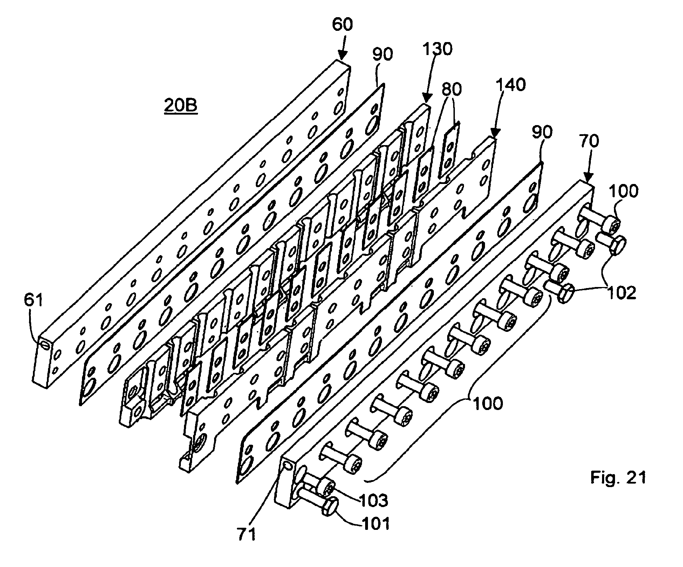

Die Induktionsantenne 20B unterscheidet sich von der Induktionsantenne 20A gemäss Fig. 4 ausschliesslich durch den Strompfad 21B. Letzteres ist u.a. Fig. 21 entnehmbar, welche eine Explosionsdarstellung der Induktionsantenne 20B enthält. Wie ein Vergleich von Fig. 21 mit Fig. 5 zeigt, umfasst die Induktionsantenne 20B dieselben Bauteile wie die Induktionsantenne 20A, mit dem einzigen Unterschied, dass im Falle der Induktionsantenne 20B der Festkörper 30 der Induktionsantenne 20A durch den Festkörper 130 und der Festkörper 40 der Induktionsantenne 20A durch den Festkörper 140 ersetzt sind.

Die vorstehend genannten Unterschiede zwischen den Induktionsantennen 20A und 20B haben zur Folge, dass mittels der Induktionsantenne 20B magnetische Wechselfelder erzeugbar sind, welche eine andere räumliche Verteilung bezüglich der Lötlinie L aufweisen als die magnetischen Wechselfelder, welche mittels der Induktionsantenne 20A erzeugbar sind.

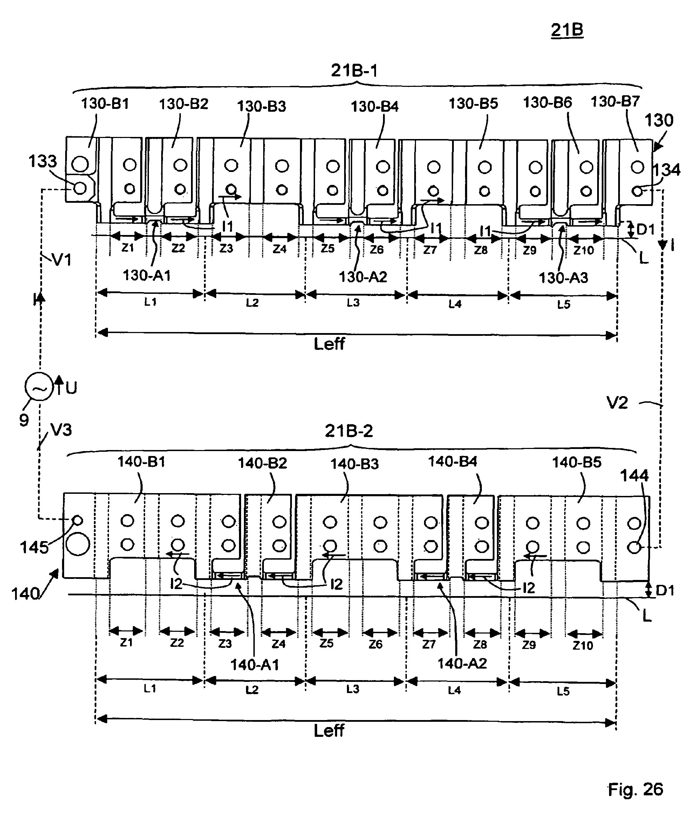

Der Wechselstrom I ist im Strompfad 21B der Induktionsantenne 20B derart entlang der Lötlinie L geführt, dass er in fünf verschiedenen Abschnitten der Lötlinie L, welche im Folgenden mit L1, L2, L3, L4 bzw. L5 bezeichnet werden und deren räumliche Lage bezüglich der jeweiligen Zwischenräume Z1-Z10 in Fig. 26 graphisch dargestellt ist, magnetische Wechselfelder erzeugt, welche im Folgenden mit H1, H2, H3, H4 bzw. H5 bezeichnet werden: Dabei bezeichnet der Ausdruck "Hi" (mit i=1-5) das magnetische Wechselfeld, welches im Abschnitt "Li" der Lötlinie L (jeweils mit i=1-5) präsent ist. Wie Fig. 26 zeigt, erstreckt sich jeder der Abschnitte L1-L5 der Lötlinie jeweils über zwei der Zwischenräume Z1-Z10, welche entlang der Lötlinie L unmittelbar hintereinander angeordnet sind: So erstreckt sich der Abschnitt L1 über die Zwischenräume Z1 und Z2, der Abschnitt L2 über die Zwischenräume Z3 und Z4, der Abschnitt L3 über die Zwischenräume Z5 und Z6, der Abschnitt L4 über die Zwischenräume Z7 und Z8 und der Abschnitt L5 über die Zwischenräume Z9 und Z10.

In Fig. 18 stellen die mit H1, H2, H3, H4 bzw. H5 bezeichneten Pfeile jeweils die Richtung der Feldstärke der magnetischen Wechselfelder H1, H2, H3, H4 bzw. H5 in den verschiedenen Abschnitten L1-L5 der Lötlinie L dar (jeweils für einen der Zwischenräume Z1-Z10 und jeweils für die momentane Stromflussrichtung des Wechselstroms I, welche in Fig. 18 durch mit dem Bezugszeichen I bezeichnete Pfeile gekennzeichnet ist). Wie aus Fig. 18 und 26 ersichtlich, ist jedes der magnetischen Wechselfelder H1-H5 in der Lötlinie L jeweils im Wesentlichen senkrecht zur Lötebene LE und senkrecht zur Lötlinie L gerichtet. Dabei weisen die magnetischen Wechselfelder H1, H3 und H5 in den Abschnitten L1, L3, und L5 bzw. in den Zwischenräumen Z1, Z2, Z5, Z6, Z9 und Z10 jeweils dieselbe Richtung auf und sind somit miteinander in Gleichphase. Hingegen sind die magnetischen Wechselfelder H2 und H4 in den Abschnitten L2 und L4 bzw. in den Zwischenräumen Z3, Z4, Z7 und Z8 entgegengesetzt zu den magnetischen Wechselfeldern H1, H3 und H5 gerichtet, sodass die magnetischen Wechselfelder H1, H3 und H5 in den Abschnitten L1, L3, und L5 jeweils in Gegenphase zu den magnetischen Wechselfeldern H2 und H3 in den Abschnitten L2 und L4 sind.

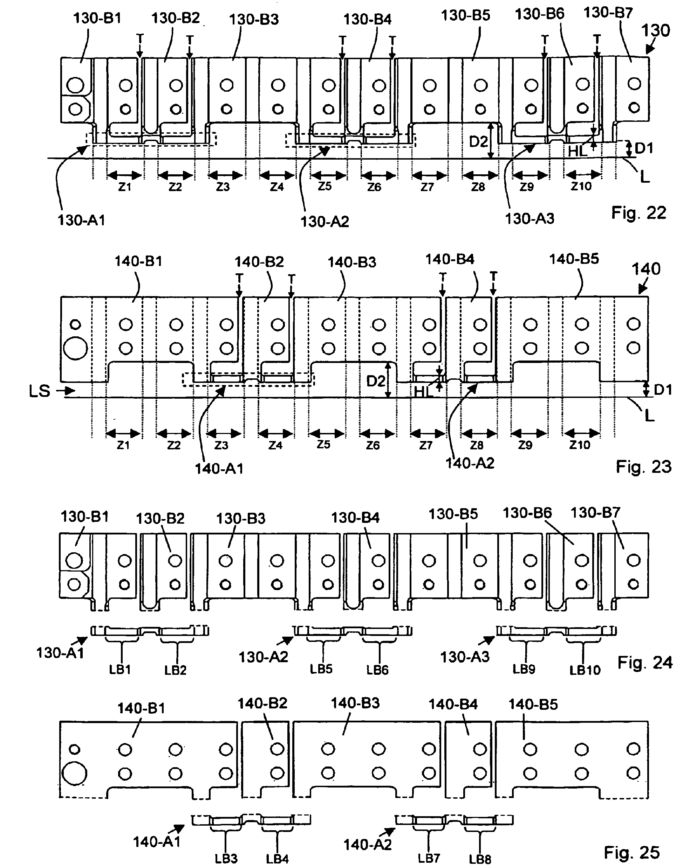

Um die vorstehend genannte räumliche Verteilung der magnetischen Wechselfelder H1-H5 zu gewährleisten, sind die Festkörper 130 und 140 gemäss Fig. 22-25 strukturiert.

Fig. 22 und 23 stellen die Festkörper 130 und 140 separat jeweils in einer Anordnung relativ zur Lötlinie L dar, welche mit der Anordnung der Festkörper 130 und 140 gemäss Fig. 18 identisch ist. Dabei zeigt Fig. 22 den Festkörper 130 in einer Seitenansicht (mit Blickrichtung senkrecht zur Lötebene LE gemäss Fig. 18) und Fig. 23 den Festkörper 140 in einer Seitenansicht (mit Blickrichtung senkrecht zur Lötebene LE gemäss Fig. 18). Wie aus Fig. 22 und 23 ersichtlich, erstrecken sich die Festkörper 130 und 140 im Wesentlichen parallel zur Lötlinie L und sind von der Lötlinie L jeweils durch einen Luftspalt LS getrennt. Um einen Vergleich zwischen der Anordnung des Festkörpers 130 gemäss Fig. 22 und der Anordnung des Festkörpers 140 gemäss Fig. 23 zu ermöglichen, sind sowohl in Fig. 22 als auch in Fig. 23 jeweils die räumlichen Lagen der jeweiligen Zwischenräume Z1-Z11 (wie in Fig. 18 definiert) markiert, sodass aus Fig. 22 und 23 die relative Anordnung der Festkörper 130 und 140 bezüglich der Niederhalterelemente P1-P11 und der Abschnitte L1-L5 der Lötlinie (wie in Fig. 26 definiert) entnehmbar ist.

Wie Fig. 22 andeutet, kann der Festkörper 130 (analog zum Festkörper 30 der Induktionsantenne 20A) als eine lineare Anordnung von verschiedenen, miteinander verbundenen Abschnitten betrachtet werden, welche entlang der Lötlinie L in einer Reihe hintereinander angeordnet sind und sich durch verschiedene Zwischenräume Z1-Z10 in unterschiedlichen Abständen D1 bzw. D2 (mit D2>D1) bezüglich der Lötlinie L erstrecken.

Wie aus Fig. 22 ersichtlich, umfasst der Festkörper 130 eine erste Gruppe von drei Abschnitten 130-A1, 130-A2 und 130-A3, welche jeweils eine längliche Form aufweisen und sich jeweils im Wesentlichen parallel zur Lötlinie L erstrecken, im vorliegenden Beispiel jeweils in einem Abstand D1 bezüglich der Lötlinie L. Der Abschnitt 130-A1 erstreckt sich dabei durch die Zwischenräume Z1 und Z2, der Abschnitt 130-A2 durch die Zwischenräume Z5 und Z6 und der Abschnitt 130-A3 durch die Zwischenräume Z9 und Z10. Weiterhin umfasst der Festkörper 130 eine zweite Gruppe von Abschnitten 130-B1, 130-B2, 130-B3, 130-B4, 130-B5, 130-B6 und 130-B7, welche einen grösseren Abstand von der Lötlinie L aufweisen als die Abschnitte 130-A1, 130-A2 und 130-A3.

Um zu kennzeichnen, welche Bereiche des Festkörpers 130 in diesem Zusammenhang als einer der genannten Abschnitte zu verstehen sein sollen, ist in Fig. 22 jeder der Abschnitte 130-A1, 130-A2 und 30-A3 mit einem aus einer unterbrochenen Linie gebildeten Rechteck umrahmt. Zur Verdeutlichung zeigt Fig. 24 eine Darstellung des Festkörpers 130, in welcher die Abschnitte 130-A1, 130-A2 und 130-A3 von den Abschnitten 130-B1, 130-B2, 130-B3, 130-B4, 130-B5, 130-B6 und 130-B7 getrennt (jeweils entlang der in Fig. 24 angegebenen gestrichelten Linien) und gegenüber den Abschnitten 130-B1, 130-B2, 130-B3, 130-B4, 130-B5, 130-B6 und 130-B7 in Richtung der Lötlinie L verschoben sind (verglichen mit der Darstellung des Festkörpers 130 in Fig. 22).

Wie Fig. 22 weiter andeutet, sind die Abschnitte 130-B1, 130-B2, 130-B3, 130-B4, 130-B5, 130-B6 und 130-B7 in einer Reihe derart hintereinander entlang der Lötlinie L angeordnet, dass jeweils zwei dieser Abschnitte, welche in der Reihe unmittelbar hintereinander angeordnet sind, durch einen sich vertikal zur Lötlinie L erstreckenden Spalt T separiert sind, um eine elektrische Isolation zwischen diesen Abschnitten zu erreichen.

Andererseits sind jeweils zwei der Abschnitte 130-B1, 130-B2, 130-B3, 130-B4, 130-B5, 130-B6 und 130-B7 an einer der Lötlinie L zugewandten Seite über einen der Abschnitte 130-A1, 130-A2 und 130-A3 miteinander verbunden. Wie aus Fig. 22 ersichtlich, ist der Abschnitt 130-A1 an einem seiner beiden Enden mit dem Abschnitt 130-B1 und an dem anderen seiner beiden Enden mit dem Abschnitt 130-B3 verbunden. Weiterhin ist der Abschnitt 130-A2 an einem seiner beiden Enden mit dem Abschnitt 130-B3 und an dem anderen seiner beiden Enden mit dem Abschnitt 130-B5 verbunden. Weiterhin ist der Abschnitt 130-A3 an einem seiner beiden Enden mit dem Abschnitt 130-B5 und an dem anderen seiner beiden Enden mit dem Abschnitt 130-B7 verbunden. Auf diese Weise ist gewährleistet, dass die Abschnitte 130-A1, 130-A2 und 130-A3 derart verbunden sind, dass sie in dieser Reihefolge elektrisch in Reihe geschaltet sind.

Wie im Folgenden noch deutlich wird, haben die Abschnitte 130-A1, 130-A2 und 130-A3 die Funktion, den Wechselstrom I entlang der Lötlinie derart zu führen, dass der Wechselstrom I in der Umgebung dieser Abschnitte bzw. in der Lötlinie L die magnetischen Wechselfelder H1, H3 und H5 erzeugt. Wegen dieser Funktion sollen die Abschnitte 130-A1, 130-A2 und 130-A3 im Folgenden auch als "wechselfelderzeugende" Abschnitte des Festkörpers 130 bzw. des Strompfads 21B bezeichnet werden.

Wie Fig. 23 andeutet, kann der Festkörper 140 (analog zum Festkörper 40 der Induktionsantenne 20A) als eine lineare Anordnung von verschiedenen, miteinander verbundenen Abschnitten betrachtet werden, welche entlang der Lötlinie L in einer Reihe hintereinander angeordnet sind und sich durch verschiedene Zwischenräume Z1-Z10 in unterschiedlichen Abständen D1 bzw. D2 (mit D2>D1) bezüglich der Lötlinie L erstrecken.

Wie aus Fig. 23 ersichtlich, umfasst der Festkörper 140 eine erste Gruppe von zwei Abschnitten 140-A1 und 140-A2, welche jeweils eine längliche Form aufweisen und sich jeweils im Wesentlichen parallel zur Lötlinie L erstrecken, im vorliegenden Beispiel jeweils in einem Abstand D1 bezüglich der Lötlinie L. Der Abschnitt 190-A1 erstreckt sich dabei durch die Zwischenräume Z3 und Z4 und der Abschnitt 140-A2 durch die Zwischenräume Z7 und Z8. Weiterhin umfasst der Festkörper 140 eine zweite Gruppe von Abschnitten 140-B1, 140-B2, 140-B3, 140-B4 und 140-B5, welche einen grösseren Abstand von der Lötlinie L aufweisen als die Abschnitte 140-A1 und 140-A2.

Um zu kennzeichnen, welche Bereiche des Festkörpers 140 in diesem Zusammenhang als einer der genannten Abschnitte zu verstehen sein sollen, ist in Fig. 23 jeder der Abschnitte 140-A1 und 140-A2 mit einem aus einer unterbrochenen Linie gebildeten Rechteck umrahmt. Zur Verdeutlichung zeigt Fig. 25 eine Darstellung des Festkörpers 140, in welcher die Abschnitte 140-A1 und 140-A2 von den Abschnitten 140-B1, 140-B2, 140-B3, 140-B4 und 140-B5 getrennt sind (jeweils entlang der in Fig. 25 angegebenen gestrichelten Linien) und gegenüber den Abschnitten 140-B1, 140-B2, 140-B3, 140-B4 und 140-B5 in Richtung der Lötlinie L verschoben sind (verglichen mit der Darstellung des Festkörpers 140 in Fig. 23).

Wie Fig. 23 weiter andeutet, sind die Abschnitte 140-B1, 140-B2, 140-B3, 140-B4 und 140-B5 in einer Reihe derart hintereinander entlang der Lötlinie L angeordnet, dass jeweils zwei dieser Abschnitte, welche in der Reihe unmittelbar hintereinander angeordnet sind, durch einen sich vertikal zur Lötlinie L erstreckenden Spalt T separiert sind, um eine elektrische Isolation zwischen diesen Abschnitten zu erreichen.

Andererseits sind jeweils zwei der Abschnitte 140-B1, 140-B2, 140-B3, 140-B4 und 140-B5 an einer der Lötlinie L zugewandten Seite über einen der Abschnitte 140-A1 und 140-A2 miteinander verbunden. Wie aus Fig. 23 ersichtlich, ist der Abschnitt 140-A1 an einem seiner beiden Enden mit dem Abschnitt 140-B1 und an dem anderen seiner beiden Enden mit dem Abschnitt 140-B3 verbunden. Weiterhin ist der Abschnitt 140-A2 an einem seiner beiden Enden mit dem Abschnitt 140-B3 und an dem anderen seiner beiden Enden mit dem Abschnitt 140-B5 verbunden. Auf diese Weise ist gewährleistet, dass die Abschnitte 140-A1 und 140-A2 derart verbunden sind, dass sie in dieser Reihefolge elektrisch in Reihe geschaltet sind.

Wie im Folgenden noch deutlich wird, haben die Abschnitte 140-A1 und 140-A2 die Funktion, den Wechselstrom I entlang der Lötlinie L derart zu führen, dass der Wechselstrom I in der Umgebung dieser Abschnitte bzw. in der Lötlinie L die magnetischen Wechselfelder H2 und H4 erzeugt. Wegen dieser Funktion sollen die Abschnitte 140-A1 und 140-A2 im Folgenden auch als "wechselfelderzeugende" Abschnitte des Festkörpers 140 bzw. des Strompfads 21B bezeichnet werden.

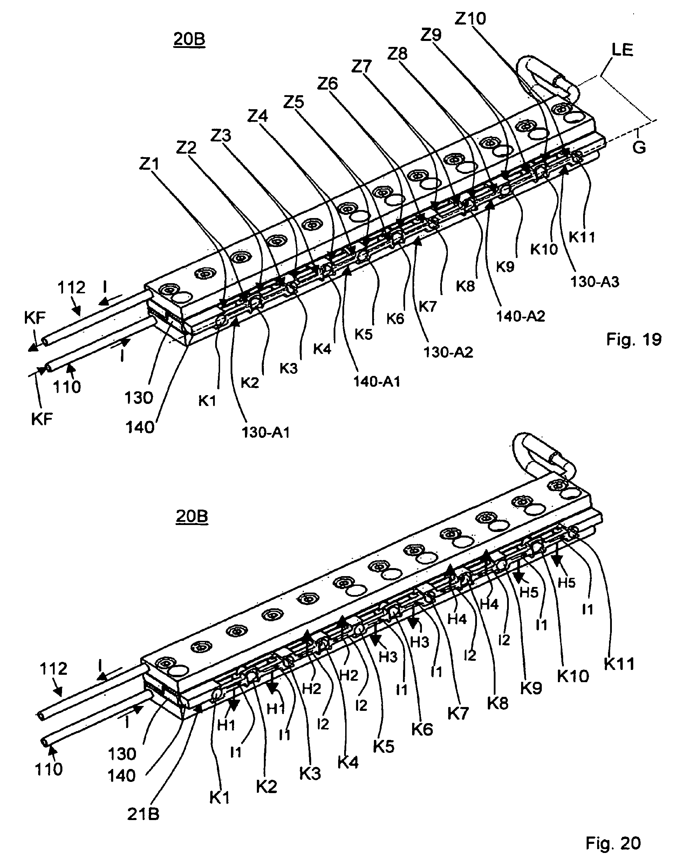

Mit Bezug auf Fig. 19 sei darauf hingewiesen, dass die wechselfelderzeugenden Abschnitte 130-A1, 130-A2 und 130-A3 des Festkörpers 130 und die wechselfelderzeugenden Abschnitte 140-A1 und 140-A2 des Festkörpers 140 abwechselnd in einer Reihe hintereinander angeordnet, sodass auf einen wechselfelderzeugenden Abschnitt des Festkörpers 130 jeweils ein wechselfelderzeugender Abschnitt des Festkörpers 140 folgt (oder umgekehrt). Weiterhin zeigt Fig. 19 die Induktionsantenne 20B in einer bevorzugten Ausführungsform, in welcher die wechselfelderzeugenden Abschnitte 130-A1, 130-A2 und 130-A3 des Festkörpers 130 und die wechselfelderzeugenden Abschnitte 140-A1 und 140-A2 des Festkörpers 140 derart geformt und angeordnet sind, dass sie sich gemeinsam in der Lötebenen LE in einer Reihe hintereinander entlang einer Geraden G - wie in Fig. 19 dargestellt - erstrecken. Letzteres ist vorteilhaft im Hinblick auf die Homogenität der magnetischen Wechselfelder H1-H5 entlang der Lötlinie L.

Fig. 26 zeigt eine schematische Darstellung des Strompfads 21B der Induktionsantenne 20B gemäss Fig. 18. Dabei ist angenommen, dass der Generator 9 für den Wechselstrom I - wie in Fig. 18 dargestellt - an das Stromeinkopplungselement 110 bzw. das Stromauskopplungselement 112 angeschlossen ist, sodass ein vom Generator 9 erzeugter Wechselstrom I im Strompfad 21B zwischen dem Stromeinkopplungselement 110 und dem Stromauskopplungselement 112 fliessen kann und dabei in der Lötlinie L ein magnetisches Wechselfeld bzw. magnetisches Wechselfelder erzeugt.

Fig. 26 stellt die Anordnung des Strompfads 21B der Induktionsantenne 20B relativ zur Lötlinie L für den Fall dar, dass der Abschnitt 130-B7 des Festkörpers 130 mit dem Abschnitt 140-B5 des Festkörpers 140 elektrisch verbunden ist. In Fig. 26 stellen gestrichelte, mit V1, V2 bzw. V3 bezeichnete Linien jeweils elektrische Verbindungen dar, welche zwischen dem Generator 9 und den Festkörpern 130 bzw. 140 oder zwischen den Festkörpern 130 und 140 bestehen. Dabei repräsentiert die elektrische Verbindung V1 eine elektrische Verbindung zwischen dem Generator 9 und dem Abschnitt 130-B1 des Festkörpers 130 (beispielsweise realisiert mittels eines Kurzschlusselements 101, welches in der in Fig. 26 dargestellten Bohrung 133 im Abschnitt 130-B1 des Festkörpers 130 platziert ist und für eine elektrische Verbindung zwischen dem Abschnitt 130-B1 und dem Kühlkörper 60 bzw. dem Stromeinkopplungselement 110 sorgt). Entsprechend repräsentiert die elektrische Verbindung V2 die bereits erwähnte Verbindung zwischen dem Abschnitt 130-B7 des Festkörpers 30 und dem Abschnitt 140-B5 des Festkörpers 140. Diese Verbindung V2 kann mittels eines Kurzschlusselements 102, welches sowohl in einer Bohrung 134 des Abschnitts 130-B7 des Festkörpers 130 als auch in einer Bohrung 144 des Abschnitt 140-B5 des Festkörpers 140 sitzt, realisiert sein. Entsprechend repräsentiert die elektrische Verbindung V3 eine elektrische Verbindung zwischen dem Generator 9 und dem Abschnitt 140-B1 des Festkörpers 140 (beispielsweise realisiert mittels eines Kurzschlusselements 103, welches in der in Fig. 26 dargestellten Bohrung 145 im Abschnitt 140-B1 des Festkörpers 140 platziert ist und für eine elektrische Verbindung zwischen dem Abschnitt 140-B1 und dem Kühlkörper 70 bzw. dem Stromauskopplungselement 112 sorgt).

In Fig. 26 ist - der Übersichtlichkeit halber - die Anordnung des Festkörpers 130 und die Anordnung des Festkörpers 140 in zwei übereinander angeordneten Zeichnungen - jeweils relativ zur Lötlinie L - dargestellt. Aus diesem Grund enthält Fig. 26 in einem oberen Teil eine Darstellung des Festkörpers 130 in einer Seitenansicht (mit Blickrichtung senkrecht zur Lötebene LE gemäss Fig. 18, entsprechend der Darstellung des Festkörpers 130 in Fig. 22) und in einem unteren Teil eine Darstellung des Festkörpers 140 in einer Seitenansicht (mit Blickrichtung senkrecht zur Lötebene LE gemäss Fig. 18, entsprechend der Darstellung des Festkörpers 140 in Fig. 23). In Fig. 26 ist weiterhin eine Einteilung der Lötlinie L in die verschiedenen (bereits erwähnten) Abschnitte L1, L2, L3, L4 bzw. L5 dargestellt, welche in der vorstehend genannten Reihenfolge in einer Reihe hintereinander angeordnet sind.

Gemäss Fig. 26 kann der Strompfad 21B als eine Reihenschaltung von zwei Abschnitten dieses Strompfads aufgefasst werden, welche in Fig. 26 mit 21B-1 und 21B-2 bezeichnet sind: "Abschnitt 21B-1" repräsentiert denjenigen Abschnitt des Strompfads 21B, welcher im Festkörper 130 ausgebildet ist; entsprechend repräsentiert "Abschnitt 21B-2" denjenigen Abschnitt des Strompfads 21B, welcher im Festkörper 140 ausgebildet ist.

Die Abschnitte 21B-1 und 21-B2 des Strompfads 21B sind über die elektrische Verbindung V2 derart in Reihe hintereinander geschaltet, dass der Wechselstrom I sowohl im Abschnitt 21B-1 und als auch im Abschnitt 21-B2 entlang der Lötlinie L geführt ist, allerdings derart, dass der Wechselstrom I im Abschnitt 21B-1 des Strompfads 21B in Gegenphase zum Wechselstrom I im Abschnitt 21B-2 des Strompfads 21B ist. Zur Verdeutlichung dieses Sachverhalts geben in Fig. 26 jeweils mit dem Bezugszeichen I versehene Pfeile die momentane Stromflussrichtung eines vom Generator 9 erzeugten elektrischen Wechselstroms I für einen bestimmten Zeitpunkt an, wobei die momentane Stromflussrichtung des Wechselstroms I in der Darstellungen gemäss Fig. 26 mit der momentane Stromflussrichtung des Wechselstroms I in der Darstellung gemäss Fig. 18 übereinstimmt. Der Wechselstrom I fliesst, wie ersichtlich, zwischen den elektrischen Verbindungen V1 und V2 jeweils durch den Abschnitt 21B-1 des Strompfads 21B und zwischen den elektrischen Verbindungen V2 und V3 jeweils durch den Abschnitt 21B-2 des Strompfads 21B. Weiterhin geben mit dem Bezugszeichen I1 versehene Pfeile die momentane Stromflussrichtung des elektrischen Wechselstroms I im Abschnitt 21B-1 des Strompfads 21B und mit dem Bezugszeichen I2 versehene Pfeile die momentane Stromflussrichtung des elektrischen Wechselstroms I im Abschnitt 21B-2 des Strompfads 21B (für denselben bestimmten Zeitpunkt) an.

Wie aus Fig. 22-26 ersichtlich, ist die momentane Stromflussrichtung des Wechselstroms I in den Abschnitten 130-A1, 130-A2 und 130-A3 des Festkörpers 130 (entsprechend der Stromflussrichtung I1 in Fig. 26) jeweils entgegengesetzt zur Stromflussrichtung des Wechselstroms I in den Abschnitten 140-A1 und 140-A2 des Festkörpers 140 (entsprechend Stromflussrichtung I2 in Fig. 26). Dementsprechend ist der elektrische Wechselstrom I in den Abschnitten 130-A1, 130-A2 und 130-A3 des Festkörpers 130 jeweils in Gleichphase und in den Abschnitten 130-A1, 130-A2 und 130-A3 des Festkörpers 130 jeweils in Gegenphase zum elektrischen Wechselstrom I in den Abschnitten 140-A1 und 140-A2 des Festkörpers 140.

Wie aus Fig. 22-26 ersichtlich, erstrecken sich im vorliegenden Beispiel die Abschnitte 130-A1, 140-A1, 130-A2, 140-A2 und 130-A3 in dieser Reihenfolge in einer Reihe hintereinander entlang der Lötlinie L jeweils in einem Abstand D1 zur Lötlinie L und sind dabei durch einen Luftspalt LS von der Lötlinie L getrennt. Im Vergleich zum Abstand D1 sind die jeweiligen Abstände der der Abschnitte 140-B1, 140-B3, bzw. 140-B5 des Festkörpers 140 und der Abschnitte 130-B3, 130-B5 bzw. 130-B7 des Festkörpers 130 von der Lötlinie L derart gross gewählt, dass der in den Abschnitten 140-B1, 140-B3 bzw. 140-B5 des Festkörpers 140 und in den Abschnitten 130-B3, 130-B5 bzw. 130-B7 des Festkörpers 130 fliessende Wechselstrom I keinen bzw. ein relativ kleinen (vernachlässigbaren) Beitrag zu den magnetischen Wechselfeldern liefert, welche der elektrische Wechselstrom I in der Lötlinie L erzeugt.

Dementsprechend erzeugt der durch die Abschnitte 130-A1, 130-A2 und 130-A3 des Festkörpers 130 fliessende elektrische Wechselstrom I die magnetischen Wechselfelder H1, H3 und H5, welche in den Zwischenräumen Z1, Z2, Z5, Z6, Z9 und Z10 bzw. den Abschnitten L1, L3, L5 der Lötlinie L präsent sind. Entsprechend erzeugt der durch die Abschnitte 140-A1 und 140-A2 des Festkörpers 140 fliessende elektrische Wechselstrom I die magnetischen Wechselfelder H2 und H4, welche in den Zwischenräumen Z3, Z4, Z7 und Z8 bzw. den Abschnitten L2 und L4 präsent sind. Da der elektrische Wechselstrom I in den Abschnitten 130-A1, 130-A2 und 130-A3 des Festkörpers 130 (wie erwähnt) in Gegenphase zum elektrische Wechselstrom I in den Abschnitten 140-A1 und 140-A2 des Festkörpers 140 ist, ist jeweils gewährleistet, dass die magnetischen Wechselfelder H1, H3 und H5 jeweils in Gegenphase zu den magnetischen Wechselfeldern H2 und H4 sind. Die effektive Länge der Induktionsantenne 21B erstreckt sich im vorliegenden Fall über alle Abschnitte L1-L5 der Lötlinie L (wie in Fig. 26 durch einen mit dem Bezugszeichen Leff versehenen Doppelpfeil gekennzeichnet).

Fig. 20 zeigt die Induktionsantenne 20B gemäss Fig. 18 in einer der Fig. 19 entsprechenden Ansicht. Im Falle der Fig. 20 ist angenommen, dass der Strompfad 21B der Induktionsantenne 20B entsprechend der in Fig. 26 dargestellten Ausführungsform des Strompfads 21B ausbildet ist. In Fig. 20 sind jeweils mit den Bezugszeichen I, I1 bzw. I2 bezeichnete Pfeile eingezeichnet, welche dieselbe Bedeutung haben wie die entsprechenden, mit I, I1 bzw. I2 bezeichneten Pfeile im Falle der Fig. 26. Dementsprechend geben mit I1 bezeichneten Pfeile die momentane Stromrichtung des Wechselstroms I in den in Fig. 19 gekennzeichneten Abschnitten 130-A1, 130-A2 und 130-A3 des Festkörpers 130 und die mit I2 bezeichneten Pfeile die momentane Stromrichtung des Wechselstroms I in den in Fig. 19 gekennzeichneten länglichen Abschnitten 140-A1 und 140-A2 des Festkörpers 140 jeweils für einen bestimmten Zeitpunkt an. Zusätzlich sind in Fig. 20 Pfeile H1, H2, H3, H4 und H5 eingezeichnet, welche die momentane Richtung der magnetischen Feldstärke der durch den Wechselstrom I erzeugten magnetischen Wechselfelder H1-H5, wie in Fig. 18 angegeben, darstellen. Dementsprechend gibt der mit Hi bezeichnete Pfeil in Fig. 20 die momentane Richtung der Feldstärke des Wechselfelds Hi in der Lötlinie L in dem Abschnitt Li gemäss Fig. 26 an, wobei i=1-5. Demnach zeigt Fig. 20 verschiedene Abschnitte des Strompfads 21A mit einander entgegengesetzten Stromflussrichtungen I1 bzw. I2 im Korrelation mit der momentanen Richtung der Wechselfelder, welche in der Umgebung der jeweiligen Abschnitte des Strompfads 21B erzeugt werden. Deutlich erkennbar sind verschiedene Abschnitte des Strompfads 21B, in deren Umgebung die jeweiligen magnetischen Wechselfelder entgegengesetzt gerichtet sind und somit in Gegenphase zueinander sind.

Mit Bezug auf Fig. 18-25 sei darauf hingewiesen, dass jeder der wechselfelderzeugenden Abschnitte 130-A1, 130-A2 und 130-A3 des Festkörpers 130 und die wechselfelderzeugenden Abschnitte 140-A1 und 140-A2 des Festkörpers 140 jeweils drei Ausnehmungen aufweist, welche sich in der Lötebene LE im Wesentlichen senkrecht zur Lötlinie L erstrecken, wobei an jedem der beiden Enden des jeweiligen wechselfelderzeugenden Abschnitts und in der Mitte zwischen den beiden Enden des jeweiligen wechselfelderzeugenden Abschnitts jeweils eine der drei Ausnehmungen ausgebildet ist. Diese Ausnehmungen bilden - wenn die Festkörper 130 und 140 der Induktionsantenne 20B derart angeordnet sind, dass sie sich relativ zueinander und relativ zu den Niederhalterelementen P1-P11 in der in Fig. 18 dargestellten Anordnung befinden - die in Fig. 18-20 dargestellten Kanäle K1-K11 zur Führung der Niederhalterelemente P1-P11.

Mit Bezug auf Fig. 18-25 sei darauf hingewiesen, dass jeder der wechselfelderzeugenden Abschnitte 130-A1, 130-A2 und 130-A3 des Festkörpers 130 und die wechselfelderzeugenden Abschnitte 140-A1 und 140-A2 des Festkörpers 140 jeweils zwei längliche Abschnitte aufweist, welche in der Induktionsantenne 20B gemäss Fig. 18 vorzugsweise derart angeordnet sind, dass sie sich in der Lötebenen LE jeweils geradlinig und im Wesentlichen parallel zur Lötlinie L erstrecken. Diese länglichen Abschnitte werden im Folgenden mit LB1, LB2, LB3, LB4, LB5, LB6, LB7, LB8, LB9 bzw. LB10 bezeichnet und sind in Fig. 24 und 25 jeweils gekennzeichnet (mittels geschweiften Klammern, welche die Erstreckung des jeweiligen länglichen Abschnitts in Richtung der Lötlinie L markiert). Jeder dieser länglichen Abschnitte ist derart angeordnet, dass er sich durch jeweils einen der Zwischenräume Z1-Z10 zwischen jeweils zwei der Niederhalterelemente P1-P11 bzw. zwischen zwei der Kanäle K1-K11 erstreckt. Jeder der länglichen Abschnitte LB1, LB2, LB3, LB4, LB5, LB6, LB7, LB8, LB9 bzw. LB10 kann über seine gesamte Länge einen konstanten Querschnitt aufweisen. Wie aus Fig. 19, 24 und 25 entnehmbar, können die länglichen Abschnitte LB1, LB2, LB3, LB4, LB5, LB6, LB7, LB8, LB9 und LB10 derart in einer Reihe hintereinander angeordnet sein, dass sie sich entlang einer Geraden (Gerade G in Fig. 19) erstrecken. Diese Ausbildung der wechselfelderzeugenden Abschnitte 130-A1, 130-A2 und 130-A3 des Festkörpers 130 und der wechselfelderzeugenden Abschnitte 140-A1 und 140-A2 des Festkörpers 140 ermöglicht eine besonders homogene räumliche Verteilung der magnetischen Wechselfelder entlang der Lötlinie L.

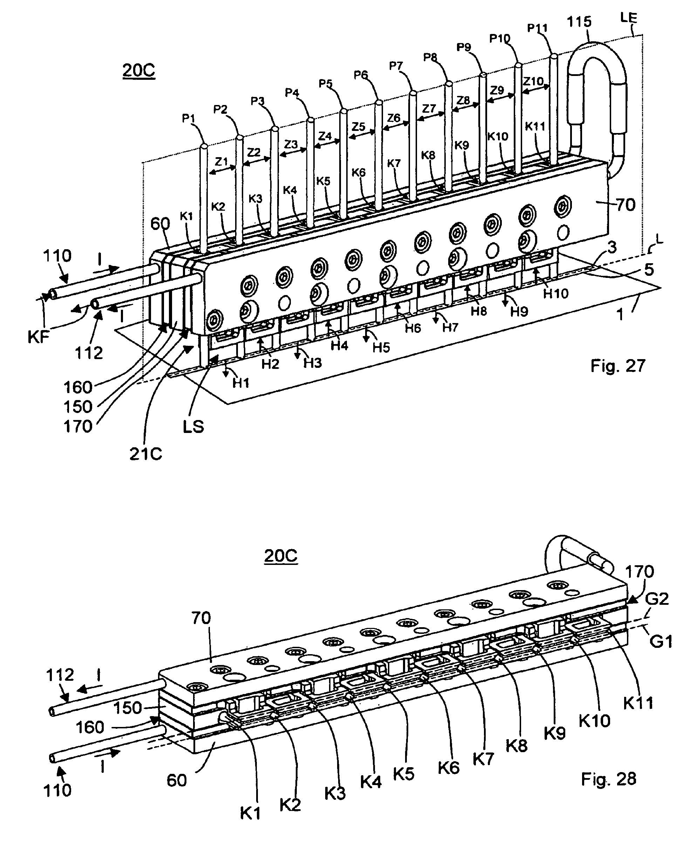

Fig. 27-40 stellen eine dritte Variante der erfindungsgemässen Lötvorrichtung 15 dar, welche eine Induktionsantenne 20C mit einem Strompfad 21C für einen (hochfrequenten) elektrischen Wechselstrom I umfasst. Diese Variante der Lötvorrichtung 15 ist mit der Lötvorrichtung 15 gemäss Fig. 4-17 hinsichtlich einer Reihe von Einzelheiten identisch. In Fig. 4-17 bzw. 27-40 dargestellte Merkmale, welche strukturell oder funktionell identisch sind, sind jeweils mit identischen Bezugszeichen versehen. Im Folgenden werden im Wesentlichen Unterschiede zwischen der Lötvorrichtung 15 in der Variante gemäss Fig. 27-40 und der Lötvorrichtung 15 in der Variante gemäss Fig. 4-17 erläutert.

Fig. 27 zeigt die Lötvorrichtung 15 einschliesslich der Induktionsantenne 20C und elf Niederhalterelementen P1-P11 in Kombination mit einer Solarzelle 1, wobei eine an einer Oberfläche der Solarzelle 1 angeordnete Stromsammelschiene 3 mit einem Band 5 in Kontakt gebracht ist, welches sich in der Längsrichtung der Stromsammelschiene 3 erstreckt. In Fig. 27 ist weiterhin die Lötlinie L in Form einer mathematischen Geraden angegeben. Wie ersichtlich, erstreckt sich die Lötlinie L an einer dem Band 5 zugewandten Oberfläche der Stromsammelschiene 3 in Längsrichtung der Stromsammelschiene 3. Zusätzlich ist in Fig. 27 eine Lötebene LE angegeben, d.h. eine Ebene, welche sich im Wesentlichen senkrecht zur Oberfläche 1-1 der Solarzelle 1 erstreckt und in welcher die Lötlinie L liegt.

Die Niederhalterelemente P1-P11 gemäss Fig. 27 sind wie die Niederhalterelemente P1-P11 gemäss Fig. 4 ausgebildet und angeordnet, d.h. die Niederhalterelemente P1-P11 gemäss Fig. 27 erstrecken sich in der Lötebene LE im Wesentlichen senkrecht zur Lötlinie L und sind entlang der Lötlinie L in einer Reihe hintereinander derart angeordnet, dass zwischen diesen Niederhalterelementen P1-P11 Zwischenräume Z1-Z10 ausgebildet sind, wobei jedes der Niederhalterelemente P1-P11 in einem der Kanäle K1-K11 geführt sind, welche in der Induktionsantenne 20C ausgebildet sind.

Wie Fig. 27 andeutet, umfasst die Induktionsantenne 20C einen Strompfad 21C für einen (hochfrequenten) Wechselstrom I, welcher mittels eines (in Fig. 27 nicht dargestellten) Generators (z.B. Generator 9 gemäss Fig. 4) erzeugbar und über das Stromeinkopplungselement 110 und/oder das Stromauskopplungselement 112 in den Strompfad 21C einkoppelbar bzw. aus dem Strompfad 21C auskoppelbar ist, wobei der elektrische Wechselstrom I entlang des Strompfads 21C derart geführt ist, dass er in der Lötlinie L und/oder in einer Umgebung der Lötlinie L ein magnetisches Wechselfeld erzeugt.

Im vorliegenden Beispiel ist der Strompfad 21C jeweils abschnittsweise in mehreren verschiedenen elektrisch leitfähigen Festkörpern ausgebildet, wobei zwischen drei verschiedenen Gruppen von einem oder mehreren dieser Festkörper unterschieden werden kann: Zu diesen Festkörpern gehören (wie Fig. 27 andeutet) ein elektrisch leitfähiger Festkörper 150, eine Gruppe 160 von einem oder mehreren elektrisch leitfähigen Festkörpern und eine Gruppe 170 von einem oder mehreren elektrisch leitfähigen Festkörpern, wobei sich der Festkörper 150, die zur Gruppe 160 gehörenden Festkörper und die zur Gruppe 170 gehörenden Festkörper - von der Lötlinie L durch einen Luftspalt LS getrennt - entlang der Lötlinie L erstrecken und einzelne Abschnitte dieser Festkörper den elektrischen Wechselstrom I entlang der Lötlinie L führen. Demnach bilden der Festkörper 150, die zur Gruppe 160 gehörenden Festkörper und die zur Gruppe 170 gehörenden Festkörper (und entsprechend einzelne Abschnitte dieser Festkörper) jeweils verschiedene Abschnitte des Strompfads 21C.

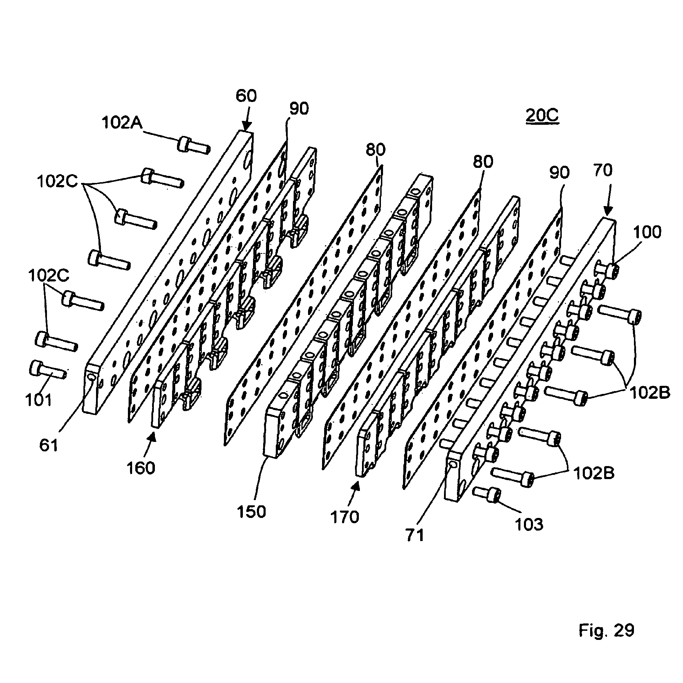

Wie im Folgenden (insbesondere im Zusammenhang mit Fig. 29-40) noch näher erläutert wird, unterscheidet sich die Induktionsantenne 20C von der Induktionsantenne 20A gemäss Fig. 4 im Wesentlichen durch den Strompfad 21C. Dieser Unterschied zwischen den Induktionsantennen 20A und 20C hat zur Folge, dass mittels der Induktionsantenne 20C magnetische Wechselfelder erzeugbar sind, welche eine andere räumliche Verteilung bezüglich der Lötlinie L aufweisen als die magnetischen Wechselfelder, welche mittels der Induktionsantenne 20A erzeugbar sind.

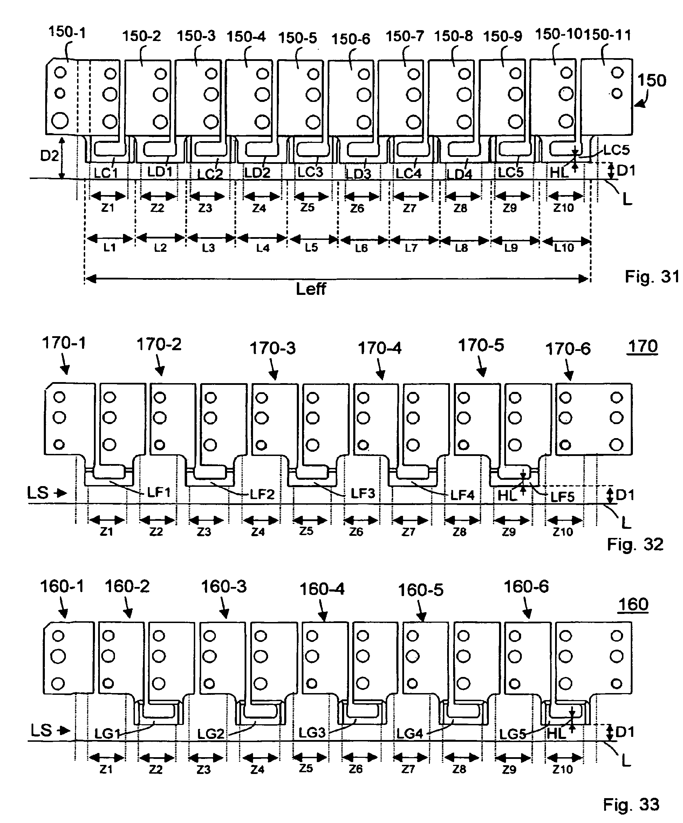

Der Wechselstrom I ist im Strompfad 21C der Induktionsantenne 20C derart entlang der Lötlinie L geführt, dass er in zehn verschiedenen Abschnitten der Lötlinie L, welche im Folgenden mit L1, L2, L3, L4, L5, L6, L7, L8, L9 und L10 bezeichnet werden und deren räumliche Lage bezüglich der jeweiligen Zwischenräume Z1-Z10 in Fig. 31 graphisch dargestellt ist, magnetische Wechselfelder erzeugt, welche im Folgenden mit H1, H2, H3, H4, H5, H6, H7, H8, H9 und H10 bezeichnet werden: Dabei bezeichnet der Ausdruck "Hi" (mit i=1-10) das magnetische Wechselfeld, welches im Abschnitt "Li" der Lötlinie L (jeweils mit i=1-10) präsent ist. Wie Fig. 27 und 31 zeigen, erstreckt sich jeder der Abschnitte L1-L10 der Lötlinie L jeweils über einen der Zwischenräume Z1-Z10.

In Fig. 27 stellen die mit H1, H2, H3, H4, H5, H6, H7, H8, H9 bzw. H10 bezeichneten Pfeile jeweils die Richtung der Feldstärke der magnetischen Wechselfelder H1, H2, H3, H4, H5, H6, H7, H8, H9 bzw. H10 in den verschiedenen Abschnitten L1-L10 der Lötlinie L dar (jeweils für einen der Zwischenräume Z1-Z10 bzw. einen der Abschnitte L1-L10 der Lötlinie L und jeweils für die momentane Stromflussrichtung des Wechselstroms I, welche in Fig. 27 durch mit dem Bezugszeichen I bezeichnete Pfeile gekennzeichnet ist). Wie aus Fig. 27 ersichtlich, ist jedes der magnetischen Wechselfelder H1-H10 in der Lötlinie L jeweils im Wesentlichen parallel zur Lötebene LE und senkrecht zur Lötlinie L gerichtet. Dabei weisen die magnetischen Wechselfelder H1, H3, H5, H7 und H9 in den Abschnitten L1, L3, L5, L7 und L9 bzw. in den Zwischenräumen Z1, Z3, Z5, Z7 und Z9 jeweils dieselbe Richtung auf und sind somit miteinander in Gleichphase. Hingegen sind die magnetischen Wechselfelder H2, H4, H6, H8 und H10 in den Abschnitten L2, L4, L6, L8 und L10 bzw. in den Zwischenräumen Z2, Z4, Z6, Z8 und Z10 entgegengesetzt zu den magnetischen Wechselfeldern H1, H3, H5, H7 und H9 gerichtet, sodass die magnetischen Wechselfelder H1, H3, H5, H7 und H9 in den Abschnitten L1, L3, L5, L7 und L9 jeweils in Gegenphase zu den magnetischen Wechselfeldern H2, H4, H6, H8 und H10 in den Abschnitten L2, L4, L6, L8 und L10 sind.

Um die vorstehend genannte räumliche Verteilung der magnetischen Wechselfelder H1-H10 zu gewährleisten, sind der Festkörper 150, die zur Gruppe 160 gehörenden Festkörper und die zur Gruppe 170 gehörenden Festkörper gemäss Fig. 29-33 strukturiert und gemäss Fig. 29 und 34-39 miteinander elektrisch verbunden. Mit Bezug auf Fig. 29-34 werden im Folgenden konstruktive Einzelheiten des Strompfads 21C der Induktionsantenne 20C erläutert.

Fig. 29 zeigt einzelne Komponenten der Induktionsantenne 20C gemäss Fig. 27 in einer Explosionsdarstellung, wobei die jeweiligen Komponenten in einer zur Lötebene LE senkrechten Richtung voneinander separiert sind. Wie ersichtlich, umfasst die Induktionsantenne 20C im vorliegenden Beispiel - zusätzlich zu dem Festkörper 150, der Gruppe 160 von Festkörpern und der Gruppe 170 von Festkörpern - (optionale) Kühlkörper 60 und 70, zwei Isolationskörper 90 (aus einem elektrisch isolierenden Material) und zwei Isolationskörper 80 (aus einem elektrisch isolierenden Material). Die Kühlkörper 60, 70 bzw. die Isolationskörper 80, 90 der Induktionsantenne 20C sind mit den entsprechenden Kühlkörpern 60, 70 bzw. den Isolationskörpern 80, 90 der Induktionsantenne 20A gemäss Fig. 4 zumindest in funktioneller Hinsicht identisch, können sich aber beispielsweise hinsichtlich ihrer Form bzw. hinsichtlich der Anordnung von Bohrungen für Befestigungsmittel oder Kurzschlusselemente unterscheiden.

Der Festkörper 150, die Gruppe 160 von Festkörpern und die Gruppe 170 von Festkörpern sind nebeneinander angeordnet und erstrecken sich zwischen den Kühlkörpern 60 und 70 im Wesentlichen parallel zueinander in eine vorgegebene Richtung (gemäss Fig. 27 im Wesentliche parallel zur Lötebene LE und zur Lötlinie L). Dabei ist der Festkörper 150 zwischen der Gruppe 160 von Festkörpern und der Gruppe 170 von Festkörpern platziert.

Die Kühlkörper 60 und 70, der Festkörper 150, die zur Gruppe 160 gehörenden Festkörper und die zur Gruppe 170 gehörenden Festkörpern sind jeweils gegeneinander elektrisch isoliert mittels der Isolationskörper 80 und 90. Einer der Isolationskörper 90 ist zwischen dem Kühlkörper 60 und der Gruppe 160 von Festkörpern angeordnet, um eine elektrische Isolierung zwischen dem Kühlkörper 60 und den zur Gruppe 160 gehörenden Festkörpern zu erreichen. Einer der Isolationskörper 80 ist zwischen der Gruppe 160 von Festkörpern und dem Festkörper 150 platziert, um eine elektrische Isolierung zwischen dem Festkörper 150 und den zur Gruppe 160 gehörenden Festkörpern zu erreichen. Einer der Isolationskörper 80 ist zwischen dem Festkörper 150 und der Gruppe 170 von Festkörpern platziert, um eine elektrische Isolierung zwischen dem Festkörper 150 und den zur Gruppe 170 gehörenden Festkörpern zu erreichen. Weiterhin ist einer der Isolationskörper 90 zwischen der Gruppe 170 von Festkörpern und dem Kühlkörper 70 platziert, um eine elektrische Isolierung zwischen dem Kühlkörper 70 und den zur Gruppe 170 gehörenden Festkörpern zu erreichen.

Wie weiterhin aus Fig. 29 ersichtlich ist, umfasst die Induktionsantenne 20C gemäss Fig. 27 Befestigungsmittel 100, welche dazu dienen, den Festkörper 150, die Gruppe 160 von Festkörpern, die Gruppe 170 von Festkörpern, die Kühlkörper 60, 70 und die Isolationskörper 80, 90 mechanisch miteinander zu verbinden und derart zusammenzuhalten, dass die Induktionsantenne 20C eine Einheit bildet, welche als Ganzes in einer vorgegebenen Position bezüglich der Lötlinie L gehalten werden kann.

Weiterhin umfasst die Induktionsantenne 20C ein Kurzschlusselement 101, welches dazu dient, eine elektrische Verbindung zwischen dem Kühlkörper 60 bzw. dem Stromeinkopplungselement 110 und dem Festkörper 150 herzustellen. Weiterhin umfasst die Induktionsantenne 20C mindestens ein Kurzschlusselement 102A, welches dazu dient, eine elektrische Verbindung zwischen dem Festkörper 150 und mindestens einem der zur Gruppe 160 gehörenden Festkörper herzustellen. Zusätzlich umfasst die Induktionsantenne 20C ein oder mehrere Kurzschlusselemente 102B und ein oder mehrere Kurzschlusselemente 102C. Die jeweiligen Kurzschlusselemente 102B und 102C dienen dazu, elektrische Verbindungen zwischen den zur Gruppe 160 gehörenden Festkörpern und den zur Gruppe 170 gehörenden Festkörpern herzustellen. Weiterhin umfasst die Induktionsantenne 20C mindestens ein Kurzschlusselement 103, welches dazu dient, eine elektrische Verbindung zwischen dem Kühlkörper 70 bzw. dem Stromauskopplungselement 112 und einem zur Annordnung 170 gehörenden Festkörper herzustellen.

Die Befestigungsmittel 100 und die Kurzschlusselemente 101, 102A, 102B, 102C und 103 sind im vorliegenden Beispiel als Schrauben ausgeführt, können aber selbstverständlich durch andere, hinsichtlich ihrer Funktion ebenfalls geeignete Mittel ersetzt werden. Um die Befestigungsmittel 100 und die Kurzschlusselemente 101, 102A, 102B, 102C und 103 bei einer Montage der Induktionsantenne 20C geeignet platzieren zu können, weisen der Kühlkörper 60, der Kühlkörper 70, der Festkörper 150, die zur Gruppe 160 gehörenden Festkörper, die zur Gruppe 170 gehörenden Festkörper und die Isolationskörper 80 und 90 entsprechend angeordnete Bohrungen auf, in welche die jeweiligen Befestigungsmittel 100 bzw. Kurzschlusselemente 101, 102A, 102B, 102C und 103 einsetzbar sind (was an dieser Stelle nicht im Einzelnen erläutert werden soll).

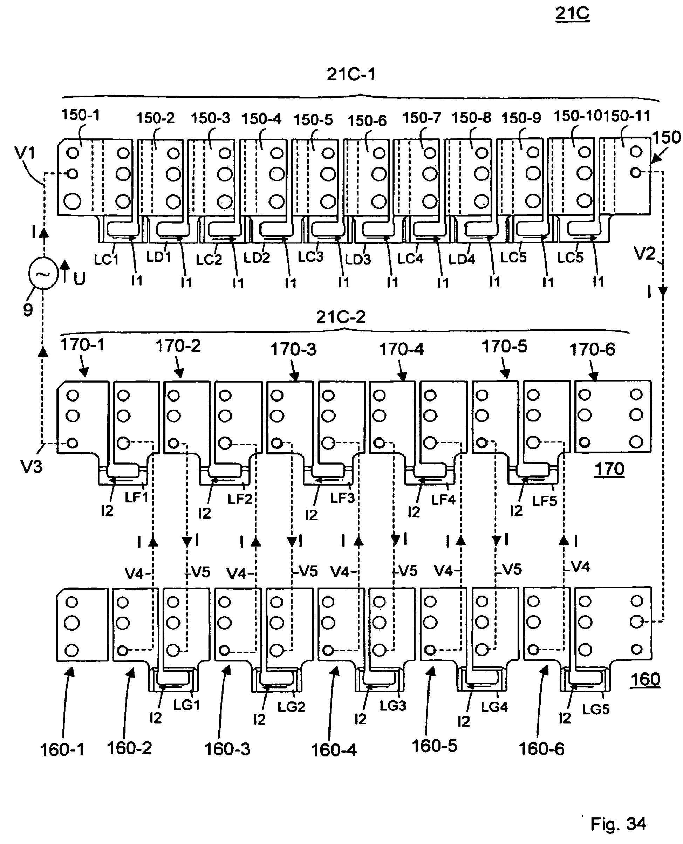

Wenn alle in Fig. 29 sichtbaren Teile der Induktionsantenne 20C derart zusammengefügt sind, dass sie eine (betriebsbereite) Induktionsantenne 20C in der in Fig. 27 dargestellten Form bilden, dann sorgen die Kurzschlusselemente 101, 102A, 102B, 102C und 103 dafür, dass eine durchgehende elektrische Verbindung für den Wechselstrom I zwischen dem Stromeinkopplungselement 110 und dem Stromauskopplungselement 112 über den Festkörper 150, die Gruppe 160 von Festkörpern und die Gruppe 170 von Festkörpern besteht, wobei jeweils Abschnitte der genannten Festkörper elektrisch in Reihe geschaltet sind. Die Kurzschlusselemente 101, 102A, 102B, 102C und 103 sind demnach als Bestandteile des Strompfads 21C zu betrachten. Letzteres wird im Zusammenhang mit Fig. 34-39 noch näher erläutert.

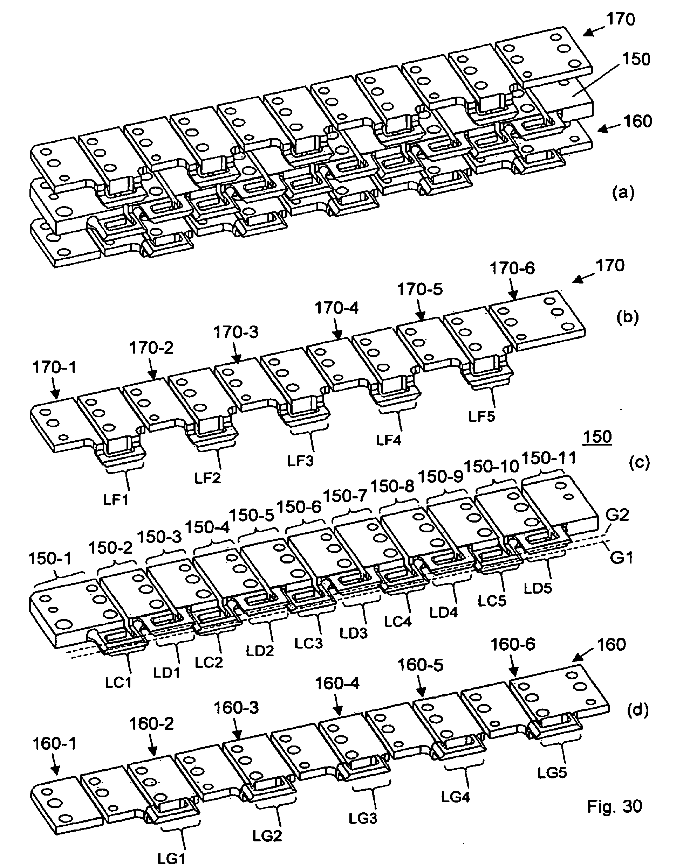

Fig. 30 zeigt konstruktive Einzelheiten des Festkörpers 150 und der zu den Gruppen 160 und 170 gehörenden Festkörper. Fig. 30 enthält vier verschiedene, mit (a), (b),(c) bzw. (d) gekennzeichnete Darstellungen. Die Darstellung (a) in Fig. 30 zeigt die in der Induktionsantenne 20C gemäss Fig. 27 vorliegende Anordnung der Festkörper der Gruppe 160, des Festkörpers 150 und der Festkörper der Gruppe 160 in einer Explosionsdarstellung, wobei die Festkörper der Gruppe 170 vom Festkörper 150 vertikal zur Lötebene LE separiert sind und die Festkörper der Gruppe 160 ebenfalls vom Festkörper 150 vertikal zur Lötebene LE separiert sind. Die Darstellungen (b)-(d) in Fig. 30 zeigen den Festkörper 150 und die Gruppen 160 und 170 der Festkörper jeweils separat.

Wie der Darstellung (c) in Fig. 30 entnehmbar ist, umfasst der Festkörper 150 im vorliegenden Beispiel zehn verschiedene längliche Abschnitte, welche mit LC1, LD1, LC2, LD2, LC3, LD3, LC4, LD4, LC5, LD5 bezeichnet sind und in dieser Reihenfolge in einer Reihe hintereinander angeordnet sind, und elf Abschnitte 150-1, 150-2, 150-3, 150-4, 150-5, 150-6, 150-7, 150-8, 150-9, 150-10 und 150-11, welche ebenfalls in einer Reihe hintereinander angeordnet sind, wobei je zwei der Abschnitte 150-1, 150-2, 150-3, 150-4, 150-5, 150-6, 150-7, 150-8, 150-9, 150-10 und 150-11, welche in der Reihe unmittelbar hintereinander angeordnet sind, über je einen der länglichen Abschnitte LC1, LD1, LC2, LD2, LC3, LD3, LC4, LD4, LC5, LD5 miteinander verbunden sind. Auf diese Weise sind je zwei der länglichen Abschnitte LC1, LD1, LC2, LD2, LC3, LD3, LC4, LD4, LC5, LD5 über einen der Abschnitte 150-2, 150-3, 150-4, 150-5, 150-6, 150-7, 150-8, 150-9, 150-10 derart miteinander verbunden, dass die Abschnitte LC1, LD1, LC2, LD2, LC3, LD3, LC4, LD4, LC5, LD5 in dieser Reihenfolge in Reihe geschaltet sind.

Wie der Darstellung (b) in Fig. 30 entnehmbar ist, umfasst die Gruppe 170 sechs separate Festkörper 170-1, 170-2, 170-3, 170-4, 170-5, 170-6. Die Festkörper 170-1, 170-2, 170-3, 170-4, 170-5 weisen im Wesentlichen dieselbe Struktur auf: Jeder dieser Festkörper 170-1, 170-2, 170-3, 170-4 bzw. 170-5 umfasst einen länglichen Abschnitt, welcher in Fig. 30 mit LF1, LF2, LF3, LF4 bzw. LF5 bezeichnet ist, und zwei mit dem länglichen Abschnitt verbundene Schenkel, wobei einer dieser Schenkel mit einem Ende des länglichen Abschnitts und der andere dieser Schenkel mit dem anderen Ende des länglichen Abschnitts verbunden ist. Jeder dieser Schenkel weist Bohrungen auf, welche dazu dienen, entweder eines der Befestigungsmittel 100 oder eines der Kurzschlusselemente 102B, 102C aufzunehmen.

Wie der Darstellung (d) in Fig. 30 entnehmbar ist, umfasst die Gruppe 160 sechs separate Festkörper 160-1, 160-2, 160-3, 160-4, 160-5, 160-6. Die Festkörper 160-2, 160-3, 160-4, 160-5, 160-6 weisen im Wesentlichen dieselbe Struktur auf: Jeder dieser Festkörper 160-2, 160-3, 160-4, 160-5, 160-6 umfasst einen länglichen Abschnitt, welcher in Fig. 30 mit LG1, LG2, LG3, LG4 bzw. LG5 bezeichnet ist, und zwei mit dem länglichen Abschnitt verbundene Schenkel, wobei einer dieser Schenkel mit einem Ende des länglichen Abschnitts und der andere dieser Schenkel mit dem anderen Ende des länglichen Abschnitts verbunden ist. Jeder dieser Schenkel weist Bohrungen auf, welche dazu dienen, entweder eines der Befestigungsmittel 100 oder eines der Kurzschlusselemente 102B, 102C aufzunehmen.

Fig. 31-33 stellen den Festkörper 150, die Festkörper der Gruppe 160 und die Festkörper der Gruppe 170 separat jeweils in einer Anordnung relativ zur Lötlinie L dar, welche mit der Anordnung dieser Festkörper gemäss Fig. 27 identisch ist. Dabei zeigt Fig. 31 den Festkörper 150, Fig. 32 die Festkörper 170-1, 170-2, 170-3, 170-4, 170-5, 170-6 (Gruppe 170) und Fig. 33 die Festkörper 160-1, 160-2, 160-3, 160-4, 160-5, 160-6 (Gruppe 160), jeweils in einer Seitenansicht mit Blickrichtung senkrecht zur Lötebene LE gemäss Fig. 27. In Fig. 31-33 sind jeweils die räumlichen Lagen der jeweiligen Zwischenräume Z1-Z11 (wie in Fig. 27 definiert) markiert, sodass aus Fig. 31-33 die relative Anordnung des Festkörpers 150, der Festkörper 170-1, 170-2, 170-3, 170-4, 170-5, 170-6 (Gruppe 170) und der Festkörper 160-1, 160-2, 160-3, 160-4, 160-5, 160-6 (Gruppe 160) bezüglich der Niederhalterelemente P1-P11 entnehmbar ist. Weiterhin sind die jeweiligen Abschnitte L1-L10 der Lötlinie L dargestellt.

Wie aus Fig. 31-33 ersichtlich, erstrecken sich der Festkörper 150, die Festkörper 170-1, 170-2, 170-3, 170-4, 170-5, 170-6 (Gruppe 170) und die Festkörper 160-1, 160-2, 160-3, 160-4, 160-5, 160-6 (Gruppe 160) im Wesentlichen parallel zur Lötlinie L und sind von der Lötlinie L jeweils durch einen Luftspalt LS getrennt, wobei einzelne Abschnitte dieser Festkörper sich in unterschiedlichen Abständen D1 bzw. D2 (mit D2>D1) bezüglich der Lötlinie L erstrecken können.

Im vorliegenden Fall haben die Abschnitte LC1, LD1, LC2, LD2, LC3, LD3, LC4, LD4, LC5, LD5 des Festkörpers 150, die Abschnitte LG1, LG2, LG3, LG4 bzw. LG5 der Festkörper 160-2, 160-3, 160-4, 160-5 bzw. 160-6 (Gruppe 160) und die Abschnitte LF1, LF2, LF3, LF4 bzw. LF5 der Festkörper 170-1, 170-2, 170-3, 170-4 bzw. 170-5 (Gruppe 170) die Funktion, den elektrischen Wechselstrom I entlang der Lötlinie L in der Nähe der Lötlinie derart zu führen, dass der durch diese Abschnitte fliessende elektrische Wechselstrom I im Wesentlichen die magnetischen Wechselfelder H1-H10 erzeugt.

Wegen dieser Funktion sollen die Abschnitte LC1, LD1, LC2, LD2, LC3, LD3, LC4, LD4, LC5, LD5 im Folgenden auch als "wechselfelderzeugende" Abschnitte des Festkörpers 150 bzw. des Strompfads 21C bezeichnet werden. Entsprechend soll jeder der Abschnitte LG1, LG2, LG3, LG4 bzw. LG5 auch als "wechselfelderzeugender" Abschnitt des jeweiligen Festkörpers 160-2, 160-3, 160-4, 160-5 bzw. 160-6 (Gruppe 160) bzw. des Strompfads 21C bezeichnet werden. Entsprechend soll jeder der Abschnitte LF1, LF2, LF3, LF4 bzw. LF5 auch als "wechselfelderzeugender" Abschnitt des jeweiligen Festkörpers 170-1, 170-2, 170-3, 170-4 bzw. 170-5 (Gruppe 170) bzw. des Strompfads 21C bezeichnet werden.

Mit Bezug auf Fig. 27, 28, 31-33 und 35 sei darauf hingewiesen, dass im Falle des Strompfads 21C an jedem der Abschnitte L1-L10 der Lötlinie L jeweils zwei wechselfelderzeugende Abschnitte paarweise nebeneinander auf verschiedenen Seiten der Lötlinie L angeordnet sind.

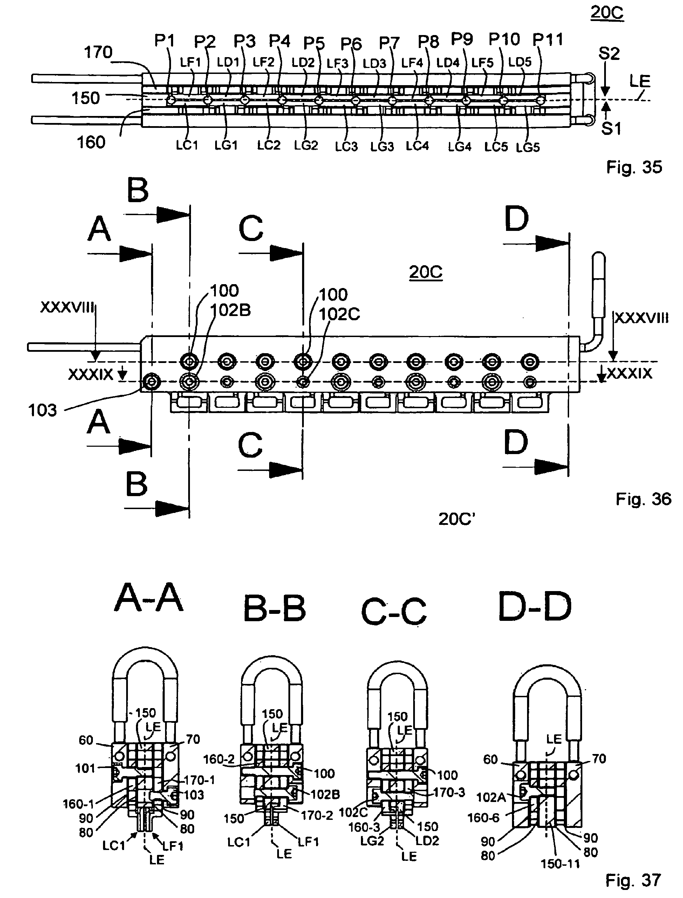

Wie aus Fig. 31 ersichtlich, ist im Falle des Festkörpers 150 jeder der wechselfelderzeugenden Abschnitte LC1, LD1, LC2, LD2, LC3, LD3, LC4, LD4, LC5, LD5 an jeweils einem der Abschnitte L1-L10 der Lötlinie L angeordnet und erstreckt sich jeweils im Wesentlichen parallel zur Lötlinie L (Fig. 31). So befindet sich der Abschnitt LC1 am Abschnitt L1, der Abschnitt LD1 am Abschnitt L2, der Abschnitt LC2 am Abschnitt L3, der Abschnitt LD2 am Abschnitt L4, der Abschnitt LC3 am Abschnitt L5, der Abschnitt LD3 am Abschnitt L6, der Abschnitt LC4 am Abschnitt L7, der Abschnitt LD4 am Abschnitt L8, der Abschnitt LC5 am Abschnitt L9 und der Abschnitt LD5 am Abschnitt L10. Dabei ist zu beachten, dass die wechselfelderzeugenden Abschnitte des Festkörpers 150 in einer Reihe hintereinander entlang der Lötlinie L derart angeordnet sind, dass sie entlang der Lötlinie L jeweils alternierend auf verschiedenen Seiten der Lötebene LE und jeweils in einem Abstand zur Lötebene LE angeordnet sind: Wie insbesondere aus Fig. 35 ersichtlich, befinden sich die (an den Abschnitten L1, L3, L5, L7 und L9 der Lötlinie L angeordneten) Abschnitte LC1, LC2, LC3, LC4, LC5 des Festkörpers 150 auf einer ersten Seite S1 der Lötebene LE und die (an den Abschnitten L2, L4, L6, L8 und L10 der Lötlinie L angeordneten) Abschnitte LD1, LD2, LD3, LD4, LD5 des Festkörpers 150 auf der der Seite S1 gegenüberliegenden Seite S2 der Lötebene LE. Dabei liegt der Festkörper 150 selbst in der Lötebene LE: Wie aus Fig. 27, 30 und 40 ersichtlich, liegen zumindest die Abschnitte 150-1, 150-2, 150-3, 150-4, 150-5, 150-6, 150-7, 150-8, 150-9, 150-10 und 150-11 des Festkörpers 150 in der Lötebene LE und gewährleisten im vorliegenden Fall eine mechanische und eine elektrische Verbindung zwischen den Abschnitten LC1, LC2, LC3, LC4, LC5 des Festkörpers 150 auf der Seite S1 der Lötebene LE und den auf der Seite S2 angeordneten Abschnitten LD1, LD2, LD3, LD4, LD5 des Festkörpers 150.

Wie aus Fig. 32, 33 und 35 ersichtlich, sind alle wechselfelderzeugenden Abschnitte LF1, LF2, LF3, LF4 bzw. LF5 der Festkörper 170-1, 170-2, 170-3, 170-4 bzw. 170-5 entlang der Lötlinie L in einer Reihe hintereinander jeweils auf der Seite S2 der Lötebene LE in einem Abstand zur Lötebene angeordnet und alle wechselfelderzeugenden Abschnitte LG1, LG2, LG3, LG4 bzw. LG5 der Festkörper 160-2, 160-3, 160-4, 160-5 bzw. 160-6 entlang der Lötlinie L in einer Reihe hintereinander jeweils auf der Seite S1 der Lötebene LE in einem Abstand zur Lötebene angeordnet.

Weiterhin ist jeder der wechselfelderzeugenden Abschnitte LF1, LF2, LF3, LF4 bzw. LF5 der Festkörper 170-1, 170-2, 170-3, 170-4 bzw. 170-5 relativ zum Festkörper 150 derart angeordnet, dass jeder der wechselfelderzeugenden Abschnitte LF1, LF2, LF3, LF4 bzw. LF5 in Kombination mit einem der wechselfelderzeugenden Abschnitte LC1, LC2, LC3, LC4, LC5 des Festkörpers 150 an demselben Abschnitt der Lötlinie angeordnet ist. Dabei ist der Abschnitt LF1 des Festkörpers 170-1 zusammen mit dem Abschnitt LC1 am Abschnitt L1 der Lötlinie L angeordnet, der Abschnitt LF2 des Festkörpers 170-2 zusammen mit dem Abschnitt LC2 am Abschnitt L3 der Lötlinie angeordnet, der Abschnitt LF3 des Festkörpers 170-3 zusammen mit dem Abschnitt LC3 am Abschnitt L5 der Lötlinie angeordnet, der Abschnitt LF4 des Festkörpers 170-4 zusammen mit dem Abschnitt LC4 am Abschnitt L7 der Lötlinie angeordnet, der Abschnitt LF5 des Festkörpers 170-5 zusammen mit dem Abschnitt LC5 am Abschnitt L9 der Lötlinie angeordnet.

Entsprechend ist der Abschnitt LG1 des Festkörpers 160-2 zusammen mit dem Abschnitt LD1 am Abschnitt L2 der Lötlinie L angeordnet, der Abschnitt LG2 des Festkörpers 160-3 zusammen mit dem Abschnitt LD2 am Abschnitt L4 der Lötlinie L angeordnet, der Abschnitt LG3 des Festkörpers 160-4 zusammen mit dem Abschnitt LD3 am Abschnitt L6 der Lötlinie L angeordnet, der Abschnitt LG4 des Festkörpers 160-5 zusammen mit dem Abschnitt LD4 am Abschnitt L8 der Lötlinie L angeordnet und der Abschnitt LG5 des Festkörpers 160-6 zusammen mit dem Abschnitt LD5 am Abschnitt L10 der Lötlinie L angeordnet.

Mit Bezug auf Fig. 34 und 36-34 wird im Folgenden eine Realisierung des Strompfads 21C der Induktionsantenne 20C beschrieben.

Fig. 34 zeigt eine schematische Darstellung des Strompfads 21C der Induktionsantenne 20C gemäss Fig. 27. Dabei ist angenommen, dass der Generator 9 für den Wechselstrom I an das Stromeinkopplungselement 110 bzw. Stromauskopplungselement 112 angeschlossen ist, sodass ein vom Generator 9 erzeugter Wechselstrom I im Strompfad 21C zwischen dem Stromeinkopplungselement 110 und dem Stromauskopplungselement 112 fliessen kann und dabei in der Lötlinie L ein magnetisches Wechselfeld bzw. magnetische Wechselfelder erzeugt.

In Fig. 34 stellen gestrichelte, mit V1, V2, V3, V4 bzw. V5 bezeichnete Linien jeweils elektrische Verbindungen dar, welche dazu dienen, den Festkörper 150 mit einem oder mehreren Festkörpern der Gruppe 160 und mit einem oder mehreren Festkörpern der Gruppe 170 und dem Generator 9 zu verbinden.

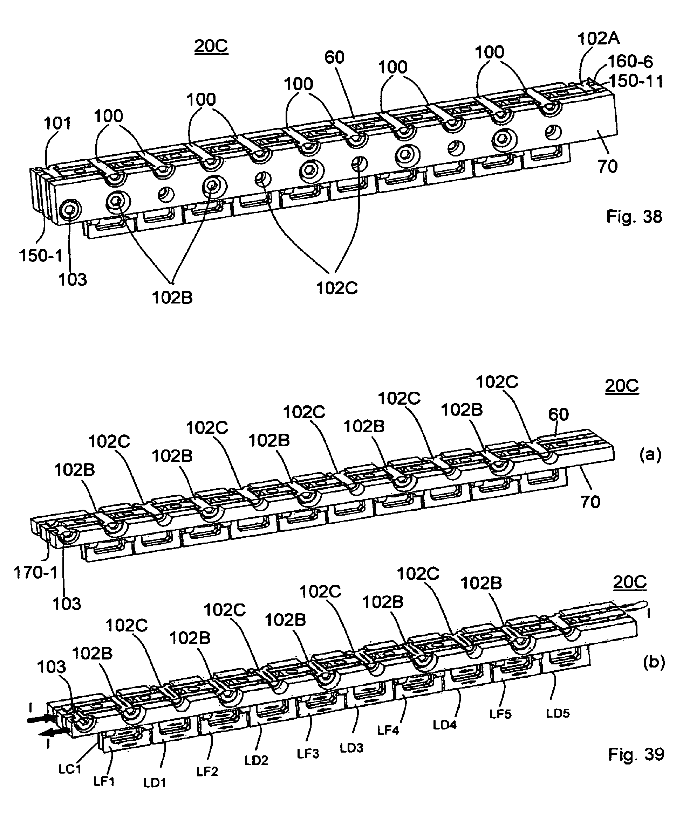

Die elektrische Verbindung V1 repräsentiert eine elektrische Verbindung zwischen dem Abschnitt 150-1 des Festkörpers 150 und dem Generator 9. Zur Realisierung dieser Verbindung dient das Kurzschlusselement 101, welches derart angeordnet ist (z.B. in einer Bohrung im Kühlkörper 60 und in einer Bohrung im Abschnitt 150-1, wie aus Fig. 37 und 38 ersichtlich), dass es den Abschnitt 150-1 des Festkörpers 150 mit dem Kühlkörper 60 und somit mit dem Stromeinkopplungselement 110 verbindet.

Die elektrische Verbindung V2 repräsentiert eine elektrische Verbindung zwischen dem Abschnitt 150-11 des Festkörpers 150 und dem Festkörper 160-6 der Gruppe 160. Zur Realisierung dieser Verbindung dient das Kurzschlusselement 102A, welches derart angeordnet ist (z.B. in einer Bohrung im Abschnitt 150-11 des Festkörpers 150 und in einer Bohrung im Festkörper 160-6, wie aus Fig. 36, 37 und 38 ersichtlich), dass es den Abschnitt 150-1 des Festkörpers 150 mit dem Kühlkörper 60 verbindet.

Die elektrische Verbindung V3 repräsentiert eine elektrische Verbindung zwischen dem Festkörper 170-1 der Gruppe 170 und dem Generator 9. Zur Realisierung dieser Verbindung dient das Kurzschlusselement 103, welches derart angeordnet ist (z.B. in einer Bohrung im Kühlkörper 70 und in einer Bohrung im Festkörper 170-1, wie aus Fig. 36, 37 und 39 ersichtlich), dass es den Festkörper 170-1 mit dem Kühlkörper 70 und somit mit dem Stromauskopplungselement 112 verbindet.

Die jeweilige elektrische Verbindung V4 und die jeweilige elektrische Verbindung V5 haben die Funktion, jeweils einen der Festkörper der Gruppe 160 mit einem der Festkörper der Gruppe 170 zu verbinden, sodass der wechselfelderzeugende Abschnitt des jeweiligen Festkörpers der Gruppe 160 und der wechselfelderzeugende Abschnitt des jeweiligen Festkörpers der Gruppe 170 über die jeweilige elektrische Verbindung V4 bzw. V5 elektrisch in Reihe geschaltet ist. Zur Realisierung der jeweiligen elektrischen Verbindung V4 dient das Kurzschlusselement 102B, zur Realisierung der elektrischen Verbindung V5 das Kurzschlusselement 102C. Die vorliegende Realisierung des Strompfads 21C umfasst mehrere elektrische Verbindungen V4 und V5, wobei die entsprechende Anordnung der Kurzschlusselemente 102B und 102C aus Fig. 36-39 ersichtlich ist.

Gemäss Fig. 34 kann der Strompfad 21C als eine Reihenschaltung von zwei Abschnitten dieses Strompfads aufgefasst werden, welche in Fig. 34 mit 21C-1 und 21C-2 bezeichnet sind: "Abschnitt 21C-1" repräsentiert denjenigen Abschnitt des Strompfads 21C, welcher im Festkörper 150 ausgebildet ist; entsprechend repräsentiert "Abschnitt 21C-2" denjenigen Abschnitt des Strompfads 21C, welcher in den jeweiligen Festkörpern der Gruppe 160 und der Gruppe 170 (und den jeweiligen Kurzschlusselementen 102B bzw. 102C, welche die jeweiligen Festkörper der Gruppe 160 und 170 verbinden) ausgebildet ist. Dabei sind die wechselfelderzeugenden Abschnitte LC1, LD1, LC2, LD2, LC3, LD3, LC4, LD4, LC5, LD5 des Festkörpers 150 derart verbunden, dass sie im Abschnitt 21-C1 des Strompfads 21C in dieser Reihenfolge elektrisch in Reihe geschaltet sind. Weiterhin sind die wechselfelderzeugenden Abschnitte der Festkörper der Gruppen 160 und 170 über die elektrischen Verbindungen V4 und V5 derart miteinander verbunden, dass die wechselfelderzeugenden Abschnitte LF1, LG1, LF2, LG2, LF3, LG3, LF4, LG4, LF5 und LG5 im Abschnitt 21-C2 des Strompfads 21C in dieser Reihenfolge elektrisch in Reihe geschaltet sind.

Die Abschnitte 21C-1 und 21-C2 des Strompfads 21B sind über die elektrische Verbindung V2 derart in Reihe hintereinander geschaltet, dass der Wechselstrom I sowohl im Abschnitt 21C-1 und als auch im Abschnitt 21-C2 entlang der Lötlinie L geführt ist, allerdings derart, dass der Wechselstrom I im Abschnitt 21C-1 des Strompfads 21C in Gegenphase zum Wechselstrom I im Abschnitt 21C-2 des Strompfads 21C ist. Zur Verdeutlichung dieses Sachverhalts geben in Fig. 34 jeweils mit dem Bezugszeichen I versehene Pfeile die momentane Stromflussrichtung eines vom Generator 9 erzeugten elektrischen Wechselstroms I für einen bestimmten Zeitpunkt an, wobei die momentane Stromflussrichtung des Wechselstroms I in der Darstellungen gemäss Fig. 34 mit der momentane Stromflussrichtung des Wechselstroms I in der Darstellung gemäss Fig. 27 übereinstimmt. Der Wechselstrom I fliesst, wie ersichtlich, zwischen den elektrischen Verbindungen V1 und V2 jeweils durch den Abschnitt 21C-1 des Strompfads 21C und zwischen den elektrischen Verbindungen V2 und V3 jeweils durch den Abschnitt 21C-2 des Strompfads 21C. Weiterhin geben mit dem Bezugszeichen I1 versehene Pfeile die momentane Stromflussrichtung des elektrischen Wechselstroms I im Abschnitt 21C-1 des Strompfads 21C und mit dem Bezugszeichen I2 versehene Pfeile die momentane Stromflussrichtung des elektrischen Wechselstroms I im Abschnitt 21C-2 des Strompfads 21C (für denselben bestimmten Zeitpunkt) an.

Wie aus Fig. 34 ersichtlich, ist die momentane Stromflussrichtung des Wechselstroms I in den wechselfelderzeugenden Abschnitten des Festkörpers 150 (d.h. in den Abschnitten LC1, LD1, LC2, LD2, LC3, LD3, LC4, LD4, LC5, LD5) jeweils entgegengesetzt zur momentanen Stromflussrichtung in den wechselfelderzeugenden Abschnitten der Festkörper der Gruppe 160 (d.h. in den Abschnitten LG1, LG2, LG3, LG4 bzw. LG5) und zur momentanen Stromflussrichtung in den wechselfelderzeugenden Abschnitten der Festkörper der Gruppe 170 (d.h. in den Abschnitten LF1, LF2, LF3, LF4 bzw. LF5). Der elektrische Wechselstrom I ist folglich in den wechselfelderzeugenden Abschnitten des Festkörpers 150 jeweils in Gegenphase zum elektrischen Wechselstrom I in den wechselfelderzeugenden Abschnitten der Festkörper der Gruppe 160 und 170.

Zur Verdeutlichung dieses Sachverhalts sei auch auf Fig. 39 verwiesen. Fig. 39 zeigt zwei Darstellungen (a) und (b) eines unteren Teils der Induktionsantenne 20C gemäss Fig. 27 in einer perspektivischen Ansicht, wobei dieser untere Teil an einer oberen Seite entlang einer Schnittebene XXXIX-XXXIX gemäss Fig. 36 geschnitten ist, sodass einerseits die räumlich Anordnung der Kurzschlusselemente 102B, 102C und 103 und andererseits die räumliche Anordnung der wechselfelderzeugenden Abschnitte des Festkörper 150 und der Festkörper der Gruppen 160 und 170 sichtbar ist. Dabei geben in der Darstellung (b) die jeweils dargestellten Pfeile die momentane Stromflussrichtung des Wechselstroms I in den Kurzschlusselementen 102B, 102C und 103 und den jeweiligen wechselfelderzeugenden Abschnitten des Festkörpers 150 und der Festkörper der Gruppen 160 und 170 an.

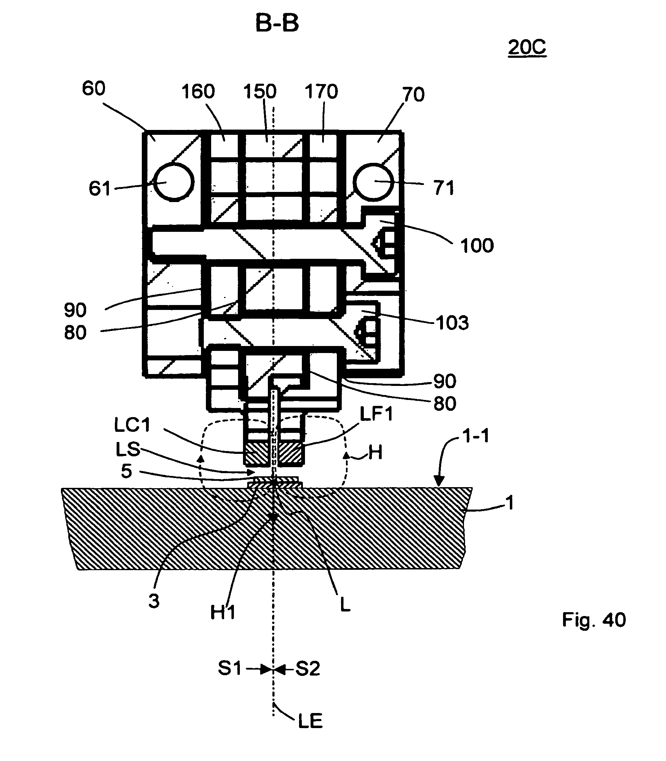

Wie erwähnt, ist im Falle der Induktionsantenne 20C an jedem der Abschnitte L1-10 der Lötlinie L einer der wechselfelderzeugenden Abschnitte des Festkörpers 150 und der wechselfelderzeugende Abschnitt eines der Festkörper der Gruppe 160 oder der Gruppe 170 angeordnet. Die wechselfelderzeugenden Abschnitte der jeweiligen Festkörper können im Wesentlichen denselben Abstand bezüglich der Lötlinie L haben. Im Falle der Induktionsantenne 20C ist daher das magnetische Wechselfeld, welches der elektrische Wechselstrom I in einem bestimmten Abschnitt der Lötlinie erzeugt, jeweils eine Superposition von Wechselfeldern, welche der Wechselstrom I in der Umgebung von zwei verschiedenen wechselfelderzeugenden Abschnitten der Festkörper erzeugt. Zur Verdeutlichung dieses Sachverhalts sei auf Fig. 40 verwiesen.

Fig. 40 zeigt die Induktionsantenne 20C in einem Querschnitt entlang der Schnittebene B-B gemäss Fig. 36 in Kombination mit einer Solarzelle 1 gemäss Fig. 4 und einem Band 5, wobei sich das Band 5 entlang der Lötlinie L in Längsrichtung der Stromsammelschiene 3 der Solarzelle 1 erstreckt. Die Schnittebene B-B gemäss Fig. 36 liegt im Bereich des Abschnitts L1 der Lötlinie. In Fig. 40 sind u.a. der wechselfelderzeugende Abschnitt LC1 des Festkörpers 150 und der wechselfelderzeugende Abschnitt LF1 des Festkörpers 170-1 sichtbar. Die Abschnitte LC1 und LF1 erstrecken sich im Wesentlichen parallel zur Lötlinie L und zur Lötebene LE auf verschiedenen Seiten S1 bzw. S2 der Lötebene LE. In Fig. 40 ist weiterhin der räumliche Verlauf mehrerer Feldlinien des magnetischen Wechselfeldes mittels gestrichelter Linien, welche die wechselfelderzeugenden Abschnitte LC1 und LF1 umgegeben, schematisch skizziert. Die jeweiligen Feldlinien sind jeweils mit einer (in einem Fall mit dem Bezugszeichen H gekennzeichneten) Pfeilspitze versehen, welche die momentane Richtung des magnetischen Wechselfelds entlang der jeweiligen Feldlinie angibt, jeweils für die in Fig. 27 angegebene momentane Stromrichtung des elektrischen Wechselstroms I. Im vorliegenden Fall haben die wechselfelderzeugenden Abschnitte LC1 und LF1 jeweils einen quadratischen Querschnitt und sind symmetrisch zur Lötebene LE angeordnet. Die Feldlinien des magnetischen Wechselfelds verlaufen dementsprechend ebenfalls symmetrisch zur Lötebene LE. Da der Wechselstrom I im Abschnitt LC1 in Gegenphase zum Wechselstrom I im Abschnitt LF1 ist, entsteht (durch Superposition des Wechselfelds, welches der Wechselstrom I in der Umgebung des Abschnitt LC1 erzeugt, und des Wechselfelds, welches der Wechselstrom I in der Umgebung des Abschnitts LF1 erzeugt) in der Lötlinie L ein magnetisches Wechselfeld, welches parallel zur Lötebene LE gerichtet ist. In Fig. 40 stellt ein mit dem Bezugszeichen H1 versehener Pfeil die Feldstärke dieses Wechselfelds für einen Punkt auf der Lötlinie L im Bereich des Abschnitts L1 dar.

Es sei darauf hingewiesen, dass im Abschnitt L2 der Lötlinie der wechselfelderzeugende Abschnitt LD1 des Festkörpers 150 auf der Seite S2 der Lötebene LE und der wechselfelderzeugende Abschnitt LG1 des Festkörpers 160-2 auf der Seite S1 der Lötebene LE angeordnet ist und der Wechselstrom I im Abschnitt LC1 in Gleichphase zum Wechselstrom I im Abschnitt LD1 und in Gegenphase zum Wechselstrom I in den wechselfelderzeugenden Abschnitten LF1 und LG1 ist. Dementsprechend erzeugt der Wechselstrom I im Abschnitt L2 in der Lötlinie L ein magnetisches Wechselfeld (H2 gemäss Fig. 27), welches entgegengesetzt zu dem magnetischen Wechselfeld H1 gemäss Fig. 40 gerichtet ist und somit in Gegenphase zum magnetischen Wechselfeld H1 im Abschnitt L1 der Lötlinie ist.

Da die wechselfelderzeugenden Abschnitte des Festkörpers 150 entlang der Lötlinie L derart in einer Reihe hintereinander angeordnet sind, dass sie entlang der Lötlinie L in den jeweiligen Abschnitten L1-L10 abwechselnd auf der einen Seite der Lötebene LE und auf der anderen Seite der Lötebene LE angeordnet sind, sind die magnetischen Wechselfelder in zwei Abschnitten der Lötlinie, welche in der Reihe unmittelbar aufeinander folgen, jeweils in Gegenphase zueinander.

Die Anordnung der wechselfelderzeugenden Abschnitte des Festkörpers 150 und der Festkörper der Gruppen 160 und 170 ermöglicht die Erzeugung eines magnetischen Wechselfelds, welches in einer Richtung vertikal zur Lötebene LE auf einen extrem schmalen Raumbereich konzentriert ist und über den gesamten Bereich der effektiven Länge Leff der Induktionsantenne 20C homogen ist. Zur Optimierung der Homogenität der magnetischen Wechselfelder können die verschiedenen Abschnitte des Strompfads 21C beispielsweise wie folgt ausgebildet sein.

Beispielsweise können die verschiedenen wechselfelderzeugenden Abschnitte des Festkörpers 150 und der Festkörper der Gruppe 160 und 170 derart ausgebildet sein, dass sie sich jeweils geradlinig im Wesentlichen parallel zur Lötlinie L erstrecken, wie insbesondere in Fig. 28 und 30-34 offenbart.

Beispielsweise können die verschiedenen wechselfelderzeugenden Abschnitte, welche paarweise an demselben Abschnitt der Lötlinie L angeordnet sind (z.B. die Abschnitte LC1 und LF1 und/oder die Abschnitte LD1 und LG1 usw.) relativ zueinander spiegelsymmetrisch bezüglich der Lötebene LE ausgebildet sein, wie in Fig. 35 und 40 offenbart.

Beispielsweise können die Abschnitte LC1, LC2, LC3, LC4 und/oder LC5 des Festkörpers 150 auf einer Geraden angeordnet sein (z.B. auf der Geraden G1 gemäss der Darstellung (c) in Fig. 30) und sich entlang dieser Geraden erstrecken. Entsprechend können die Abschnitte LD1, LD2, LD3, LD4 und/oder LD5 des Festkörpers 150 auf einer Geraden angeordnet sein (z.B. auf der Geraden G2 gemäss der Darstellung (c) in Fig. 30) und sich entlang dieser Geraden erstrecken. Beispielsweise können die Abschnitte LC1, LC2, LC3, LC4 und/oder LC5 des Festkörpers 150 und die Abschnitte LG1, LG2, LG3, LG4 bzw. LG5 auf einer Geraden liegen (z.B. auf Gerade G1 gemäss Fig. 28) und sich entlang dieser Geraden erstrecken. Ebenfalls können Abschnitte LD1, LD2, LD3, LD4 und/oder LD5 des Festkörpers 150 und die Abschnitte LF1, LF2, LF3, LF4 bzw. LF5 auf einer Geraden liegen (z.B. auf Geraden G2 gemäss Fig. 28) und sich entlang dieser Geraden erstrecken. Die genannten Geraden können dabei parallel zur Lötebene LE liegen.

Weiterhin können die wechselfelderzeugenden Abschnitte, welche paarweise an einem der Abschnitte L1-L10 der Lötlinie L angeordnet sind (z.B. die Abschnitte LC1 und LF1 und/oder LG1 und LD1), jeweils in einem der Zwischenräume Z1-Z10 zwischen jeweils zwei der Niederhalterelemente P1-P11 angeordnet sein und sich von einem dieser zwei Niederhalterelemente bis zum anderen dieser zwei Niederhalterelemente, vorzugsweise geradlinig, erstrecken, wie beispielsweise in Fig. 27 und 35 offenbart.

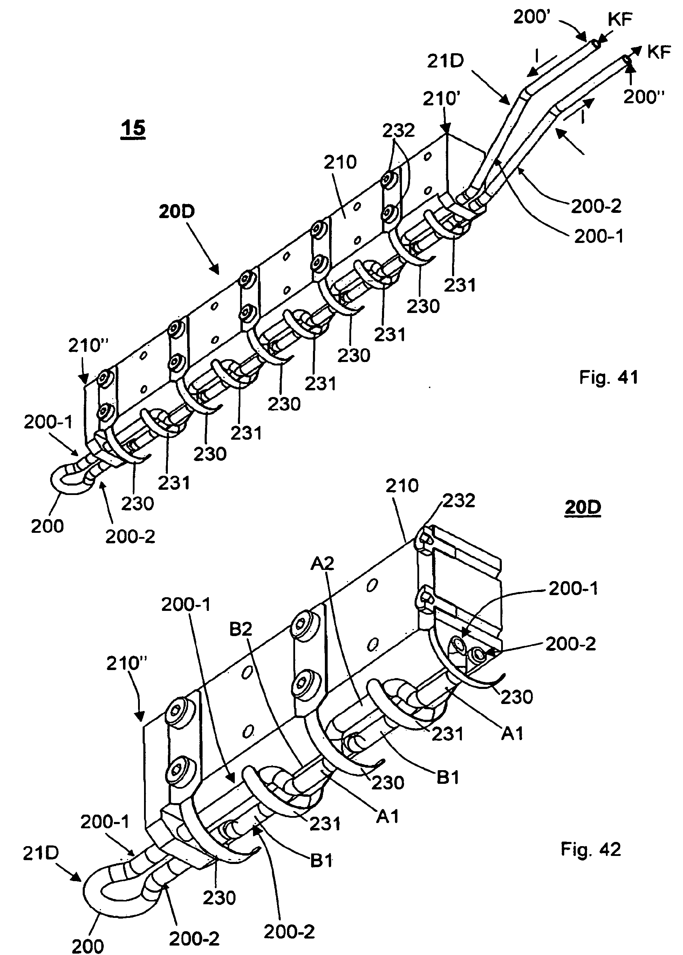

Mit Bezug auf Fig. 41-47 werden im folgenden drei verschiedene Varianten der erfindungsgemässen Lötvorrichtung 15 erläutert, welche die Gemeinsamkeit aufweisen, dass der elektrische Wechselstrom I in der Induktionsantenne der jeweiligen Variante der Lötvorrichtung 15 in einem Strompfad geführt ist, welcher in Form eines Rohres ausgebildet ist. Zur Abfuhr der vom elektrischen Wechselstrom I erzeugten Wärme kann ein derartiges Rohr direkt gekühlt werden, beispielsweise mittels eines durch das Rohr strömenden Kühlfluids. Um den Wechselstrom I entlang der Lötlinie L in unterschiedlichen Abständen zur Lötlinie L führen zu können, muss ein derartiges Rohr geeignet geformt werden, beispielsweise durch Biegen. In diesem Zusammenhang ist zu beachten, dass ein derartiges Rohr in der Regel nur mit einem Biegeradius von grösser als 5 mm gebogen werden kann, um eine Beschädigung des Rohrs zu vermeiden. Dies führt zu verschiedenen Randbedingungen im Hinblick auf den Platzbedarf eines Strompfads, welcher in Form eines gebogenen Rohres realisiert werden soll. Dies ist insbesondere relevant für die Ausbildung der jeweiligen Niederhalterelemente zum Niederhalten des Bandes. Sollen beispielsweise die Niederhalterelemente P1-P11, welche im Zusammenhang mit den Induktionsantennen 21A-21C offenbart sind, mit einem aus einem gebogenen Rohr gebildeten Strompfad kombiniert werden, so muss das Rohr mit einem Biegeradius von mehr als 5 mm um die jeweiligen Niederhalterelemente herum geführt werden. In diesem Zusammenhang ist beispielsweise zu beachten, dass die Niederhalterelemente P1-P11 typischerweise in Abständen von 8-24 mm angeordnet sind. Unter diesen Umständen kann ein aus einem gebogenen Rohr gebildeter Strompfad nicht in beliebig kleinen Abständen relativ zu den Niederhalterelementen P1-P11 angeordnet werden.

Fig. 41-44, 45A und 45B stellen eine vierte Variante der erfindungsgemässen Lötvorrichtung 15 dar, welche eine Induktionsantenne 20D mit einem Strompfad 21D für einen (hochfrequenten) elektrischen Wechselstrom I umfasst.

Fig. 41 zeigt die Induktionsantenne 20D in einer perspektivischen Ansicht. Der Strompfad 21D der Induktionsantenne 20D besteht aus einem elektrischen Leiter 200 in Form eines Rohres, wobei jeder Abschnitt des Leiters 200 einen Abschnitt des Strompfads 21D bildet. Der Leiter 200 ist schleifenförmig ausgebildet und umfasst zwei im Wesentlichen parallel verlaufende Leiterabschnitte, einen ersten Leiterabschnitt 200-1, welcher ein erstes Ende 200' des Leiters 200 bildet, und einen zweiten Leiterabschnitt 200-2, welcher ein zweites Ende 200" des Leiters 200 bildet. Die beiden Enden 200' und 200" des Leiters 200 dienen als Anschlüsse für einen (in Fig. 41-44, 45A und 45B nicht dargestellten) Generator für den elektrischen Wechselstrom I, sodass der Wechselstrom I über die Enden 200' und 200" in den Leiter 200 einkoppelbar bzw. aus dem Leiter 200 auskoppelbar ist. Weiterhin ist es möglich, die Enden 200' und 200" des Leiters 200 an eine Leitung für ein Kühlfluid anzuschliessen, sodass ein Kühlfluidstrom KF durch den Leiter 200 strömen kann.

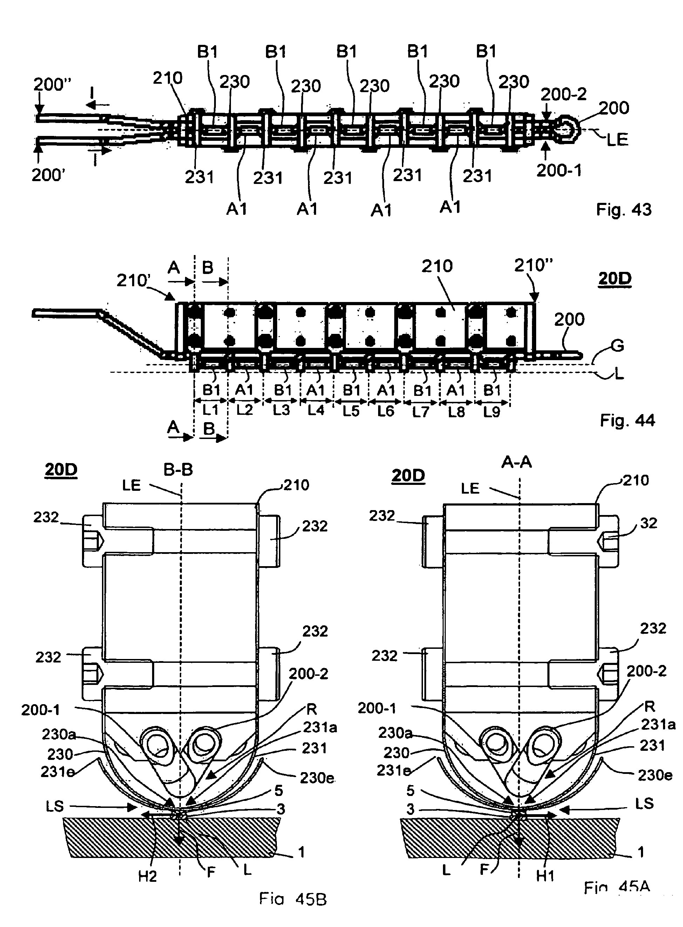

Wie Fig. 41 zeigt, umfasst die Induktionsantenne 20D weiterhin eine Tragstruktur 210, an welcher der Leiter 200 befestigt ist und welche dazu dient, den Leiter 200 relativ zu einer Solarzelle zu positionieren und in einer Position relativ zu einer Solarzelle zu halten (wie in Fig. 45A und 45B dargestellt). Zum Befestigen des elektrischen Leiters 200 an der Tragstruktur 210 können die beiden Leiterabschnitte 200-1, 200-2 jeweils mit einem vorderen Endabschnitt 210' und einem hinteren Endabschnitt 210" der Tragstruktur 210 verbunden sein.

Mit Bezug auf die in Fig. 41-44, 45A und 45B dargestellten Ansichten der erfindungsgemässen Lötvorrichtung 15 bzw. der Induktionsantenne 20D sei darauf hingewiesen, dass die Lötvorrichtung 15 im vorliegenden Beispiel Niederhalterelemente 230 und 231 umfasst, welche als elastische Strukturen ausgebildet sind und an der Tragstruktur 210 mit Befestigungsmitteln 232 befestigt sind. Im vorliegenden Beispiel sind die Niederhalterelemente 230 und 231 an gegenüberliegenden Seiten der Tragstruktur 210 befestigt.

Um mittels der Induktionsantenne 20D ein Band 5 an eine Stromsammelschiene 3 einer Solarzelle 1 zu löten, kann die Tragstruktur 210 gegenüber der Solarzelle 1 in eine vorgegebene Position gebracht werden, in welcher sich sowohl die Tragstruktur 210 als auch der Leiter 200 in Längsrichtung der Stromsammelschiene 3 erstreckt. Eine derartige Situation ist in Fig. 44, 45A und 45B dargestellt. Fig. 44 zeigt die Induktionsantenne 20D in einer Seitenansicht, wobei sich die Tragstruktur 210 parallel zu einer Lötlinie L erstreckt. Fig. 45A zeigt einen Querschnitt der Induktionsantenne 20D in einem Schnitt durch die Schnittebene A-A gemäss Fig. 44 und Fig. 45B einen Querschnitt der Induktionsantenne 20D in einem Schnitt durch die Schnittebene B-B gemäss Fig. 44, wobei die Schnittebenen A-A und B-B senkrecht zur Lötlinie L ausgerichtet sind.

In der Darstellung gemäss Fig. 45A und 45B erstreckt sich die Lötlinie L an einer Oberfläche der Stromsammelschiene 3 in Längsrichtung der Stromsammelschiene 3 und das Band 5 liegt auf der Oberfläche der Stromsammelschiene 3 und erstreckt sich in der Längsrichtung der Lötlinie L. In Fig. 45A und 45B ist weiterhin eine Lötebene LE dargestellt, welche im Wesentlichen senkrecht zur Oberfläche der Solarzelle 1 angeordnet ist, wobei die Lötlinie LE in der Lötebene L liegt.

In der in Fig. 45A und 45B dargestellten Situation erstrecken sich die Leiterabschnitte 200-1, 200-2 - durch einen Luftspalt LS von der Lötlinie L getrennt - entlang der Lötlinie L.

Wie Fig. 45A und 45B weiterhin zu entnehmen ist, weisen die Niederhalterelemente 230 jeweils mindestens einen Abschnitt 230e auf, welcher in den Luftspalt LS ragt. Entsprechend weisen die Niederhalterelemente 231 jeweils mindestens einen Abschnitt 231e auf, welcher ebenfalls in den Luftspalt LS ragt. Wenn die Tragstruktur 210 in die vorgegebene Position gemäss Fig. 45A und 45B gebracht ist, ist jeweils ein mit dem Bezugszeichen 230a bezeichneter Bereich des Abschnitts 230e mit dem Band 5 in Kontakt gebracht und jeweils ein mit dem Bezugszeichen 231a bezeichneter Bereich des Abschnitts 231e mit dem Band 5 in Kontakt gebracht, wobei die Niederhalterelemente 230, 231 derart deformiert sind, dass mit dem jeweiligen mindestens einen Abschnitt 230e, 231e eine senkrecht zur Oberfläche der Stromsammelschiene 3 gerichtete Kraft F auf das Band 5 übertragen wird. Wie ersichtlich, erstrecken sich die Abschnitte 230e (zumindest in dem jeweiligen Bereich 230a) und die Abschnitte 231e (zumindest in dem jeweiligen Bereich 231a) jeweils tangential zur Oberfläche der Stromsammelschiene 3. Wie ersichtlich, sind die Niederhalterelemente 230 und 231 entlang der Lötlinie L in einer Reihe hintereinander derart angeordnet, dass die jeweiligen Abschnitte 230e der Niederhalterelemente 230 und die jeweiligen Abschnitte 231e der Niederhalterelemente 231 ein freien Raumbereich R begrenzen. Dieser freie Raum R erstreckt sich zwischen der Tragstruktur 210 und den jeweiligen Abschnitten 230e, 231e in Längsrichtung der Lötlinie L über die gesamte Länge der Tragstruktur 210 und bietet Platz zur Aufnahme des Leiters 200 (Fig. 41).

Wie Fig. 41-44, 45A und 45B zeigen, sind die beiden Leiterabschnitte 200-1 und 200-2 im Wesentlichen parallel zur Lötebene LE bzw. zur Lötlinie L angeordnet. Die beiden Leiterabschnitte 200-1 und 200-2 sind nicht geradlinig. Wie insbesondere aus Fig. 42-44 ersichtlich, besteht der Leiterabschnitt 200-1 aus einer Folge von geradlinigen Abschnitten A1 und A2, welche jeweils einen unterschiedlichen Abstand zur Lötlinie L haben. In Längsrichtung des Leiterabschnitts 200-1 folgen dabei die Abschnitte A1 und A2 jeweils abwechselnd nacheinander. Dabei hat der Abschnitt A1 einen geringeren Abstand von der Lötlinie L als der Abschnitt A2. Der Leiterabschnitt 200-2 besteht (analog zu Leiterabschnitt 200-1) aus einer Folge von geradlinigen Abschnitten B1 und B2, welche jeweils einen unterschiedlichen Abstand zur Lötlinie L haben. In Längsrichtung des Leiterabschnitts 200-2 folgen dabei die Abschnitte B1 und B2 jeweils abwechselnd nacheinander. Dabei hat der Abschnitt B1 einen geringeren Abstand von der Lötlinie L als der Abschnitt B2. Die Leiterabschnitte 200-1 und 200-2 sind dabei relativ zueinander derart angeordnet, dass die Abschnitte A1 des Leiterabschnitts 200-1 und die Abschnitte B1 des Leiterabschnitts 200-2, wie insbesondere in Fig. 43 und 44 gezeigt, abwechselnd hintereinander auf einer Geraden G liegen, welche in der Lötebene LE und im Wesentlichen parallel zur Lötlinie L verläuft.

Wenn ein Generator für den Wechselstrom I an die Enden 200' und 200" des Leiters 200 angeschlossen ist und somit der Wechselstrom I über die Enden 200' und 200" in die Leiterabschnitte 200-1 und 200-2 eingekoppelt bzw. aus den Leiterabschnitten 200-1 und 200-2 ausgekoppelt wird, dann fliesst dieser Wechselstrom I durch den Strompfad 21D derart, dass der Wechselstrom I in der Lötlinie L und/oder in einer Umgebung der Lötlinie L ein magnetisches Wechselfeld erzeugt. Der Wechselstrom I ist dabei in dem Abschnitt des Strompfads 21D, welcher aus dem Leiterabschnitt 200-1 gebildet ist, in Gegenphase zum Wechselstrom I in dem Abschnitt des Strompfads 21D, welcher aus dem Leiterabschnitt 200-2 gebildet ist. In Fig. 41 und 43 geben mit dem Bezugszeichen I versehene Pfeile die momentane Stromflussrichtung des Wechselstroms I in verschiedenen Abschnitten des Leiters 200 bzw. des Strompfads 21D (für einen bestimmten Zeitpunkt) an: Wie ersichtlich, ist die momentane Stromflussrichtung des Wechselstroms I in dem aus dem Leiterabschnitt 200-1 gebildeten Abschnitt des Strompfads 21D entgegengesetzt zur momentane Stromflussrichtung des Wechselstroms I in dem aus dem Leiterabschnitt 200-2 gebildeten Abschnitt des Strompfads 21D. Folglich ist die momentane Stromflussrichtung des Wechselstroms I in allen Abschnitten A1 jeweils entgegengesetzt zur momentane Stromflussrichtung des Wechselstroms I in den jeweiligen Abschnitten B1, d.h. der elektrische Wechselstrom I ist in allen Abschnitten A1 jeweils in Gleichphase und in jedem der Abschnitte A1 jeweils in Gegenphase zum elektrischen Wechselstrom I in den Abschnitten B1.

Wie erwähnt, haben die Abschnitte A2 und B2 einen grösseren Abstand zur Lötlinie als die Abschnitte A1 und B1. Die Abstände der Abschnitte A2 und B2 zur Lötlinie sind im vorliegenden Beispiel derart gewählt, dass in den Bereichen der Lötlinie L, die an einem Abschnitt A1 des Leiterabschnitts 200-1 liegen, das magnetische Wechselfeld im Wesentlichen durch den elektrischen Wechselstrom I in diesem Abschnitt A1 bestimmt ist. Entsprechend wird in den Bereichen der Lötlinie L, die an einem Abschnitt B1 des Leiterabschnitts 200-2 liegen, das magnetische Wechselfeld im Wesentlichen durch den elektrischen Wechselstrom I in diesem Abschnitt B1 bestimmt.

In Fig. 44 sind verschiedene Abschnitte der Lötlinie L mit Bezugszeichen L1, L3, L3, L4, L5, L6, L7, L8 bzw. L9 gekennzeichnet. Wie aus Fig. 43 und 44 ersichtlich, erstreckt sich jeder einzelne der Abschnitte L1-L9 der Lötlinie L zwischen einem der Niederhalterelemente 230 und einem der Niederhalterelemente 231. Dabei erstreckt sich an den Abschnitten L1, L3, L5, L7 und L9 jeweils einer der Abschnitte B1 des Leiterabschnitts 200-2 entlang der Lötlinie L (jeweils durch einen Luftspalt von der Lötlinie L getrennt und im Wesentlichen parallel zur Lötlinie L). Entsprechend erstreckt sich an den Abschnitten L2, L4, L6, und L8 der Lötlinie L jeweils einer der Abschnitte A1 des Leiterabschnitts 200-1 entlang der Lötlinie L (jeweils durch einen Luftspalt von der Lötlinie L getrennt und im Wesentlichen parallel zur Lötlinie L).

Da der elektrische Wechselstrom I in allen Abschnitten A1 des Leiterabschnitts 200-1 jeweils in Gleichphase und in jedem der Abschnitte A1 jeweils in Gegenphase zum elektrischen Wechselstrom I in den Abschnitten B1 ist, sind die magnetischen Wechselfelder, welche der elektrische Wechselstrom I in den Abschnitten L2, L4, L6 und L8 erzeugt, jeweils in Gegenphase zu den magnetischen Wechselfeldern, welche der elektrische Wechselstrom I in den Abschnitten L1, L3, L5, und L7 erzeugt. Zur Verdeutlichung dieses Sachverhalts sei auf Fig. 45A und 45B verwiesen. In Fig. 45A stellt ein mit dem Bezugszeichen H1 bezeichneter Pfeil die momentane Richtung der magnetischen Feldstärke H1 des magnetischen Wechselfelds (für die in Fig. 41 angegebene momentane Stromflussrichtung des Wechselstroms I) an einem Punkt auf der Lötlinie L dar, welcher in der Mitte des Abschnitts L1 liegt. In Fig. 45B stellt ein mit dem Bezugszeichen H2 bezeichneter Pfeil die momentane Richtung der magnetischen Feldstärke des magnetischen Wechselfelds (für die in Fig. 41 angegebene momentane Stromflussrichtung des Wechselstroms I) an einem Punkt auf der Lötlinie L dar, welcher in der Mitte des Abschnitts L2 liegt. Wie ersichtlich, ist die magnetische Feldstärke H1 im Abschnitt L1 entgegengesetzt gerichtet (und somit in Gegenphase) zur magnetischen Feldstärke H2 im Abschnitt L2. Dabei sind die magnetischen Feldstärken H1 und H2 in der Lötlinie L jeweils im Wesentlichen senkrecht zur Lötebene LE gerichtet.

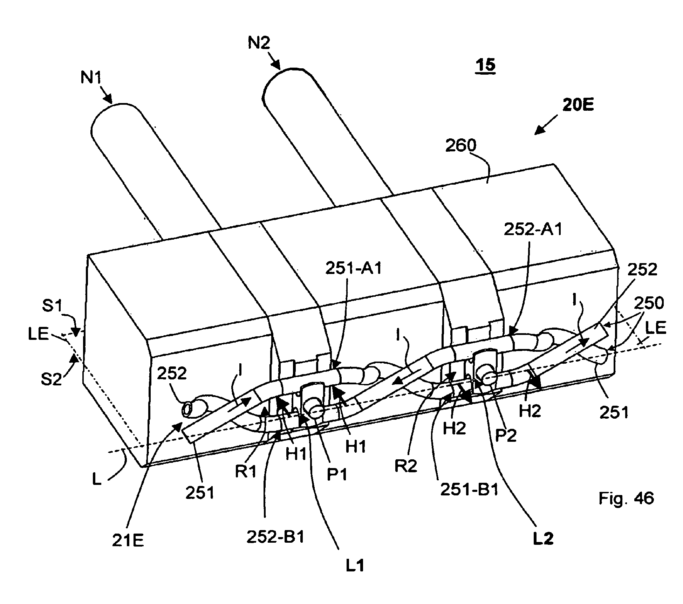

Fig. 46 stellt eine fünfte Variante der erfindungsgemässen Lötvorrichtung 15 dar, welche eine Induktionsantenne 20E mit einem Strompfad 21E für einen (hochfrequenten) elektrischen Wechselstrom I umfasst.

Fig. 46 zeigt die Induktionsantenne 20E in einer perspektivischen Ansicht in einer Anordnung relativ zu einer Lötebene LE und einer Lötlinie L, wobei die Lötlinie L in der Löteebene LE liegt. Der Strompfad 21E der Induktionsantenne 20E besteht aus einem elektrischen Leiter 250 in Form eines Rohres, wobei jeder Abschnitt des Leiters 250 einen Abschnitt des Strompfads 21E bildet.

Der Leiter 250 ist schleifenförmig ausgebildet und umfasst zwei sich entlang der Lötlinie L erstreckende Leiterabschnitte 251 und 252. Die Induktionsantenne 20E umfasst weiterhin eine Tragstruktur 260 für den Leiter 250, welche im vorliegenden Beispiel in der Lötebene LE angeordnet ist und sich entlang der Lötlinie L erstreckt. Dabei ist der Leiter 250 an einer der Lötlinie L zugewandten Seite der Tragstruktur 260 angeordnet und an dieser befestigt.

Die Lötvorrichtung 15 umfasst ferner eine Anordnung von mehreren Niederhaltern zum Niederhalten eines Bandes an einer Oberfläche einer Stromsammelschiene einer Solarzelle, von welchen Niederhaltern in Fig. 46 zwei Niederhalter N1 und N2 sichtbar sind, wobei der Niederhalter N1 ein Niederhalterelement P1 und der Niederhalter N2 ein Niederhalterelement P2 umfasst. Die Niederhalterelemente P1 und P2 sind (wie die Niederhalterelemente P1 und P2 gemäss Fig. 4) als Stifte ausgebildet, welche sich in der Lötebene LE im Wesentlichen senkrecht zur Lötlinie L erstrecken und jeweils in einem in der Tragstruktur 260 ausgebildeten Kanal angeordnet sind.

Es sei darauf hingewiesen, dass in Fig. 46 nur ein Teil der Tragstruktur 260 und nur ein Teil des Strompfads 21E bzw. des Leiters 250 dargestellt ist. So ist in Fig. 46 nicht sichtbar, dass die Leiterabschnitte 251 und 252 derart miteinander verbunden sind, dass sie elektrisch in Reihe geschaltet sind.

Der Leiter 250 kann an einen (in Fig. 46 nicht dargestellten) Generator für den elektrischen Wechselstrom I angeschlossen werden, sodass der elektrische Wechselstrom I in den Leiter 250 einkoppelbar bzw. aus dem Leiter 250 auskoppelbar ist und in den Leiterabschnitten 251 und 252 entlang der Lötlinie L fliessen kann. In Fig. 46 geben mit dem Bezugszeichen I versehene Pfeile die momentane Stromrichtung des Wechselstroms I in verschiedenen Abschnitten des Strompfads 250E bzw. der Leiterabschnitte 251 und 252 an. Wie ersichtlich, ist die momentane Stromflussrichtung des elektrischen Wechselstroms I im Leiterabschnitt 251 entgegengesetzt zur momentanen Stromflussrichtung des elektrischen Wechselstroms I im Leiterabschnitt 252, sodass der elektrische Wechselstrom I im Leiterabschnitt 251 in Gegenphase zum elektrischen Wechselstrom I im Leiterabschnitt 252 ist.

Wie aus Fig. 46 ersichtlich, sind die Leiterabschnitte 251 und 252 derart gebogen und gegeneinander verdreht, dass sowohl der Leiterabschnitt 251 als auch der Leiterabschnitt 252 einen oder mehrere Abschnitte aufweisen, welche sich auf einer ersten Seite S1 der Lötebenen LE erstrecken, und dass sowohl der Leiterabschnitt 251 und als auch der Leiterabschnitt 252 einen oder mehrere Abschnitte aufweisen, welche sich auf einer zweiten, der ersten Seite S1 gegenüberliegenden Seite S2 der Lötebenen LE erstrecken.

Wie aus Fig. 46 ersichtlich, weist der Leiterabschnitt 251 einen Abschnitt 251-A1 auf, welcher einen ersten Abschnitt des Strompfads 21E bildet und welcher sich auf der ersten Seite S1 einer Lötebene LE in einem Abstand zur Lötebene LE entlang eines ersten Abschnitts L1 der Lötlinie L - von diesem Abschnitt L1 der Lötlinie L durch einen Luftspalt getrennt - erstreckt (wie ersichtlich, befindet sich der Abschnitt L1 in der Nähe des Niederhalterelements P1). Weiterhin weist der Leiterabschnitt 251 einen Abschnitt 251-B1 auf, welcher einen zweiten Abschnitt des Strompfads 21E bildet und welcher sich auf der Seite S2 der Lötebene LE in einem Abstand zur Lötebene LE entlang eines zweiten Abschnitts L2 der Lötlinie L - von diesem Abschnitt L2 der Lötlinie L durch einen Luftspalt getrennt - erstreckt (wie ersichtlich, befindet sich der Abschnitt L2 in der Nähe des Niederhalterelements P2).

Wie aus Fig. 46 ersichtlich, weist der Leiterabschnitt 252 einen Abschnitt 252-A1 auf, welche einen dritten Abschnitt des Strompfads 21E bildet und welcher sich auf der Seite S1 der Lötebene LE in einem Abstand zur Lötebene LE entlang des Abschnitts L2 der Lötlinie L - von diesem Abschnitt L2 der Lötlinie L durch einen Luftspalt getrennt - erstreckt. Weiterhin weist der Leiterabschnitt 252 einen Abschnitt 252-B1 auf, welcher einen vierten Abschnitt des Strompfads 21E bildet und welcher sich auf der Seite S2 der Lötebene LE in einem Abstand zur Lötebene LE entlang des Abschnitt L1 der Lötlinie L - von diesem Abschnitte L1 der Lötlinie L durch einen Luftspalt getrennt - erstreckt.

Wie erwähnt bzw. aus Fig. 46 anhand der dargestellte Stromflussrichtungen des elektrischen Wechselstroms I in den Leiterabschnitten 251 und 252 ersichtlich, sind der Abschnitt 251-A1 (d.h. der erste Abschnitt des Strompfads 21E), der Abschnitt 251-B1 (d.h. der zweite Abschnitt des Strompfads 21E), der Abschnitt 252-A1 (d.h. der dritte Abschnitt des Strompfads 21E) und Abschnitt 252-B1 (d.h. der vierte Abschnitt des Strompfads 21E) elektrisch in einer Reihe hintereinandergeschaltet, sodass der elektrische Wechselstrom I im Abschnitt 251-Al mit dem elektrischen Wechselstrom I im Abschnitt 251-B1 in Gleichphase und mit dem elektrischen Wechselstrom I im Abschnitt 252-A1 und mit dem elektrischen Wechselstrom I im Abschnitt 252-B1 in Gegenphase ist.

Im vorliegenden Beispiel sind die Abschnitte 251-A1 und 252-B1 auf verschiedenen Seiten S1 und S2 der Lötebene LE angeordnet und erstrecken sich im Bereich des Abschnitts L1 in jeweils einem in etwa gleichen Abstand zur Lötlinie L entlang der Lötlinie L, wobei die Stromflussrichtung des elektrischen Wechselstroms I im Abschnitt 251-A1 entgegensetzt zur Stromflussrichtung des elektrischen Wechselstroms I im Abschnitt 252-B1. Der elektrische Wechselstrom I erzeugt deshalb im Bereich des Abschnitts L1 ein magnetisches Wechselfeld H1, welches aus einer Superposition des magnetischen Wechselfelds, welches der durch den Abschnitt 251-A1 fliessende Wechselstrom in der Umgebung dieses Abschnitts erzeugt, und des magnetischen Wechselfelds, welches der durch den Abschnitt 252-B1 fliessende Wechselstrom in der Umgebung dieses Abschnitts erzeugt, resultiert. In Fig. 46 stellen mit dem Bezugszeichen H1 bezeichnete Pfeile die magnetische Feldstärke des magnetischen Wechselfelds für Punkte auf der Lötlinie L dar, welche im Abschnitt L1 liegen (für die in Fig. 46 angegebene Stromflussrichtung des elektrischen Wechselstroms I).

Entsprechend sind die Abschnitte 252-A1 und 251-B1 auf verschiedenen Seiten S1 und S2 der Lötebene LE angeordnet und erstrecken sich im Bereich des Abschnitts L2 in jeweils einem in etwa gleichen Abstand zur Lötlinie L entlang der Lötlinie L, wobei die Stromflussrichtung des elektrischen Wechselstroms I im Abschnitt 252-A1 entgegengesetzt zur Stromflussrichtung des elektrischen Wechselstroms I im Abschnitt 251-B1 ist. Der elektrische Wechselstrom I erzeugt deshalb im Bereich des Abschnitts L2 ein magnetisches Wechselfeld H2, welches aus einer Superposition des magnetischen Wechselfelds, welches der durch den Abschnitt 252-A1 fliessende Wechselstrom in der Umgebung dieses Abschnitts erzeugt, und des magnetischen Wechselfelds, welches der durch den Abschnitt 251-B1 fliessende Wechselstrom in der Umgebung dieses Abschnitts erzeugt, resultiert. In Fig. 46 stellen mit dem Bezugszeichen H2 bezeichnete Pfeile die magnetische Feldstärke des magnetischen Wechselfelds für Punkte auf der Lötlinie L, welche im Abschnitt L2 liegen, dar (für die in Fig. 46 angegebene Stromflussrichtung des elektrischen Wechselstroms I).

Wie ersichtlich, sind die magnetischen Wechselfelder H1 und H2 im Wesentlichen parallel zur Lötebene LE und senkrecht zur Lötlinie L gerichtet. Die momentane Richtung des magnetischen Wechselfeld H1 ist entgegengesetzt zur momentanen Richtung des magnetischen Wechselfelds H2, sodass das magnetische Wechselfeld H1 im Abschnitt L1 in Gegenphase zum magnetischen Wechselfelds H2 im Abschnitt L2 ist.

Um eine gute Homogenität der Wechselfelder H1 bzw. H2 zu erzielen, kann der Abschnitt 251-A1 bezüglich der Lötebene LE spiegelbildlich zum Abschnitt 252-B1 bzw. der Abschnitt 252-A1 bezüglich der Lötebene LE spiegelbildlich zum Abschnitt 251-B1 ausgebildet sein. Dabei können die Leiterabschnitte 251 und 252 miteinander verdrillt sein.

Im vorliegenden Beispiel ist zwischen dem Abschnitt 251-A1 und dem Abschnitt 252-B1 ein freier Raumbereich R1 ausgebildet, welcher derart bemessen ist, dass sich das Niederhalterelement P1 durch diesen freien Raumbereich R1 erstreckt. Entsprechend ist zwischen dem Abschnitt 251-B1 und dem Abschnitt 252-A1 ein freier Raumbereich R2 ausgebildet, welcher derart bemessen ist, dass sich das Niederhalterelement P2 durch diesen freien Raumbereich R2 erstreckt.

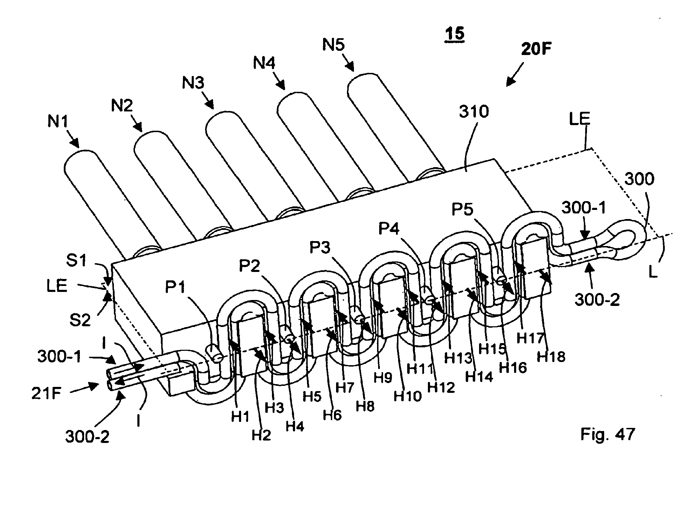

Fig. 47 stellt eine sechste Variante der erfindungsgemässen Lötvorrichtung 15 dar, welche eine Induktionsantenne 20F mit einem Strompfad 21F für einen (hochfrequenten) elektrischen Wechselstrom I umfasst.

Fig. 47 zeigt die Induktionsantenne 20F in einer perspektivischen Ansicht in einer Anordnung relativ zu einer Lötebene LE und einer Lötlinie L, wobei die Lötlinie L in der Lötebene LE liegt. Der Strompfad 21F der Induktionsantenne 20F besteht aus einem elektrischen Leiter 300 in Form eines Rohres, wobei jeder Abschnitt des Leiters 300 einen Abschnitt des Strompfads 21F bildet.

Die Induktionsantenne 20F umfasst weiterhin eine Tragstruktur 310 für den Leiter 300, welche im vorliegenden Beispiel in der Lötebene LE angeordnet ist und sich entlang der Lötlinie L erstreckt. Dabei ist der Leiter 300 an einer der Lötlinie L zugewandten Seite der Tragstruktur 310 angeordnet und an dieser befestigt.

Die Lötvorrichtung 15 umfasst ferner eine Anordnung von mehreren Niederhaltern N1-N5 zum Niederhalten eines Bandes an einer Oberfläche einer Stromsammelschiene einer Solarzelle. Jeder der Niederhalter N1, N2, N3, N4 bzw. N5 umfasst ein Niederhalterelement P1, P2, P3, P4 bzw. P5, wobei die Niederhalterelemente P1-P5 (wie die Niederhalterelemente P1-P11 gemäss Fig. 4) als Stifte ausgebildet sind, welche sich in der Lötebene LE im Wesentlichen senkrecht zur Lötlinie L erstrecken und jeweils in einem in der Tragstruktur 310 ausgebildeten Kanal angeordnet sind. Dabei sind die Niederhalterelemente P1-P5 in einer Reihe hintereinander entlang der Lötlinie L angeordnet.

Wie aus Fig. 47 ersichtlich, ist der Leiter 300 schleifenförmig ausgebildet und weist zwei Schenkel 300-1, 300-2 auf, wobei ein Ende des Schenkels 300-1 mit einem Ende des Schenkels 300-2 verbunden ist. Der Schenkel 300-1 erstreckt sich in einer Mäanderform entlang der Lötlinie L derart, dass er die Lötebene LE an mehreren separaten Orten kreuzt, sodass der Schenkel 300-1 mehrere in seiner Längsrichtung aufeinander folgende Längsabschnitte aufweist, welche sich - jeweils entlang einer Kurve, welche gekrümmt und/oder abschnittsweise gekrümmt und/oder abschnittsweise geradlinig ist - abwechselnd auf einer Seite S1 der Lötebene LE und auf der anderen Seite S2 der Lötebene LE erstrecken. Im vorliegenden Beispiel kreuzt der Schenkel 300-1 die Lötebene LE zwischen zwei benachbarten Niederhalterelementen P1 und P2 bzw. P2 und P3 bzw. P3 und P4 bzw. P4 und P5 an jeweils zwei separaten Orten.

Die Schenkel 300-1 und 300-2 können sich in einer Ebene erstrecken, welche senkrecht zur Lötebene LE und/oder parallel zu einer Oberfläche einer Solarzelle angeordnet ist. Der Schenkel 300-2 kann sich parallel zu dem Schenkel 300-1 erstrecken (wie in der Darstellung gemäss Fig. 47). Im vorliegenden Beispiel kreuzt der Schenkel 300-2 (wie der Schenkel 300-1) die Lötebene LE zwischen zwei benachbarten Niederhalterelementen P1 und P2 bzw. P2 und P3 bzw. P3 und P4 bzw. P4 und P5 an jeweils zwei separaten Orten.

An die Schenkel 300-1 und 300-2 kann ein Generator für den elektrischen Wechselstrom I angeschlossen werden, sodass der elektrischen Wechselstrom I in den Leiter 300 einkoppelbar bzw. aus dem Leiter 300 auskoppelbar ist und in den Schenkeln 300-1 und 300-2 entlang der Lötlinie L fliessen kann. In Fig. 47 geben mit dem Bezugszeichen I versehene Pfeile die momentane Stromrichtung des Wechselstroms I in verschiedenen Abschnitten des Strompfads 25F bzw. in den Schenkeln 300-1 und 300-22 an. Wie ersichtlich, ist die momentane Stromflussrichtung des elektrischen Wechselstroms I im Schenkel 300-1 entgegengesetzt zur momentanen Stromflussrichtung des elektrischen Wechselstroms I im Schenkel 300-2, sodass der elektrische Wechselstrom I im Schenkel 300-1 im Gegenphase zum elektrischen Wechselstrom I im Schenkel 300-2 ist. Der elektrische Wechselstrom I ist im Leiter 300 derart geführt, dass er in der Lötlinie L ein magnetisches Wechselfeld erzeugt. Wie in Fig. 47 ersichtlich, erzeugt der elektrische Wechselstrom I in der Lötlinie L Wechselfelder, welche im Wesentlichen parallel zur Lötebene LE und senkrecht zur Lötlinie L gerichtet sind. Im vorliegenden Beispiel geben Pfeile mit den Bezugszeichen H1-18 jeweils die momentane Richtung der Feldstärke des magnetischen Wechselfelder für verschiedene Punkte auf der Lötlinie L an (jeweils für die in Fig. 47 angegebene momentane Stromflussrichtung des Wechselstroms I).

Wie ersichtlich, sind die magnetischen Wechselfelder H1, H3, H5, H7, H9, H11, H13, H15 und H17 in Gleichphase. Ausserdem ist jedes der magnetischen Wechselfelder H1, H3, H5, H7, H9, H11, H13, H15 und H17 in Gegenhase zu jedem der magnetischen Wechselfelder H2, H4, H6, H8, H10, H12, H14, H16 und H18.

## Patentansprüche

1. Lötvorrichtung (15) zum Befestigen eines elektrisch leitfähigen Bandes (5) an einer geraden Stromsammelschiene (3) einer Solarzelle (1) entlang einer geraden Lötlinie (L) mittels induktivem Löten, welche umfasst:
eine Mehrzahl Niederhalterelemente (P1-P11; 230, 231) zum Niederhalten des Bandes (5) auf einer Oberfläche der Stromsammelschiene (3), wobei die Niederhalterelemente (P1-P11; 230, 231) entlang der Lötlinie (L) in einer Reihe hintereinander angeordnet sind;
eine Induktionsantenne (20A; 20B; 20C; 20D; 20E; 20F) mit einem sich entlang der Lötlinie (L) erstreckenden Strompfad (21A; 21B; 21C; 21D; 21E; 21F) für einen elektrischen Wechselstrom (I), wobei der elektrische Wechselstrom (I) entlang des Strompfads (21A; 21B; 21C; 21D; 21E; 21F) derart geführt ist, dass er in der Lötlinie (L) und/oder in einer Umgebung der Lötlinie (L) ein magnetisches Wechselfeld (H1, H2) erzeugt,
**dadurch gekennzeichnet, dass**
sich der Strompfad (21A; 21B; 21C; 21D; 21E; 21F) entlang mehrerer in einer Reihe hintereinander angeordneter Abschnitte (L1-L10) der Lötlinie (L) derart erstreckt, dass das magnetische Wechselfeld (H1) in mindestens einem der Abschnitte (L1) der Lötlinie (L) in Gegenphase zu dem magnetischen Wechselfeld (H2) in mindestens einem anderen der Abschnitte (L2) der Lötlinie (L) ist.

2. Lötvorrichtung nach Anspruch 1, wobei
der Strompfad (21A; 21B; 21D) der Induktionsantenne (20A, 20B, 20D) aufweist:
einen ersten Abschnitt (30-A1; 130-A1; B1), welcher sich in einer Lötebene (LE), in welcher die Lötlinie (L) liegt, entlang des mindestens einen der Abschnitte (L1) der Lötlinie (L) - von diesem mindestens einen der Abschnitte (L1) der Lötlinie (L) durch einen Luftspalt (LS) getrennt - erstreckt;
einen zweiten Abschnitt (40-A1; 140-A1; A1), welcher sich in der Lötebene (LE) entlang des mindestens einen anderen der Abschnitte (L2) der Lötlinie (L) - von diesem mindestens einen anderen der Abschnitte (L2) der Lötlinie (L) durch einen Luftspalt (LS) getrennt - erstreckt;
wobei ein Ende des ersten Abschnitts (30-A1; 130-A1; B1) des Strompfads (21A; 21B; 21D) mit einem Ende des zweiten Abschnitts (40-A1; 140-A1; A1) des Strompfads (21A; 21B; 21D) derart verbunden ist, dass der erste und der zweite Abschnitt des Strompfads (21A; 21B; 21D) elektrisch in Reihe geschaltet sind und der elektrische Wechselstrom (I) im ersten Abschnitt (30-A1; 130-A1; B1) des Strompfads (21A; 21B; 21D) in Gegenphase zum elektrischen Wechselstrom im zweiten Abschnitt (40-A1; 140-A1; A1) des Strompfads (21A; 21B; 21D) ist.

3. Lötvorrichtung nach Anspruch 2, wobei der erste Abschnitt (30-A1; 130-A1; B1) des Strompfads (21A; 21B; 21D) und der zweite Abschnitt (40-A1; 140-A1; A1) des Strompfads (21A; 21B; 21D) sich jeweils geradlinig und im Wesentlichen parallel zur Lötlinie (L) erstrecken.

4. Lötvorrichtung nach Anspruch 3, wobei der erste Abschnitt (30-A1; 130-A1; B1) des Strompfads (21A; 21B; 21D) und der zweite Abschnitt (40-A1; 140-A1; A1) des Strompfads (21A; 21B; 21D) hintereinander auf einer sich in der Lötebene (LE) erstreckenden Geraden (G) liegen.

5. Lötvorrichtung nach einem der Ansprüche 2-4, wobei sich die Niederhalterelemente (P1-P11) jeweils in der Lötebene (LE) im Wesentlichen senkrecht zur Lötlinie (L) erstrecken und mindestens drei dieser Niederhalterelemente (P1-P11) entlang der Lötlinie (L) in einer Reihe hintereinander derart angeordnet sind, dass zwischen jeweils zwei der Niederhalterelemente (P1-P11), welche in der Reihe unmittelbar hintereinander angeordnet sind, jeweils ein Zwischenraum (Z1-Z10) ausgebildet ist, und
wobei der erste Abschnitt (30-A1) des Strompfads (21A) in einem der Zwischenräume (Z1) zwischen jeweils zwei der Niederhalterelemente (P1, P2) und
der zweite Abschnitt (40-A1) des Strompfads (21A) in einem anderen der Zwischenräume (Z2) zwischen jeweils zwei der Niederhalterelemente (P2, P3) angeordnet ist.

6. Lötvorrichtung nach Anspruch 1, wobei der Strompfad (21C; 21E) der Induktionsantenne (20C, 20E) aufweist:
einen ersten Abschnitt (LC1; 251-A1), welcher sich auf einer ersten Seite (S1) einer Lötebene (LE), in welcher die Lötlinie (L) liegt, in einem Abstand zur Lötebene (LE) entlang des mindestens einen der Abschnitte (L1) der Lötlinie (L) - von diesem mindestens einen der Abschnitte (L1) der Lötlinie (L) durch einen Luftspalt (LS) getrennt - erstreckt;
einen zweiten Abschnitt (LD1; 251-B1), welcher sich auf einer zweiten, der ersten Seite (S1) der Lötebene (LE) gegenüberliegenden Seite (S2) der Lötebene (LE) in einem Abstand zur Lötebene (LE) entlang des mindestens einen anderen der Abschnitte (L2) der Lötlinie (L) - von diesem mindestens einen anderen der Abschnitte (L2) der Lötlinie (L) durch einen Luftspalt (LS) getrennt - erstreckt;
einen dritten Abschnitt (LG1; 252-A1), welcher sich auf der ersten Seite (S1) der Lötebene (LE) in einem Abstand zur Lötebene (LE) entlang des mindestens einen anderen der Abschnitte (L2) der Lötlinie (L) - von diesem mindestens einen anderen der Abschnitte (L2) der Lötlinie (L) durch einen Luftspalt (LS) getrennt - erstreckt;
einen vierten Abschnitt (LF1; 252-B1), welcher sich auf der zweiten Seite (S2) der Lötebene (LE) in einem Abstand zur Lötebene (LE) entlang des mindestens einen der Abschnitte (L1) der Lötlinie (L) - von diesem mindestens einen der Abschnitte (L1) der Lötlinie (L) durch einen Luftspalt (LS) getrennt - erstreckt;
wobei der erste Abschnitt (LC1; 251-A1) des Strompfads, der zweite Abschnitt (LD1; 251-B1) des Strompfads, der dritte Abschnitt (LG1; 252-A1) des Strompfads und der vierte Abschnitt (LF1; 252-B1) des Strompfads elektrisch in einer Reihe hintereinandergeschaltet sind, sodass der elektrische Wechselstrom (I) im ersten Abschnitt (LC1; 251-A1) des Strompfads (21C; 21E) mit dem elektrischen Wechselstrom (I) im zweiten Abschnitt (LD1; 251-B1) des Strompfads in Gleichphase und mit dem elektrischen Wechselstrom (I) im dritten Abschnitt (LG1; 252-A1) des Strompfads und mit dem elektrischen Wechselstrom (I) im vierten Abschnitt (LF1; 252-B1) des Strompfads in Gegenphase ist.

7. Lötvorrichtung nach der Anspruch 6, wobei
sich der erste Abschnitt (LC1; 251-A1) des Strompfads (21C; 21E) und/oder
der zweite Abschnitt (LD1; 251-B1) des Strompfads (21C; 21E) und/oder
der dritte Abschnitt (LG1; 252-A1) des Strompfads (21C; 21E) und/oder
der vierte Abschnitt (LF1; 252-B1) des Strompfads (21C; 21E)
jeweils geradlinig im Wesentlichen parallel zur Lötlinie (L) erstrecken.

8. Lötvorrichtung nach einem der Ansprüche 6 oder 7, wobei der erste Abschnitt (LC1; 251-A1) des Strompfads (21C; 21E) und der vierte Abschnitt (LF1; 252-B1) des Strompfads (21C; 21E) relativ zueinander spiegelsymmetrisch bezüglich der Lötebene (LE) ausgebildet sind und/oder der zweite Abschnitt (LD1; 251-B1) des Strompfads (21C; 21E) und der dritte Abschnitt (LG1; 252-A1) des Strompfads (21C; 21E) relativ zueinander spiegelsymmetrisch bezüglich der Lötebene (LE) ausgebildet sind.

9. Lötvorrichtung nach einem der Ansprüche 6-8, wobei der erste Abschnitt (LC1; 251-A1) und der dritte Abschnitt (LG1; 252-A1) des Strompfads (21C; 21E) sich entlang einer ersten Geraden (G1) und
der zweite Abschnitt (LD1; 251-B1) und der vierte Abschnitt (LF1; 252-B1) des Strompfads (21C; 21E) sich entlang einer zweiten Geraden (G2) erstrecken.

10. Lötvorrichtung nach einem der Ansprüche 6 oder 7, wobei der erste Abschnitt (251-A1) und der zweite Abschnitt (251-B1) des Strompfads (21E) als hintereinander angeordnete Längsabschnitte eines ersten Leiterabschnitts (251) ausgebildet sind und
der dritte Abschnitt (252-A1) und vierte Abschnitt (252-B1) des Strompfads (21E) als hintereinander angeordnete Längsabschnitte eines zweiten Leiterabschnitts (252) ausgebildet sind,
wobei der erste und der zweite Leiterabschnitt (251, 252) miteinander verdrillt sind.

11. Lötvorrichtung nach einem der Ansprüche 6-9, wobei sich die Niederhalterelemente (P1-P11) jeweils in der Lötebene (LE) im Wesentlichen senkrecht zur Lötlinie (L) erstrecken und mindestens drei dieser Niederhalterelemente (P1-P11) entlang der Lötlinie (L) in einer Reihe hintereinander derart angeordnet sind, dass zwischen jeweils zwei der Niederhalterelemente (P1-P11), welche in der Reihe unmittelbar hintereinander angeordnet sind, jeweils ein Zwischenraum (Z1-Z10) ausgebildet ist, und
wobei der erste Abschnitt (LC1) und der vierte Abschnitt (LF1) des Strompfads (21C) in einem der Zwischenräume (Z1) zwischen jeweils zwei der Niederhalterelemente (P1, P2) und
der zweite Abschnitt (LD1) und der dritte Abschnitt (LG1) des Strompfads (21C) in einem anderen der Zwischenräume (Z2) zwischen jeweils zwei der Niederhalterelemente (P2, P3) angeordnet sind.

12. Lötvorrichtung nach einem der Ansprüche 6-10, wobei zwischen dem ersten Abschnitt (251-A1) des Strompfads (21E) und dem vierten Abschnitt (252-B1) des Strompfads (21E) ein freier Raumbereich (R1) ausgebildet ist und sich mindestens eines der Niederhalterelemente (P1) durch diesen freien Raumbereich (R1) erstreckt und/oder zwischen dem zweiten Abschnitt (251-B1) des Strompfads (21E) und dem dritten Abschnitt (252-A1) des Strompfads (21E) ein freier Raumbereich (R2) ausgebildet ist und sich mindestens eines der Niederhalterelemente (P2) durch diesen freien Raumbereich (R2) erstreckt.

13. Lötvorrichtung nach Anspruch 1, wobei der Strompfad (21F) der Induktionsantenne (20F) ein schleifenförmiger Leiter (300) ist, welcher zwei Schenkel (300-1, 300-2) aufweist, wobei ein Ende des einen Schenkels (300-1) mit einem Ende des anderen Schenkels (300-2) verbunden ist,
wobei sich mindestens einer der zwei Schenkel (300-1) in einer Mäanderform entlang der Lötlinie (L) erstreckt und eine Lötebene (LE), in welcher die Lötlinie (L) liegt, an mehreren separaten Orten kreuzt, sodass dieser eine Schenkel (300-1) mehrere in seiner Längsrichtung aufeinander folgende Längsabschnitte aufweist, welche sich - jeweils entlang einer Kurve, welche gekrümmt und/oder abschnittsweise gekrümmt und/oder abschnittsweise geradlinig ist - abwechselnd auf einer Seite (S1) der Lötebene (LE) und auf der anderen Seite (S2) der Lötebene erstrecken.

14. Lötvorrichtung nach Anspruch 13, wobei sich die zwei Schenkel (300-1, 300-2) in einer Ebene erstrecken, welche senkrecht zur Lötebene (LE) und/oder parallel zu einer Oberfläche (1-1) der Solarzelle (1) angeordnet ist, und
sich der andere der zwei Schenkel (300-2) parallel zu dem einen der zwei Schenkel (300-1) erstreckt und der elektrische Wechselstrom (I) in dem einen der zwei Schenkel (300-1) in Gegenphase zu dem elektrischen Wechselstrom (I) in dem anderen der zwei Schenkel (300-2) ist.

## Claims

1. A soldering device (15) for fastening an electrically conductive strip (5) to a straight busbar (3) of a solar cell (1) along a straight soldering line (L) by means of inductive soldering, comprising:
a plurality of hold-down elements (P1-P11; 230, 231) for holding down the strip (5) on a surface of the busbar (3), wherein the hold-down elements (P1-P11; 230, 231) are arranged in a row along the soldering line (L) one after the other;
an induction antenna (20A; 20B; 20C; 20D; 20E; 20F) having a current path (21A; 21B; 21C; 21D; 21E; 21F) extending along the soldering line (L) for an electrical alternating current (I), wherein the electrical alternating current (I) is carried along the current path (21A; 21B; 21C; 21D; 21E; 21F) in such a way that it generates a magnetic alternating field (H1, H2) in the soldering line (L) and/or in the surroundings of the soldering line (L),
**characterized in that**
the current path (21A; 21B; 21C; 21D; 21E; 21F) extends along a plurality of segments (L1-L10) of the soldering line (L) arranged in a row one after the other, such that the magnetic alternating field (H1) in at least one of the segments (L1) of the soldering line (L) is in phase opposition to the magnetic alternating field (H2) in at least one other one of the segments (L2) of the soldering line (L).

2. The soldering device according to claim 1, wherein the current path (21A; 21B; 21D) of the induction antenna (20A, 20B, 20D) has:
a first segment (30-A1; 130-A1; B1), which extends in a soldering plane (LE), in which the soldering line (L) is situated, along the at least one of the segments (L1) of the soldering line (L) - separated from this at least one of the segments (L1) of the soldering line (L) by an air gap (LS);
a second segment (40-A1; 140-A1; A1) which extends in the soldering plane (LE) along the at least one other one of the segments (L2) of the soldering line (L) - separated from this at least one other one of the segments (L2) of the soldering line (L) by an air gap (LS) ;
wherein one end of the first segment (30-A1; 130-A1; B1) of the current path (21A; 21B; 21D) is connected to an end of the second segment (40-A1; 140-A1; A1) of the current path (21A; 21B; 21D) in such a way that the first and second segments of the current path (21A; 21B; 21D) are electrically connected in series, and the electrical alternating current (I) in the first segment (30-A1; 130-A1; B1) of the current path (21A; 21B; 21D) is in phase opposition to the electrical alternating current in the second segment (40-A1; 140-A1; A1) of the current path (21A; 21B; 21D).

3. The soldering device according to claim 2, wherein
the first segment (30-A1; 130-A1; B1) of the current path (21A; 21B; 21D) and the second segment (40-A1; 140-A1; A1) of the current path (21A; 21B; 21D) each extend in a straight line and essentially in parallel with the soldering line (L).

4. The soldering device according to claim 3, wherein the first segment (30-A1; 130-A1; B1) of the current path (21A; 21B; 21D) and the second segment (40-A1; 140-A1; A1) of the current path (21A; 21B; 21D) are situated one after the other on a straight line (G) extending in the soldering plane (LE).

5. The soldering device according to any one of claims 2 to 4, wherein
the hold-down elements (P1-P11) each extend essentially perpendicular to the soldering line (L) in the soldering plane (LE), and at least three of these hold-down elements (P1-P11) are arranged along the soldering line (L) in a row, one after the other, such that an intermediate space (Z1-Z10) is formed between two of the hold-down elements (P1-P11), which are arranged directly one after the other in the row, and
wherein the first segment (30-A1) of the current path (21A) is arranged in one of the intermediate spaces (Z1) between two of the hold-down elements (P1, P2), and
the second segment (40-A1) of the current path (21A) is arranged in another one of the intermediate spaces (Z2) between two of the hold-down elements (P2, P3).

6. The soldering device according to claim 1, wherein
the current path (21C; 21E) of the induction antenna (20C, 20E) has:
a first segment (LC1; 251-A1), which extends on a first side (S1) of a soldering plane (LE), in which the soldering line (L) lies, at a distance from the soldering plane (LE) along the at least one of the segments (L1) of the soldering line (L) - separated from the at least one of the segments (L1) of the soldering line (L) by an air gap (LS);
a second segment (LD1; 251-B1), which extends on a second side (S2) of the soldering plane (LE) opposite the first side (S1) of the soldering plane (LE) at a distance from the soldering plane (LE) along the at least one other one of the segments (L2) of the soldering line (L) - separated from this at least one other one of the segments (L2) of the soldering line (L) by an air gap (LS);
a third segment (LG1; 252-A1), which extends on the first side (S1) of the soldering plane (LE) at a distance from the soldering plane (LE) along the at least one other one of the segments (L2) of the soldering line (L) - separated from this at least one other one of the segments (L2) of the soldering line (L) by an air gap (LS);
a fourth segment (LF1; 252-B1), which extends on the second side (S2) of the soldering plane (LE) at a distance from the soldering plane (LE) along the at least one of the segments (L1) of the soldering line (L) - separated from this at least one of the segments (L1) of the soldering line (L) by an air gap (LS);
wherein the first segment (LC1; 251-A1) of the current path, the second segment (LD1; 251-B1) of the current path, the third segment (LG1; 252-A1) of the current path and the fourth segment (LF1; 252-B1) of the current path are electrically connected in series, one after the other, so that
the electrical alternating current (I) in the first segment (LC1; 251-A1) of the current path (21C; 21E) is in phase with the electrical alternating current (I) in the second segment (LD1; 251-B1) of the current path and is in phase opposition to the electrical alternating current (I) in the third segment (LG1; 252-A1) of the current path and is in phase opposition to the electrical alternating current (I) in the fourth segment (LF1; 252-B1) of the current path.

7. The soldering device according to claim 6, wherein
the first segment (LC1; 251-A1) of the current path (21C; 21E) and/or
the second segment (LD1; 251-B1) of the current path (21C; 21E) and/or
the third segment (LG1; 252-A1) of the current path (21C; 21E) and/or
the fourth segment (LF1; 252-B1) of the current path (21C; 21E)
each extends in a straight line essentially parallel to the soldering line (L).

8. The soldering device according to any one of claims 6 or 7, wherein
the first segment (LC1; 251-A1) of the current path (21C; 21E) and the fourth segment (LF1; 252-B1) of the current path (21C; 21E) are designed to be in mirror symmetry relative to one another with respect to the soldering plane (LE) and/or the second segment (LD1; 251-B1) of the current path (21C; 21E) and the third segment (LG1; 252-A1) of the current path (21C; 21E) are designed to be in mirror symmetry relative to one another with respect to the soldering plane (LE).

9. The soldering device according to any one of claims 6 to 8, wherein
the first segment (LC1; 251-A1) and the third segment (LG1; 252-A1) of the current path (21C; 21E) extend along a first straight line (G1), and
the second segment (LD1; 251-B1) and the fourth segment (LF1; 252-B1) of the current path (21C; 21E) extend along a second straight line (G2).

10. The soldering device according to any one of claims 6 or 7, wherein
the first segment (251-A1) and the second segment (251-B1) of the current path (21E) are designed as longitudinal segments of a first conductor segment (251) arranged sequentially, one after the other, and
the third segment (252-A1) and the fourth segment (252-B1) of the current path (21E) are designed as longitudinal segments of a second conductor segment (252) arranged sequentially, one after the other, and
wherein the first and the second conductor segments (251, 252) are twisted together.

11. The soldering device according to any one of claims 6 to 9, wherein
the hold-down elements (P1-P11) each extend essentially at a right angle to the soldering line (L) in the soldering plane (LE), and at least three of these hold-down elements (P1-P11) are arranged along the soldering line (L) in a row, one after the other, so that an intermediate space (Z1-Z10) is formed between two of the hold-down elements (P1-P11), which are arranged one after the other in the row, and
wherein the first segment (LC1) and the fourth segment (LF1) of the current path (21C) are arranged in one of the intermediate spaces (Z1) between two of the hold-down elements (P1, P2), and
the second segment (LD1) and the third segment (LG1) of the current path (21C) are arranged in another one of the intermediate spaces (Z2) between two of the hold-down elements (P2, P3).

12. The soldering device according to any one of claims 6 to 10, wherein
a free space region (R1) is formed between the first segment (251-A1) of the current path (21E) and the fourth segment (252-B1) of the current path (21E), and at least one of the hold-down elements (P1) extends through this free space region (R1) and/or a free space region (R2) is formed between the second segment (251-B1) of the current path (21E) and the third segment (252-A1) of the current path (21E), and at least one of the hold-down elements (P2) extends through this free space region (R2).

13. The soldering device according to claim 1, wherein
the current path (21F) of the induction antenna (20F) is a loop-shaped conductor (300) having two legs (300-1, 300-2), wherein one end of the one leg (300-1) is connected to one end of the other leg (300-2),
wherein at least one of the two legs (300-1) extends in a meandering form along the soldering line (L) and intersects the soldering plane (LE) in which the soldering line (L) is situated at several separate locations, so that this one leg (300-1) has a plurality of longitudinal sections following one another in its longitudinal direction, extending alternately on one side (S1) of the soldering plane (LE) and on the other side (S2) of the soldering plane - each one along a curve which is curved and/or is curved in sections and/or is straight in sections.

14. The soldering device according to claim 13, wherein
the two legs (300-1, 300-2) extend in a plane, which is arranged perpendicular to the soldering plane (LE) and/or parallel to a surface (1-1) of the solar cell (1), and
the other one of the two legs (300-2) extends parallel to the one of the two legs (300-1) and the electrical alternating current (I) in the one of the two legs (300-1) is in phase opposition to the electrical alternating current (I) in the other one of the two legs (300-2).

## Revendications

1. Dispositif de brasage (15) pour fixer une bande électroconductrice (5) sur une barre collectrice de courant (3) d'une cellule solaire (1) le long d'une ligne de brasage droite (L) au moyen de brasage inductif, lequel comprend :
une pluralité d'éléments abaisseurs (P1-P11, 230, 231) pour maintenir abaissée la bande (5) sur une surface de la barre collectrice de courant (3), les éléments abaisseurs (P1-P11, 230, 231) étant disposés en série les uns derrière les autres le long de la ligne de brasage (L),
une antenne à induction (20A, 20B, 20C, 21D, 20E, 20F) avec un trajet de courant (21A, 21B, 21C, 21D, 21E, 21F) s'étendant le long de la ligne de brasage (L) pour un courant alternatif électrique (I), le courant alternatif électrique (I) étant guidé le long du trajet de courant (21A, 21B, 21C, 21D, 21E, 21F) de telle manière qu'il produit un champ alternatif magnétique (H1, H2) dans la ligne de brasage (L) et/ou dans un environnement de la ligne de brasage (L),
**caractérisé en ce que**
le trajet de courant (21A, 21B, 21C, 21D, 21E, 21F) s'étend le long de plusieurs sections (L1-L10) de la ligne de brasage (L) disposées en série les unes derrière les autres de telle manière que le champ magnétique alternatif (H1) dans au moins une des sections (L1) de la ligne de brasage (L) en opposition de phase au champ magnétique alternatif (H2) dans au moins une autre des sections (L2) de la ligne de brasage (L).

2. Dispositif de brasage selon la revendication 1, le trajet de courant (21A, 21B, 21D) de l'antenne à induction (20A, 20B, 20D) comportant :
une première section (30-A1, 130-A1, B1), laquelle s'étend dans un plan de brasage (LE) dans lequel la ligne de brasage (L) se situe, le long d'au moins une des sections (L1) de la ligne de brasage (L), [séparée de celle-ci par un entrefer (LS) au moins une des sections (L1) de la ligne de brasage (L),
une deuxième section (40-A1, 140-A1, A1), laquelle s'étend dans un plan de brasage (LE) le long d'au moins une autre des sections (L2) de la ligne de brasage (L), [séparée de celle-ci par un entrefer (LS) au moins une autre des sections (L2) de la ligne de brasage (L),
une extrémité de la première section (30-A1, 130-A1, B1) du trajet de courant (21A, 21B, 21D) étant reliée à une extrémité de la deuxième section (40-A1, 140-A1, A1) du trajet de courant (21A, 21B, 21D) de telle manière que la première et la deuxième section du trajet de courant (21A, 21B, 21D) sont électriquement connectées en série et le courant électrique alternatif (I) dans la première section (30-A1, 130-A1, B1) du trajet de courant (21A, 21B, 21D) est en opposition de phase au courant électrique alternatif dans la deuxième section (40-A1, 140-A1, A1) du trajet de courant (21A, 21B, 21D).

3. Dispositif de brasage selon la revendication 2, la première section (30-A1, 130-A1, B1) du trajet de courant (21A, 21B, 21D) et la deuxième section (40-A1, 140-A1, A1) du trajet de courant (21A, 21B, 21D) s'étendant respectivement de façon rectiligne et pour l'essentiel parallèlement à la ligne de brasage (L).

4. Dispositif de brasage selon la revendication 3, la première section (30-A1, 130-A1, B1) du trajet de courant (21A, 21B, 21D) et la deuxième section (40-A1, 140-A1, A1) du trajet de courant (21A, 21B, 21D) étant l'une derrière l'autre sur une droite (G) s'étendant dans le plan de brasage (LE).

5. Dispositif de brasage selon l'une quelconque des revendications 2-4, les éléments abaisseurs (P1-P11) étant disposés respectivement dans le plan de brasage (LE) pour l'essentiel perpendiculairement à la ligne de brasage (L) et au moins trois de ces éléments abaisseurs (P1-P11) étant disposés le long de la ligne de brasage (L) en série les uns derrière les autres de telle manière qu'entre respectivement deux éléments abaisseurs (P1-P11), qui sont disposés en série directement l'un derrière l'autre, un espace intermédiaire (Z1-Z10) est respectivement constitué, et
la première section (30-A1) du trajet de courant (21A) étant disposée dans un des espaces intermédiaires (Z1) entre respectivement deux des éléments abaisseurs (P1, P2) et
la deuxième section (40-A1) du trajet de courant (21A) étant disposée dans un autre des espaces intermédiaires (Z2) entre respectivement deux des éléments abaisseurs (P2, P3).

6. Dispositif de brasage selon la revendication 1, le trajet de courant (21C, 21E) de l'antenne à induction (20C, 20E) comportant :
une première section (LC1, 251-A1), laquelle s'étend sur un premier côté (S1) d'un plan de brasage (LE), dans lequel se trouve la ligne de brasage (L), à une distance du plan de brasage (LE) le long d'au moins une des sections (L1) de la ligne de brasage (L), [séparée de celle-ci par un entrefer (LS) au moins une des sections (L1) de la ligne de brasage (L),
une deuxième section (LD1, 251-B1), laquelle s'étend sur un deuxième côté (S2) du plan de brasage (LE) opposé au premier côté (S1) du plan de brasage (LE) à une distance du plan de brasage (LE) le long d'au moins une autre des sections (L2) de la ligne de brasage (L), [séparée de celle-ci par un entrefer (LS) au moins une autre des sections (L2) de la ligne de brasage (L),
une troisième section (LG1, 252-A1), laquelle s'étend sur le premier côté (S1) du plan de brasage (LE) à une distance du plan de brasage (LE) le long d'au moins une autre des sections (L2) de la ligne de brasage (L), [séparée de celle-ci par un entrefer (LS) au moins une autre des sections (L2) de la ligne de brasage (L),
une quatrième section (LF1-, 252-B1), laquelle s'étend sur le deuxième côté (S2) du plan de brasage (LE) à une distance du plan de brasage (LE) le long d'au moins une des sections (L1) de la ligne de brasage (L), [séparée de celle-ci par un entrefer (LS) au moins une des sections (L1) de la ligne de brasage (L) ,
la première section (LC1, 251-A1) du trajet de courant, la deuxième section (LD1, 251-B1) du trajet de courant, la troisième section (LG1, 252-A1) du trajet de courant et la quatrième section (LF1, 252-B1) du trajet de courant étant électriquement connectées en série l'une derrière l'autre, de sorte que
le courant électrique alternatif (I) dans la première section (LC1, 251-A1) du trajet de courant (21C, 21E) se trouve en phase continue avec le courant électrique alternatif (I) dans la deuxième section (LD1, 251-B1) du trajet de courant et en opposition de phase avec le courant électrique alternatif (I) dans la troisième section (LG1, 252-A1) du trajet de courant et avec le courant électrique alternatif (I) dans la quatrième section (LF1, 252-B1) du trajet de courant.

7. Dispositif de brasage selon la revendication 6, la première section (LC1, 251-A1) du trajet de courant (21C, 21E), et/ou
la deuxième section (LD1, 251-B1) du trajet de courant (21C, 21E), et/ou
la troisième section (LG1, 252-A1) du trajet de courant (21C, 21E), et/ou
la quatrième section (LF1, 252-B1) du trajet de courant (21C, 21E)
s'étendant respectivement de façon rectiligne pour l'essentiel parallèlement à la ligne de brasage (L).

8. Dispositif de brasage selon l'une quelconque des revendications 6 ou 7, la première section (LC1, 251-A1) du trajet de courant (21C, 21E) et la quatrième section (LF1, 252-B1) du trajet de courant (21C, 21E) étant constituées en symétrie spéculaire l'une par rapport à l'autre eu égard au plan de brasage (LE) et/ou la deuxième section (LD1, 251-B1) du trajet de courant (21C, 21E) et la troisième section (LG1, 252-A1) du trajet de courant (21C, 21E) étant constituées en symétrie spéculaire l'une par rapport à l'autre eu égard au plan de brasage (LE).

9. Dispositif de brasage selon l'une quelconque des revendications 6-8, la première section (LC1, 251-A1) et la troisième section (LG1, 252-A1) du trajet de courant (21C, 21E) s'étendent le long d'une première droite (G1) et
la deuxième section (LD1, 251-B1) et la quatrième section (LF1, 252-B1) du trajet de courant (21C, 21E) s'étendent le long d'une deuxième droite (G2).

10. Dispositif de brasage selon l'une quelconque des revendications 6 ou 7, la première section (251-A1) et la deuxième section (251-B1) du trajet de courant (21E) étant constituées comme sections longitudinales disposées l'une derrière l'autre d'une première section de conducteur (251) et
la troisième section (252-A1) et la quatrième section (252-B1) du trajet de courant (21E) sont constituées comme sections longitudinales disposées l'une derrière l'autre d'une deuxième section de conducteur (252),
la première et la deuxième section de conducteur (251, 252) étant torsadées l'une avec l'autre.

11. Dispositif de brasage selon l'une quelconque des revendications 6-9, les éléments abaisseurs (P1-P11) s'étendant respectivement dans le plan de brasage (LE) pour l'essentiel perpendiculairement à la ligne de brasage (L) et au moins trois de ces éléments abaisseurs (P1-P11) étant disposés le long de la ligne de brasage (L) en série l'un derrière l'autre de telle manière qu'entre respectivement deux des éléments abaisseurs (P1-P11), qui sont disposés en série directement l'un derrière l'autre, un espace intermédiaire (Z1-Z10) est respectivement constitué, et
la première section (LC1) et la quatrième section (LF1) du trajet de courant (21C) étant disposées respectivement dans un des espaces intermédiaires (Z1) entre deux éléments abaisseurs (P1, P2), et
la deuxième section (LD1) et la troisième section (LG1) du trajet de courant (21C) étant disposées dans un autre des espaces intermédiaires (Z2) entre respectivement deux des éléments abaisseurs (P2, P3).

12. Dispositif de brasage selon l'une quelconque des revendications 6-10, une zone d'espace libre (R1) étant constituée entre la première section (251-A1) du trajet de courant (21E) et la quatrième section (252-B1) du trajet de courant (21E) et au moins un des éléments abaisseurs (P1) s'étendant à travers cette zone d'espace libre (R1) et/ou une zone d'espace libre (R2) étant constituée entre la deuxième section (251-B1) du trajet de courant (21E) et la troisième section (252-A1) du trajet de courant (21E) et au moins un des éléments abaisseurs (P2) s'étendant à travers cette zone d'espace libre (R2).

13. Dispositif de brasage selon la revendication 1, le trajet de courant (21F) de l'antenne à induction (20F) étant un conducteur en forme de boucle (300), lequel comporte deux branches (300-1, 300-2), une extrémité d'une branche (300-1) étant reliée à une extrémité de l'autre branche (300-2),
au moins une des deux branches (300-1) s'étendant dans une forme de méandre le long de la ligne de brasage (L) et croise en plusieurs endroits séparés un plan de brasage (LE) dans lequel se trouve la ligne de brasage (L), de telle manière que cette branche (300-1) comporte plusieurs sections longitudinales se succédant dans sa direction longitudinale, lesquelles s'étendent alternativement sur un côté (S1) du plan de brasage (LE) et sur l'autre côté (S2) du plan de brasage (respectivement le long d'une courbe, qui est arquée et/ou arquée par section et/ou rectiligne par section).

14. Dispositif de brasage selon la revendication 13, les deux branches (300-1, 300-2) s'étendant dans un plan qui est disposé perpendiculairement au plan de brasage (LE) et/ou parallèlement à une surface (1-1) de la cellule solaire (1), et
l'autre des deux branches (300-2) s'étendant parallèlement à une des deux branches (300-1) et le courant électrique alternatif (I) dans une des deux branches (300-1) étant en opposition de phase au courant électrique alternatif (I) dans l'autre des deux branches (300-2).
